# EUROPEAN PATENT SPECIFICATION

(11) **EP 3 595 025 B1**
(45) Date of publication and mention of the grant of the patent: **30.12.2020**
(21) Application number: 18809895.8
(22) Date of filing: 29.05.2018
(51) Int. Cl.: H01L 51/54

(54) **ORGANIC LIGHT EMITTING ELEMENT**
ORGANISCHES LICHTEMITTIERENDES ELEMENT
ÉLÉMENT ÉLECTROLUMINESCENT ORGANIQUE

(30) Priority: 29.05.2017 KR 20170066305
(43) Date of publication of application: 15.01.2020
(73) Proprietor: LG Chem, Ltd., Seoul 07336 (KR)
(72) Inventor: HEO, Dong Uk, Daejeon 34122 (KR); LEE, Dong Hoon, Daejeon 34122 (KR); HUH, Jungoh, Daejeon 34122 (KR); JANG, Boonjae, Daejeon 34122 (KR); CHA, Yongbum, Daejeon 34122 (KR); HAN, Miyeon, Daejeon 34122 (KR); YANG, Junghoon, Daejeon 34122 (KR); YUN, Heekyung, Daejeon 34122 (KR)
(74) Representative: Hoffmann Eitle
(86) International application number: PCT/KR2018/006078
(87) International publication number: WO 2018/221930

(56) References cited:
- WO-A1-2014/072017
- WO-A1-2016/021989
- CN-A- 102 786 508
- JP-A- 2003 096 072
- KR-A- 20150 083 917
- KR-A- 20150 106 501
- KR-A- 20160 047 670
- US-A1- 2016 118 599
- "Photoelectron Spectrophotometer in air. Surface Analyzer. Model AC-3", , 11 June 2012 (2012-06-11), pages 1-6, XP055029420, Retrieved from the Internet: URL:http://www.rkiinstruments.com/pdf/AC3. pdf [retrieved on 2012-06-11]

## Description

### [Technical Field]

The present specification relates to an organic light emitting device.

### [Background Art]

An organic light emission phenomenon generally refers to a phenomenon converting electrical energy to light energy using an organic material. An organic light emitting device using an organic light emission phenomenon normally has a structure including an anode, a cathode, and an organic material layer therebetween. Herein, the organic material layer is often formed in a multilayer structure formed with different materials in order to increase efficiency and stability of the organic light emitting device, and for example, may be formed with a hole injection layer, a hole transfer layer, a light emitting layer, an electron transfer layer, an electron injection layer and the like. When a voltage is applied between the two electrodes in such an organic light emitting device structure, holes and electrons are injected to the organic material layer from the anode and the cathode, respectively, and when the injected holes and electrons meet, excitons are formed, and light emits when these excitons fall back to the ground state.

Development of new materials for such an organic light emitting device has been continuously required.

### Prior Art Documents

Korean Patent Application Laid-Open Publication No. 10-2000-0051826 US-A-2016/0118599 teaches an organic light-emitting device which includes a compound represented by the following general F formula:

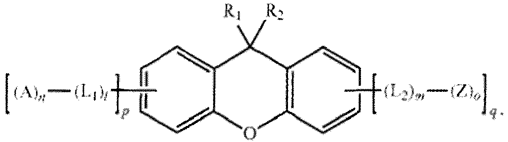

An example of such a compound is:

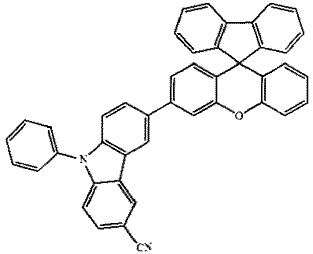

WO 2016/021989 discloses an organic electroluminescent compound represented by the following general formula:

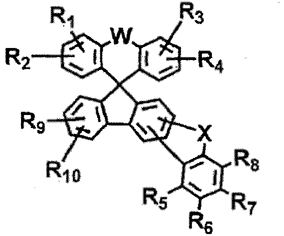

An example of such compound is

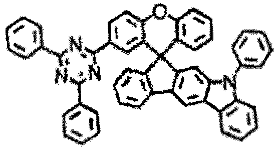

WO-A-2014/072017 discloses an electronic device which includes a compound of the following general formula:

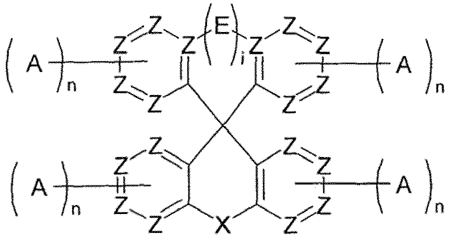

An example of such a compound is

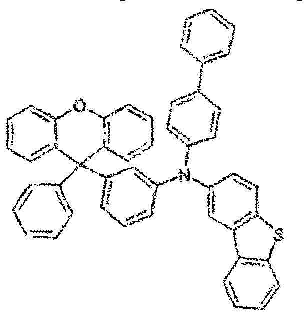

### [Disclosure]

### [Technical Problem]

The present specification provides an organic light emitting device.

### [Technical Solution]

One embodiment of the present specification provides an organic light emitting device including an anode; a cathode; and a light emitting layer provided between the anode and the cathode, the device further including an electron control layer provided between the light emitting layer and the cathode and including a compound represented by the following Chemical Formula 1; and an electron transfer layer provided between the electron control layer and the cathode and including a compound represented by the following Chemical Formula 3: 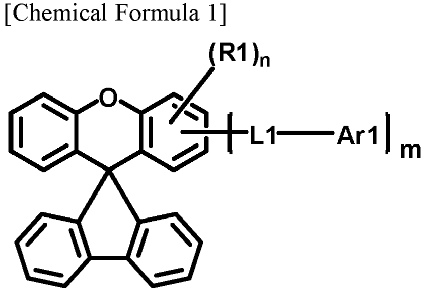 in Chemical Formula 1,
R1 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group,
L1 is a direct bond; a substituted or unsubstituted arylene group; or a substituted or unsubstituted heteroarylene group,
Ar1 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; a substituted or unsubstituted monocyclic heterocyclic group; a substituted or unsubstituted tricyclic or higher heterocyclic group; a substituted or unsubstituted dicyclic heterocyclic group including two or more Ns; a substituted or unsubstituted isoquinolyl group; or a structure represented by the following Chemical Formula 2,
m is an integer of 1 to 4, n is an integer of 0 to 3, and 1≤n+m≤4, and
when m and n are each an integer of 2 or greater, two or more structures in the parentheses are the same as or different from each other, 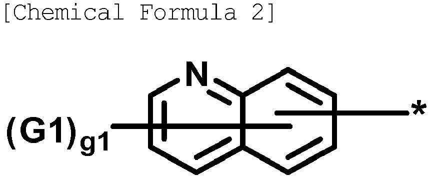
in Chemical Formula 2,
G1 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group,
g1 is an integer of 1 to 6, and when g1 is 2 or greater, G1s are the same as or different from each other, and
* is a site bonding to L1 of Chemical Formula 1, 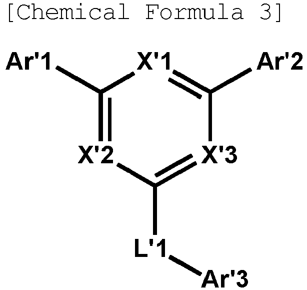
in Chemical Formula 3,
Ar'1 and Ar'2 are the same as or different from each other, and each independently a substituted or unsubstituted aryl group or a substituted or unsubstituted heteroaryl group,
X'1 is N or CR'1, X'2 is N or CR'2, and X'3 is N or CR'3,
at least two of X'1 to X'3 are N,
L'1 is a direct bond; a substituted or unsubstituted arylene group; or a substituted or unsubstituted heteroarylene group,
R'1 to R'3 are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group, and
Ar'3 is represented by the following Chemical Formula 4a, 4b or 4c,

[Chemical Formula 4a] ****-(L'2)n1-Ar'4**

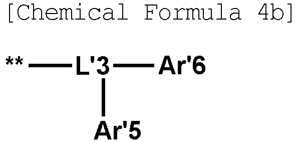

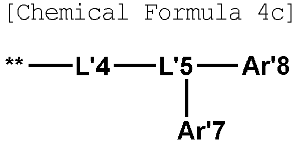

in Chemical Formulae 4a to 4c,
** is a site bonding to L'1 of Chemical Formula 3,
n1 is an integer of 1 to 3,
L'2 and L'4 are the same as or different from each other, and each independently a direct bond; a substituted or unsubstituted alkylene group; a substituted or unsubstituted arylene group; or a substituted or unsubstituted heteroarylene group,
L'3 and L'5 are the same as or different from each other, and each independently a substituted or unsubstituted trivalent aryl group; or a substituted or unsubstituted trivalent heteroaryl group, and
Ar'4 to Ar'8 are the same as or different from each other, and each independently a nitrile group; an aryl group unsubstituted or substituted with one, two or more substituents selected from the group consisting of a substituted or unsubstituted alkyl group, a substituted or unsubstituted aryl group, a substituted or unsubstituted pyridyl group, a substituted or unsubstituted carbazole group and a nitrile group; or a substituted or unsubstituted heteroaryl group.

### [Advantageous Effects]

An organic light emitting device according to one embodiment of the present specification is capable of enhancing efficiency, obtaining a low driving voltage and/or enhancing lifetime properties.

### [Description of Drawings]

FIG. 1 is a diagram illustrating an organic light emitting device (10) according to one embodiment of the present specification.
FIG. 2 is a diagram illustrating an organic light emitting device (11) according to another embodiment of the present specification.
FIG. 3 is a diagram illustrating an organic light emitting device (12) according to another embodiment of the present specification.

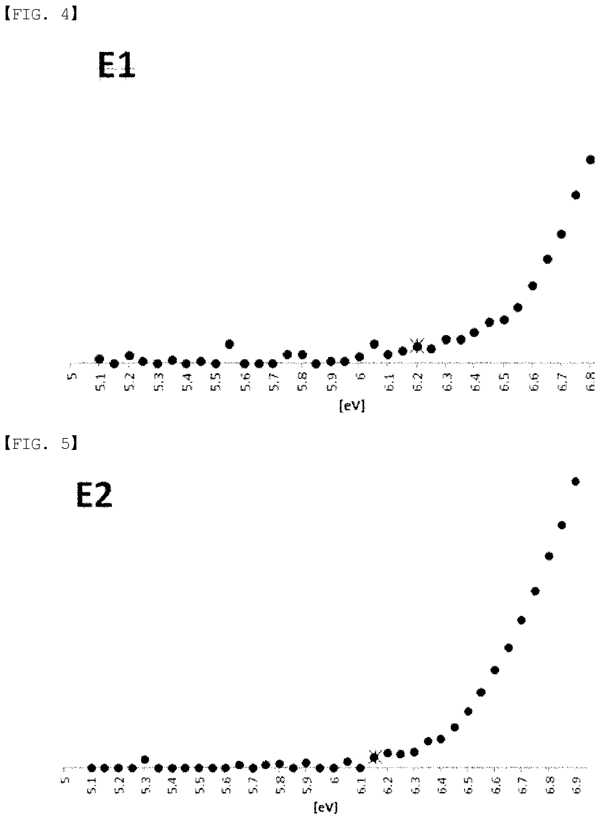

FIG. 4 is a diagram showing a HOMO energy level measured for Compound E1 of Preparation Example 1-1 according to one embodiment of the present specification using an optoelectronic spectrometer.
FIG. 5 is a diagram showing a HOMO energy level measured for Compound E2 of Preparation Example 1-2 according to one embodiment of the present specification using an optoelectronic spectrometer.

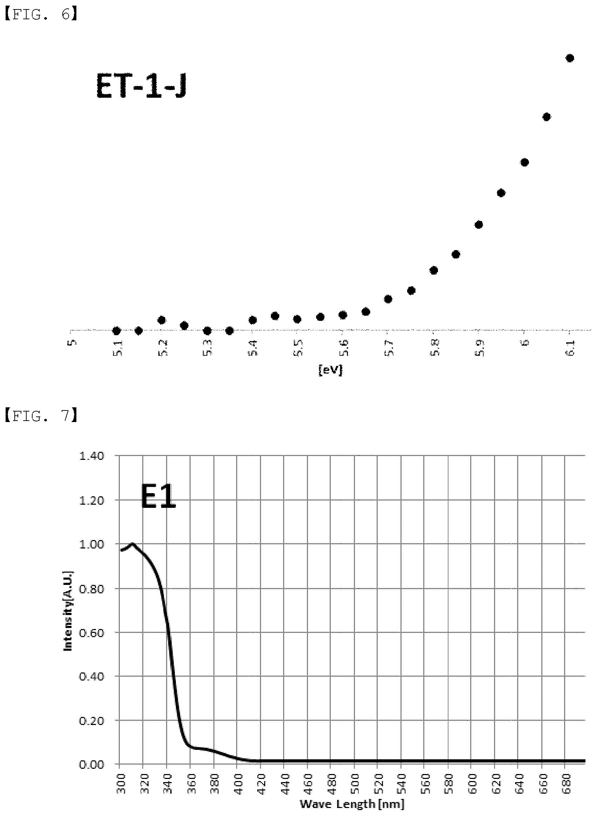

FIG. 6 is a diagram showing a HOMO energy level measured for Compound [ET-1-J] using an optoelectronic spectrometer.
FIG. 7 is a diagram showing a LUMO energy level calculated as a wavelength value measured for Compound E1 of Preparation Example 1-1 according to one embodiment of the present specification through photoluminescence (PL).

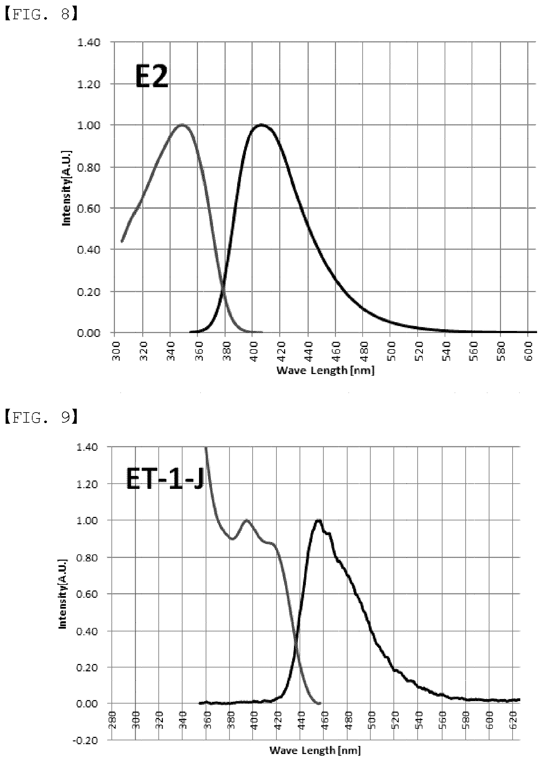

FIG. 8 is a diagram showing a LUMO energy level calculated as a wavelength value measured for Compound E2 of Preparation Example 1-2 according to one embodiment of the present specification through photoluminescence (PL).
FIG. 9 is a diagram showing a LUMO energy level calculated as a wavelength value measured for Compound [ET-1-J] througuh photoluminescence (PL).
FIG. 10 is a diagram showing a molecular 3D structure for Compound E9 of Preparation Example 1-9 according to one embodiment of the present specification using Chem 3D Pro.
FIG. 11 is a diagram showing a molecular 3D structure for Compound E18 of Preparation Example 1-18 according to one embodiment of the present specification using Chem 3D Pro.
FIG. 12 is a diagram showing a molecular 3D structure for Compound [ET-1-E] using Chem 3D Pro.
FIG. 13 is a diagram showing a molecular 3D structure for Compound [ET-1-I] using Chem 3D Pro.

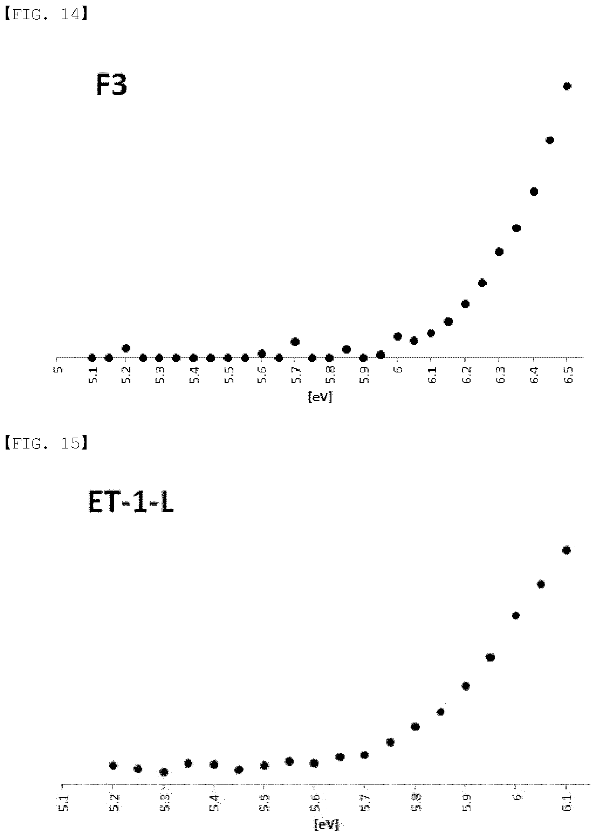

FIG. 14 is a diagram showing a HOMO energy level measured for Compound F3 of Preparation Example 2-3 according to one embodiment of the present specification using an optoelectronic spectrometer.
FIG. 15 is a diagram showing a HOMO energy level measured for Compound [ET-1-L] using an optoelectronic spectrometer.

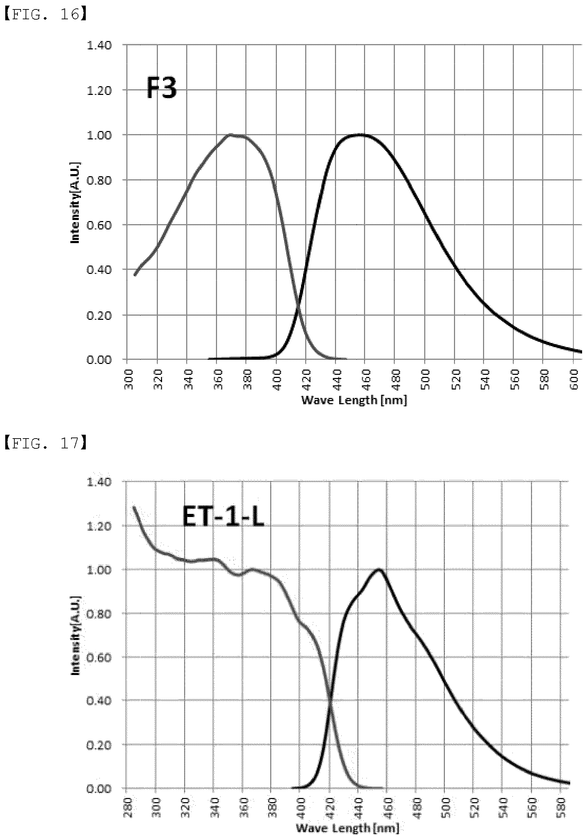

FIG. 16 is a diagram showing a LUMO energy level calculated as a wavelength value measured for Compound F3 of Preparation Example 2-3 according to one embodiment of the present specification through photoluminescence (PL).
FIG. 17 is a diagram showing a LUMO energy level calculated as a wavelength value measured for Compound [ET-1-L] through photoluminescence (PL).
FIG. 18 is a diagram showing HOMO energy and LUMO energy values for compounds measured in Example 2 of the present specification.

### [Mode for Disclosure]

Hereinafter, the present specification will be described in more detail.

One embodiment of the present specification provides an organic light emitting device including an anode; a cathode; and a light emitting layer provided between the anode and the cathode, the device further including an electron control layer provided between the light emitting layer and the cathode and including a compound represented by Chemical Formula 1; and an electron transfer layer provided between the electron control layer and the cathode and including a compound represented by Chemical Formula 3.

When using the compound represented by Chemical Formula 3 alone as an electron transfer layer without an electron control layer, a barrier may occur in electron injection to a light emitting layer although an electron injection ability from a cathode is smooth (refer to Example 1 and Example 2). However, when using the compound represented by Chemical Formula 1 as an electron control layer, and using the compound represented by Chemical Formula 3 as an electron transfer layer at the same time, efficiency and lifetime properties of an organic light emitting device may be enhanced by excellent hole blocking and effectively moving electron injection.

An organic light emitting device according to one embodiment of the present specification may enhance driving voltage, efficiency and/or lifetime properties by controlling materials included in an electron control layer and an electron transfer layer, and thereby adjusting an energy level between each layer.

According to one embodiment of the present specification, the compound represented by Chemical Formula 1 is capable of enhancing efficiency, obtaining a low driving voltage and enhancing lifetime properties in an organic light emitting device by being included in an electron control layer as a nonlinear structure. In addition, in the structure of the compound represented by Chemical Formula 1, molecular dipole moment may be designed close to nonpolar by a substituent Ar1 having an electron deficient-structured substituent, and therefore, an amorphous layer may be formed when manufacturing an organic light emitting device including the compound represented by Chemical Formula 1 in an electron control layer. Accordingly, the organic light emitting device according to one embodiment of the present specification is capable of enhancing efficiency, obtaining a low driving voltage and enhancing lifetime properties.

Particularly, the compound represented by Chemical Formula 1 has substituents in just one benzene in the spiro fluorene xanthene (core structure), and, particularly when n=0 and m=1, has a three-dimensionally horizontal structure as well as having the above-described electronic properties, and therefore, electron mobility is strengthened when forming an organic material layer using such a material. On the other hand, when two or more benzene rings are substituted in the core structure of Chemical Formula 1, the horizontal structure as above may not be obtained, and therefore, electron mobility is low compared to the compound of the present disclosure.

In the present specification, the "energy level" means a size of energy. Accordingly, the energy level is interpreted to mean an absolute value of the corresponding energy value. For example, the energy level being low or deep means an absolute value increasing in a negative direction from a vacuum level.

In the present specification, a highest occupied molecular orbital (HOMO) means a molecular orbital present in a region with highest energy in a region where electrons are capable of participating in bonding, a lowest unoccupied molecular orbital (LUMO) means a molecular orbital present in a region with lowest energy in an electron anti-bonding region, and a HOMO energy level means a distance from a vacuum level to the HOMO. In addition, a LUMO energy level means a distance from a vacuum level to the LUMO.

In the present specification, a bandgap means a difference between HOMO and LUMO energy levels, that is, a HOMO-LUMO gap.

According to one embodiment of the present specification, the compound represented by Chemical Formula 1 may have a HOMO energy level of 6.0 eV or greater, a triplet energy level of 2.5 eV or greater, and a bandgap of 3.0 eV or greater.

As triplet energy increases, efficiency of an organic light emitting device may be enhanced since triplet energy of a light emitting layer is not transferred to adjacent layers. In addition, having a HOMO energy level of 6.0 eV or greater in an electron control layer prevents hole transfer of a light emitting layer, and a device with high efficiency and long lifetime may be manufactured.

Accordingly, when using the compound represented by Chemical Formula 1 satisfying the above-mentioned range in an electron control layer, electron mobility is high, and therefore, properties of low driving voltage, high efficiency and long lifetime are obtained when used in an organic light emitting device. In addition, by the LUMO energy level having a value of 3.0 eV to 2.6 eV, an energy barrier with a light emitting layer is not high making electron injection smooth. The LUMO energy level means an energy level in a region having a low energy barrier with a light emitting layer.

In the present specification, the HOMO energy level may be measured using an optoelectronic spectrometer (manufactured by RIKEN KEIKI Co., Ltd.: AC3) under the atmosphere, and the LUMO energy level may be calculated as a wavelength value measured through photoluminescence (PL).

In the present specification, a description of a certain part "including" certain constituents means capable of further including other constituents, and does not exclude other constituents unless particularly stated on the contrary.

In the present specification, a description of one member being placed "on" another member includes not only a case of the one member adjoining the other member but a case of still another member being present between the two members.

Examples of substituents in the present specification are described below, however, the substituents are not limited thereto.

The term "substitution" means a hydrogen atom bonding to a carbon atom of a compound is changed to another substituent, and the position of substitution is not limited as long as it is a position at which the hydrogen atom is substituted, that is, a position at which a substituent can substitute, and when two or more substituents substitute, the two or more substituents may be the same as or different from each other.

In the present specification, the term "substituted or unsubstituted" means being substituted with one, two or more substituents selected from the group consisting of deuterium; a halogen group; a nitrile group; a nitro group; an imide group; an amide group; a carbonyl group; an ester group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; and a substituted or unsubstituted heterocyclic group, or being substituted with a substituent linking two or more substituents among the substituents illustrated above, or having no substituents. For example, "a substituent linking two or more substituents" may include a biphenyl group. In other words, a biphenyl group may be an aryl group, or interpreted as a substituent linking two phenyl groups.

In the present specification, the halogen group may include fluorine, chlorine, bromine or iodine.

In the present specification, the number of carbon atoms of the imide group is not particularly limited, but is preferably from 1 to 30. Specifically, compounds having structures as below may be included, however, the imide group is not limited thereto.

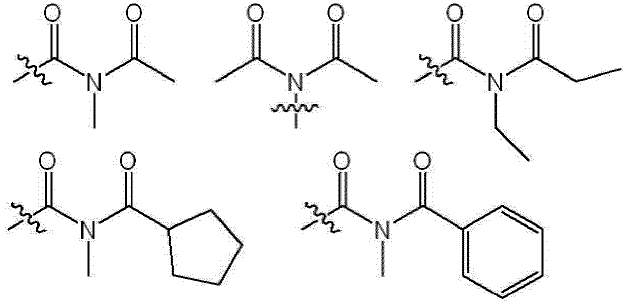

In the present specification, in the amide group, the nitrogen of the amide group may be substituted with a linear, branched or cyclic alkyl group having 1 to 30 carbon atoms or an aryl group having 6 to 30 carbon atoms. Specifically, compounds having the following structural formulae may be included, however, the amide group is not limited thereto.

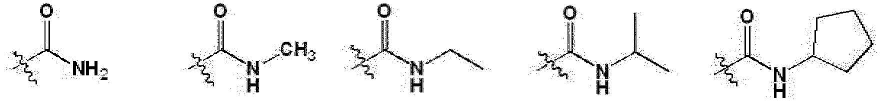

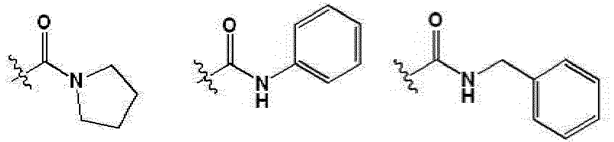

In the present specification, the number of carbon atoms of the carbonyl group is not particularly limited, but is preferably from 1 to 30. Specifically, compounds having structures as below may be included, however, the carbonyl group is not limited thereto.

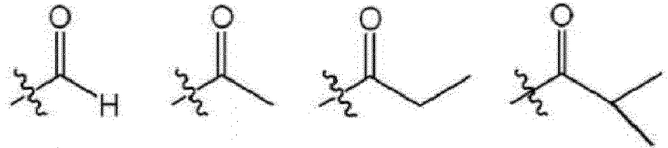

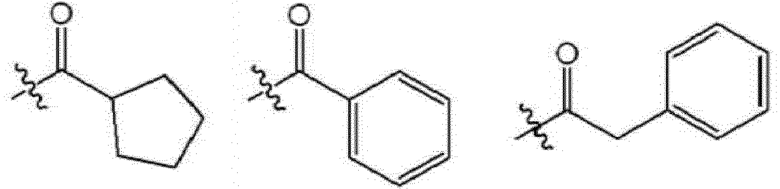

In the present specification, in the ester group, the oxygen of the ester group may be substituted with a linear, branched or cyclic alkyl group having 1 to 25 carbon atoms or an aryl group having 6 to 30 carbon atoms. Specifically, compounds having the following structural formulae may be included, however, the ester group is not limited thereto.

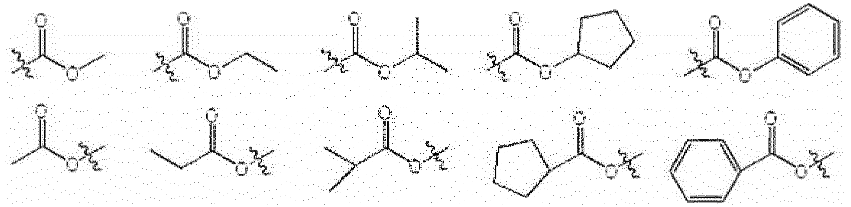

In the present specification, the alkyl group may be linear or branched, and although not particularly limited thereto, the number of carbon atoms is preferably from 1 to 30. Specifically, the number of carbon atoms is preferably from 1 to 20. More specifically, the number of carbon atoms is preferably from 1 to 10. Specific examples thereof may include a methyl group; an ethyl group; a propyl group; an n-propyl group; an isopropyl group; a butyl group; an n-butyl group; an isobutyl group; a tert-butyl group; a sec-butyl group; a 1-methylbutyl group; a 1-ethylbutyl group; a pentyl group; an n-pentyl group; an isopentyl group; a neopentyl group; a tert-pentyl group; a hexyl group; an n-hexyl group; a 1-methylpentyl group; a 2-methylpentyl group; a 4-methyl-2-pentyl group; a 3,3-dimethylbutyl group; a 2-ethylbutyl group; a heptyl group; an n-heptyl group; a 1-methylhexyl group; a cyclopentylmethyl group; a cyclohexylmethyl group; an octyl group; an n-octyl group; a tert-octyl group; a 1-methylheptyl group; a 2-ethylhexyl group; a 2-propylpentyl group; an n-nonyl group; a 2,2-dimethylheptyl group; a 1-ethylpropyl group; a 1,1-dimethylpropyl group; an isohexyl group; a 2-methylpentyl group; a 4-methylhexyl group; a 5-methylhexyl group and the like, but are not limited thereto.

In the present specification, the cycloalkyl group is not particularly limited, but preferably has 3 to 30 carbon atoms and more preferably has 3 to 20 carbon atoms. Specific examples thereof may include a cyclopropyl group; a cyclobutyl group; a cyclopentyl group; a 3-methylcyclopentyl group; a 2,3-dimethylcyclopentyl group; a cyclohexyl group; a 3-methylcyclohexyl group; a 4-methylcyclohexyl group; a 2,3-dimethylcyclohexyl group; a 3,4,5-trimethylcyclohexyl group; a 4-tert-butylcyclohexyl group; a cycloheptyl group; a cyclooctyl group and the like, but are not limited thereto.

In the present specification, the alkoxy group may be linear, branched or cyclic. The number of carbon atoms of the alkoxy group is not particularly limited, but is preferably from 1 to 30. Specifically, the number of carbon atoms is preferably 1 to 20. More specifically, the number of carbon atoms is preferably 1 to 10. Specific examples thereof may include a methoxy group; an ethoxy group; an n-propoxy group; an isopropoxy group; an i-propyloxy group; an n-butoxy group; an isobutoxy group; a tert-butoxy group; a sec-butoxy group; an n-pentyloxy group; a neopentyloxy group; an isopentyloxy group; an n-hexyloxy group; a 3,3-dimethylbutyloxy group; an 2-ethylbutyloxy group; an n-octyloxy group; an n-nonyloxy group; an n-decyloxy group; a benzyloxy group; a p-methylbenzyloxy group and the like, but are not limited thereto.

In the present specification, the amine group may be selected from the group consisting of -NH₂; an alkylamine group; an N-alkylarylamine group; an arylamine group; an N-arylheteroarylamine group; an N-alkylheteroarylamine group and a heteroarylamine group, and although not particularly limited thereto, the number of carbon atoms is preferably from 1 to 30. Specific examples of the amine group may include a methylamine group; a dimethylamine group; an ethylamine group; a diethylamine group; a phenylamine group; a naphthylamine group; a biphenylamine group; an anthracenylamine group; a 9-methylanthracenylamine group; a diphenylamine group; an N-phenylnaphthylamine group; a ditolylamine group; an N-phenyltolylamine group; a triphenylamine group; an N-phenylbiphenylamine group; an N-biphenylnaphthylamine group; an N-naphthylfluorenylamine group; an N-phenylphenanthrenylamine group; an N-biphenylphenanthrenylamine group; an N-phenylfluorenylamine group; an N-phenylterphenylamine group; an N-phenanthrenylfluorenylamine group; an N-biphenylfluorenylamine group and the like, but are not limited thereto.

In the present specification, the N-alkylarylamine group means an amine group in which N of the amine group is substituted with an alkyl group and an aryl group.

In the present specification, the N-arylheteroarylamine group means an amine group in which N of the amine group is substituted with an aryl group and a heteroaryl group.

In the present specification, the N-alkylheteroarylamine group means an amine group in which N of the amine group is substituted with an alkyl group and a heteroaryl group.

In the present specification, the alkyl group in the alkylamine group, the N-arylalkylamine group, the alkylthioxy group, the alkylsulfoxy group and the N-alkylheteroarylamine group is the same as the examples of the alkyl group described above. Specifically, the alkylthioxy group may include a methylthioxy group; an ethylthioxy group; a tert-butylthioxy group; a hexylthioxy group; an octylthioxy group and the like, and the alkylsulfoxy group may include mesyl; an ethylsulfoxy group; a propylsulfoxy group; a butylsulfoxy group and the like, however, the alkylthoixy group and the alkylsulfoxy group are not limited thereto.

In the present specification, the alkenyl group may be linear or branched, and although not particularly limited thereto, the number of carbon atoms is preferably from 2 to 30. Specific examples thereof may include a vinyl group; a 1-propenyl group; an isopropenyl group; a 1-butenyl group; a 2-butenyl group; a 3-butenyl group; a 1-pentenyl group; a 2-pentenyl group; a 3-pentenyl group; a 3-methyl-1-butenyl group; a 1,3-butadienyl group; an allyl group; a 1-phenylvinyl-1-yl group; a 2-phenylvinyl-1-yl group; a 2,2-diphenylvinyl-1-yl group; a 2-phenyl-2-(naphthyl-1-yl)vinyl-1-yl group; a 2,2-bis(diphenyl-1-yl)vinyl-1-yl group; a stilbenyl group; a styrenyl group and the like, but are not limited thereto.

In the present specification, the silyl group may be represented by a chemical formula of -SiRaRbRc, and Ra, Rb and Rc may each be hydrogen; a substituted or unsubstituted alkyl group; or a substituted or unsubstituted aryl group. Specific examples of the silyl group may include a trimethylsilyl group; a triethylsilyl group; a t-butyldimethylsilyl group; a vinyldimethylsilyl group; a propyldimethylsilyl group; a triphenylsilyl group; a diphenylsilyl group; a phenylsilyl group and the like, but are not limited thereto.

In the present specification, the boron group may be - BR₁₀₀R₁₀₁, and R₁₀₀ and R₁₀₁ are the same as or different from each other, and may be each independently selected from the group consisting of hydrogen; deuterium; a halogen group; a nitrile group; a substituted or unsubstituted monocyclic or polycyclic cycloalkyl group having 3 to 30 carbon atoms; a substituted or unsubstituted linear or branched alkyl group having 1 to 30 carbon atoms; a substituted or unsubstituted monocyclic or polycyclic aryl group having 6 to 30 carbon atoms; and a substituted or unsubstituted monocyclic or polycyclic heteroaryl group having 2 to 30 carbon atoms.

In the present specification, specific examples of the phosphine oxide group may include a diphenylphosphine oxide group; a dinaphthylphosphine oxide group and the like, but are not limited thereto.

In the present specification, the aryl group is not particularly limited, but preferably has 6 to 30 carbon atoms, and more preferably has 6 to 20 carbon atoms. The aryl group may be monocyclic or polycyclic.

When the aryl group is a monocyclic aryl group, the number of carbon atoms is not particularly limited, but is preferably from 6 to 30. Specific examples of the monocyclic aryl group may include a phenyl group; a biphenyl group; a terphenyl group and the like, but are not limited thereto.

When the aryl group is a polycyclic aryl group, the number of carbon atoms is not particularly limited, but is preferably from 10 to 30. Specific examples of the polycyclic aryl group may include a naphthyl group; an anthracenyl group; a phenanthryl group; a triphenyl group; a pyrenyl group; a phenalenyl group; a perylenyl group; a chrysenyl group; a fluorenyl group and the like, but are not limited thereto.

In the present specification, the fluorenyl group may be substituted, and adjacent groups may bond to each other to form a ring.

When the fluorenyl group is substituted, 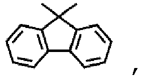 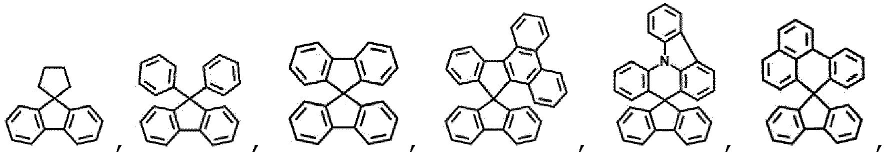 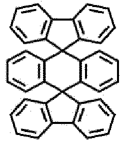 and the like may be included. However, the compound is not limited thereto.

In the present specification, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituting ortho positions in a benzene ring, and two substituents substituting the same carbon in an aliphatic ring may be interpreted as groups "adjacent" to each other.

In the present specification, the aryl group in the aryloxy group, the arylthioxy group, the arylsulfoxy group, the N-arylalkylamine group, the N-arylheteroarylamine group and the arylphosphine group is the same as the examples of the aryl group described above. Specific examples of the aryloxy group may include a phenoxy group; a p-tolyloxy group; an m-tolyloxy group; a 3,5-dimethylphenoxy group; a 2,4,6-trimethylphenoxy group; a p-tert-butylphenoxy group; a 3-biphenyloxy group; a 4-biphenyloxy group; a 1-naphthyloxy group; a 2-naphthyloxy group; a 4-methyl-1-naphthyloxy group; a 5-methyl-2-naphthyloxy group; a 1-anthryloxy group; a 2-anthryloxy group; a 9-anthryloxy group; a 1-phenanthryloxy group; a 3-phenanthryloxy group; a 9-phenanthryloxy group and the like. Specific examples of the arylthioxy group may include a phenylthioxy group; a 2-methylphenylthioxy group; a 4-tert-butylphenylthioxy group and the like, and specific examples of the arylsulfoxy group may include a benzenesulfoxy group; a p-toluenesulfoxy group and the like. However, the aryloxy group, the arylthioxy group and the arylsulfoxy group are not limited thereto.

In the present specification, examples of the arylamine group include a substituted or unsubstituted monoarylamine group, a substituted or unsubstituted diarylamine group, or a substituted or unsubstituted triarylamine group. The aryl group in the arylamine group may be a monocyclic aryl group or a polycyclic aryl group. The arylamine group including two or more aryl groups may include monocyclic aryl groups, polycyclic aryl groups, or both monocyclic aryl groups and polycyclic aryl groups. For example, the aryl group in the arylamine group may be selected from among the examples of the aryl group described above.

In the present specification, the heteroaryl group is a group including one or more atoms that are not carbon, that is, heteroatoms, and specifically, the heteroatom may include one or more atoms selected from the group consisting of O, N, Se, S and the like. The number of carbon atoms is not particularly limited, but is preferably from 2 to 30 and more preferably from 2 to 20, and the heteroaryl group may be monocyclic or polycyclic. Examples of the heteroaryl group may include a thiophene group; a furanyl group; a pyrrole group; an imidazolyl group; a thiazolyl group; an oxazolyl group; an oxadiazolyl group; a pyridyl group; a bipyridyl group; a pyrimidyl group; a triazinyl group; a triazolyl group; an acridyl group; a pyridazinyl group; a pyrazinyl group; a quinolinyl group; a quinazolinyl group; a quinoxalinyl group; a phthalazinyl group; a pyridopyrimidyl group; a pyridopyrazinyl group; a pyrazinopyrazinyl group; an isoquinolinyl group; an indolyl group; a carbazolyl group; a benzoxazolyl group; a benzimidazolyl group; a benzothiazolyl group; a benzocarbazolyl group; a benzothiophene group; a dibenzothiophene group; a benzofuranyl group; a phenanthrolinyl group; an isoxazolyl group; a thiadiazolyl group; a phenothiazinyl group; a dibenzofuranyl group and the like, but are not limited thereto.

In the present specification, examples of the heteroarylamine group include a substituted or unsubstituted monoheteroarylamine group, a substituted or unsubstituted diheteroarylamine group, or a substituted or unsubstituted triheteroarylamine group. The heteroarylamine group including two or more heteroaryl groups may include monocyclic heteroaryl groups, polycyclic heteroaryl groups, or both monocyclic heteroaryl groups and polycyclic heteroaryl groups. For example, the heteroaryl group in the heteroarylamine group may be selected from among the examples of the heteroaryl group described above.

In the present specification, examples of the heteroaryl group in the N-arylheteroarylamine group and the N-alkylheteroarylamine group are the same as the examples of the heteroaryl group described above.

In the present specification, the arylene group means an aryl group having two bonding sites, that is, a divalent group. Descriptions on the aryl group provided above may be applied thereto except for each being a divalent group.

In the present specification, the heteroarylene group means a heteroaryl group having two bonding sites, that is, a divalent group. Descriptions on the heteroaryl group provided above may be applied thereto except for each being a divalent group.

In the present specification, the heterocyclic group may be monocyclic or polycyclic, may be aromatic, aliphatic or a fused ring of aromatic and aliphatic, and may be selected from among the examples of the heteroaryl group. Examples of the heterocyclic group in addition thereto may include a hydroacridyl group (for example, 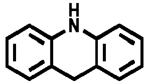 ) and a sulfonyl group-including heterocyclic structure such as 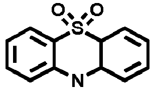 or

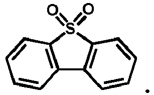

In the present specification, the "ring" in the substituted or unsubstituted ring formed by adjacent groups bonding to each other means a substituted or unsubstituted hydrocarbon ring; or a substituted or unsubstituted heteroring.

In the present specification, the hydrocarbon ring may be aromatic, aliphatic or a fused ring of aromatic and aliphatic, and may be selected from among the examples of the cycloalkyl group or the aryl group except for those that are not monovalent.

In the present specification, the aromatic ring may be monocyclic or polycyclic, and may be selected from among the examples of the aryl group except for those that are not monovalent.

In the present specification, the heteroring includes one or more atoms that are not carbon, that is, heteroatoms, and specifically, the heteroatom may include one or more atoms selected from the group consisting of O, N, Se, S and the like. The heteroring may be monocyclic or polycyclic, aromatic, aliphatic or a fused ring of aromatic and aliphatic, and may be selected from among the examples of the heteroaryl group or the heterocyclic group except for those that are not monovalent.

According to one embodiment of the present specification, in Chemical Formula 1, L1 is a direct bond; an arylene group; or a heteroarylene group.

According to one embodiment of the present specification, in Chemical Formula 1, L1 is a direct bond; a substituted or unsubstituted phenylene group; a substituted or unsubstituted biphenylene group; a substituted or unsubstituted naphthylene group; a substituted or unsubstituted terphenylene group; a substituted or unsubstituted quaterphenylene group; a substituted or unsubstituted anthracenylene group; a substituted or unsubstituted phenanthrenylene group; a substituted or unsubstituted triphenylenylene group; a substituted or unsubstituted pyrenylene group; a substituted or unsubstituted fluorenylene group; a substituted or unsubstituted spiro cyclopentane fluorenylene group; a substituted or unsubstituted dibenzofuranylene group; a substituted or unsubstituted divalent dibenzothiophene group; a substituted or unsubstituted carbazolene group; a substituted or unsubstituted pyridylene group; a substituted or unsubstituted divalent furan group; or a substituted or unsubstituted divalent thiophene group.

According to one embodiment of the present specification, in Chemical Formula 1, L1 is a direct bond; a phenylene group; a biphenylylene group; a naphthylene group; a terphenylylene group; a pyrimidylene group; a divalent furan group; or a divalent thiophene group.

According to one embodiment of the present specification, in Chemical Formula 1, L1 may be a direct bond; or represented by one of the following structural formulae.

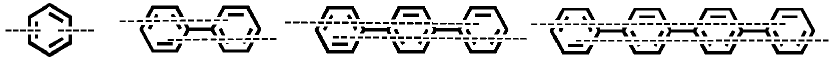

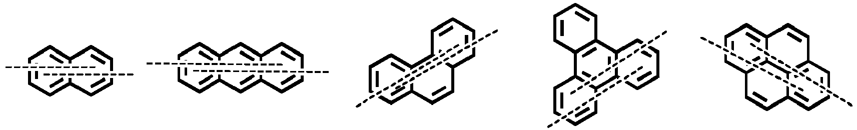

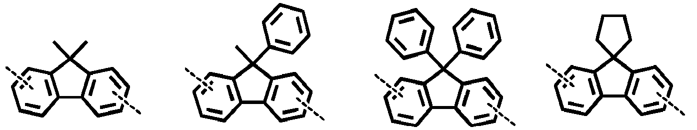

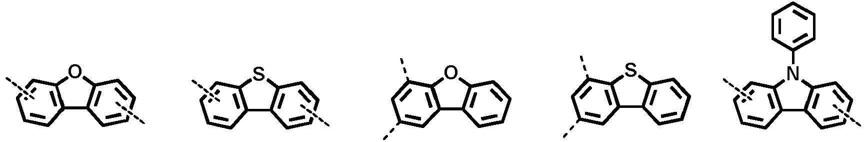

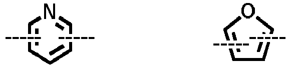

In the structures, ----- is a site bonding to a main chain.

According to one embodiment of the present specification, in Chemical Formula 1, Ar1 is a nitrile group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted amine group; a substituted or unsubstituted arylphosphine group; a substituted or unsubstituted phosphine oxide group; a substituted or unsubstituted aryl group; a substituted or unsubstituted monocyclic heterocyclic group; a substituted or unsubstituted tricyclic or higher heterocyclic group; a substituted or unsubstituted dicyclic heterocyclic group including two or more Ns; a substituted or unsubstituted isoquinolyl group; or a structure represented by any one selected from among Chemical Formula 2 and the following Chemical Formulae 6 to 15.

According to one embodiment of the present specification, in Chemical Formula 1, Ar1 is a nitrile group; a substituted or unsubstituted alkoxy group; a substituted or unsubstituted phosphine oxide group; a substituted or unsubstituted silyl group; a substituted or unsubstituted aryl group; a substituted or unsubstituted monocyclic heterocyclic group; a substituted or unsubstituted tricyclic or higher heterocyclic group; a substituted or unsubstituted dicyclic heterocyclic group including two or more Ns; a substituted or unsubstituted isoquinolyl group; or a structure represented by any one selected from among Chemical Formula 2 and the following Chemical Formulae 6 to 15.

According to one embodiment of the present specification, in Chemical Formula 1, Ar1 is a nitrile group; a substituted or unsubstituted alkoxy group; a substituted or unsubstituted phosphine oxide group; a substituted or unsubstituted aryl group; or a structure represented by any one selected from among Chemical Formula 2 and the following Chemical Formulae 6 to 15.

According to one embodiment of the present specification, in Chemical Formula 1, Ar1 is a nitrile group; an alkoxy group unsubstituted or substituted with a halogen group; a phosphine oxide group unsubstituted or substituted with an aryl group; an aryl group unsubstituted or substituted with a nitrile group; or a structure represented by any one selected from among Chemical Formula 2 and the following Chemical Formulae 6 to 15.

According to one embodiment of the present specification, in Chemical Formula 1, Ar1 is a nitrile group; a methoxy group substituted with a fluoro group; a phosphine oxide group unsubstituted or substituted with a phenyl group, a terphenyl group or a naphthyl group; a phenyl group unsubstituted or substituted with a nitrile group; a terphenyl group unsubstituted or substituted with a nitrile group; or a structure represented by any one selected from among Chemical Formula 2 and the following Chemical Formulae 6 to 15.

According to one embodiment of the present specification, in Chemical Formula 1, Ar1 may be represented by the following Chemical Formula 1a.

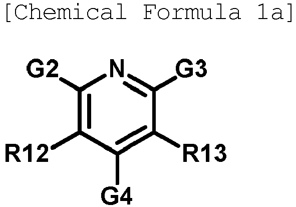

In Chemical Formula 1a,
any one of G2 to G4, R12 and R13 is a site bonding to L1 of Chemical Formula 1, and the rest are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group.

According to one embodiment of the present specification, in Chemical Formula 1, Ar1 is represented by any one selected from among Chemical Formula 2 and the following Chemical Formulae 6 to 15.

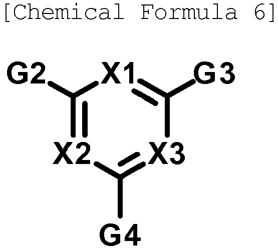

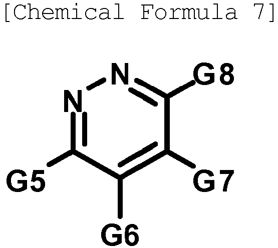

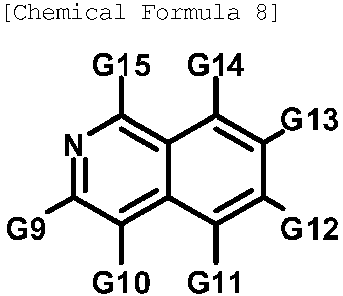

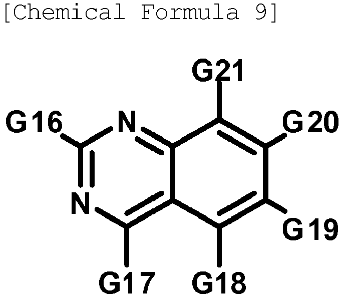

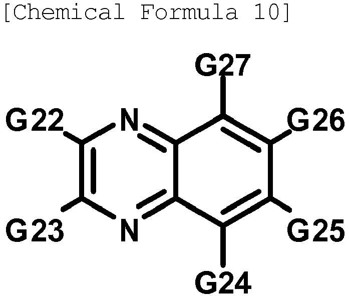

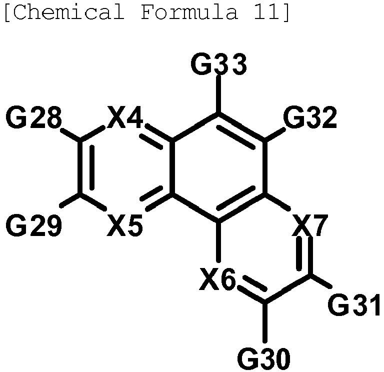

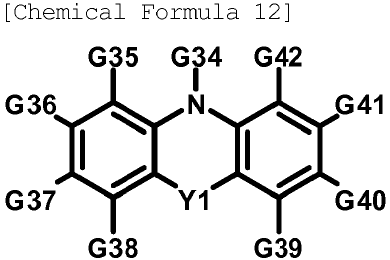

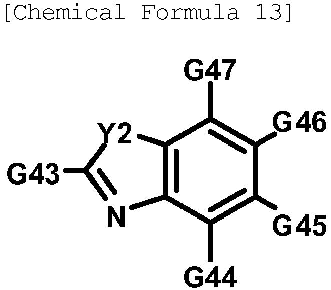

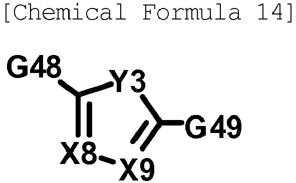

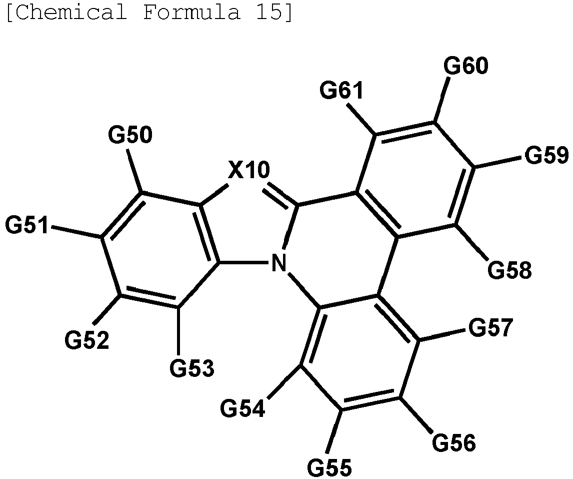

In Chemical Formulae 6 to 15,
X1 is N or CR11, X2 is N or CR12, X3 is N or CR13, X4 is N or CR14, X5 is N or CR15, X6 is N or CR16, X7 is N or CR17, X8 is N or CR18, X9 is N or CR19, and X10 is N or CR20,
at least two of X1 to X3 are N, and at least one of X4 to X7 is N,
Y1 is O; S; NQ1; or CQ2Q3, Y2 is O; S; NQ4; or CQ5Q6, and Y3 is O; S; or NQ7,
any one of G2 to G4 and R11 to R13, any one of G5 to G8, any one of G9 to G15, any one of G16 to G21, any one of G22 to G27, any one of G28 to G33 and R14 to R17, any one of G34 to G42, any one of G43 to G47, any one of G48, G49, R18 and R19, and any one of G50 to G61 are a site bonding to L1 of Chemical Formula 1, and
the rest of G2 to G61 and R11 to R19 other than the site bonding to L1 of Chemical Formula 1, R20 and Q1 to Q7 are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group.

According to another embodiment of the present specification, in Chemical Formula 2, G1 is hydrogen; or an aryl group.

According to another embodiment of the present specification, in Chemical Formula 2, G1 is hydrogen; or a phenyl group.

According to another embodiment of the present specification, Chemical Formula 2 is represented by any one selected from among the following Chemical Formulae 2-1 to 2-4.

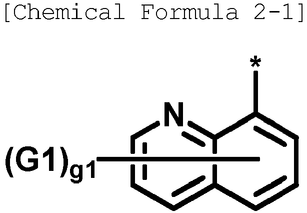

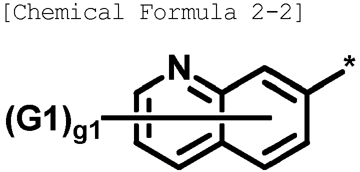

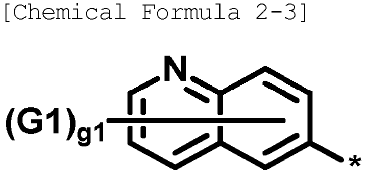

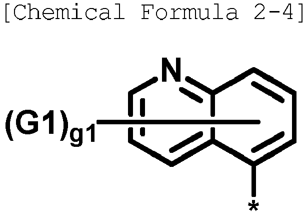

In Chemical Formulae 2-1 to 2-4, G1 and g1 have the same definitions as in Chemical Formula 2, and * is a site bonding to L1 of Chemical Formula 1.

According to another embodiment of the present specification, in Chemical Formula 6, any one of G2 to G4 and R11 to R13 is a site bonding to L1 of Chemical Formula 1, and the rest are the same as or different from each other, and each independently hydrogen; a substituted or unsubstituted aryl group; or a substituted or unsubstituted heteroaryl group.

According to another embodiment of the present specification, in Chemical Formula 6, any one of G2 to G4 and R11 to R13 is a site bonding to L1 of Chemical Formula 1, and the rest are the same as or different from each other, and each independently hydrogen; an aryl group unsubstituted or substituted with a nitrile group, an aryl group, a heterocyclic group substituted with an alkyl group, or a heterocyclic group unsubstituted or substituted with an aryl group; or a heteroaryl group.

According to another embodiment of the present specification, in Chemical Formula 6, any one of G2 to G4 and R11 to R13 is a site bonding to L1 of Chemical Formula 1, and the rest the same as or different from each other, and each independently hydrogen; a phenyl group unsubstituted or substituted with an aryl group, a heterocyclic group substituted with an alkyl group, or a heterocyclic group unsubstituted or substituted with an aryl group; a biphenyl group unsubstituted or substituted with a nitrile group or a heterocyclic group; a terphenyl group; a naphthyl group unsubstituted or substituted with an aryl group or a heteroaryl group; a fluorenyl group unsubstituted or substituted with an alkyl group; a triphenylenyl group; a phenanthrenyl group; a phenalenyl group; a pyridyl group; a dibenzofuranyl group; or a dibenzothiophene group.

According to another embodiment of the present specification, in Chemical Formula 6, any one of G2 to G4 and R11 to R13 is a site bonding to L1 of Chemical Formula 1, and the rest are the same as or different from each other, and each independently hydrogen; a phenyl group unsubstituted or substituted with a phenyl group, a terphenyl group, a carbazolyl group, a quinolyl group, a phenoxazinyl group, a phenothiazinyl group, a triphenylenyl group, a fluoranthenyl group, a pyridyl group, a dibenzothiophene group, a dibenzofuranyl group, a benzocarbazolyl group, a dihydrophenazinyl group substituted with a phenyl group, or a dihydroacridine group substituted with a methyl group; a nitrile group; a biphenyl group unsubstituted or substituted with a carbazolyl group; a terphenyl group; a naphthyl group unsubstituted or substituted with a phenyl group, a pyridyl group or a dibenzofuranyl group; a fluorenyl group unsubstituted or substituted with a methyl group; a triphenylenyl group; a phenanthrenyl group; a phenalenyl group; a pyridyl group; a dibenzofuranyl group; or a dibenzothiophene group.

According to another embodiment of the present specification, Chemical Formula 6 may be represented by the following Chemical Formula 6a or 6b.

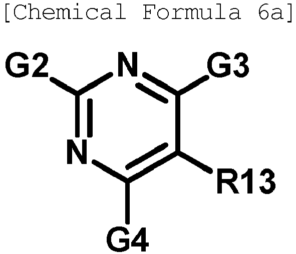

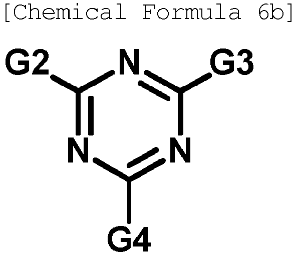

In Chemical Formulae 6a and 6b, G2 to G4 and R13 have the same definitions as in Chemical Formula 6.

According to one embodiment of the present specification, when at least two of X1 to X3 are N in Chemical Formula 6, a role of an electron control layer is smoothly performed with deep HOMO energy of 6.1 eV or greater, and since electron mobility is high, a device with low driving voltage, high efficiency and long lifetime may be obtained when used in an organic light emitting device. Specifically, when Ar1 is represented by Chemical Formula 6a or Chemical Formula 6b, the above-mentioned effects are maximized.

Particularly, a triazine group where Ar1 is Chemical Formula 6b has deep HOMO energy of 6.1 eV or greater, and therefore, a role of an electron control layer is smoothly performed, and since electron mobility is high, properties of low driving voltage, high efficiency and long lifetime are obtained when used in an organic light emitting device.

According to another embodiment of the present specification, in Chemical Formula 7, any one of G5 to G8 is a site bonding to L1 of Chemical Formula 1, and the rest are the same as or different from each other, and each independently hydrogen; or a substituted or unsubstituted aryl group.

According to another embodiment of the present specification, in Chemical Formula 7, any one of G5 to G8 is a site bonding to L1 of Chemical Formula 1, and the rest are the same as or different from each other, and each independently hydrogen; or an aryl group.

According to another embodiment of the present specification, in Chemical Formula 7, any one of G5 to G8 is a site bonding to L1 of Chemical Formula 1, and the rest are the same as or different from each other, and each independently hydrogen; a phenyl group; or a naphthyl group.

According to another embodiment of the present specification, in Chemical Formula 8, any one of G9 to G15 is a site bonding to L1 of Chemical Formula 1, and the rest are the same as or different from each other, and each independently hydrogen; or a substituted or unsubstituted aryl group.

According to another embodiment of the present specification, in Chemical Formula 8, any one of G9 to G15 is a site bonding to L1 of Chemical Formula 1, and the rest are the same as or different from each other, and each independently hydrogen; or an aryl group.

According to another embodiment of the present specification, in Chemical Formula 8, any one of G9 to G15 is a site bonding to L1 of Chemical Formula 1, and the rest are the same as or different from each other, and each independently hydrogen; or a phenyl group.

According to another embodiment of the present specification, in Chemical Formula 9, any one of G16 to G21 is a site bonding to L1 of Chemical Formula 1, and the rest are the same as or different from each other, and each independently hydrogen; or a substituted or unsubstituted aryl group.

According to another embodiment of the present specification, in Chemical Formula 9, any one of G16 to G21 is a site bonding to L1 of Chemical Formula 1, and the rest are the same as or different from each other, and each independently hydrogen; or an aryl group.

According to another embodiment of the present specification, in Chemical Formula 9, any one of G16 to G21 is a site bonding to L1 of Chemical Formula 1, and the rest are the same as or different from each other, and each independently hydrogen; a phenyl group; a biphenyl group; or a naphthyl group.

According to another embodiment of the present specification, in Chemical Formula 10, any one of G22 to G27 is a site bonding to L1 of Chemical Formula 1, and the rest are the same as or different from each other, and each independently hydrogen; or an aryl group.

According to another embodiment of the present specification, in Chemical Formula 10, any one of G22 to G27 is a site bonding to L1 of Chemical Formula 1, and the rest are the same as or different from each other, and each independently hydrogen; or a phenyl group.

According to another embodiment of the present specification, in Chemical Formula 11, any one of G28 to G33 and R14 to R17 is a site bonding to L1 of Chemical Formula 1, and the rest are the same as or different from each other, and each independently hydrogen.

According to another embodiment of the present specification, Chemical Formula 11 is represented by any one selected from among the following Chemical Formulae 11-1 to 11-8.

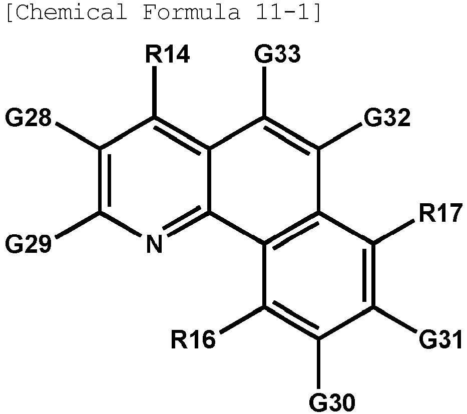

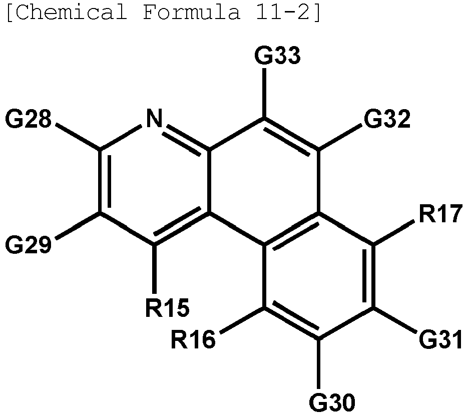

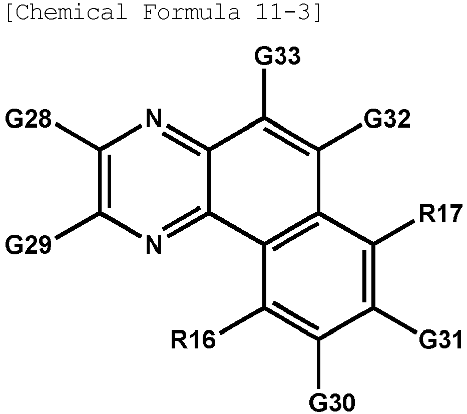

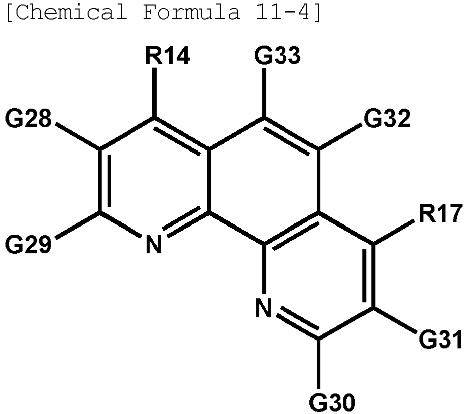

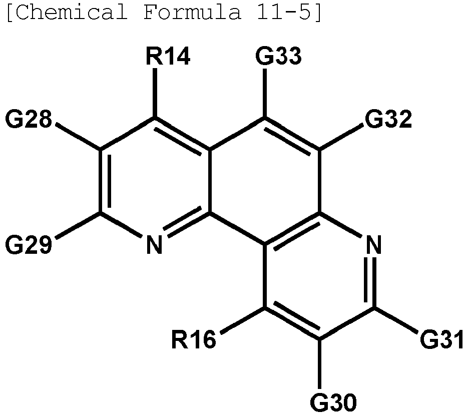

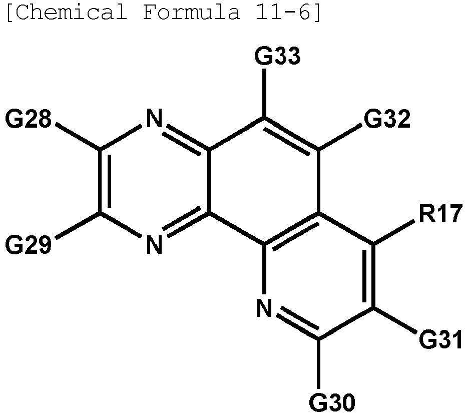

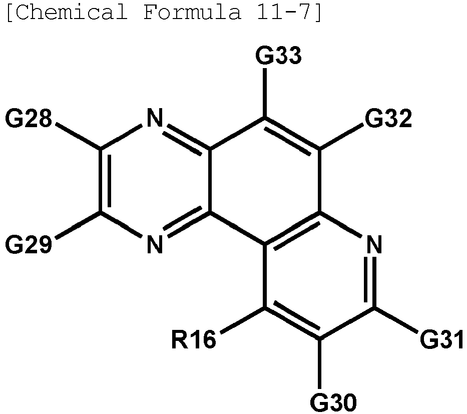

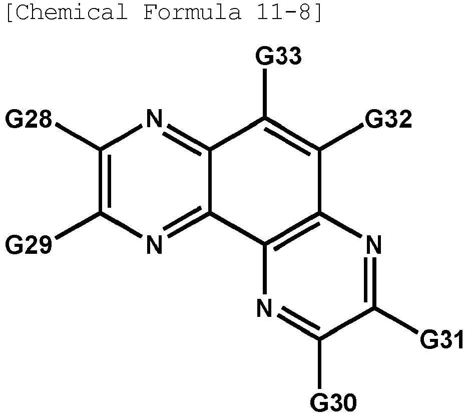

In Chemical Formulae 11-1 to 11-8, G28 to G33 and R14 to R17 have the same definitions as in Chemical Formula 11.

According to another embodiment of the present specification, in Chemical Formula 12, any one of G34 to G42 is a site bonding to L1 of Chemical Formula 1, and the rest and Q1 to Q3 are the same as or different from each other, and each independently hydrogen.

According to another embodiment of the present specification, in Chemical Formula 13, any one of G43 to G47 is a site bonding to L1 of Chemical Formula 1, and the rest and Q4 to Q6 are the same as or different from each other, and each independently hydrogen; a substituted or unsubstituted alkyl group; or a substituted or unsubstituted aryl group.

According to another embodiment of the present specification, in Chemical Formula 13, any one of G43 to G47 is a site bonding to L1 of Chemical Formula 1, and the rest and Q4 to Q6 are the same as or different from each other, and each independently hydrogen; an alkyl group; or an aryl group.

According to another embodiment of the present specification, in Chemical Formula 13, any one of G43 to G47 is a site bonding to L1 of Chemical Formula 1, and the rest and Q4 to Q6 are the same as or different from each other, and each independently hydrogen; a methyl group; or a phenyl group.

According to another embodiment of the present specification, when Y2 is NQ4 in Chemical Formula 13, G43 and Q4 bond to each other to form a substituted or unsubstituted ring.

According to another embodiment of the present specification, when Y2 is NQ4 in Chemical Formula 13, G43 and Q4 bond to each other to form a substituted or unsubstituted heteroring.

According to another embodiment of the present specification, when Y2 is NQ4 in Chemical Formula 13, G43 and Q4 bond to each other to form a benzoisoquinol ring.

According to another embodiment of the present specification, Chemical Formula 13 is represented by any one selected from among the following Chemical Formulae 13-1 to 13-4.

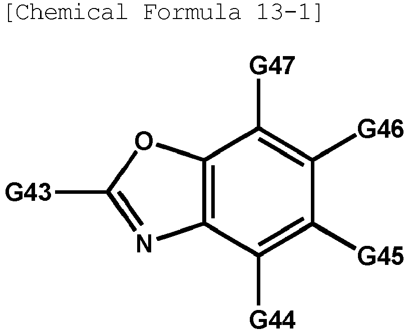

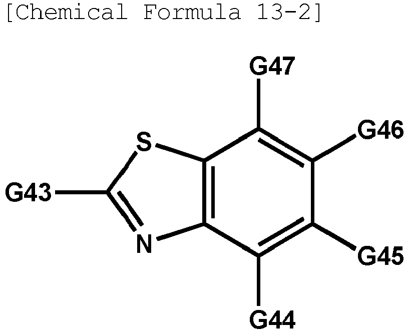

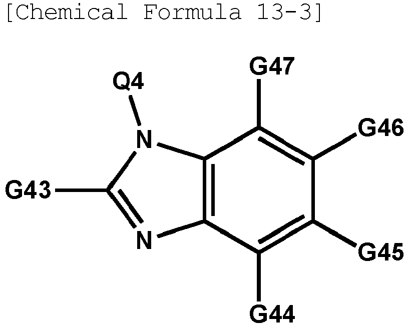

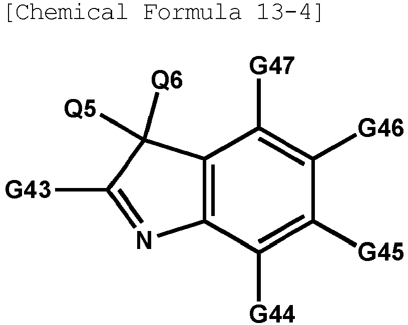

In Chemical Formulae 13-1 to 13-4, any one of G43 to G47 is a site bonding to L1 of Chemical Formula 1, and the rest and Q4 to Q6 are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group.

According to another embodiment of the present specification, in Chemical Formula 14, any one of G48, G49, R18 and R19 is a site bonding to L1 of Chemical Formula 1, and the rest and Q7 are the same as or different from each other, and each independently hydrogen; or a substituted or unsubstituted aryl group.

According to another embodiment of the present specification, in Chemical Formula 14, any one of G48, G49, R18 and R19 is a site bonding to L1 of Chemical Formula 1, and the rest and Q7 are the same as or different from each other, and each independently hydrogen; or an aryl group.

According to another embodiment of the present specification, in Chemical Formula 14, any one of G48, G49, R18 and R19 is a site bonding to L1 of Chemical Formula 1, and the rest and Q7 are the same as or different from each other, and each independently hydrogen; or a phenyl group.

According to another embodiment of the present specification, Chemical Formula 14 is represented by any one selected from among the following Chemical Formulae 14-1 to 14-9.

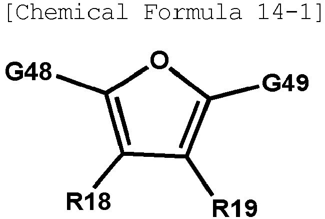

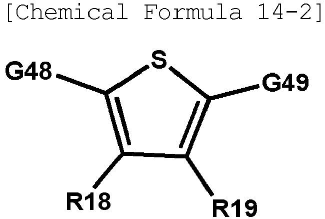

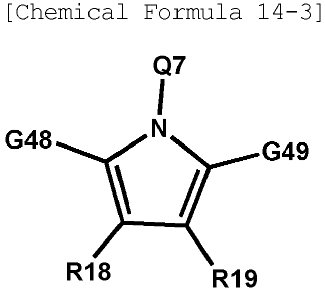

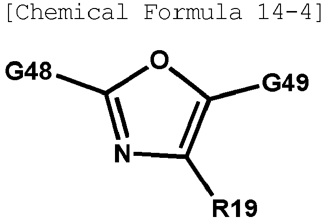

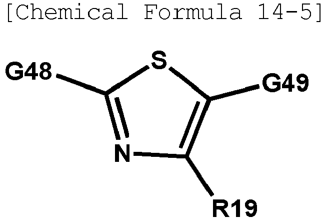

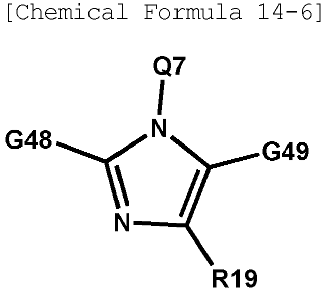

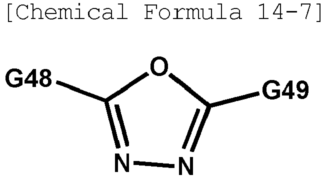

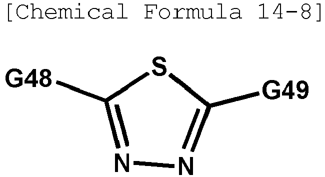

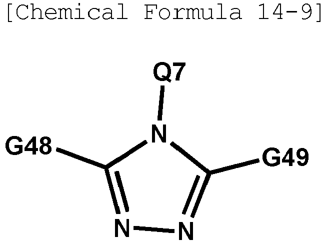

In Chemical Formulae 14-1 to 14-9,
G48, G49, R18, R19 and Q7 have the same definitions as in Chemical Formula 14.

According to one embodiment of the present specification, in Chemical Formula 15, the rest of G50 to G61 other than the site bonding to L1 of Chemical Formula 1, and R20 are the same as or different from each other, and each independently hydrogen; a substituted or unsubstituted aryl group; or a substituted or unsubstituted heteroaryl group.

According to one embodiment of the present specification, in Chemical Formula 15, the rest of G50 to G61 other than the site bonding to L1 of Chemical Formula 1, and R20 are the same as or different from each other, and each independently hydrogen; or a substituted or unsubstituted aryl group.

According to one embodiment of the present specification, in Chemical Formula 15, the rest of G50 to G61 other than the site bonding to L1 of Chemical Formula 1, and R20 are the same as or different from each other, and each independently hydrogen; or a phenyl group.

According to one embodiment of the present specification, in Chemical Formula 15, the rest of G50 to G61 other than the site bonding to L1 of Chemical Formula 1, and R20 are the same as or different from each other, and each independently hydrogen.

According to one embodiment of the present specification, m is 1.

According to one embodiment of the present specification, Chemical Formula 1 is represented by any one selected from among the following Chemical Formulae 1-1 to 1-4.

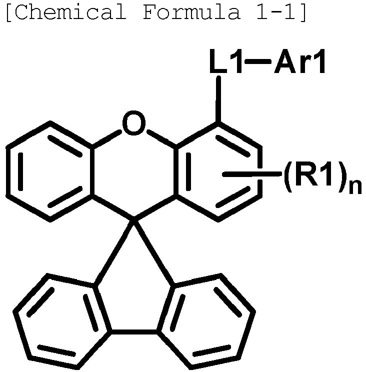

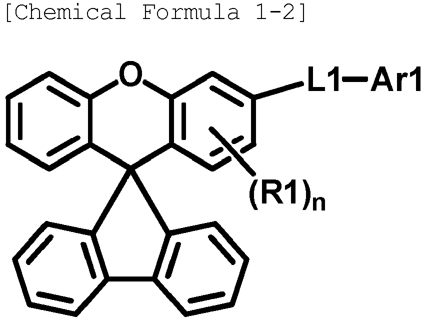

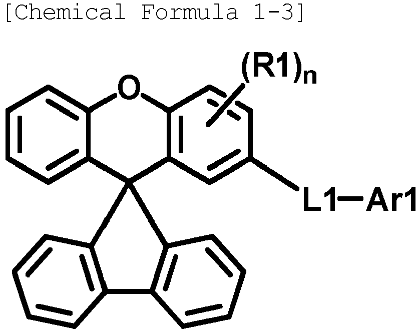

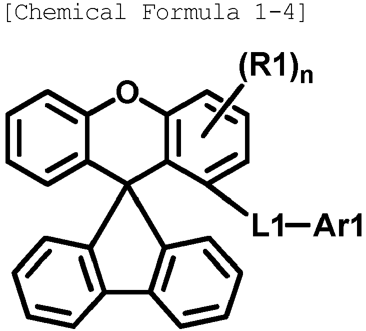

In Chemical Formulae 1-1 to 1-4,
L1, Ar1, R1 and n have the same definitions as in Chemical Formula 1.

According to one embodiment of the present specification, R1 is hydrogen.

Generally, electron mobility of a compound varies depending on orientation in a molecular 3D structure, and electron mobility is strengthened in a more horizontal structure. The compound represented by Chemical Formula 1 substituted with one -L1-Ar1 according to one embodiment of the present specification has an advantage of increasing electron mobility with a stronger tendency toward a horizontal structure of the molecule compared to the compound substituted with two - L1-Ar1s. Accordingly, when using the heterocyclic compound represented by Chemical Formula 1 in an organic light emitting device, effects of low driving voltage, high efficiency and long lifetime are obtained. (Refer to APPLIED PHYSICS LETTERS 95, 243303 (2009))

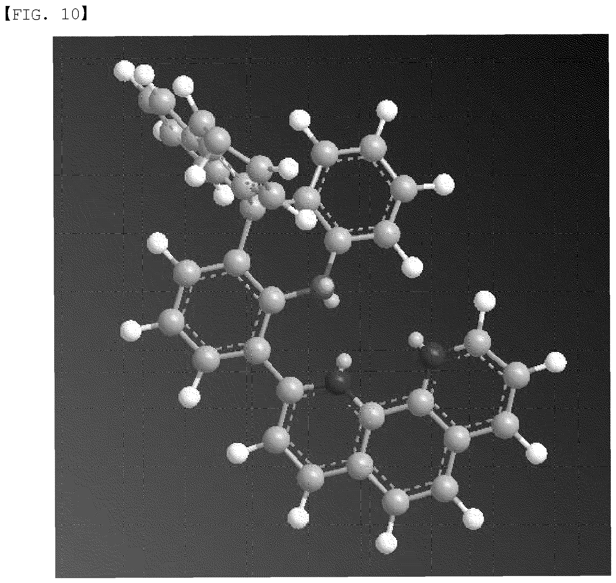

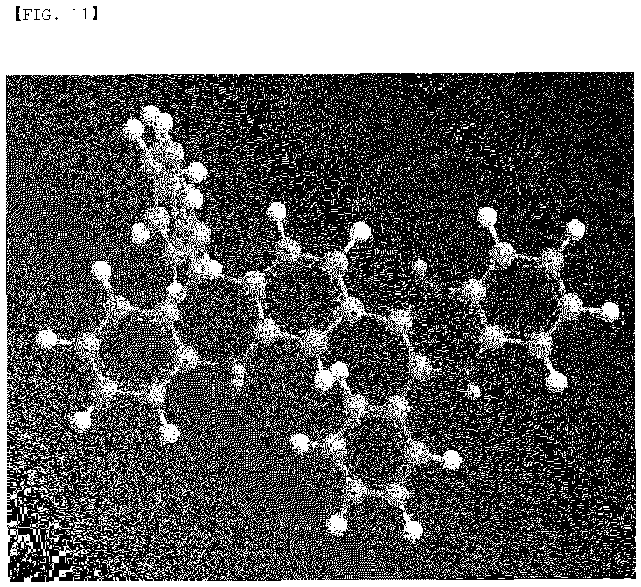

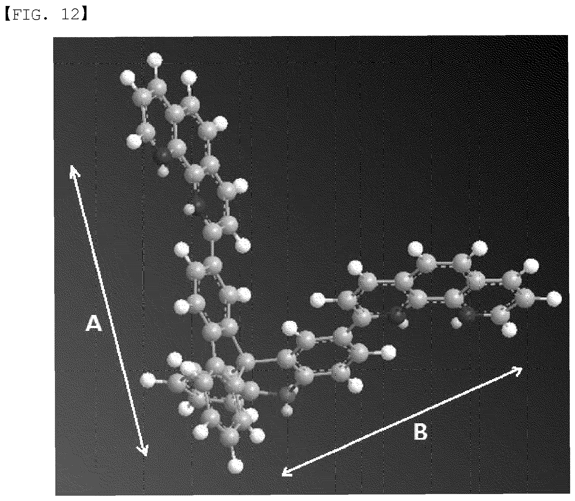

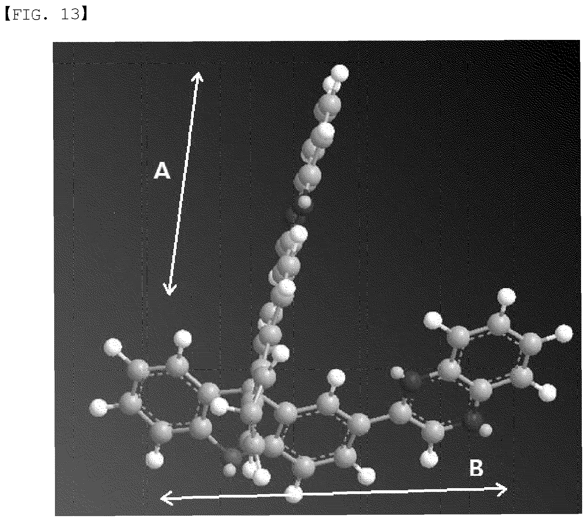

According to FIG. 10 and FIG. 11 presenting 3D structures of Compounds E9 and E18 according to one embodiment of the present specification, it may be identified that the molecules of the compounds have a horizontal structure, and according to FIG. 12 and FIG. 13 presenting 3D structures of Compounds ET-1-E and ET-1-I used as compounds of comparative examples of the present specification, it may be identified that the A axis and the B axis are almost perpendicular to each other in each compound, and the molecules are very out of a horizontal structure. As a result, it may be seen that Compounds E9 and E18 according to one embodiment of the present specification have a horizontal structure compared to Compounds ET-1-E and ET-1-I due to a difference in orientation in the molecular 3D structure, and as a result, excellent effects are obtained in terms of driving voltage, efficiency and lifetime when using the compound represented by Chemical Formula 1 in an organic light emitting device.

According to one embodiment of the present specification, Chemical Formula 1 may be represented by any one selected from among the following compounds.

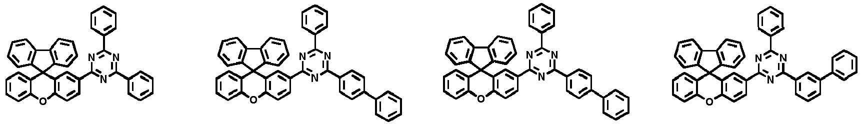

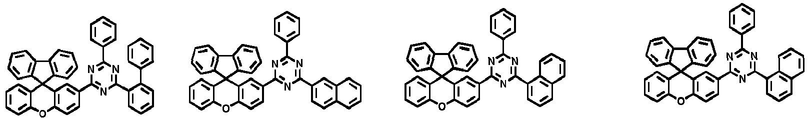

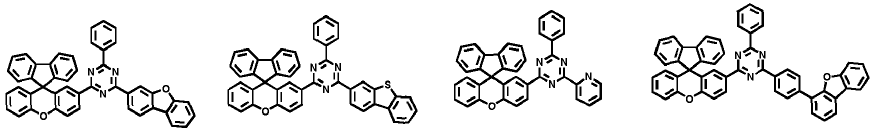

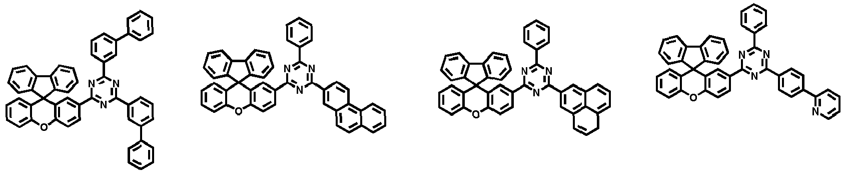

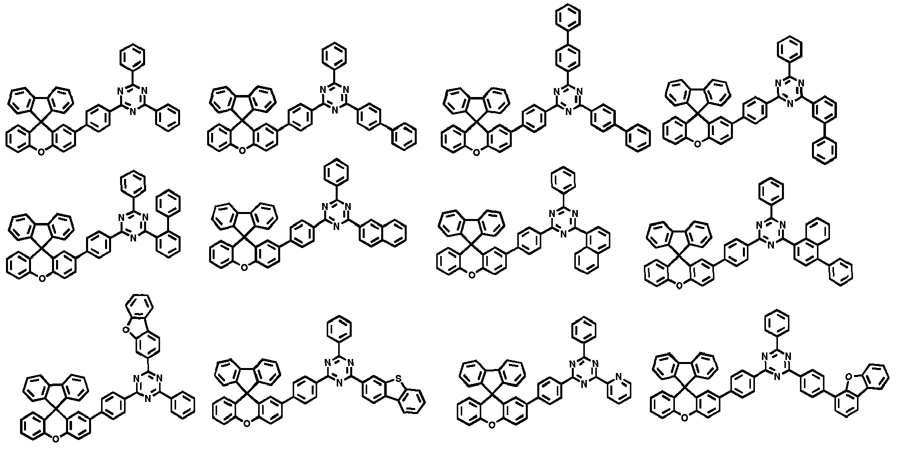

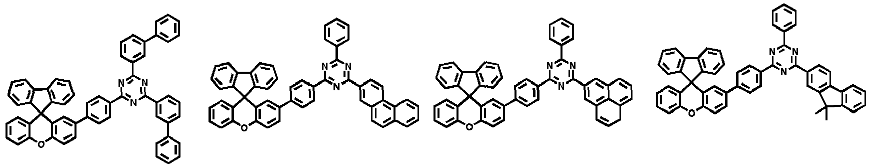

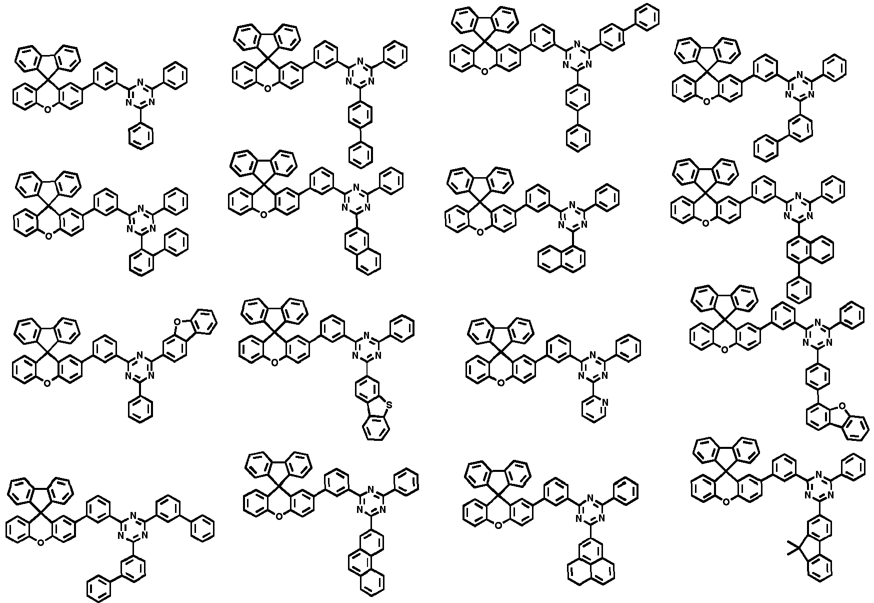

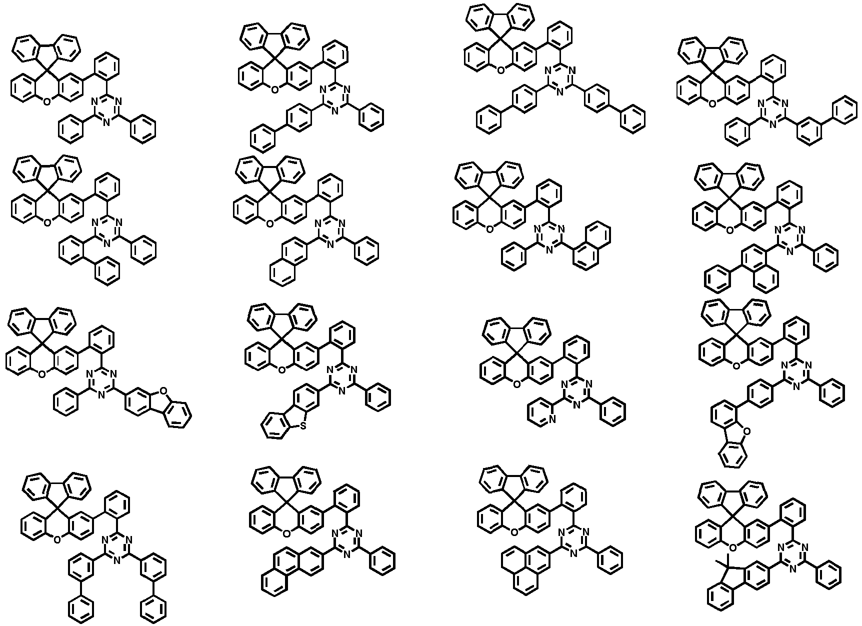

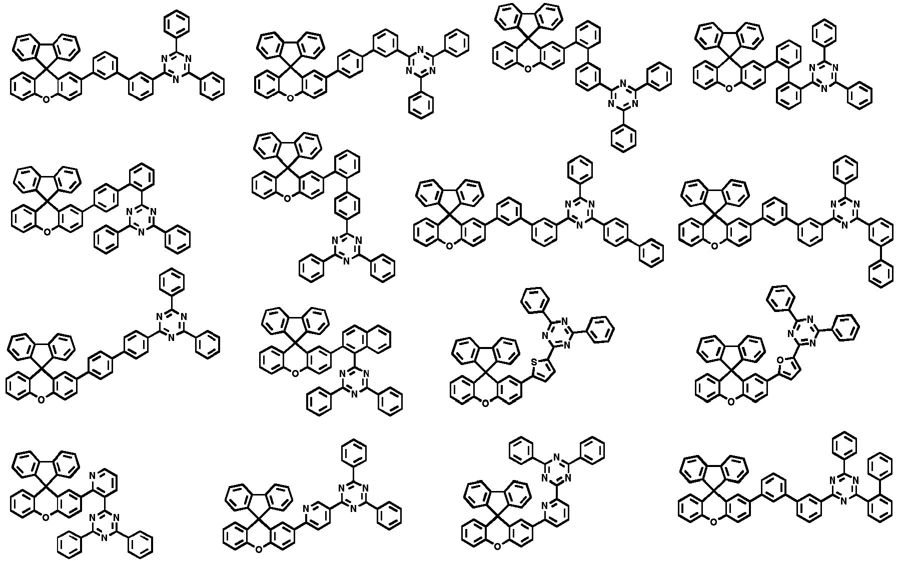

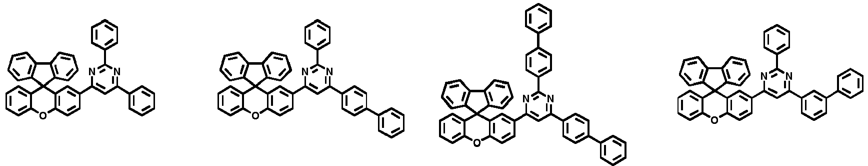

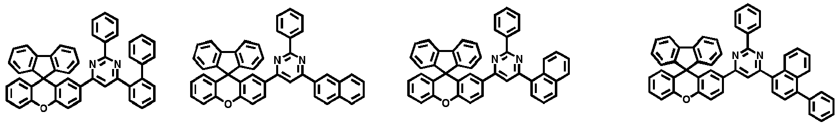

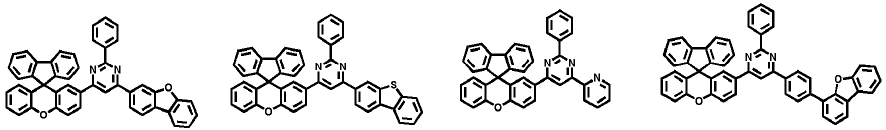

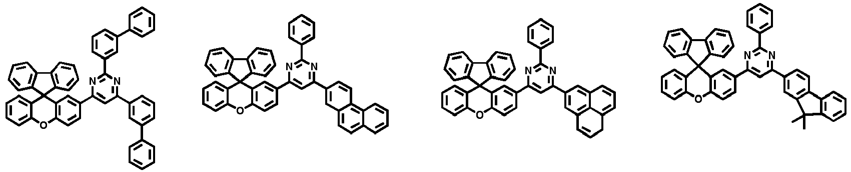

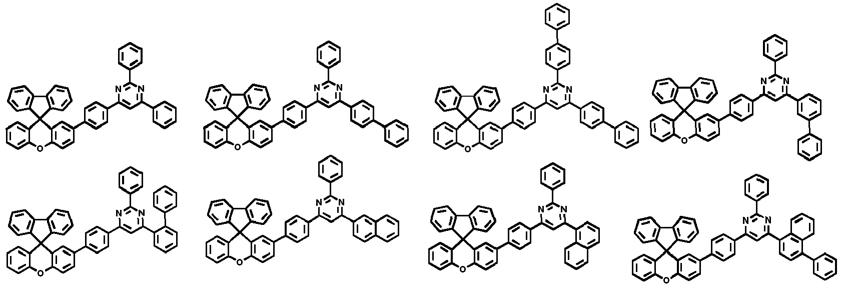

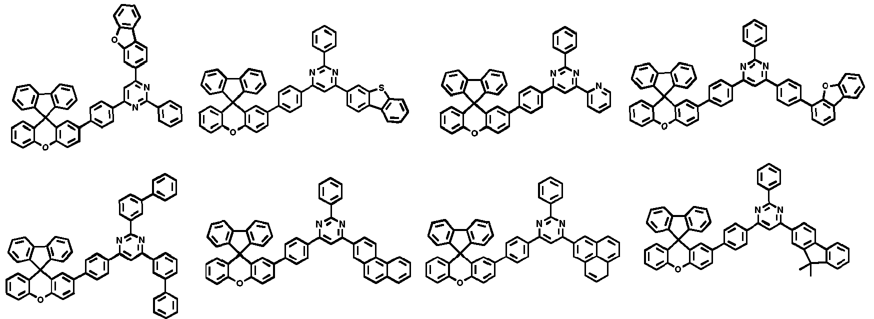

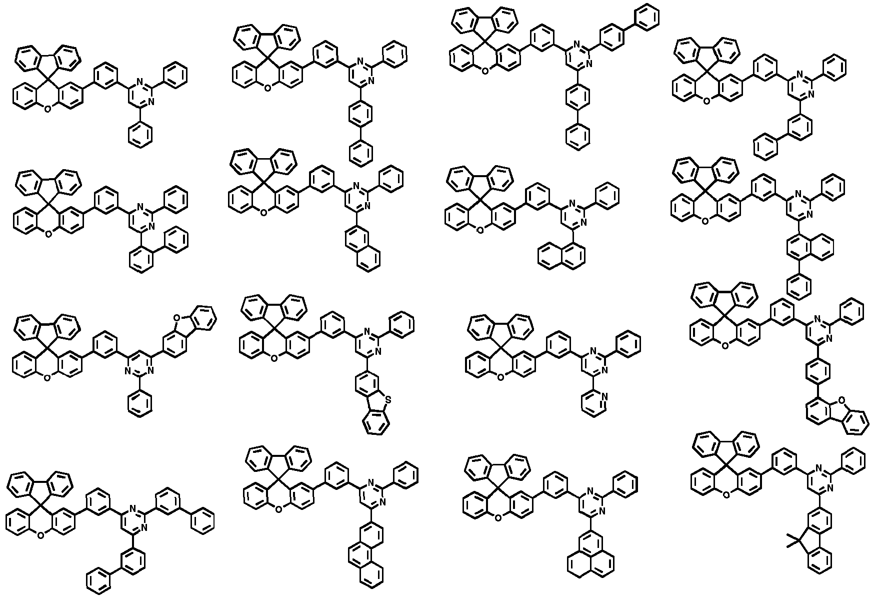

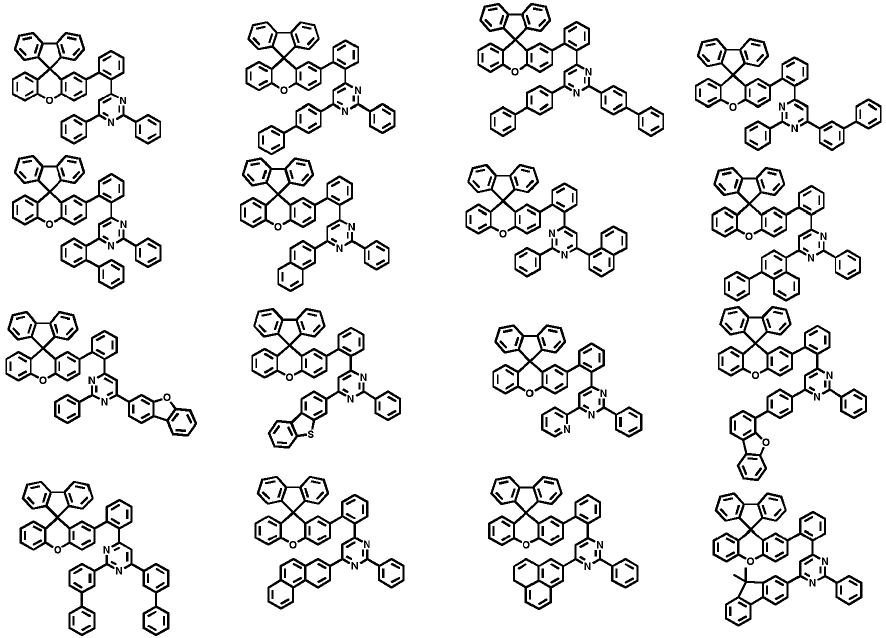

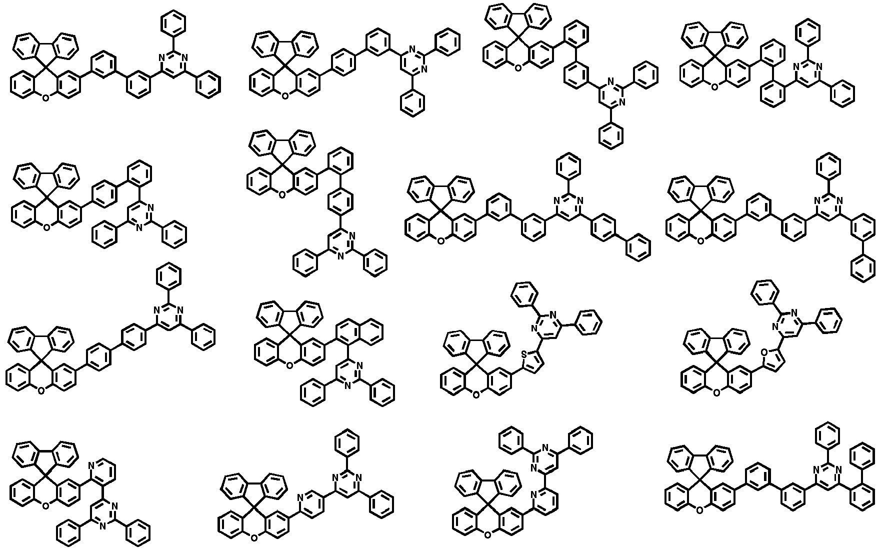

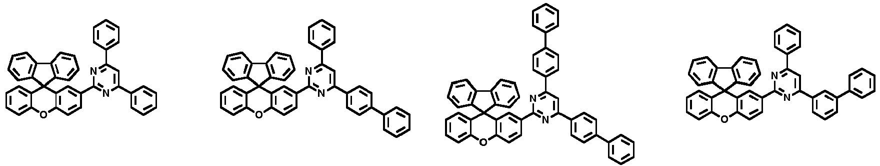

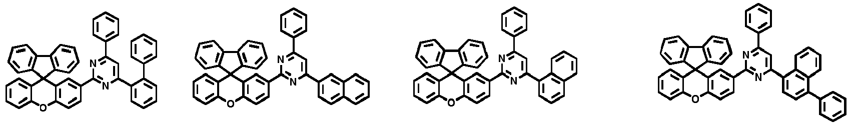

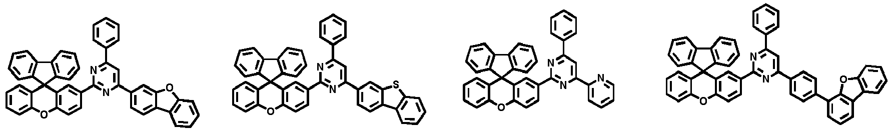

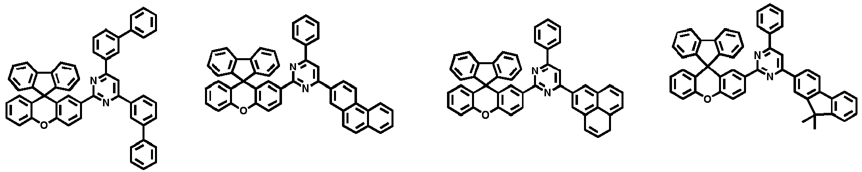

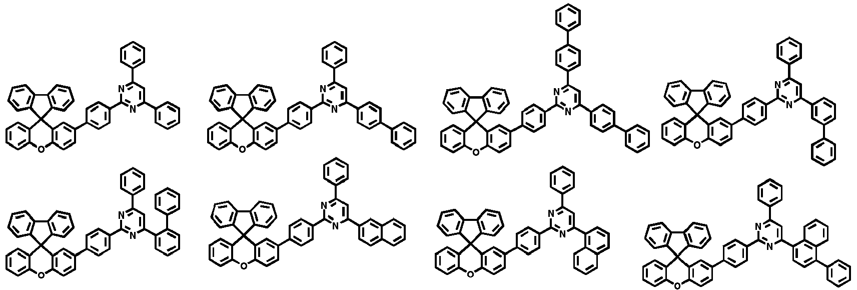

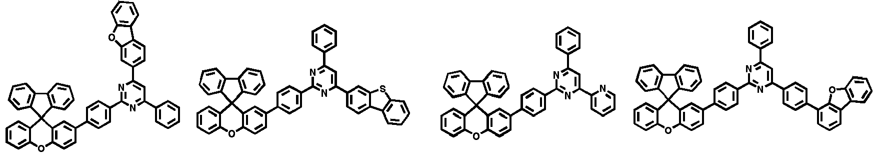

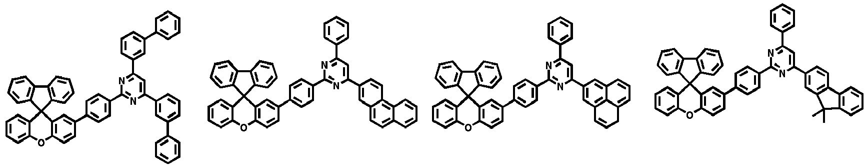

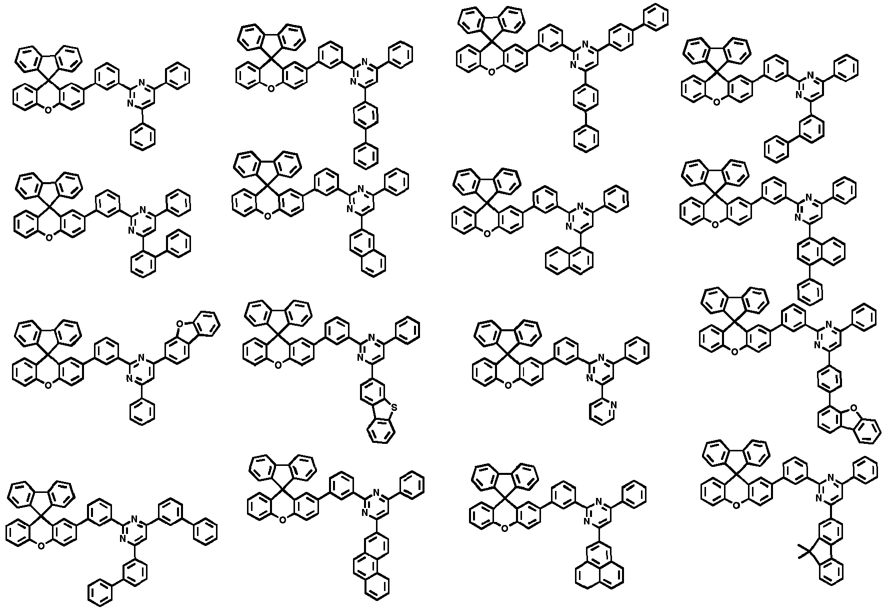

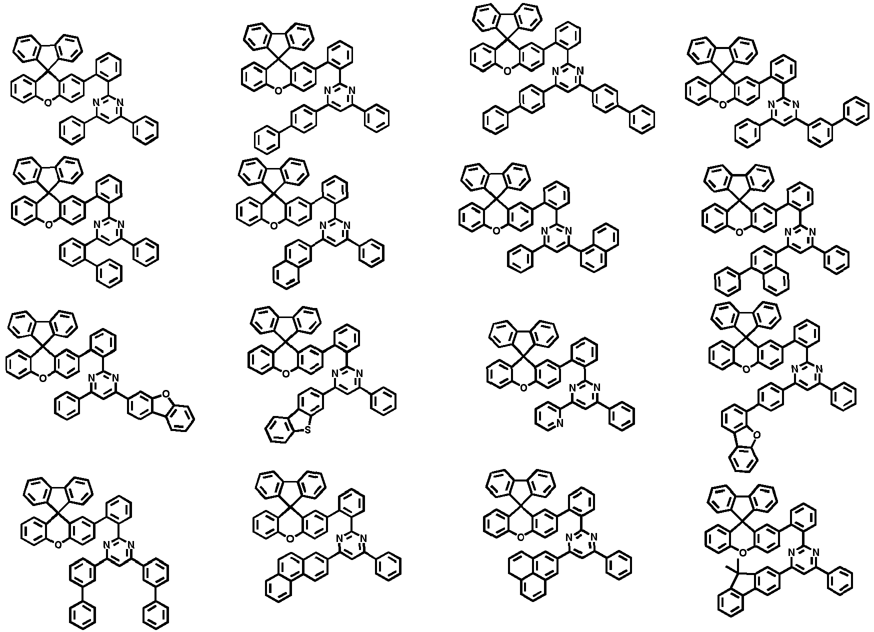

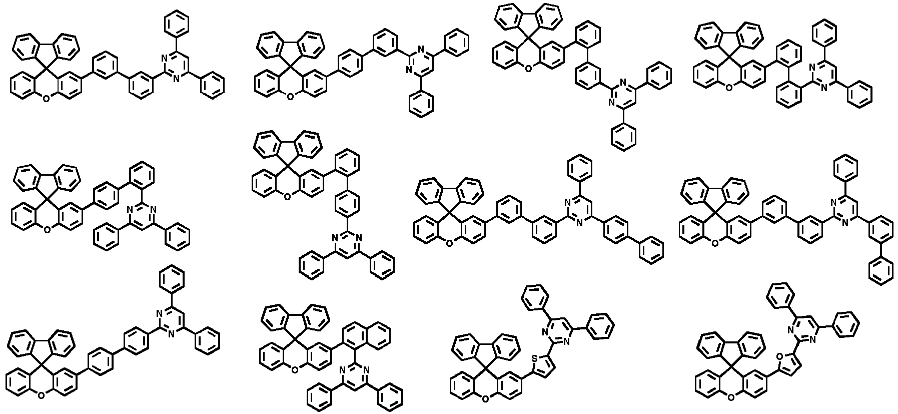

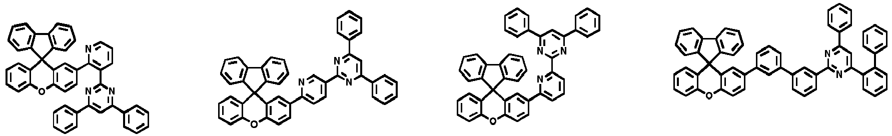

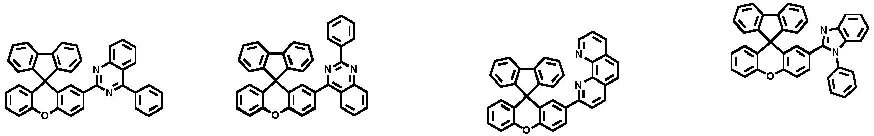

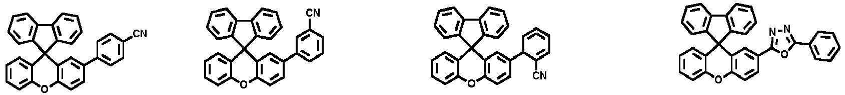

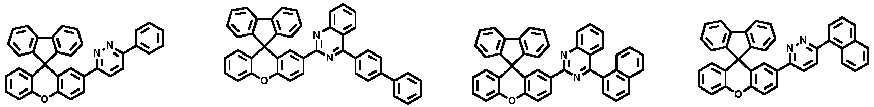

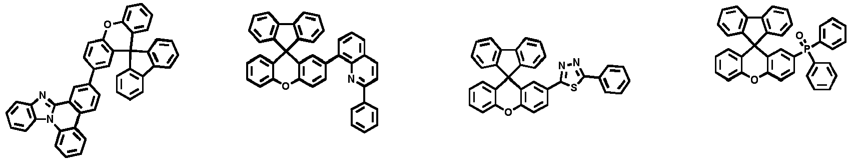

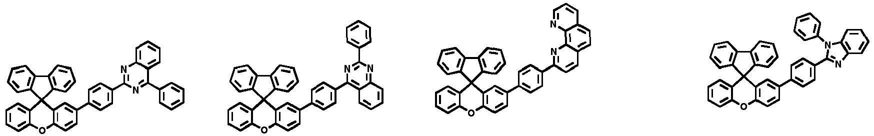

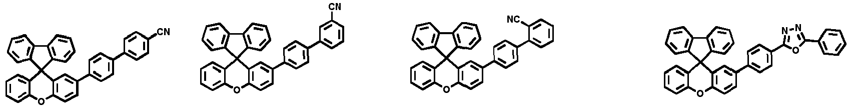

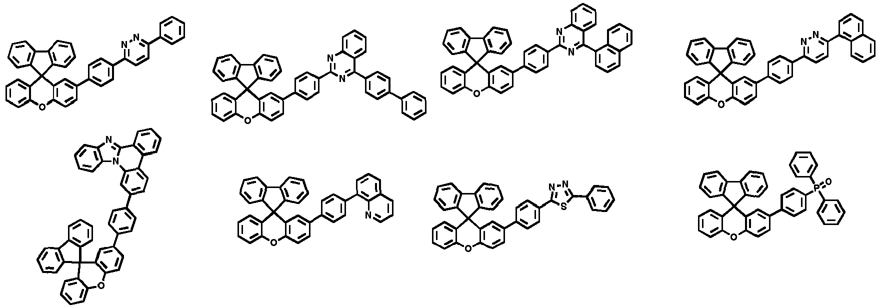

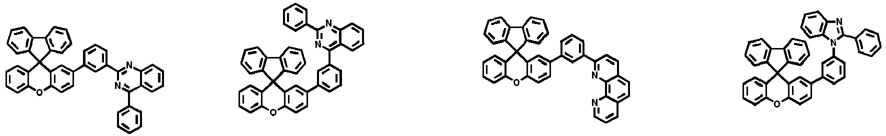

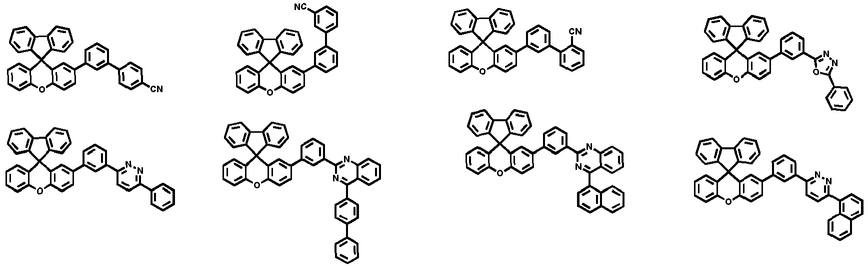

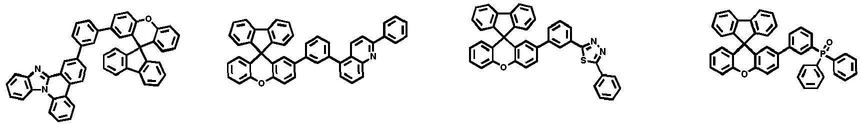

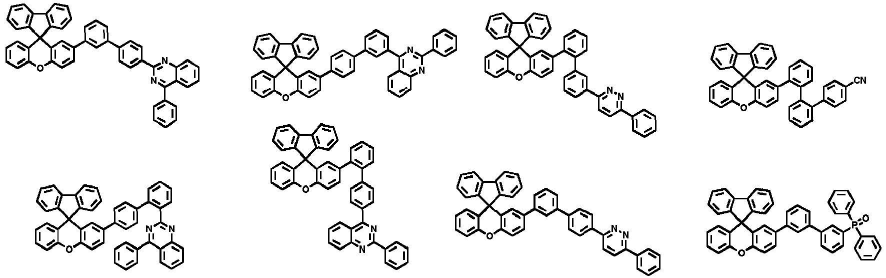

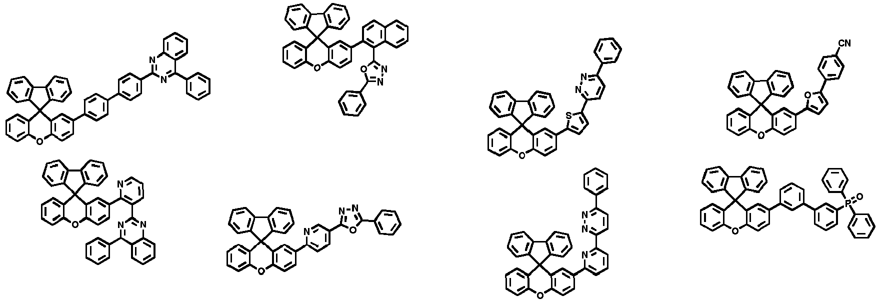

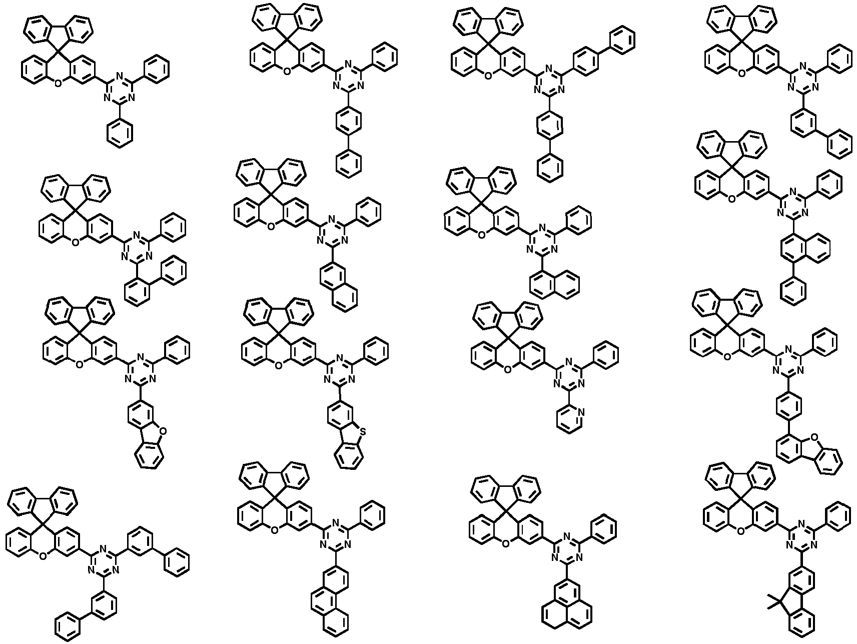

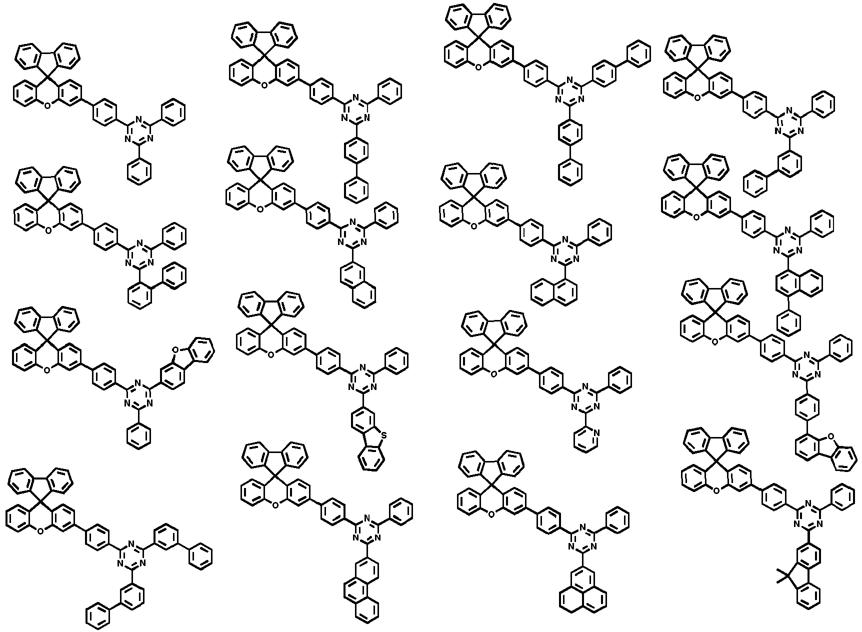

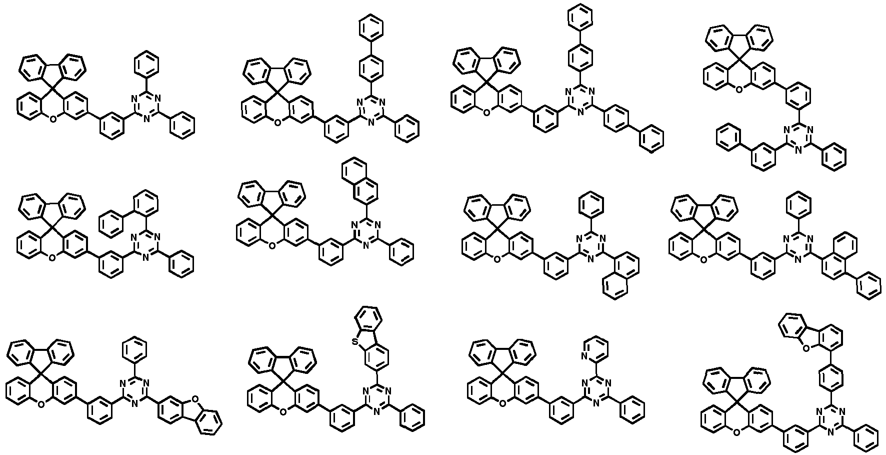

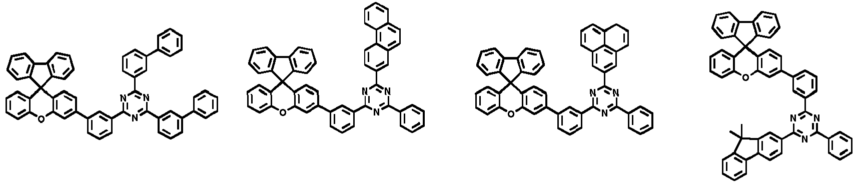

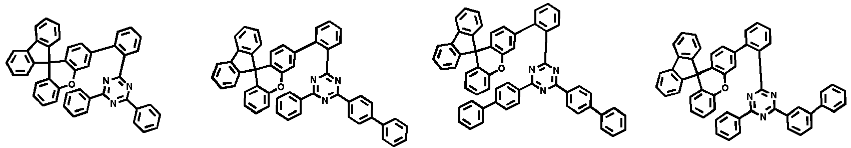

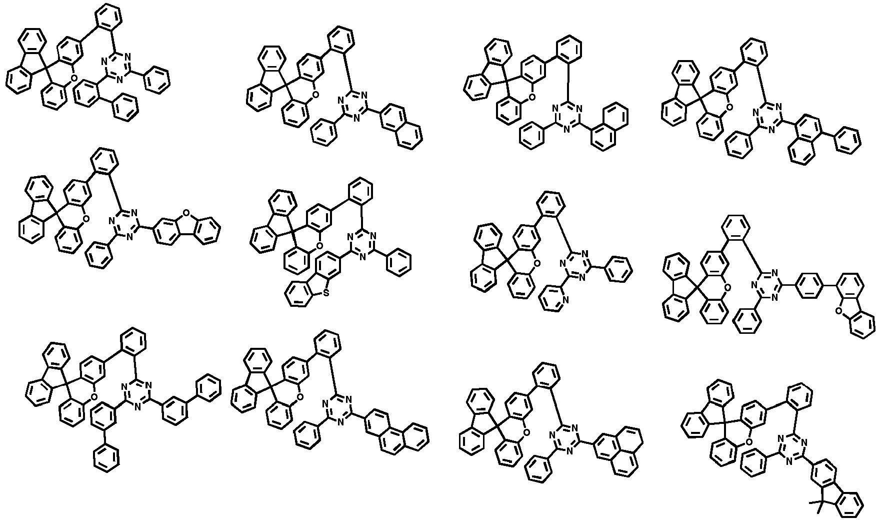

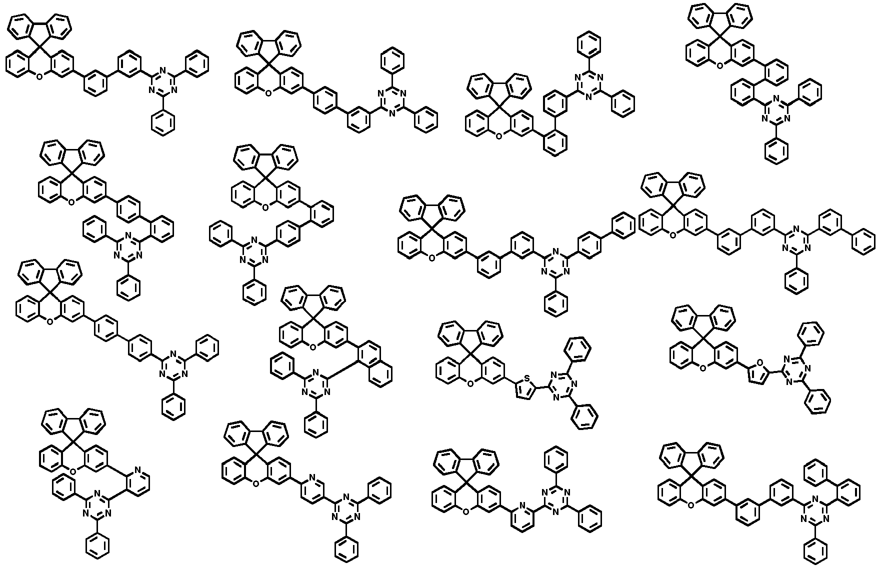

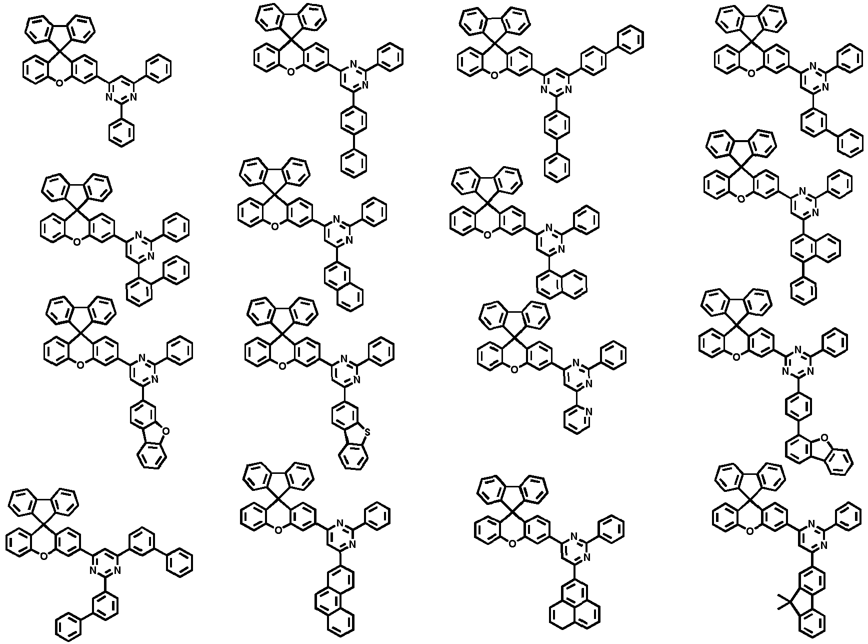

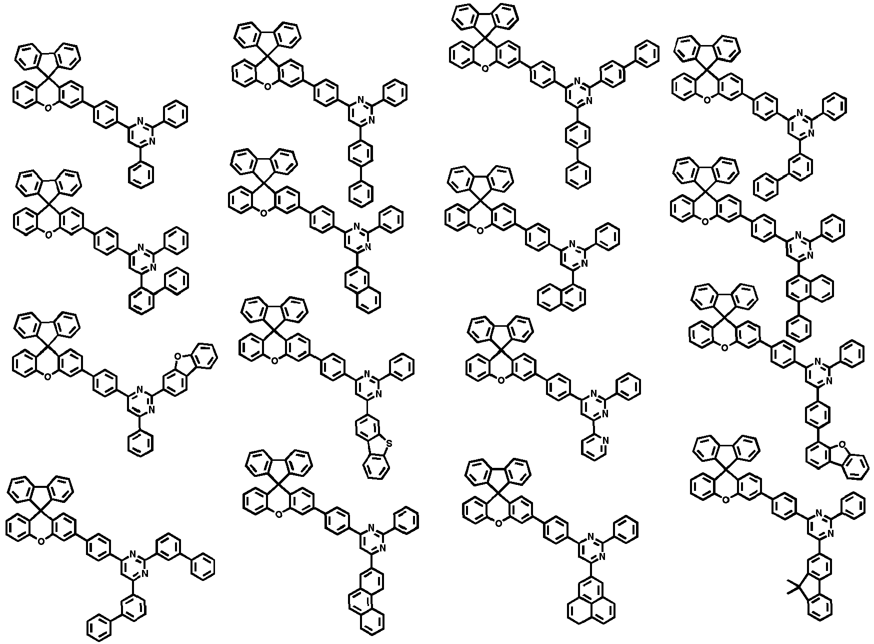

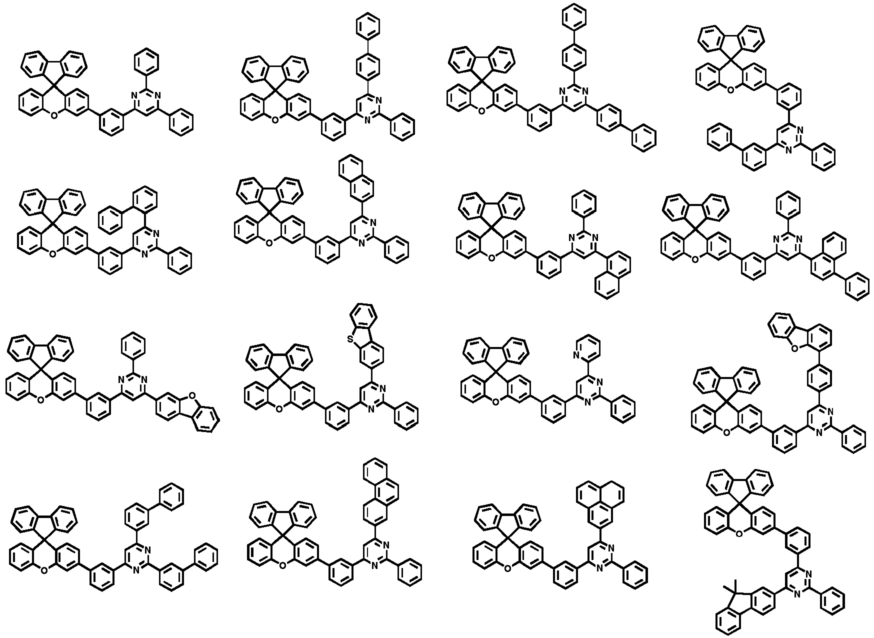

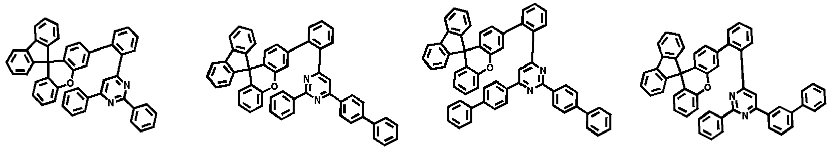

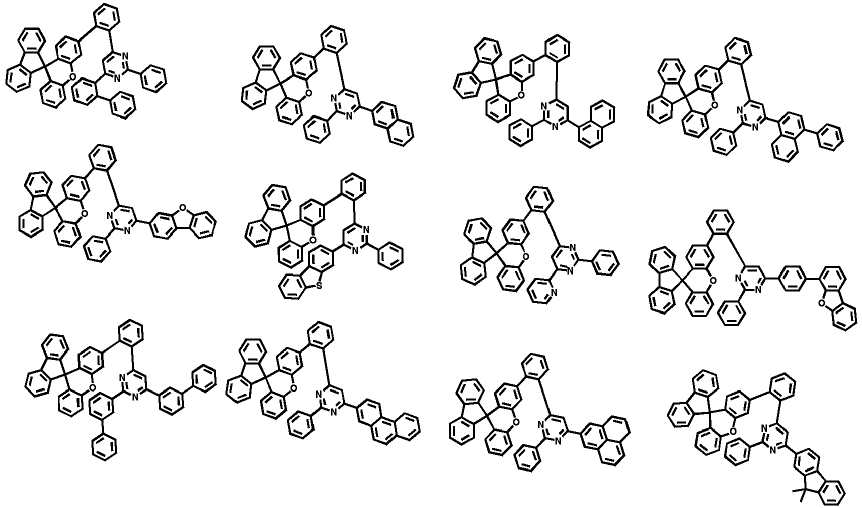

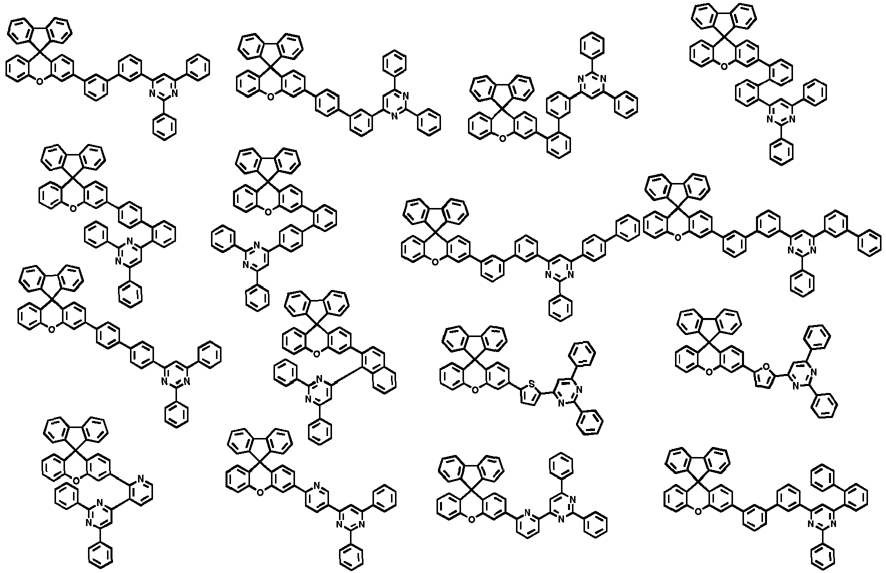

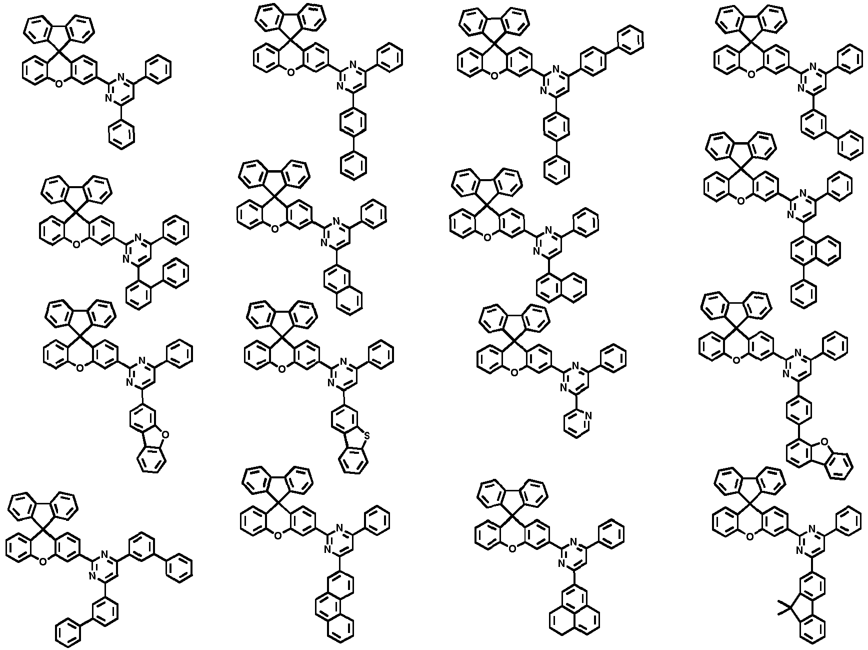

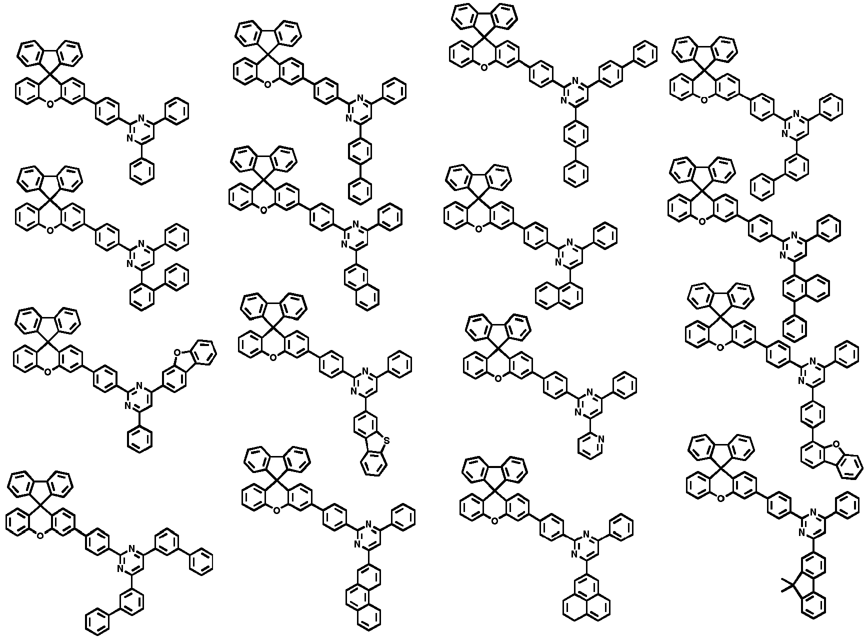

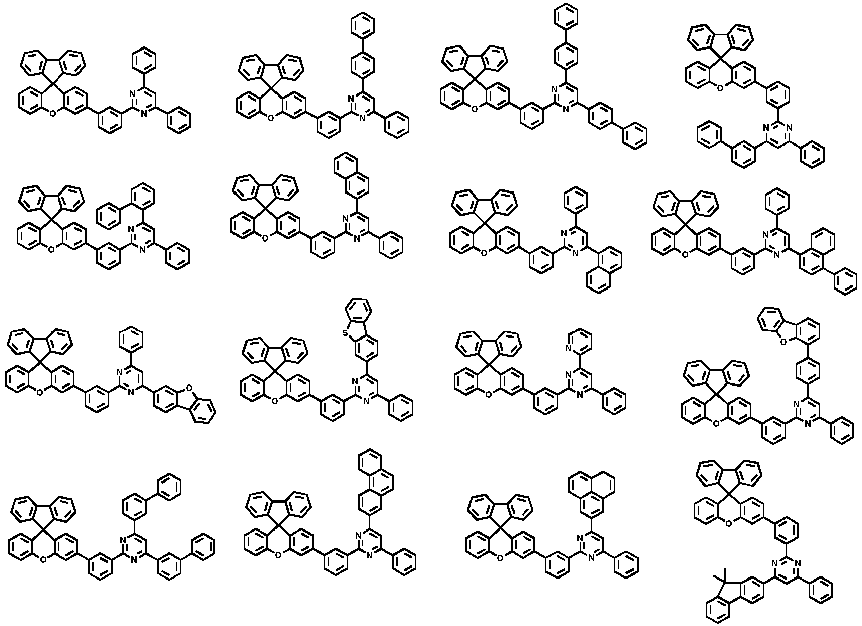

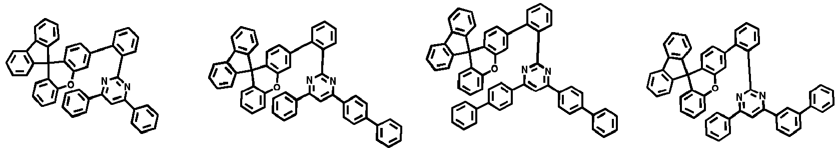

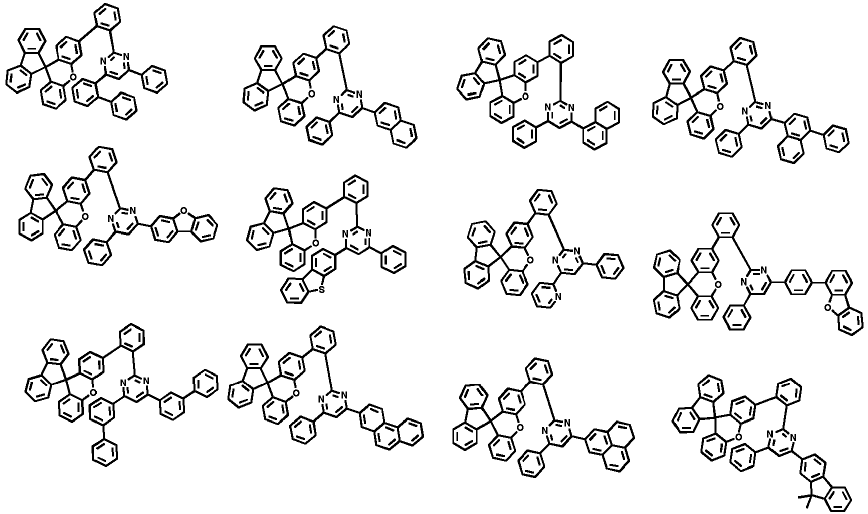

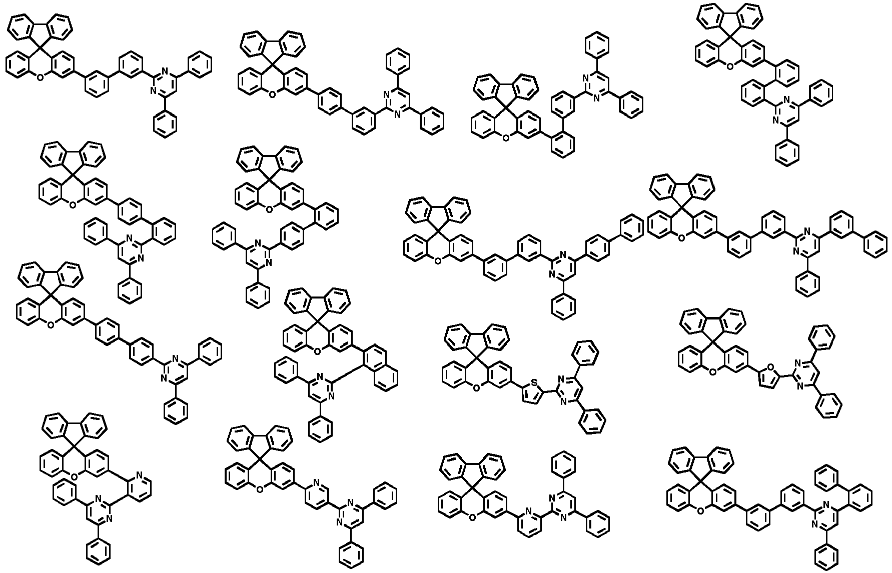

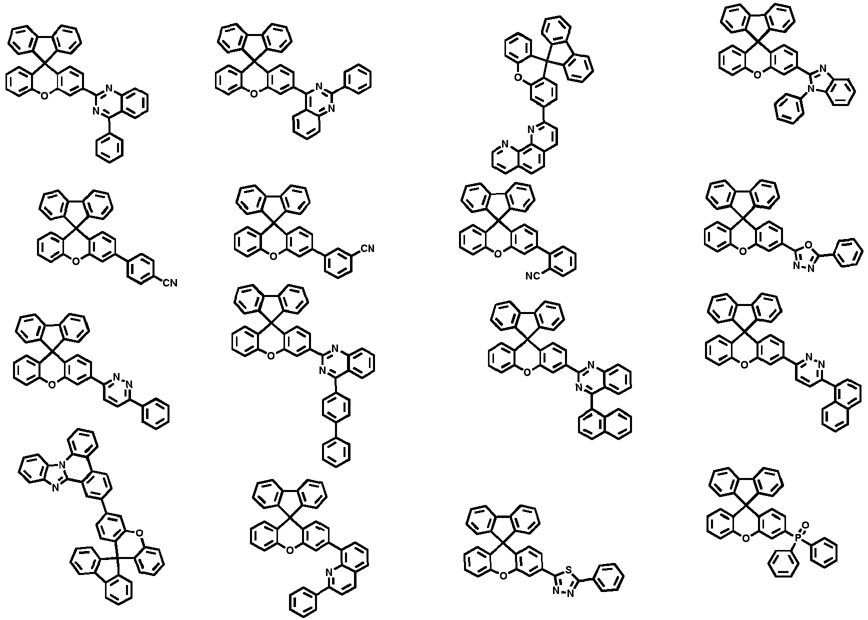

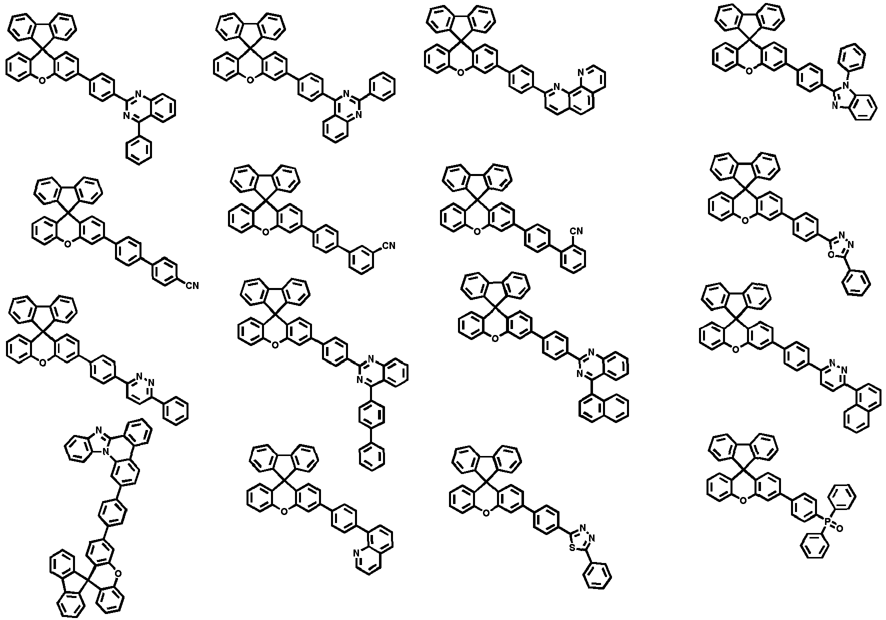

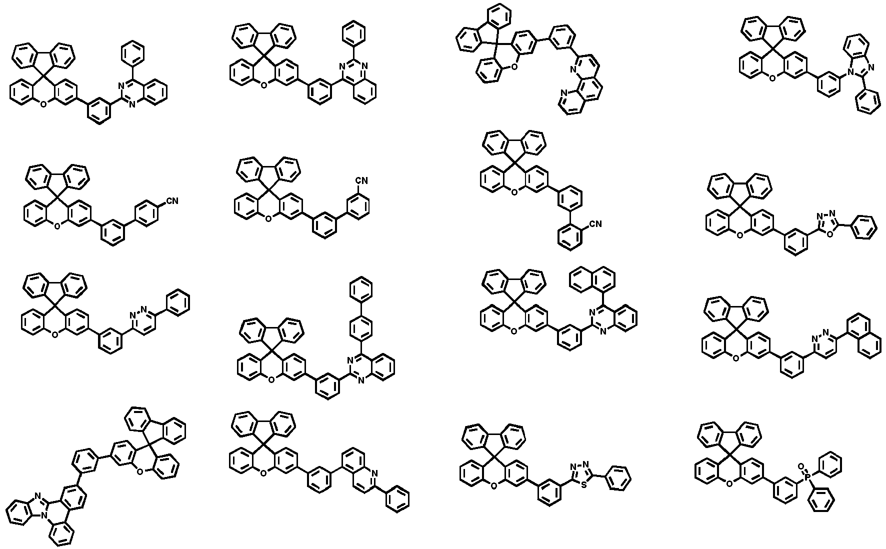

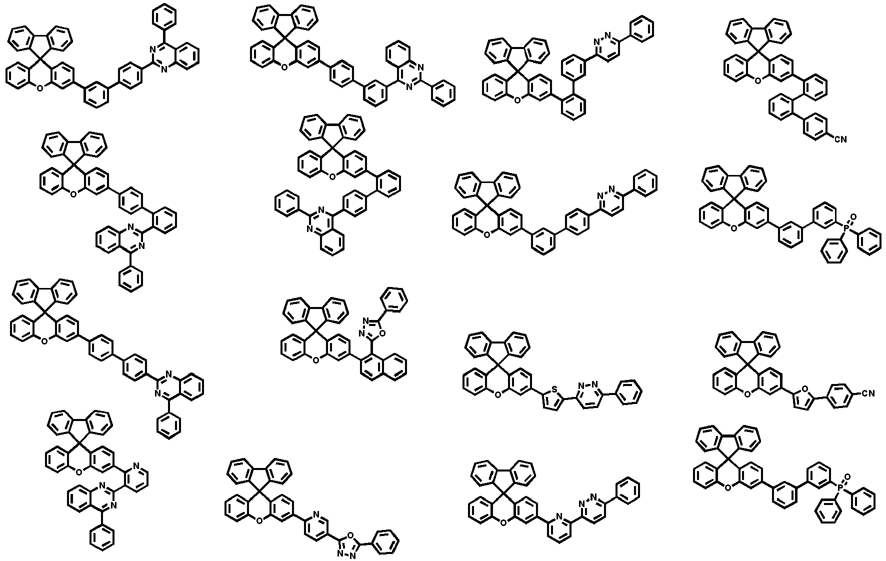

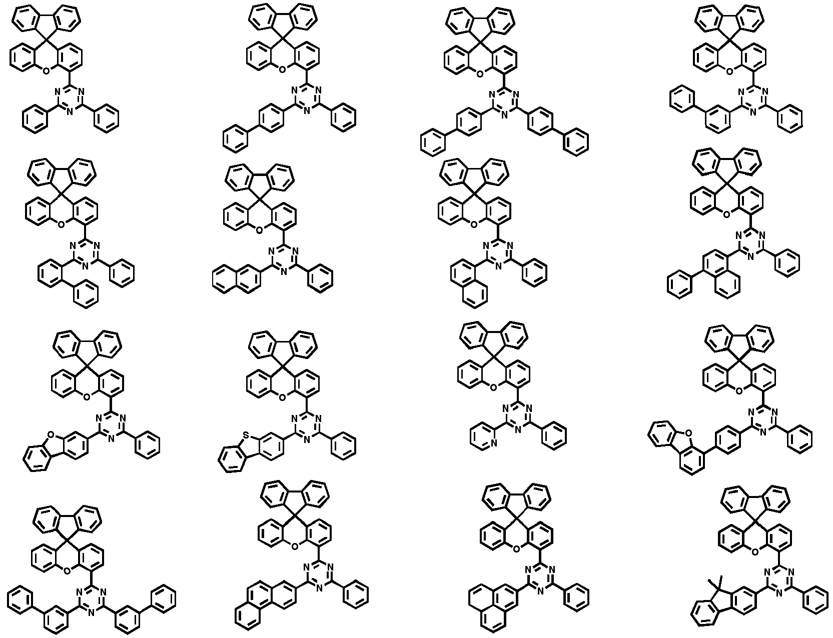

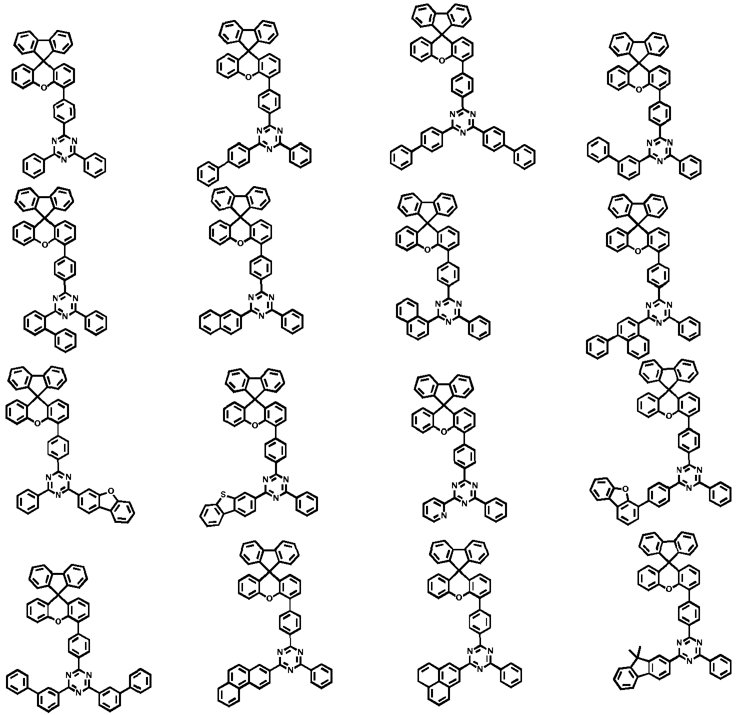

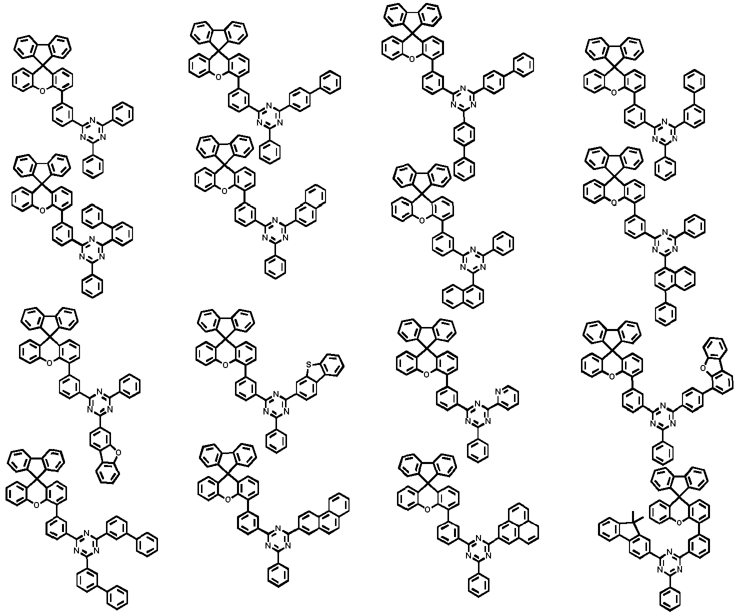

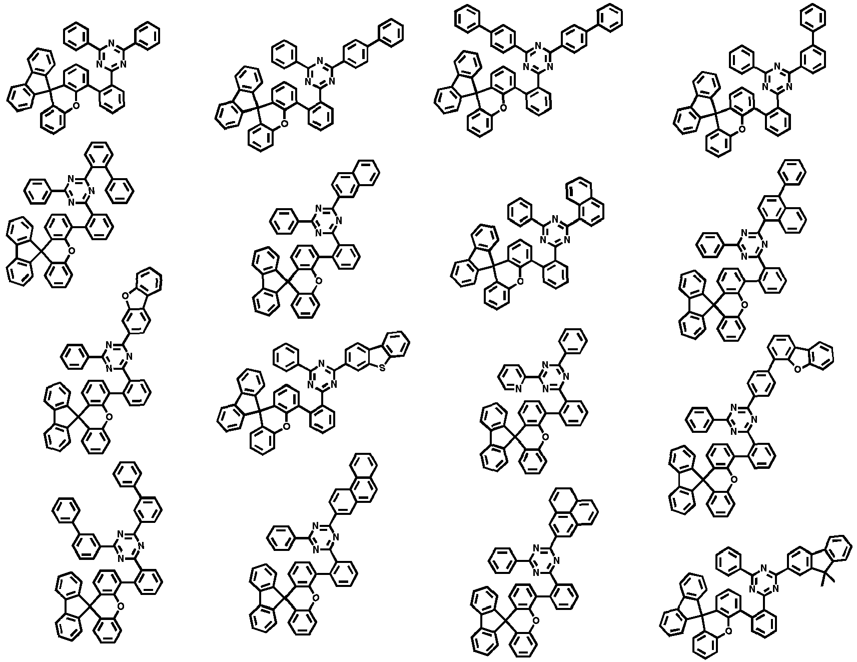

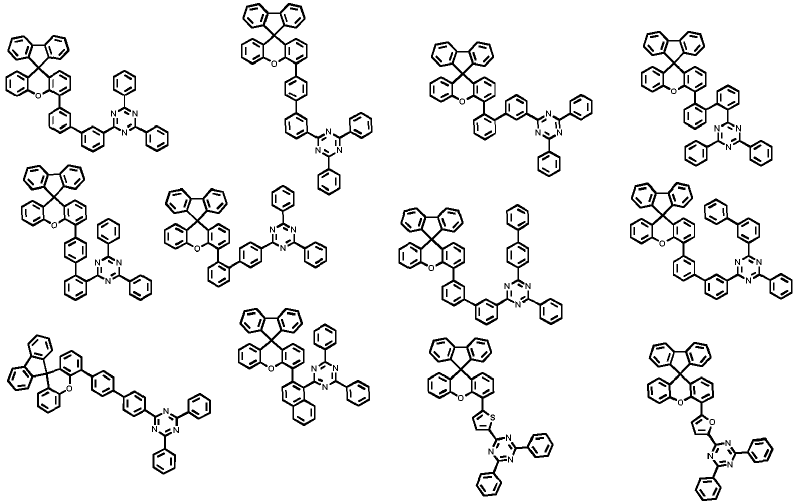

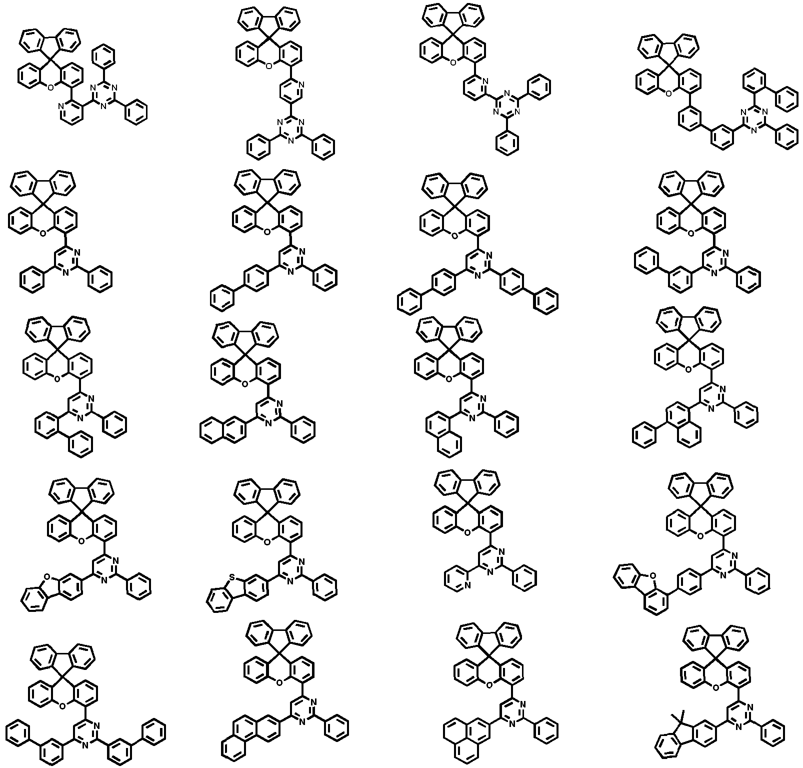

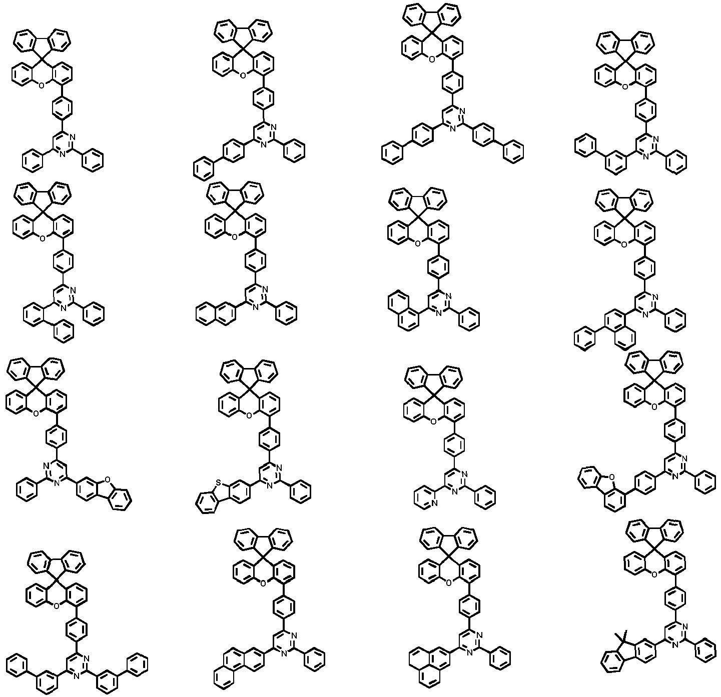

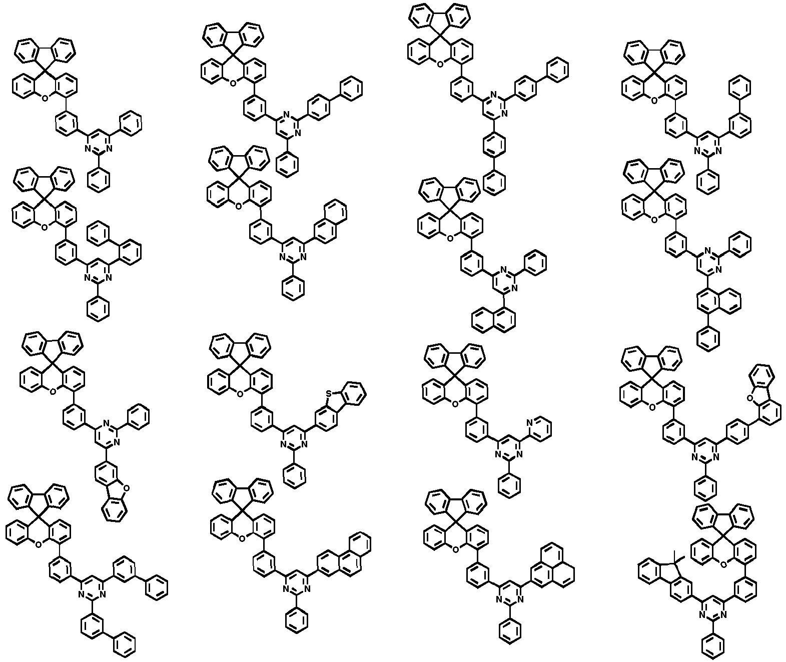

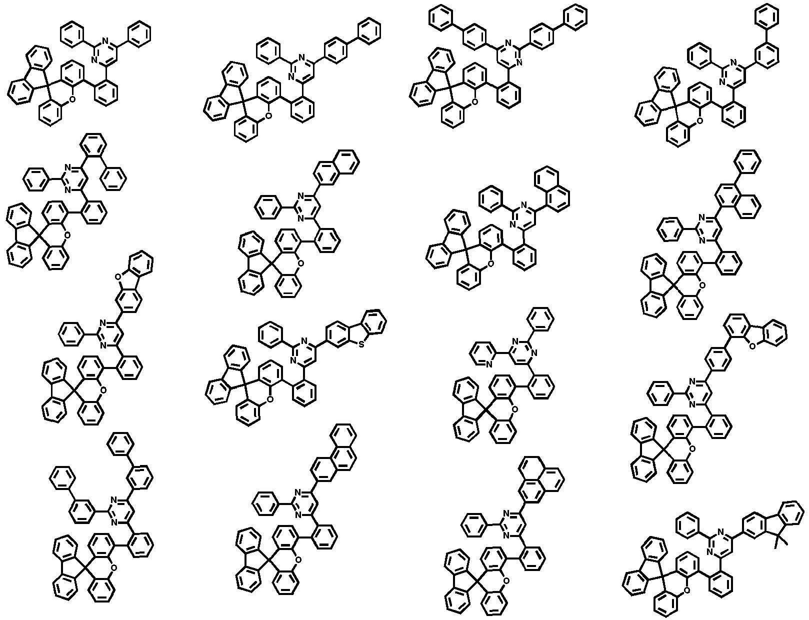

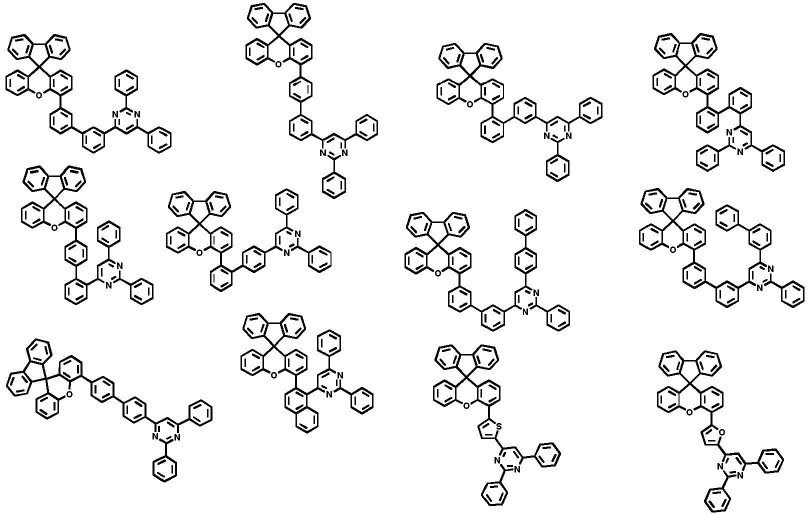

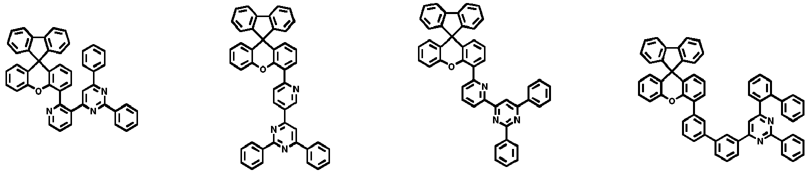

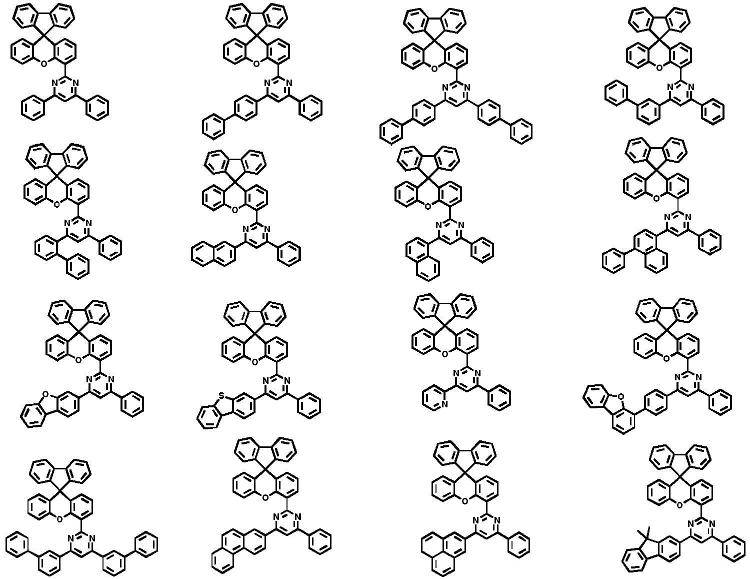

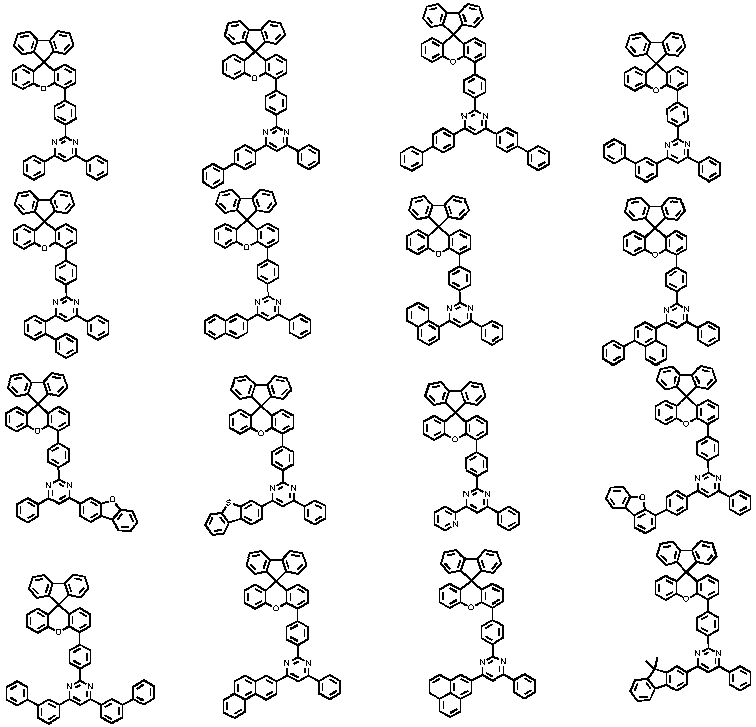

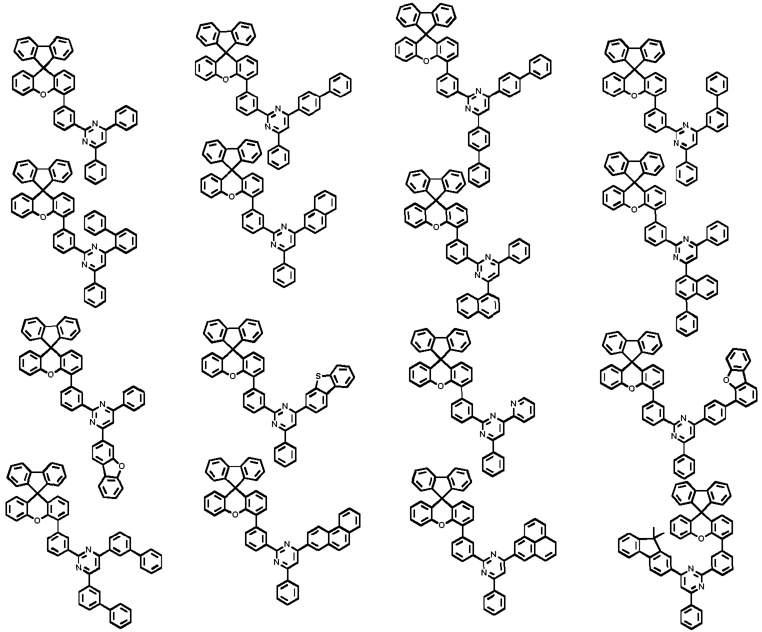

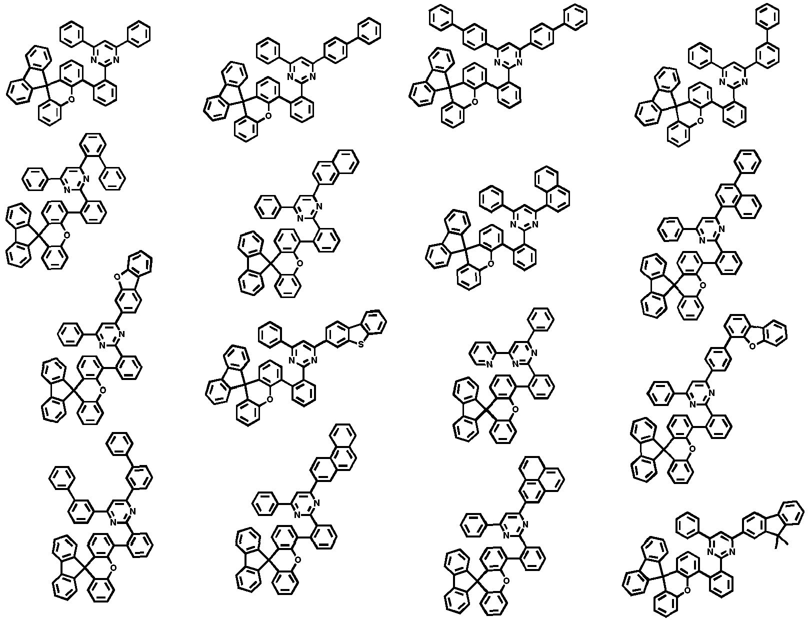

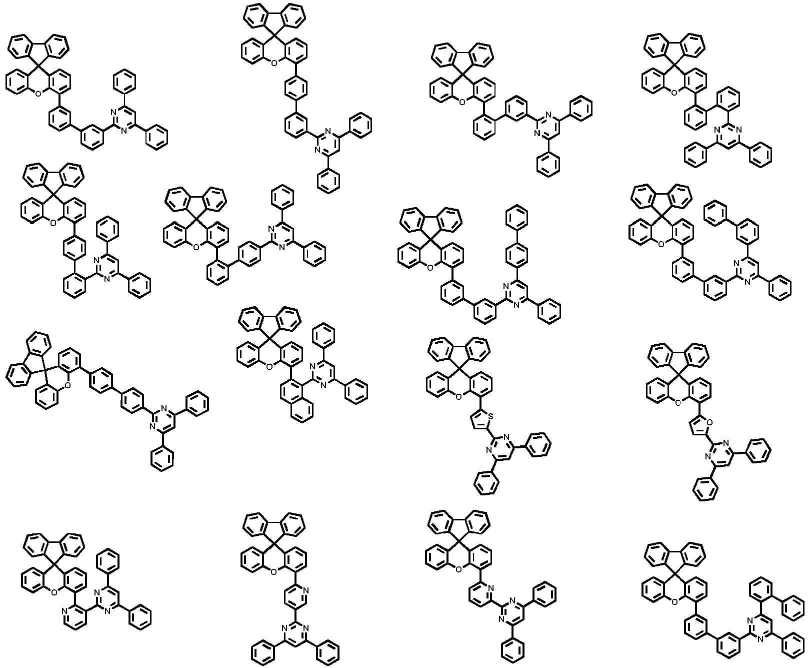

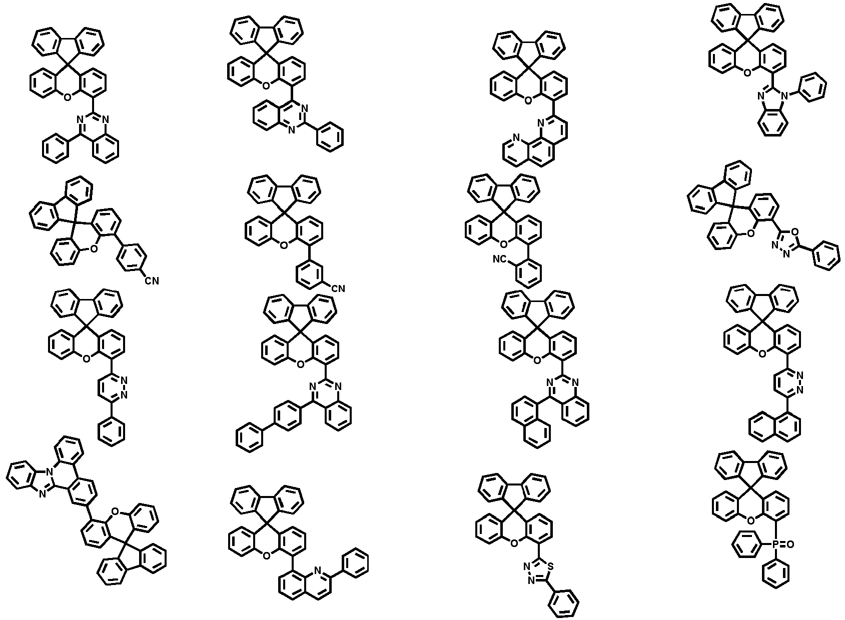

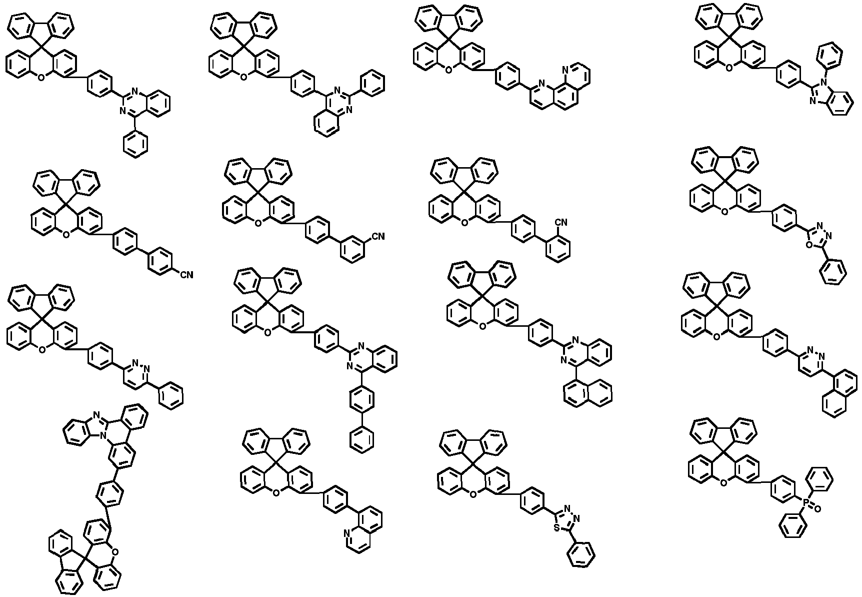

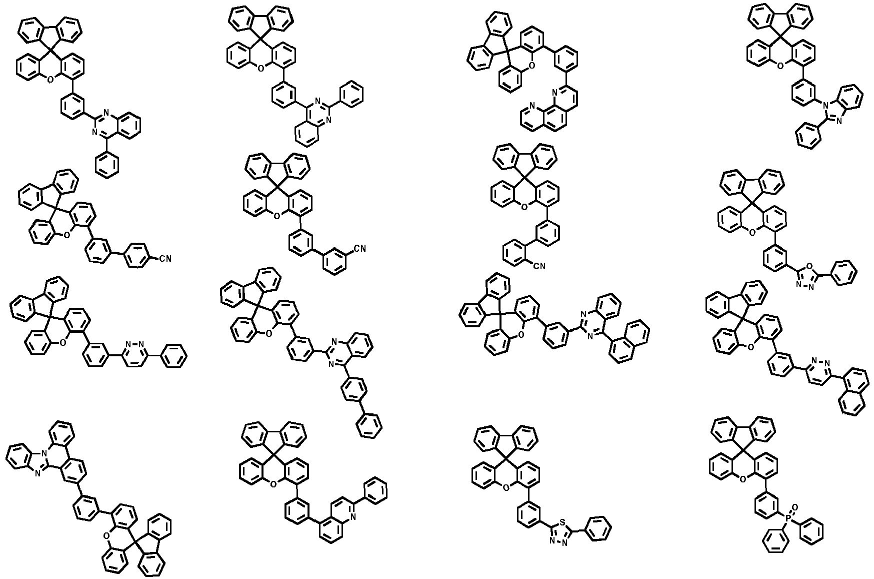

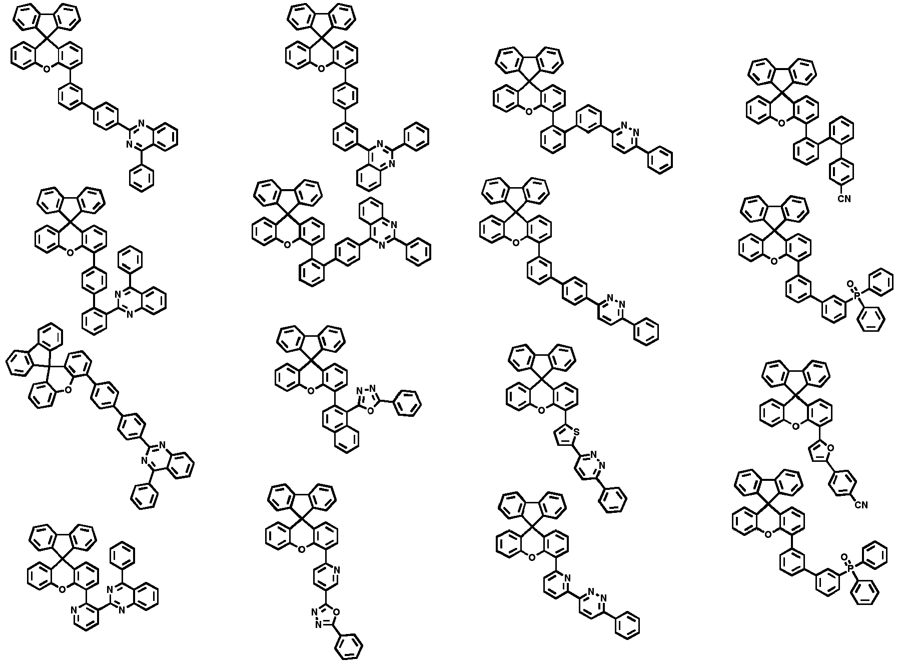

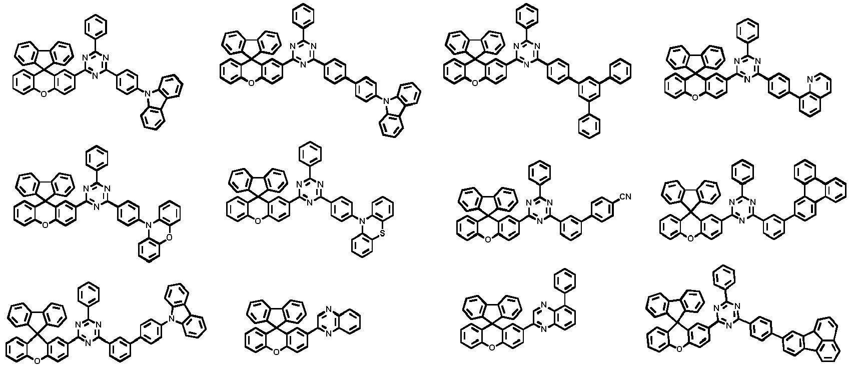

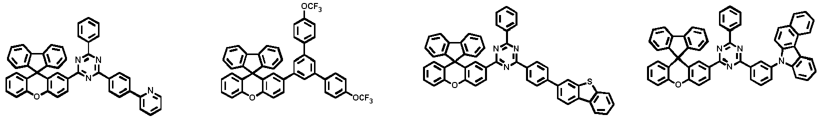

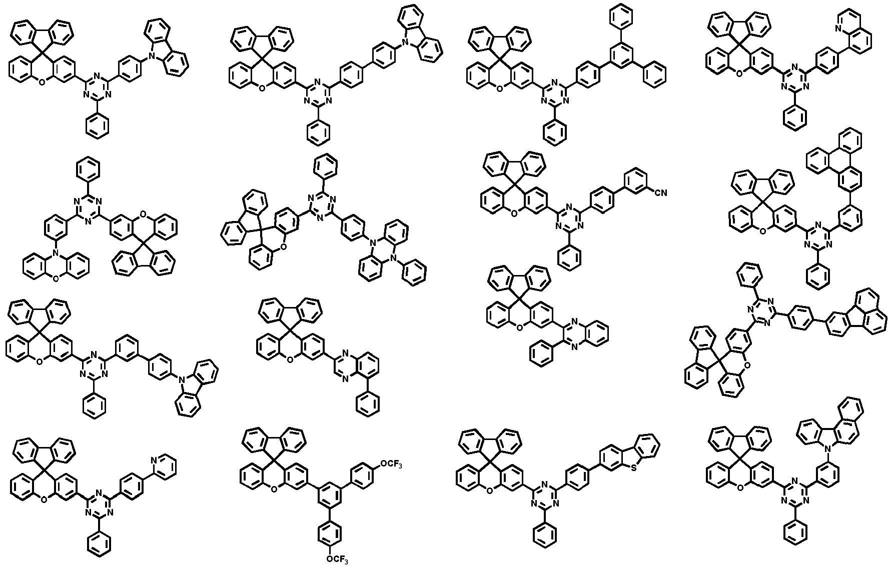

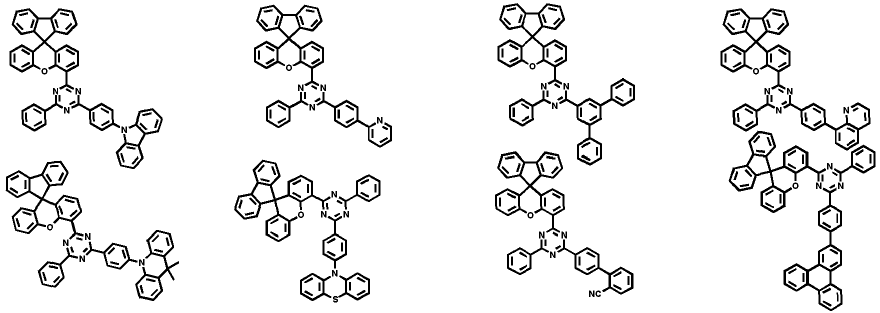

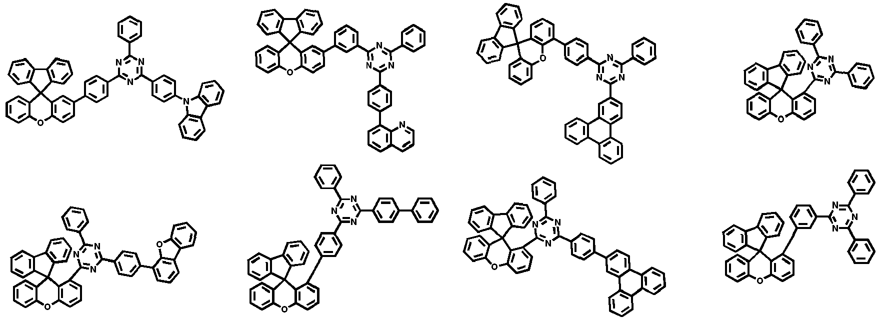

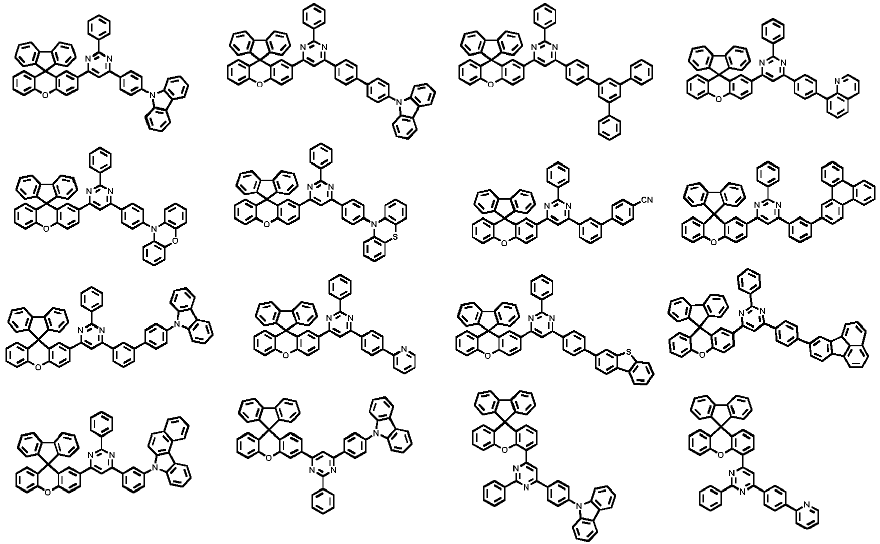

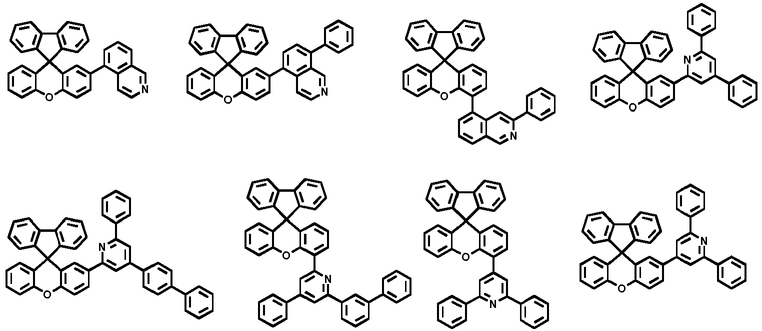

According to one embodiment of the present specification, Chemical Formula 3 is represented by any one selected from among the following Chemical Formulae 3-1 to 3-4.

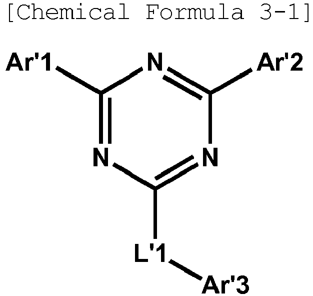

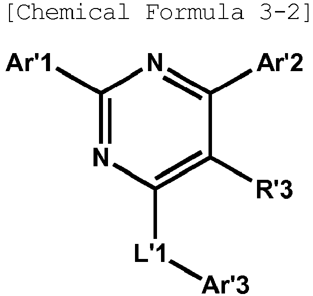

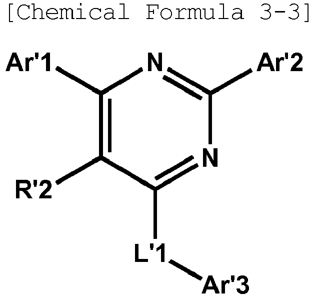

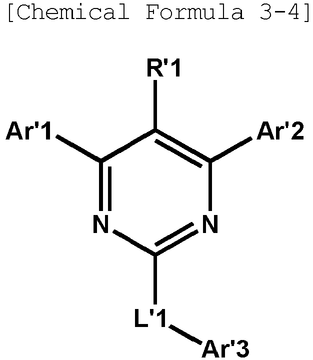

In Chemical Formulae 3-1 to 3-4, substituents have the same definitions as in Chemical Formula 3.

According to one embodiment of the present specification, in Chemical Formula 3, R'1 to R'3 are each hydrogen.

According to one embodiment of the present specification, Chemical Formula 3 may be represented by any one selected from among the following Chemical Formulae 3a to 3c.

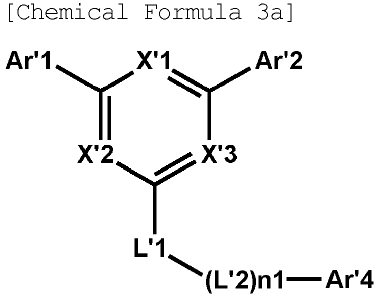

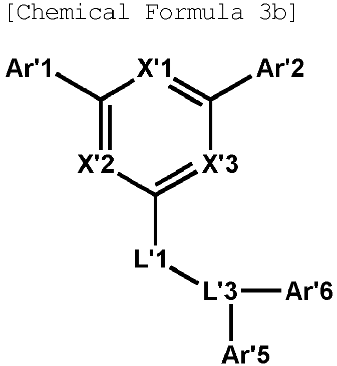

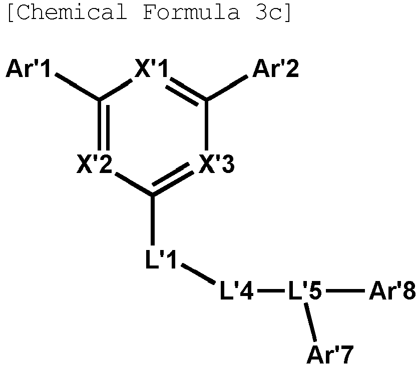

In Chemical Formulae 3a to 3c, substituents have the same definitions as in Chemical Formula 3 and Chemical Formulae 4a to 4c.

According to one embodiment of the present specification, in Chemical Formula 3, Ar'1 and Ar'2 are the same as or different from each other, and each independently a substituted or unsubstituted aryl group having 6 to 30 carbon atoms; or a substituted or unsubstituted heteroaryl group having 2 to 30 carbon atoms.

According to one embodiment of the present specification, in Chemical Formula 3, Ar'1 and Ar'2 are the same as or different from each other, and each independently a substituted or unsubstituted aryl group having 6 to 20 carbon atoms; or a substituted or unsubstituted heteroaryl group having 2 to 20 carbon atoms.

According to one embodiment of the present specification, in Chemical Formula 3, Ar'1 and Ar'2 are the same as or different from each other, and each independently a substituted or unsubstituted aryl group having 6 to 20 carbon atoms.

According to one embodiment of the present specification, in Chemical Formula 3, Ar'1 and Ar'2 are the same as or different from each other, and each independently a substituted or unsubstituted phenyl group; a substituted or unsubstituted biphenyl group; a substituted or unsubstituted naphthyl group; or a substituted or unsubstituted fluorenyl group.

According to one embodiment of the present specification, in Chemical Formula 3, Ar'1 and Ar'2 are the same as or different from each other, and each independently a phenyl group; a biphenyl group; a naphthyl group; or a fluorenyl group substituted with a phenyl group.

According to one embodiment of the present specification, L'1 is a direct bond; a substituted or unsubstituted arylene group having 6 to 30 carbon atoms; or a substituted or unsubstituted heteroarylene group having 2 to 30 carbon atoms, L'2 and L'4 are the same as or different from each other, and each independently a direct bond; a substituted or unsubstituted alkylene group having 1 to 30 carbon atoms; a substituted or unsubstituted arylene group having 6 to 30 carbon atoms; or a substituted or unsubstituted heteroarylene group having 2 to 30 carbon atoms.

According to one embodiment of the present specification, L'1 is a direct bond; a substituted or unsubstituted arylene group having 6 to 20 carbon atoms; or a substituted or unsubstituted heteroarylene group having 2 to 20 carbon atoms, L'2 and L'4 are the same as or different from each other, and each independently a direct bond; a substituted or unsubstituted alkylene group having 1 to 20 carbon atoms; a substituted or unsubstituted arylene group having 6 to 20 carbon atoms; or a substituted or unsubstituted heteroarylene group having 2 to 20 carbon atoms.

According to one embodiment of the present specification, L'1 is a direct bond; a substituted or unsubstituted phenylene group; a substituted or unsubstituted biphenylene group; a substituted or unsubstituted terphenylene group; a substituted or unsubstituted naphthylene group; or a substituted or unsubstituted fluorenylene group, L'2 and L'4 are the same as or different from each other, and each independently a direct bond; a substituted or unsubstituted methylene group; a substituted or unsubstituted ethylene group; a substituted or unsubstituted propylene group; a substituted or unsubstituted phenylene group; a substituted or unsubstituted biphenylene group; a substituted or unsubstituted terphenylene group; a substituted or unsubstituted naphthylene group; or a substituted or unsubstituted fluorenylene group.

According to one embodiment of the present specification, L'1 is a direct bond; a phenylene group; a biphenylene group; a terphenylene group; a naphthylene group; or a fluorenylene group unsubstituted or substituted with a methyl group, L'2 and L'4 are the same as or different from each other, and each independently a direct bond; a methylene group unsubstituted or substituted with a methyl group; a propylene group; a phenylene group; a biphenylene group; a terphenylene group; a naphthylene group; or a fluorenylene group unsubstituted or substituted with a methyl group.

According to one embodiment of the present specification, L'3 and L'5 are the same as or different from each other, and each independently a substituted or unsubstituted trivalent aryl group having 6 to 30 carbon atoms; or a substituted or unsubstituted trivalent heteroaryl group having 2 to 30 carbon atoms.

According to one embodiment of the present specification, L'3 and L'5 are the same as or different from each other, and each independently a substituted or unsubstituted trivalent aryl group having 6 to 20 carbon atoms; or a substituted or unsubstituted trivalent heteroaryl group having 2 to 20 carbon atoms.

According to one embodiment of the present specification, L'3 and L'5 are the same as or different from each other, and each independently a substituted or unsubstituted trivalent phenyl group; a substituted or unsubstituted trivalent biphenyl group; a substituted or unsubstituted trivalent terphenyl group; a substituted or unsubstituted trivalent naphthyl group; or a substituted or unsubstituted trivalent fluorenyl group.

According to one embodiment of the present specification, L'3 and L'5 are the same as or different from each other, and each independently a trivalent phenyl group; a trivalent biphenyl group; a trivalent terphenyl group; a trivalent naphthyl group; or a trivalent fluorenyl group.

According to one embodiment of the present specification, L'3 and L'5 are the same as or different from each other, and each independently a trivalent phenyl group.

According to one embodiment of the present specification, Ar'4 to Ar'8 are the same as or different from each other, and each independently a nitrile group; an aryl group having 6 to 30 carbon atoms unsubstituted or substituted with one, two or more substituents selected from the group consisting of a substituted or unsubstituted alkyl group, a substituted or unsubstituted aryl group, a substituted or unsubstituted pyridyl group, a substituted or unsubstituted carbazole group and a nitrile group; or a substituted or unsubstituted heteroaryl group having 2 to 30 carbon atoms.

According to one embodiment of the present specification, Ar'4 to Ar'8 are the same as or different from each other, and each independently a nitrile group; an aryl group having 6 to 20 carbon atoms unsubstituted or substituted with one, two or more substituents selected from the group consisting of a substituted or unsubstituted alkyl group, a substituted or unsubstituted aryl group, a substituted or unsubstituted pyridyl group, a substituted or unsubstituted carbazole group and a nitrile group; or a substituted or unsubstituted heteroaryl group having 2 to 20 carbon atoms.

According to one embodiment of the present specification, Ar'4 to Ar'8 are the same as or different from each other, and may be each independently represented by a nitrile group; an aryl group unsubstituted or substituted with one, two or more substituents selected from the group consisting of a substituted or unsubstituted alkyl group, a substituted or unsubstituted aryl group, a substituted or unsubstituted pyridyl group, a substituted or unsubstituted carbazole group and a nitrile group; a triazine group unsubstituted or substituted with a substituted or unsubstituted aryl group; or any one selected from among the following Chemical Formulae 16 to 18.

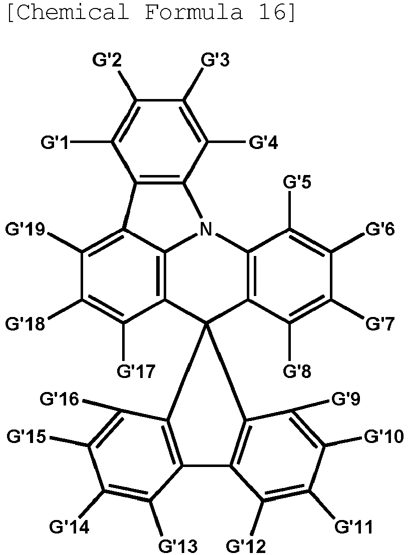

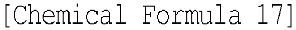

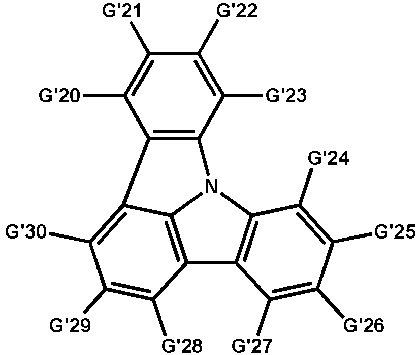

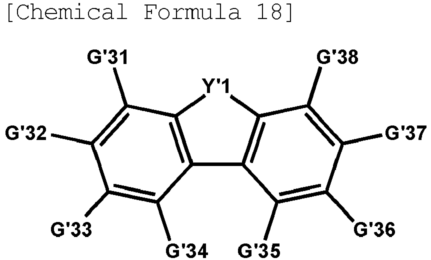

In Chemical Formulae 16 to 18,
Y'1 is O; S; or NR'4,
any one of G'1 to G'19, any one of G'20 to G'30, and any one of G'31 to G'38 and R'4 are a site bonding to L'2 of Chemical Formula 4a, L'3 of Chemical Formula 4b or L'5 of Chemical Formula 4c, and
the rest of G'1 to G'38 and R'4 other than the site bonding to L'2 of Chemical Formula 4a, L'3 of Chemical Formula 4b or L'5 of Chemical Formula 4c are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group.

According to one embodiment of the present specification, the rest of G'1 to G'38 and R'4 other than the site bonding to L'2 of Chemical Formula 4a, L'3 of Chemical Formula 4b or L'5 of Chemical Formula 4c are the same as or different from each other, and each independently hydrogen; or a substituted or unsubstituted aryl group.

According to one embodiment of the present specification, the rest of G'1 to G'38 and R'4 other than the site bonding to L'2 of Chemical Formula 4a, L'3 of Chemical Formula 4b or L'5 of Chemical Formula 4c are each independently hydrogen.

According to one embodiment of the present specification, Ar'4 to Ar'8 are the same as or different from each other, and may be each independently represented by a nitrile group; an aryl group having 6 to 30 carbon atoms unsubstituted or substituted with one, two or more substituents selected from the group consisting of a substituted or unsubstituted alkyl group, a substituted or unsubstituted aryl group, a substituted or unsubstituted pyridyl group, a substituted or unsubstituted carbazole group and a nitrile group; a triazine group unsubstituted or substituted with a substituted or unsubstituted aryl group; or any one selected from among Chemical Formulae 16 to 18.

According to one embodiment of the present specification, Ar'4 to Ar'8 are the same as or different from each other, and may be each independently represented by a nitrile group; an aryl group unsubstituted or substituted with one, two or more substituents selected from the group consisting of an alkyl group, an aryl group, a pyridyl group, a carbazole group and a nitrile group; a triazine group unsubstituted or substituted with an aryl group; or any one selected from among Chemical Formulae 16 to 18.

According to one embodiment of the present specification, Ar'4 to Ar'8 are the same as or different from each other, and may be each independently represented by a nitrile group; an aryl group having 6 to 30 carbon atoms unsubstituted or substituted with one, two or more substituents selected from the group consisting of an alkyl group, an aryl group, a pyridyl group, a carbazole group and a nitrile group; a triazine group unsubstituted or substituted with an aryl group; or any one selected from among Chemical Formulae 16 to 18.

According to one embodiment of the present specification, Ar'4 to Ar'8 are the same as or different from each other, and may be each independently represented by a nitrile group; an aryl group unsubstituted or substituted with one, two or more substituents selected from the group consisting of a methyl group, a phenyl group, a pyridyl group, a carbazole group and a nitrile group; a triazine group unsubstituted or substituted with a phenyl group; or any one selected from among Chemical Formulae 16 to 18.

According to one embodiment of the present specification, Ar'4 to Ar'8 are the same as or different from each other, and may be each independently represented by a nitrile group; an aryl group having 6 to 30 carbon atoms unsubstituted or substituted with one, two or more substituents selected from the group consisting of a methyl group, a phenyl group, a pyridyl group, a carbazole group and a nitrile group; a triazine group unsubstituted or substituted with a phenyl group; or any one selected from among Chemical Formulae 16 to 18.

According to one embodiment of the present specification, Ar'4 to Ar'8 are the same as or different from each other, and may be each independently represented by a nitrile group; a phenyl group unsubstituted or substituted with one, two or more substituents selected from the group consisting of an alkyl group, an aryl group, a pyridyl group, a carbazole group and a nitrile group; a naphthyl group unsubstituted or substituted with one, two or more substituents selected from the group consisting of an alkyl group, an aryl group, a pyridyl group, a carbazole group and a nitrile group; a fluorenyl group unsubstituted or substituted with one, two or more substituents selected from the group consisting of an alkyl group, an aryl group, a pyridyl group, a carbazole group and a nitrile group; a triazine group unsubstituted or substituted with a phenyl group; or any one selected from among Chemical Formulae 16 to 18.

According to one embodiment of the present specification, Ar'4 to Ar'8 are the same as or different from each other, and may be each independently represented by a nitrile group; a phenyl group unsubstituted or substituted with one, two or more substituents selected from the group consisting of a methyl group, a phenyl group, a pyridyl group, a carbazole group and a nitrile group; a naphthyl group unsubstituted or substituted with one, two or more substituents selected from the group consisting of a methyl group, a phenyl group, a pyridyl group, a carbazole group and a nitrile group; a fluorenyl group unsubstituted or substituted with one, two or more substituents selected from the group consisting of a methyl group, a phenyl group, a pyridyl group, a carbazole group and a nitrile group; a triazine group unsubstituted or substituted with a phenyl group; or any one selected from among Chemical Formulae 16 to 18.

According to one embodiment of the present specification, Chemical Formula 3 may be represented by any one selected from among the following compounds.

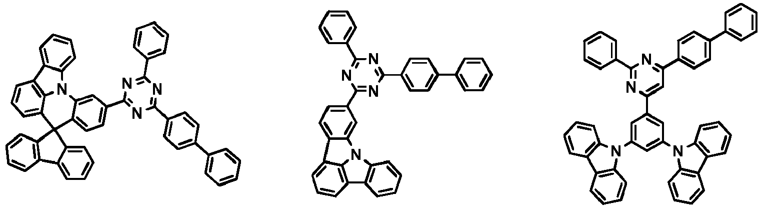

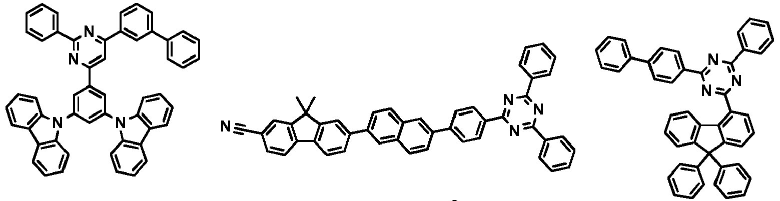

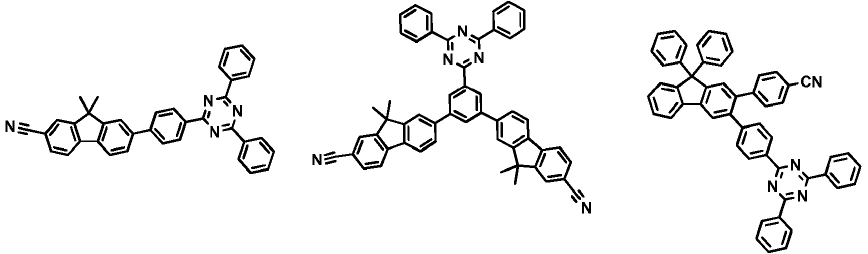

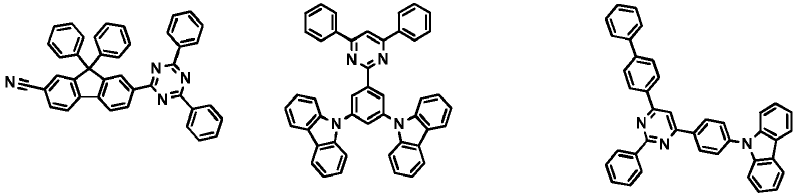

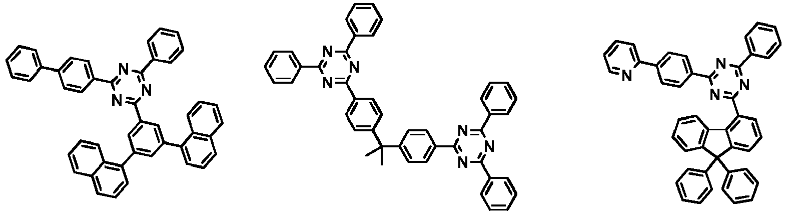

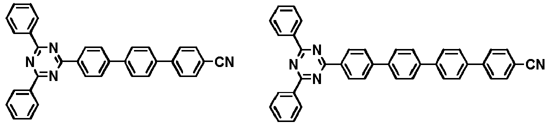

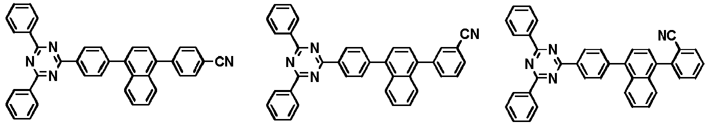

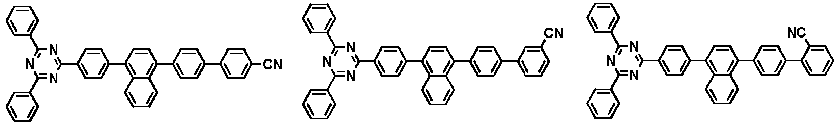

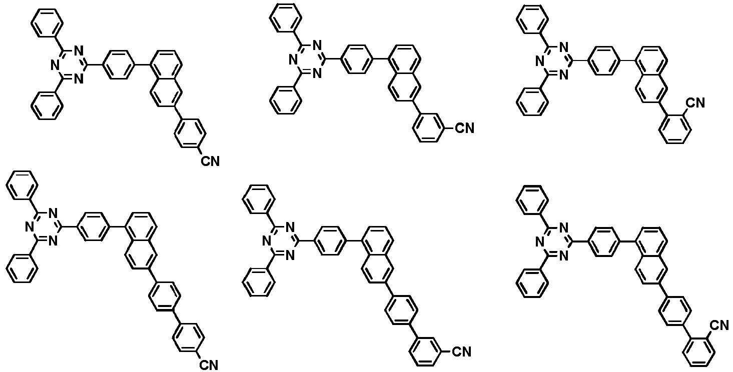

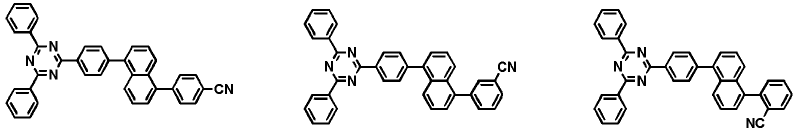

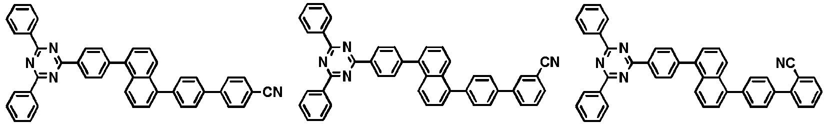

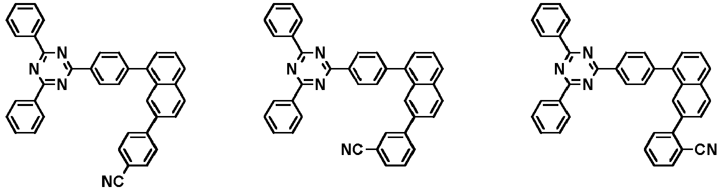

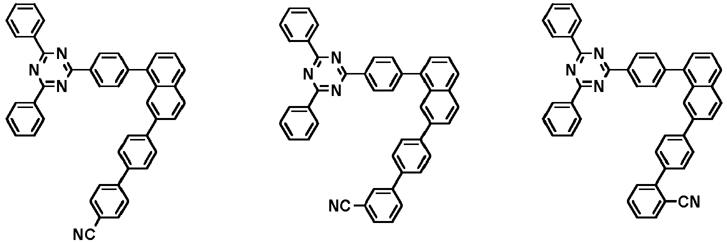

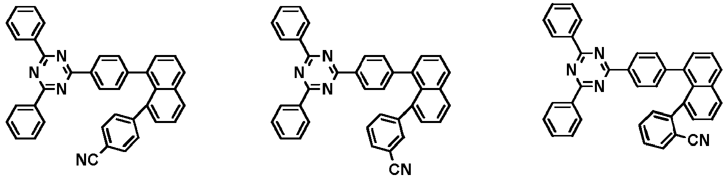

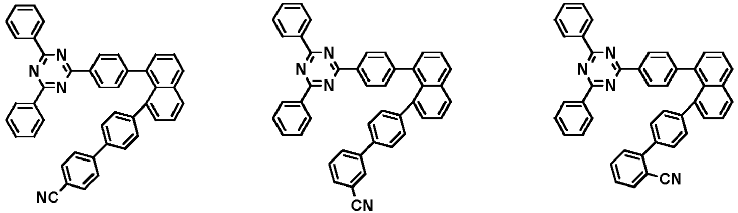

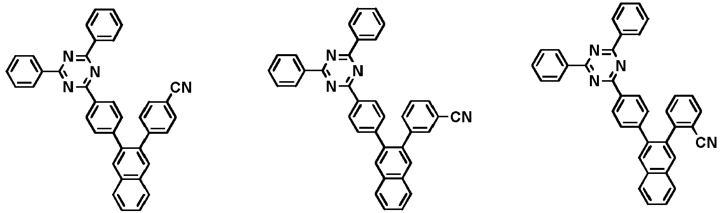

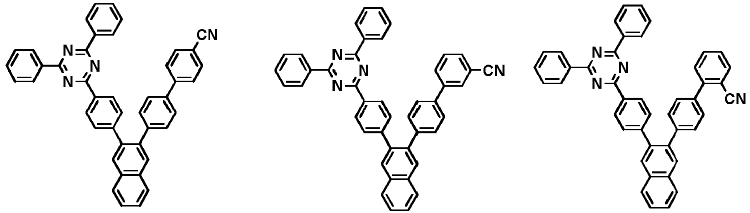

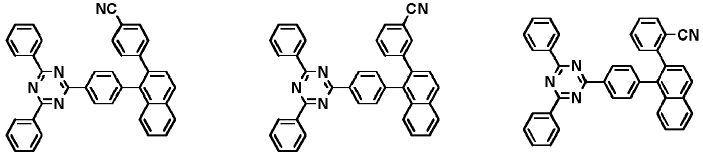

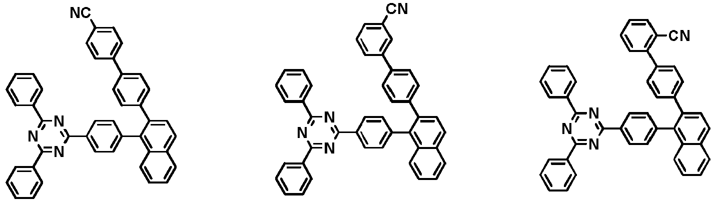

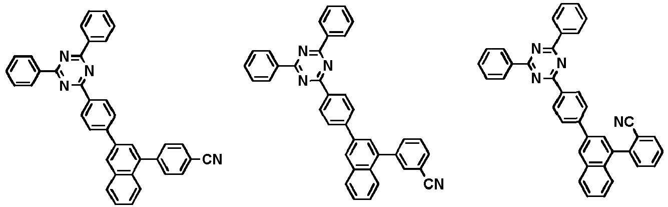

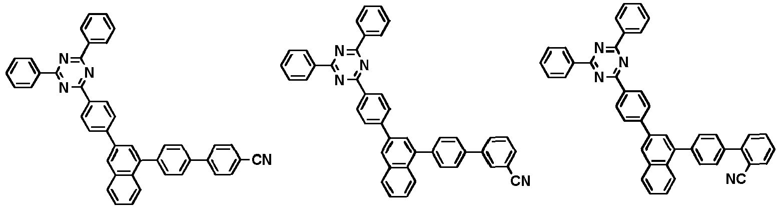

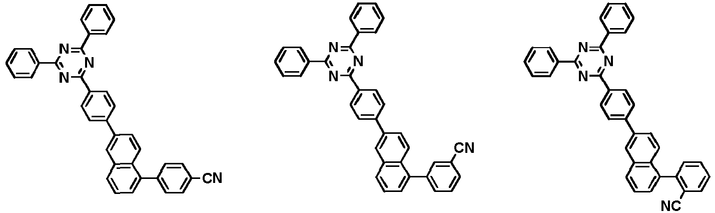

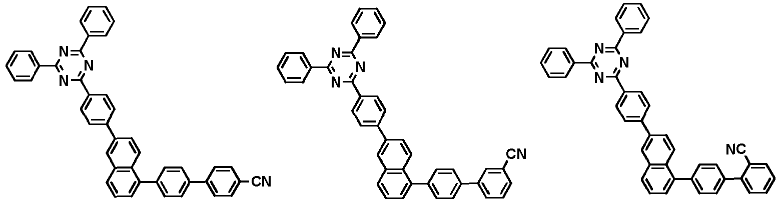

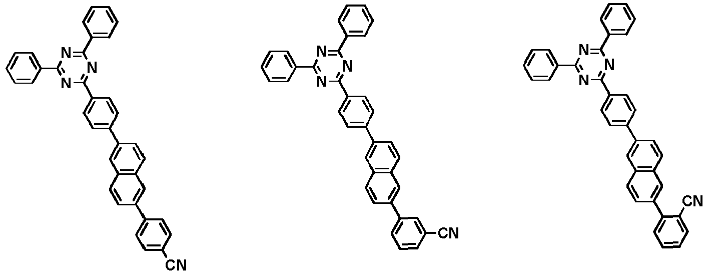

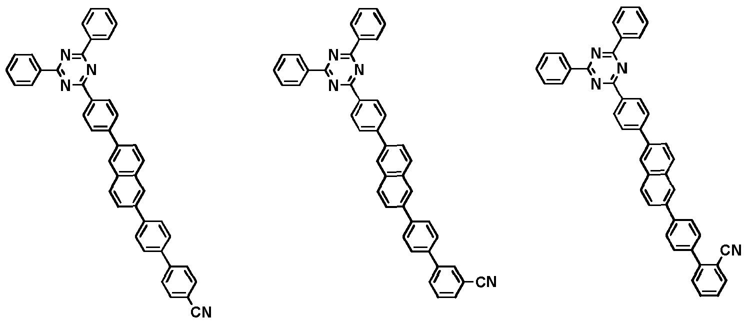

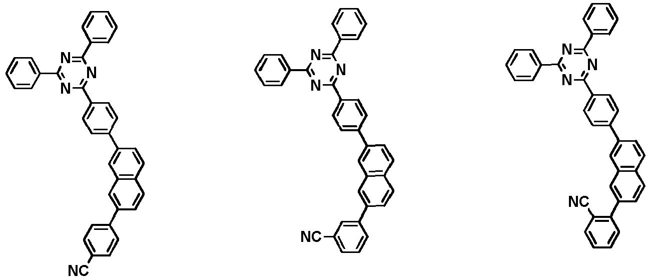

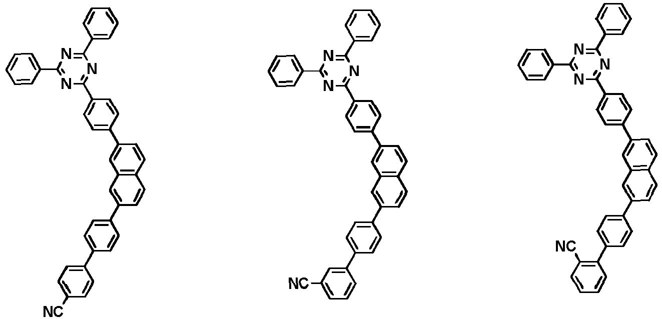

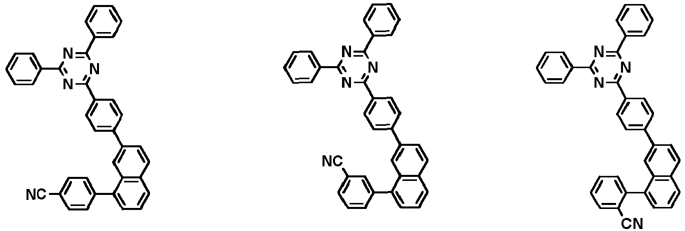

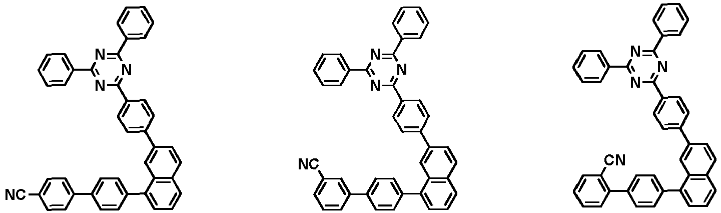

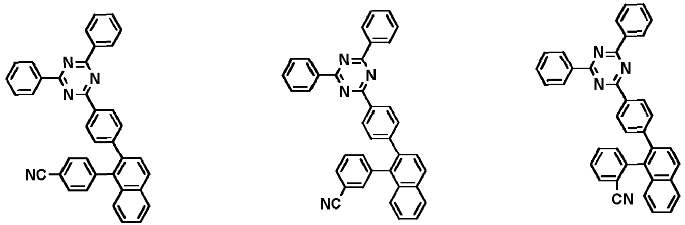

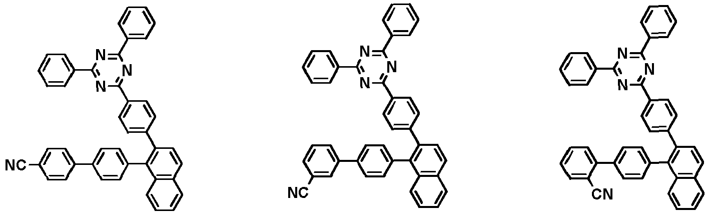

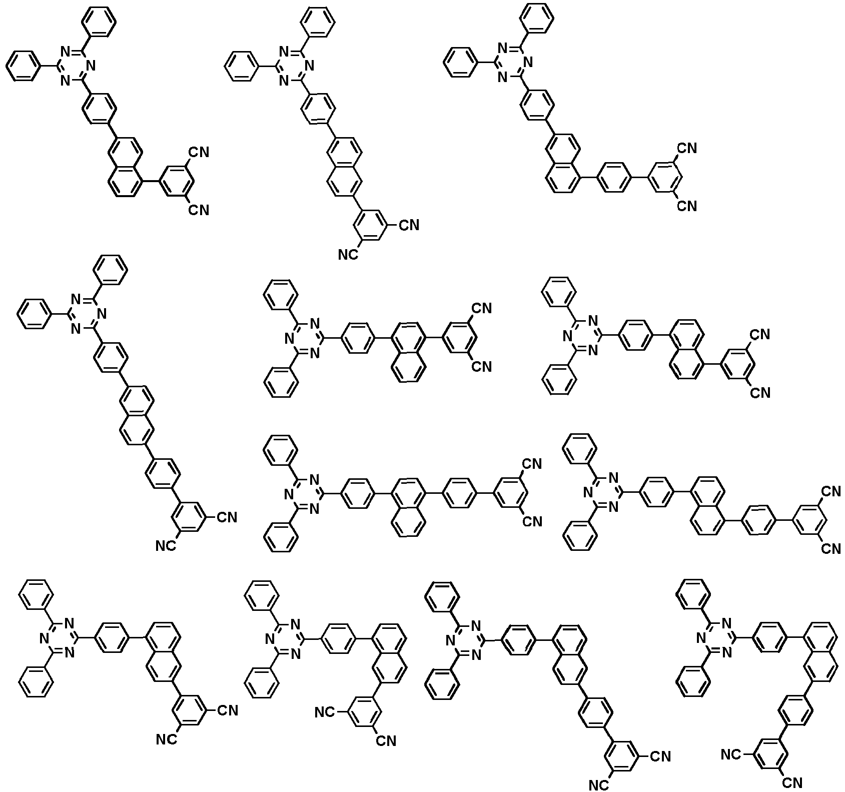

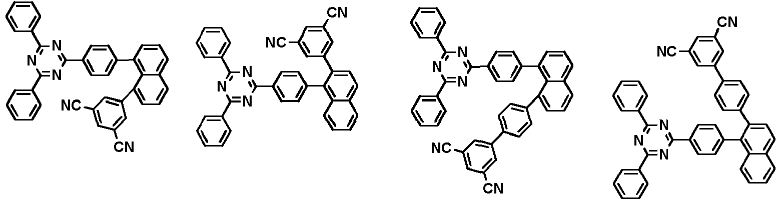

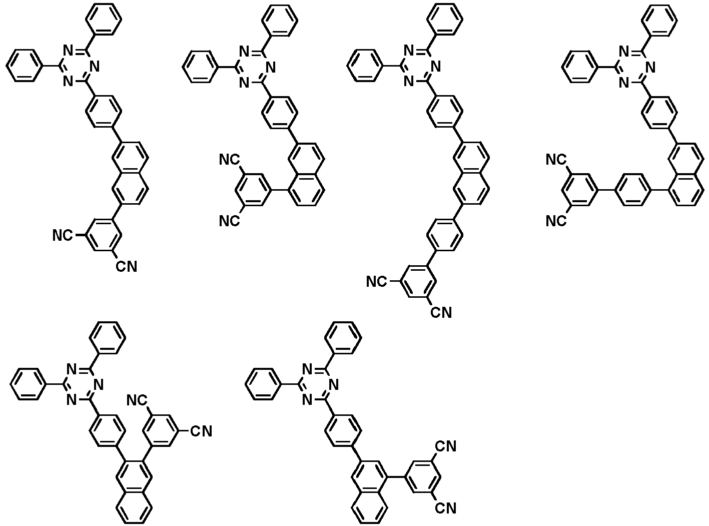

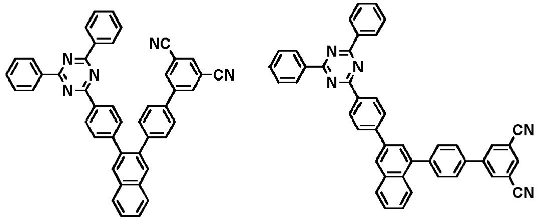

According to one embodiment of the present specification, the electron transfer layer may further include a compound represented by the following Chemical Formula 5.

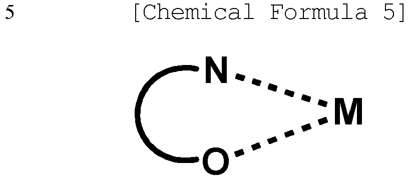

In Chemical Formula 5,
M is an alkali metal or an alkaline-earth metal,
a curve connecting N and O represents bonds or atoms 10 required to form a substituted or unsubstituted ring including N or O, and
a dotted line means N and O forming a metal complex with M.

According to one embodiment of the present specification, the alkali metal may mean a group 1 element of the periodic table, that is, Li, Na, K, Rb or the like, and the alkaline-earth metal may mean a group 2 element of the periodic table, that is, Be, Mg, Ca, Sr or the like.

According to one embodiment of the present specification, Chemical Formula 5 may be represented by the following Chemical Formula 5-1.

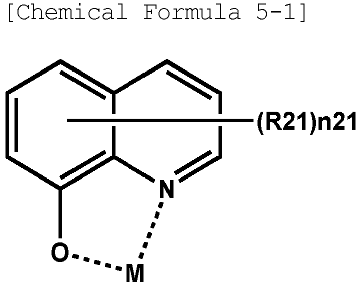

In Chemical Formula 5-1,
R21 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group,
n21 is an integer of 1 to 6, and when n21 is an integer of 2 or greater, substituents in the parentheses are the same as or different from each other, and
the remaining substituents have the same definitions as in Chemical Formula 5.

According to one embodiment of the present specification, M may be Li.

According to one embodiment of the present specification, R21 may be hydrogen.

According to one embodiment of the present specification, when the electron transfer layer including the compound represented by Chemical Formula 3 is adjacent to a cathode, the electron transfer layer may further include the compound represented by Chemical Formula 5.

In one embodiment of the present specification, when using the compound represented by Chemical Formula 3 in an electron transfer layer, the compound represented by Chemical Formula 5 may be mixed and used as an n-type dopant. Herein, the compound represented by Chemical Formula 3 and the compound represented by Chemical Formula 5 may have a weight ratio of 1:100 to 100:1. Specifically, the weight ratio may be from 1:10 to 10:1. More specifically, the weight ratio may be 1:1.

According to one embodiment of the present specification, the organic material layer may further include one or more organic material layers selected from among a hole injection layer, a hole transfer layer and an electron injection layer.

An organic light emitting device according to one embodiment of the present specification includes an anode; a cathode; and a light emitting layer provided between the anode and the cathode, further includes an electron control layer provided between the light emitting layer and the cathode and including the compound represented by Chemical Formula 1, and an electron transfer layer provided between the electron control layer and the cathode and including the compound represented by Chemical Formula 3, may further include the compound represented by Chemical Formula 5 in the electron transfer layer, and in addition thereto, may further include one or more organic material layers selected from among a hole transfer layer, a hole injection layer and an electron injection layer. However, the structure of the organic light emitting device is not limited thereto, and may include less or more numbers of organic material layers.

The organic light emitting device according to one embodiment of the present specification includes an anode; a cathode; and a light emitting layer provided between the anode and the cathode, further includes an electron control layer provided between the light emitting layer and the cathode and including the compound represented by Chemical Formula 1, and an electron transfer layer provided between the electron control layer and the cathode and including the compound represented by Chemical Formula 3, and has a hole transfer layer provided between the anode and the light emitting layer, and has a hole injection layer provided between the anode and the hole transfer layer.

The organic light emitting device according to one embodiment of the present specification includes an anode; a cathode; and a light emitting layer provided between the anode and the cathode, further includes an electron control layer provided between the light emitting layer and the cathode and including the compound represented by Chemical Formula 1, and an electron transfer layer provided between the electron control layer and the cathode and including the compound represented by Chemical Formula 3, may further include the compound represented by Chemical Formula 5 in the electron transfer layer, has a hole transfer layer provided between the anode and the light emitting layer, and has a hole injection layer provided between the anode and the hole transfer layer.

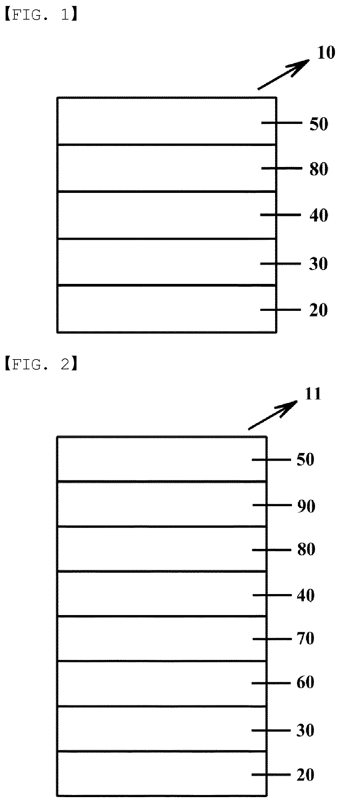

According to one embodiment of the present specification, the organic material layer of the organic light emitting device of the present specification may be formed in a single layer structure, but may be formed in a multilayer structure in which two or more organic material layers are laminated. For example, the organic light emitting device in the present specification may have structures as illustrated in FIG. 1 to FIG. 3, however, the structure is not limited thereto.

FIG. 1 illustrates a structure of an organic light emitting device (10) in which an anode (30), a light emitting layer (40), an electron transfer layer (80) and a cathode (50) are consecutively laminated on a substrate (20). FIG. 1 is an exemplary structure of an organic light emitting device according to one embodiment of the present specification, and other organic material layers may be further included.

FIG. 2 illustrates a structure of an organic light emitting device (11) in which an anode (30), a hole injection layer (60), a hole transfer layer (70), a light emitting layer (40), an electron transfer layer (80), an electron injection layer (90) and a cathode (50) are consecutively laminated on a substrate (20). FIG. 2 is an exemplary structure of an organic light emitting device according to an embodiment of the present specification, and other organic material layers may be further included.

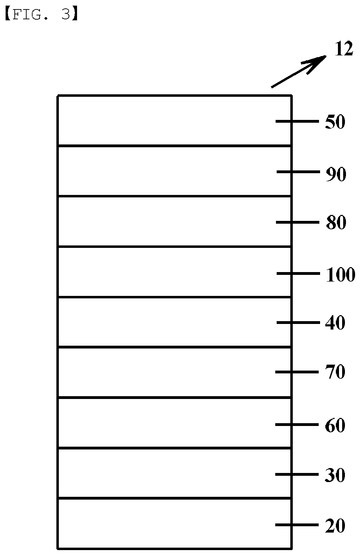

FIG. 3 illustrates a structure of an organic light emitting device (12) in which an anode (30), a hole injection layer (60), a hole transfer layer (70), a light emitting layer (40), an electron control layer (100), an electron transfer layer (80), an electron injection layer (90) and a cathode (50) are consecutively laminated on a substrate (20). FIG. 3 is an exemplary structure of an organic light emitting device according to an embodiment of the present specification, and other organic material layers may be further included.

In one embodiment of the present specification, the n-type dopant may be a metal complex and the like, and an alkali metal such as Li, Na, K, Rb, Cs or Fr; an alkaline-earth metal such as Be, Mg, Ca, Sr, Ba or Ra; a rare-earth metal such as La, Ce, Pr, Nd, Sm, Eu, Tb, Th, Dy, Ho, Er, Em, Gd, Yb, Lu, Y or Mn; or a metal compound including one or more metals of the above-mentioned metals may be used, however, the n-type dopant is not limited thereto, and those known in the art may be used. According to one embodiment, the electron transfer layer or the layer carrying out electron injection and electron transfer at the same time including the compound of Chemical Formula 3 may further include LiQ.

The organic light emitting device of the present specification may be manufactured using materials and methods known in the art, except that one or more layers of the organic material layers include the compound represented by Chemical Formula 1 or the compound represented by Chemical Formula 3 of the present specification.

When the organic light emitting device includes a plurality of organic material layers, the organic material layers may be formed with materials the same as or different from each other.

For example, the organic light emitting device of the present specification may be manufactured by consecutively laminating an anode, an organic material layer and a cathode on a substrate. Herein, the organic light emitting device may be manufactured by forming an anode on a substrate by depositing a metal, a metal oxide having conductivity, or an alloy thereof using a physical vapor deposition (PVD) method such as sputtering or e-beam evaporation, and forming an organic material layer including a hole injection layer, a hole transfer layer, a light emitting layer, an electron control layer and an electron transfer layer thereon, and then depositing a material capable of being used as a cathode thereon. In addition to such a method, the organic light emitting device may also be manufactured by consecutively depositing a cathode material, an organic material layer and an anode material on a substrate. In addition, the compound represented by Chemical Formula 1 or Chemical Formula 3 may be formed into an organic material layer using a solution coating method as well as a vacuum deposition method when manufacturing the organic light emitting device. Herein, the solution coating method means spin coating, dip coating, doctor blading, inkjet printing, screen printing, a spray method, roll coating and the like, but is not limited thereto.

As the anode material, materials having large work function are normally preferred so that hole injection to an organic material layer is smooth. Specific examples of the anode material capable of being used in the present disclosure include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, but are not limited thereto.

As the cathode material, materials having small work function are normally preferred so that electron injection to an organic material layer is smooth. Specific examples of the cathode material include metals such as magnesium, calcium, sodium, potassium, titanium, indium, yttrium, lithium, gadolinium, aluminum, silver, tin and lead, or alloys thereof; multilayer structure materials such as LiF/Al, LiO₂/Al or Mg/Ag, and the like, but are not limited thereto.

The hole injection layer is a layer that injects holes from an electrode, and the hole injection material is preferably a compound that has an ability to transfer holes, therefore, has a hole injection effect in an anode, has an excellent hole injection effect for a light emitting layer or a light emitting material, prevents excitons generated in the light emitting layer from moving to an electron injection layer or an electron injection material, and in addition thereto, has an excellent thin film forming ability. The highest occupied molecular orbital (HOMO) of the hole injection material is preferably in between the work function of an anode material and the HOMO of surrounding organic material layers. Specific examples of the hole injection material include metal porphyrins, oligothiophene, arylamine-based organic materials, hexanitrile hexaazatriphenylene-based organic materials, quinacridone-based organic materials, perylene-based organic materials, anthraquinone, and polyaniline- and polythiophene-based conductive polymers, and the like, but are not limited thereto.

The hole transfer layer is a layer receiving holes from a hole injection layer and transferring the holes to a light emitting layer, and as the hole transfer material, materials capable of receiving holes from an anode or a hole injection layer, moving the holes to a light emitting layer, and having high mobility for the holes are suited. Specific examples thereof include arylamine-based organic materials, conductive polymers, block copolymers having conjugated parts and nonconjugated parts together, and the like, but are not limited thereto.

The light emitting material of the light emitting layer is a material capable of emitting light in a visible light region by receiving holes and electrons from a hole transfer layer and an electron transfer layer, respectively, and binding the holes and the electrons, and is preferably a material having favorable quantum efficiency for fluorescence or phosphorescence. Specific examples thereof include 8-hydroxyquinoline aluminum complexes (Alq₃); carbazole series compounds; dimerized styryl compounds; BAlq; 10-hydroxybenzoquinoline-metal compounds; benzoxazole, benzothiazole and benzimidazole series compounds; poly(p-phenylenevinylene) (PPV) series polymers; spiro compounds; polyfluorene; rubrene, and the like, but are not limited thereto.

The light emitting layer may include a host material and a dopant material. The host material may include fused aromatic ring derivatives, heteroring-containing compounds or the like. Specifically, as the fused aromatic ring derivative, anthracene derivatives, pyrene derivatives, naphthalene derivatives, pentacene derivatives, phenanthrene compounds, fluoranthene compounds and the like may be included, and as the heteroring-containing compound, carbazole derivatives, dibenzofuran derivatives, ladder-type furan compounds, pyrimidine derivatives and the like may be included, however, the host material is not limited thereto.

The dopant material may include aromatic amine derivatives, styrylamine compounds, boron complexes, fluoranthene compounds, metal complexes and the like. Specifically, the aromatic amine derivative is a fused aromatic ring derivative having a substituted or unsubstituted arylamino group, and arylamino group-including pyrene, anthracene, chrysene, peryflanthene and the like may be included. The styrylamine compound is a compound in which substituted or unsubstituted arylamine is substituted with at least one arylvinyl group, and one, two or more substituents selected from the group consisting of an aryl group, a silyl group, an alkyl group, a cycloalkyl group and an arylamino group may be substituted or unsubstituted. Specifically, styrylamine, styryldiamine, styryltriamine, styryltetramine and the like may be included, however, the styrylamine compound is not limited thereto. As the metal complex, iridium complexes, platinum complexes and the like may be used, however, the metal complex is not limited thereto.

The electron transfer layer is a layer receiving electrons from an electron injection layer and transferring the electrons to a light emitting layer, and as the electron transfer material, materials capable of favorably receiving electrons from a cathode, moving the electrons to a light emitting layer, and having high mobility for the electrons are suited. Specific examples thereof include Al complexes of 8-hydroxyquinoline; complexes including Alq₃; organic radical compounds; hydroxyflavon-metal complexes, and the like, but are not limited thereto. The electron transfer layer may be used together with any desired cathode material as used in the art. Particularly, examples of the suitable cathode material may include common materials having low work function and having an aluminum layer or a silver layer following. Specifically, cesium, barium, calcium, ytterbium and samarium are included, and in each case, an aluminum layer or a silver layer follows.

The electron injection layer is a layer injecting electrons from an electrode, and compounds having an electron transferring ability, having an electron injection effect from a cathode, having an excellent electron injection effect for a light emitting layer or light emitting material, and preventing excitons generated in the light emitting layer from moving to a hole injection layer, and in addition thereto, having an excellent thin film forming ability are preferred. Specific examples thereof include fluorenone, anthraquinodimethane, diphenoquinone, thiopyran dioxide, oxazole, oxadiazole, triazole, imidazole, perylene tetracarboxylic acid, fluorenylidene methane, anthrone or the like, and derivatives thereof, metal complex compounds, nitrogen-containing 5-membered ring derivatives, and the like, but are not limited thereto.

The hole blocking layer is layer blocking holes from reaching a cathode, and may be generally formed under the same condition as the hole injection layer. Specific examples thereof may include oxadiazole derivatives, triazole derivatives, phenanthroline derivatives, BCP, aluminum complexes and the like, but are not limited thereto.

The metal complex compound includes 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)berylium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium and the like, but is not limited thereto.

The organic light emitting device according to the present specification may be a top-emission type, a bottom-emission type or a dual-emission type depending on the materials used.

According to one embodiment of the present specification, the compound represented by Chemical Formula 1 or Chemical Formula 3 may be included in an organic solar cell or an organic transistor in addition to the organic light emitting device.

Hereinafter, the present specification will be described in detail with reference to examples. However, the examples according to the present specification may be modified to various other forms, and the scope of the present specification is not to be construed as being limited to the examples described below. Examples of the present specification are provided in order to more fully describe the present specification to those having average knowledge in the art.

### <Synthesis Example>

### <Preparation Example 1-1> Synthesis of Compound E1

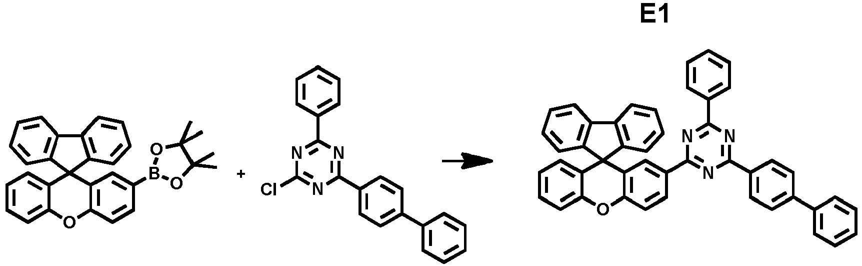

After completely dissolving compounds of 4,4,5,5-tetramethyl-2-(spiro[fluorene-9,9'-xanthen]-2'-yl)-1,3,2-dioxaborolane (10.0 g, 21.8 mmol) and 2-([1,1'-biphenyl]-4-yl)-4-chloro-6-phenyl-1,3,5-triazine (7.5 g, 21.8 mmol) in tetrahydrofuran (100 ml), potassium carbonate (9.0 g, 65.4 mmol) dissolved in water (50 ml) was added thereto, and after introducing tetrakistriphenyl-phosphino palladium (756 mg, 0.65 mmol) thereto, the result was heated and stirred for 8 hours. After lowering the temperature to room temperature and terminating the reaction, the potassium carbonate solution was removed to filter white solids. The filtered white solids were washed twice each with tetrahydrofuran and ethyl acetate to prepare Compound E1 (12.6 g, yield 90%).
MS[M+H]⁺=640

### <Preparation Example 1-2> Synthesis of Compound E2

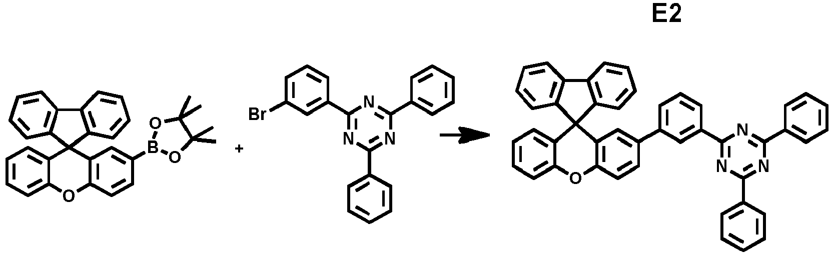

Compound E2 was prepared in the same manner as in Preparation Example 1-1 except that 2-(3-bromophenyl)-4,6-diphenyl-1,3,5-triazine was used instead of the compound 2-([1,1'-biphenyl]-4-yl)-4-chloro-6-phenyl-1,3,5-triazine.
MS[M+H]⁺=640

### <Preparation Example 1-3> Synthesis of Compound E3

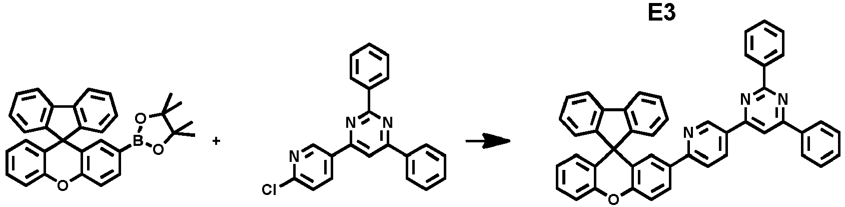

Compound E3 was prepared in the same manner as in Preparation Example 1-1 except that 4-(6-chloropyridin-3-yl)-2,6-diphenylpyrimidine was used instead of the compound 2-([1,1'-biphenyl]-4-yl)-4-chloro-6-phenyl-1,3,5-triazine.
MS[M+H]⁺=640

### <Preparation Example 1-4> Synthesis of Compound E4

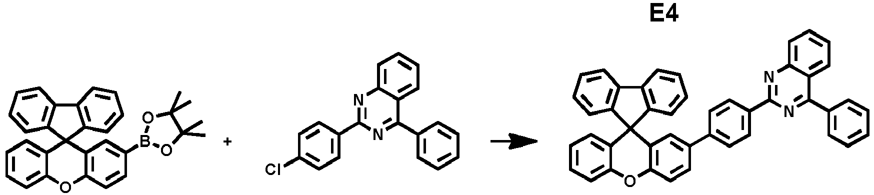

Compound E4 was prepared in the same manner as in Preparation Example 1-1 except that 2-(4-chlorophenyl)-4-phenylquinazoline was used instead of the compound 2-([1,1'-biphenyl]-4-yl)-4-chloro-6-phenyl-1,3,5-triazine.
MS[M+H]⁺=613

### <Preparation Example 1-5> Synthesis of Compound E5

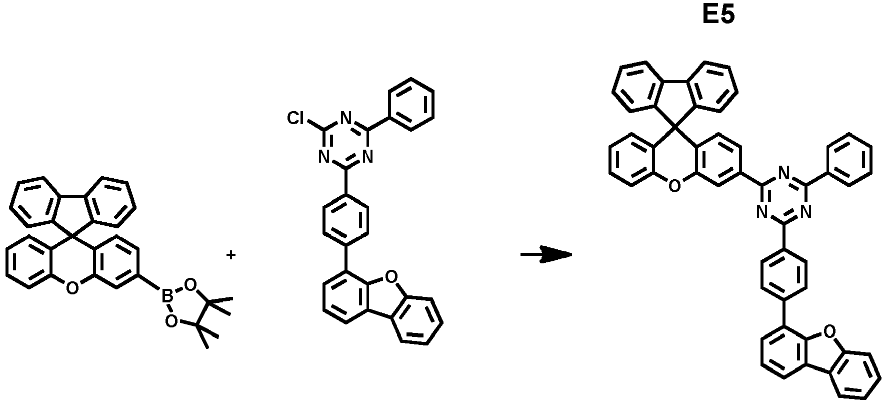

Compound E5 was prepared in the same manner as in Preparation Example 1-1 except that 4,4,5,5-tetramethyl-2-(spiro[fluorene-9,9'-xanthene]-3'-yl)-1,3,2-dioxaborolane was used instead of the compound 4,4,5,5-tetramethyl-2-(spiro[fluorene-9,9'-xanthen]-2'-yl)-1,3,2-dioxaborolane, and 2-chloro-4-(4-(dibenzo[b,d]furan-4-yl)phenyl)-6-phenyl-1,3,5-triazine was used instead of the compound 2-([1,1'-biphenyl]-4-yl)-4-chloro-6-phenyl-1,3,5-triazine.
MS[M+H]⁺=730

### <Preparation Example 1-6> Synthesis of Compound E6

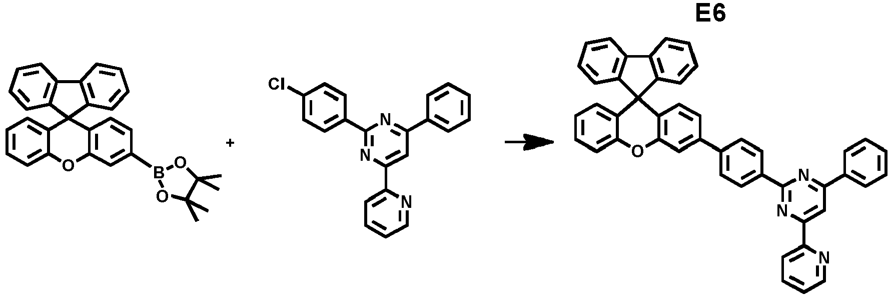

Compound E6 was prepared in the same manner as in Preparation Example 1-5 except that 2-(4-chlorophenyl)-4-phenyl-6-(pyridin-2-yl)pyrimidine was used instead of the compound 2-chloro-4-(4-(dibenzo[b,d]furan-4-yl)phenyl)-6-phenyl-1,3,5-triazine.
MS[M+H]⁺=640

### <Preparation Example 1-7> Synthesis of Compound E7

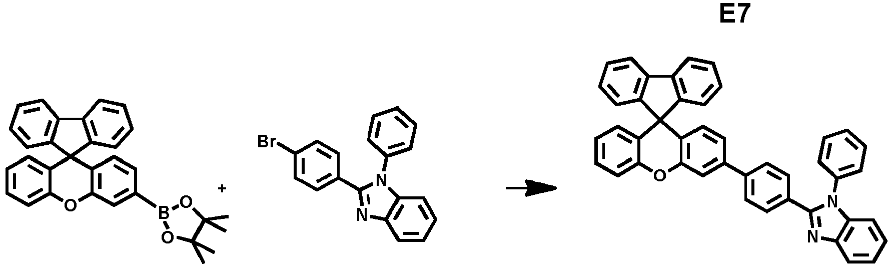

Compound E7 was prepared in the same manner as in Preparation Example 1-5 except that 2-(4-bromophenyl)-1-phenyl-1H-benzo[d]imidazole was used instead of the compound 2-chloro-4-(4-(dibenzo[b,d]furan-4-yl)phenyl)-6-phenyl-1,3,5-triazine.
MS[M+H]⁺=601

### <Preparation Example 1-8> Synthesis of Compound E8

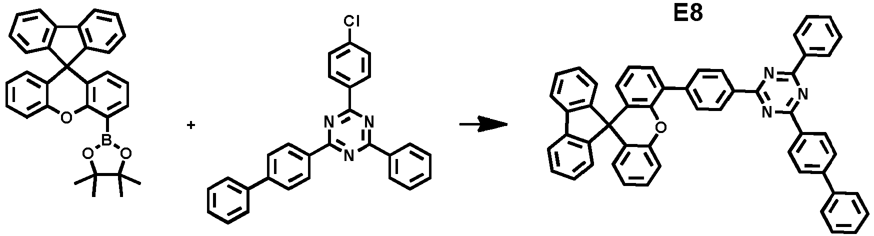

Compound E8 was prepared in the same manner as in Preparation Example 1-1 except that 4,4,5,5-tetramethyl-2-(spiro[fluorene-9,9'-xanthene]-4'-yl)-1,3,2-dioxaborolane was used instead of the compound 4,4,5,5-tetramethyl-2-(spiro[fluorene-9,9'-xanthen]-2'-yl)-1,3,2-dioxaborolane, and 2-([1,1'-biphenyl]-4-yl)-4-(4-chlorophenyl)-6-phenyl-1,3,5-triazine was used instead of the compound 2-([1,1'-biphenyl]-4-yl)-4-chloro-6-phenyl-1,3,5-triazine.
MS[M+H]⁺=716

### <Preparation Example 1-9> Synthesis of Compound E9

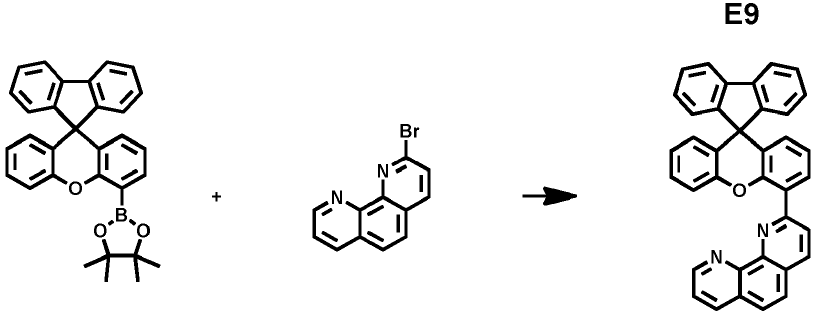

Compound E9 was prepared in the same manner as in Preparation Example 1-8 except that 2-bromo-1,10-phenanthroline was used instead of the compound 2-([1,1'-biphenyl]-4-yl)-4-(4-chlorophenyl)-6-phenyl-1,3,5-triazine.
MS[M+H]⁺=511

### <Preparation Example 1-10> Synthesis of Compound E10

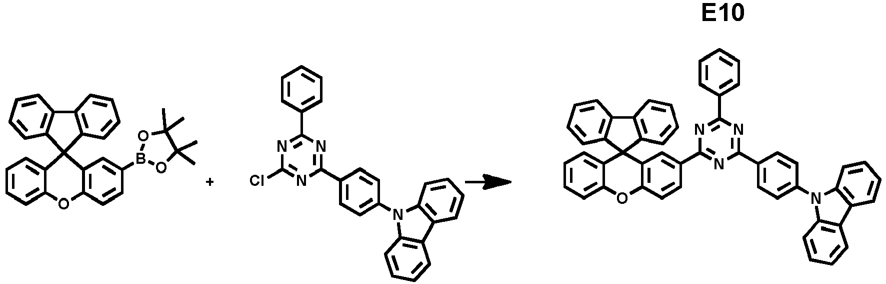

Compound E10 was prepared in the same manner as in Preparation Example 1-1 except that 9-(4-(4-chloro-6-phenyl-1,3,5-triazin-2-yl)phenyl)-9H-carbazole was used instead of the compound 2-([1,1'-biphenyl]-4-yl)-4-chloro-6-phenyl-1,3,5-triazine.
MS[M+H]⁺=729

### <Preparation Example 1-11> Synthesis of Compound E11

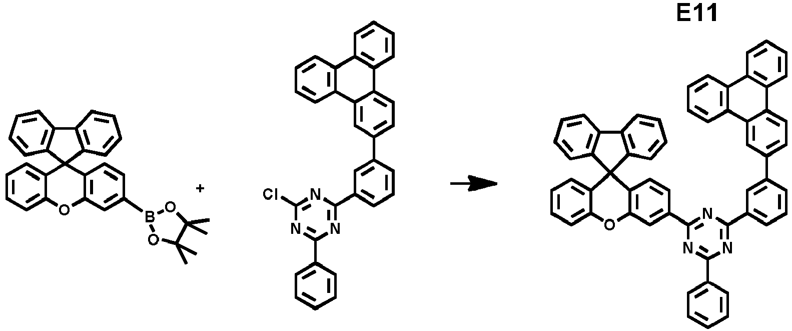

Compound E11 was prepared in the same manner as in Preparation Example 1-5 except that 2-chloro-4-phenyl-6-(3-(triphenylen-2-yl)phenyl)-1,3,5-triazine was used instead of the compound 2-chloro-4-(4-(dibenzo[b,d]furan-4-yl)phenyl)-6-phenyl-1,3,5-triazine.
MS[M+H]⁺=790

### <Preparation Example 1-12> Synthesis of Compound E12

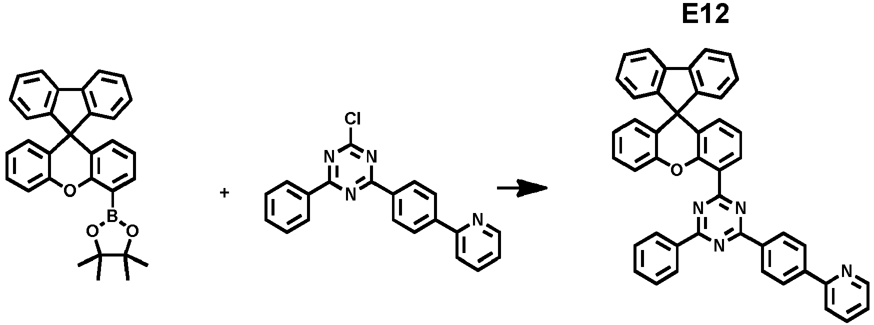

Compound E12 was prepared in the same manner as in Preparation Example 1-8 except that 2-chloro-4-phenyl-6-(4-(pyridin-2-yl)phenyl)-1,3,5-triazine was used instead of the compound 2-([1,1'-biphenyl]-4-yl)-4-(4-chlorophenyl)-6-phenyl-1,3,5-triazine.
MS[M+H]⁺=641

### <Preparation Example 1-13> Synthesis of Compound E13

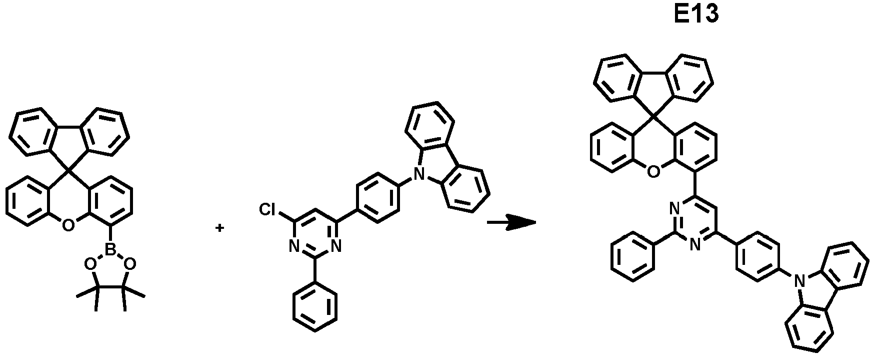

Compound E13 was prepared in the same manner as in Preparation Example 1-8 except that 9-(4-(6-chloro-2-phenylpyridin-4-yl)phenyl)-9H-carbazole was used instead of the compound 2-([1,1'-biphenyl]-4-yl)-4-(4-chlorophenyl)-6-phenyl-1,3,5-triazine.
MS[M+H]⁺=728

### <Preparation Example 1-14> Synthesis of Compound E14

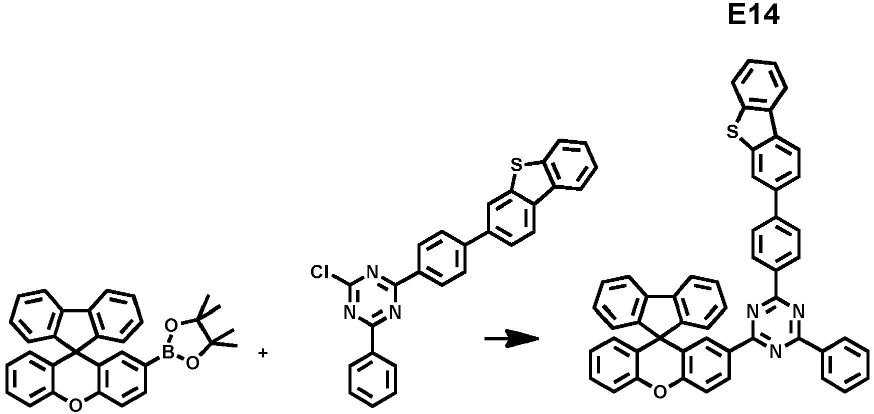

Compound E14 was prepared in the same manner as in Preparation Example 1-1 except that 2-chloro-4-(4-(dibenzo[b,d]thiophen-3-yl)phenyl)-6-phenyl-1,3,5-triazine was used instead of the compound 2-([1,1'-biphenyl]-4-yl)-4-chloro-6-phenyl-1,3,5-triazine.
MS[M+H]⁺=746

### <Preparation Example 1-15> Synthesis of Compound E15

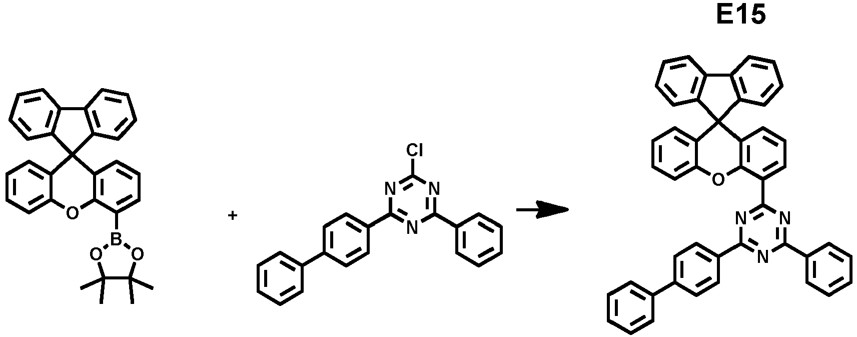

Compound E15 was prepared in the same manner as in Preparation Example 1-8 except that 2-([1,1'-biphenyl]-4-yl)-4-chloro-6-phenyl-1,3,5-triazine was used instead of the compound 2-([1,1'-biphenyl]-4-yl)-4-(4-chlorophenyl)-6-phenyl-1,3,5-triazine.
MS[M+H]⁺=640

### <Preparation Example 1-16> Synthesis of Compound E16

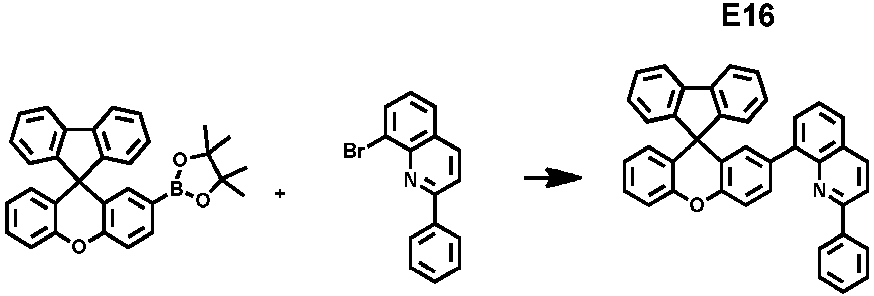

Compound E16 was prepared in the same manner as in Preparation Example 1-1 except that each starting material was as in the above-described reaction formula.
MS[M+H]⁺=536

### <Preparation Example 1-17> Synthesis of Compound E17

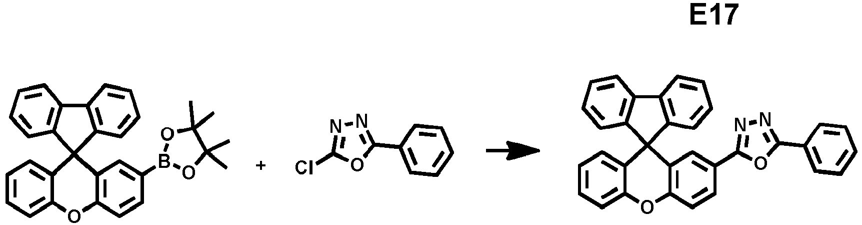

Compound E17 was prepared in the same manner as in Preparation Example 1-1 except that each starting material was as in the above-described reaction formula.
MS[M+H]⁺=477

### <Preparation Example 1-18> Synthesis of Compound E18

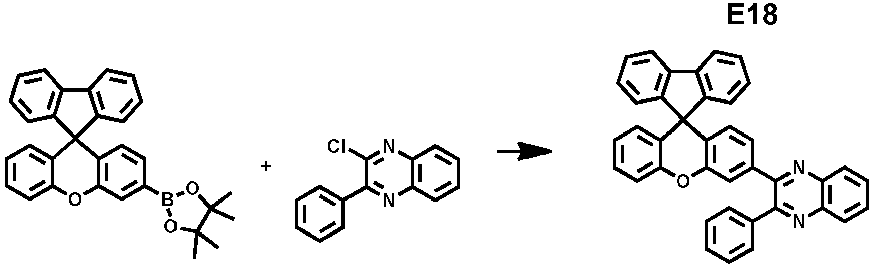

Compound E18 was prepared in the same manner as in Preparation Example 1-1 except that each starting material was as in the above-described reaction formula.
MS[M+H]⁺=537

### <Preparation Example 1-19> Synthesis of Compound E19

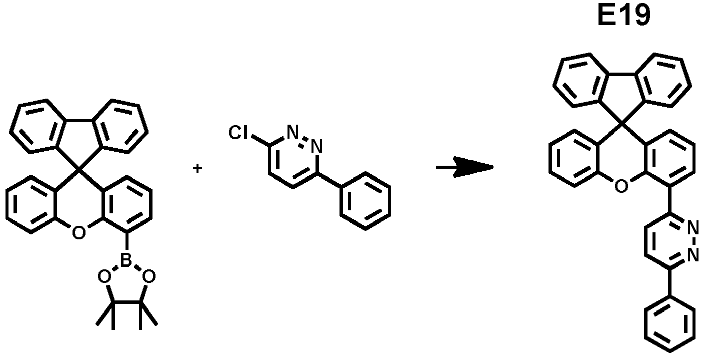

Compound E19 was prepared in the same manner as in Preparation Example 1-1 except that each starting material was as in the above-described reaction formula.
MS[M+H]⁺=487

### <Preparation Example 1-20> Synthesis of Compound E20

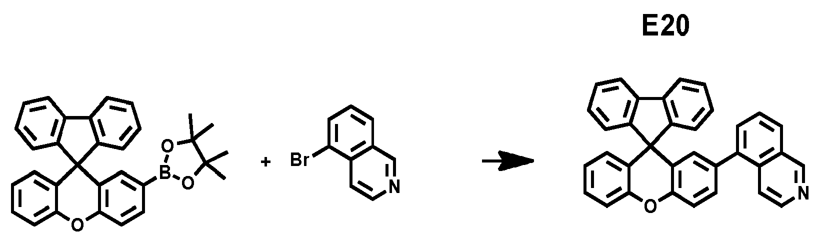

Compound E20 was prepared in the same manner as in Preparation Example 1-1 except that each starting material was as in the above-described reaction formula.
MS[M+H]⁺=460

### <Preparation Example 1-21> Synthesis of Compound E21

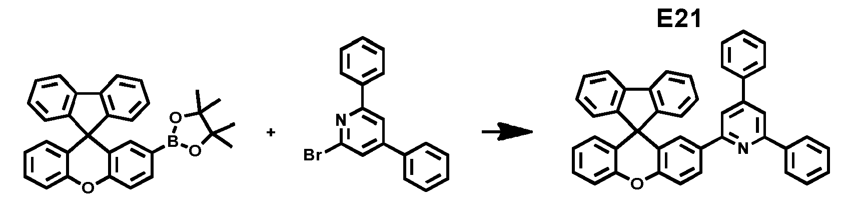

Compound E21 was prepared in the same manner as in Preparation Example 1-1 except that each starting material was as in the above-described reaction formula. MS[M+H]⁺=562

### <Preparation Example 1-22> Synthesis of Compound E22

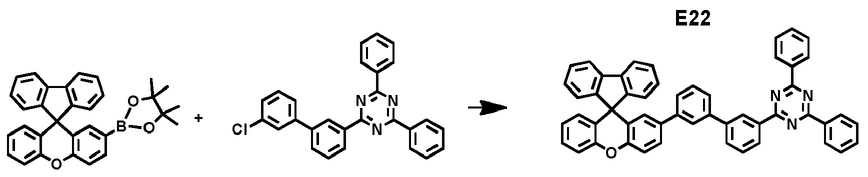

Compound E22 was prepared in the same manner as in Preparation Example 1-1 except that each starting material was as in the above-described reaction formula.
MS[M+H]⁺=716

### <Preparation Example 1-23> Synthesis of Compound E23

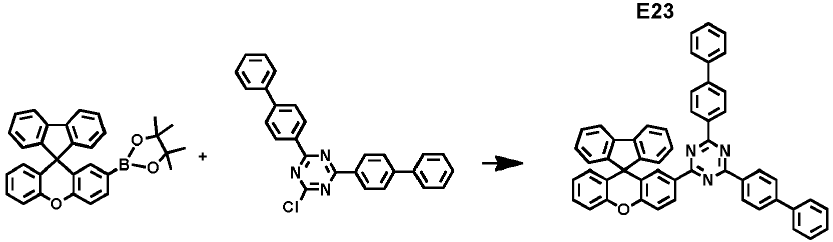

Compound E23 was prepared in the same manner as in Preparation Example 1-1 except that each starting material was as in the above-described reaction formula.
MS[M+H]⁺=716

### <Preparation Example 2-1> Synthesis of Compound F1

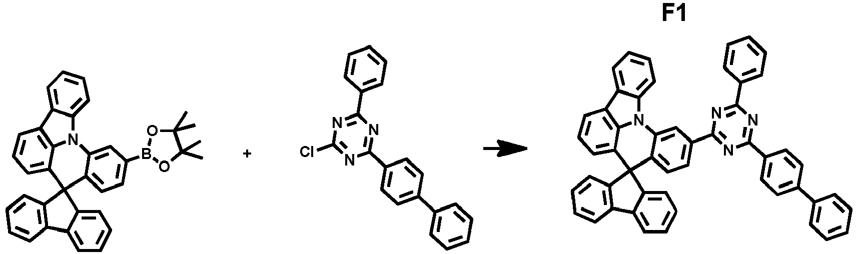

Compound **F1** was prepared in the same manner as in Preparation Example 1-1 except that each starting material was as in the above-described reaction formula.
MS[M+H]⁺=713

### <Preparation Example 2-2> Synthesis of Compound F2

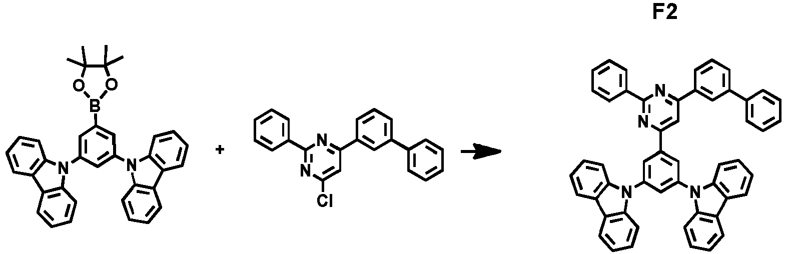

Compound F2 was prepared in the same manner as in Preparation Example 1-1 except that each starting material was as in the above-described reaction formula.
MS[M+H]⁺=715

### <Preparation Example 2-3> Synthesis of Compound F3

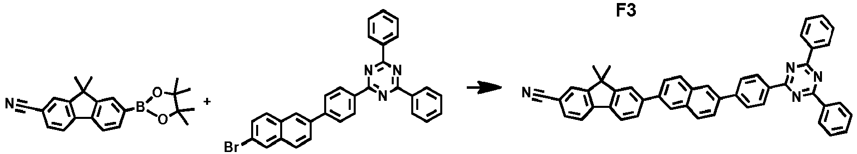

Compound F3 was prepared in the same manner as in Preparation Example 1-1 except that each starting material was as in the above-described reaction formula.
MS[M+H]⁺=653

### <Preparation Example 2-4> Synthesis of Compound F4

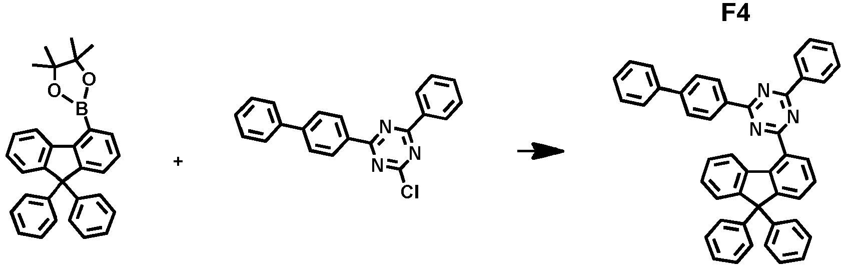

Compound F4 was prepared in the same manner as in Preparation Example 1-1 except that each starting material was as in the above-described reaction formula.
MS[M+H]⁺=626

### <Preparation Example 2-5> Synthesis of Compound F5

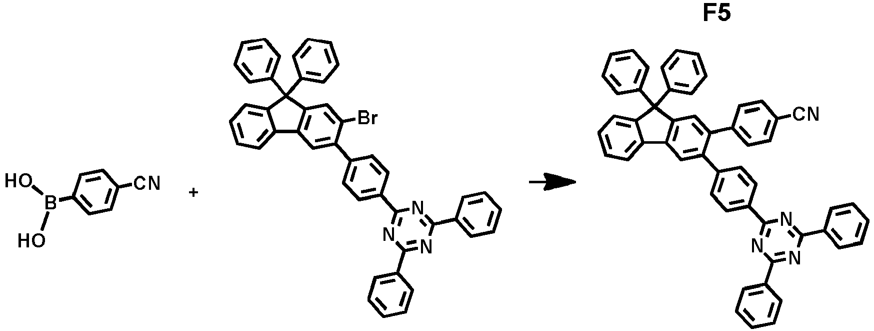

Compound F5 was prepared in the same manner as in Preparation Example 1-1 except that each starting material was as in the above-described reaction formula.
MS[M+H]⁺=727

### <Example 1-1>

A glass substrate on which indium tin oxide (ITO) was coated as a thin film to a thickness of 1,000 Å was placed in detergent-dissolved distilled water and ultrasonic cleaned. Herein, a product of Fischer Co. was used as the detergent, and as the distilled water, distilled water filtered twice with a filter manufactured by Millipore Co. was used. After the ITO was cleaned for 30 minutes, ultrasonic cleaning was repeated twice using distilled water for 10 minutes. After the cleaning with distilled water was finished, the substrate was ultrasonic cleaned with solvents of isopropyl alcohol, acetone and methanol, then dried, and then transferred to a plasma cleaner. In addition, the substrate was cleaned for 5 minutes using oxygen plasma, and then transferred to a vacuum depositor.

On the transparent ITO electrode prepared as above, a hole injection layer was formed by thermal vacuum depositing the following compound [HI-A] to a thickness of 600 Å. A hole transfer layer was formed on the hole injection layer by vacuum depositing hexaazatriphenylene (HAT) of the following chemical formula to 50 Å and the following compound [HT-A] (600 Å) in consecutive order.

Subsequently, a light emitting layer was formed on the hole transfer layer to a film thickness of 200 Å by vacuum depositing the following compounds [BH] and [BD] in a weight ratio of 25:1.

An electron control layer was formed on the light emitting layer to a thickness of 50 Å by vacuum depositing [Compound E1]. On the electron control layer, an electron transfer layer was formed to a thickness of 300 Å by vacuum depositing [Compound F1] and the following lithium quinolate [LiQ] compound in a weight ratio of 1:1. A cathode was formed on the electron transfer layer by depositing lithium fluoride (LiF) to a thickness of 10 Å and aluminum to a thickness of 1,000 Å in consecutive order.

An organic light emitting device was manufactured by maintaining, in the above-mentioned processes, the deposition rates of the organic materials at 0.4 Å/sec to 0.9 Å/sec, the deposition rates of the lithium fluoride and the aluminum of the cathode at 0.3 Å/sec and 2 Å/sec, respectively, and the degree of vacuum during the deposition at 1×10⁻⁷ torr to 5×10⁻⁸ torr.

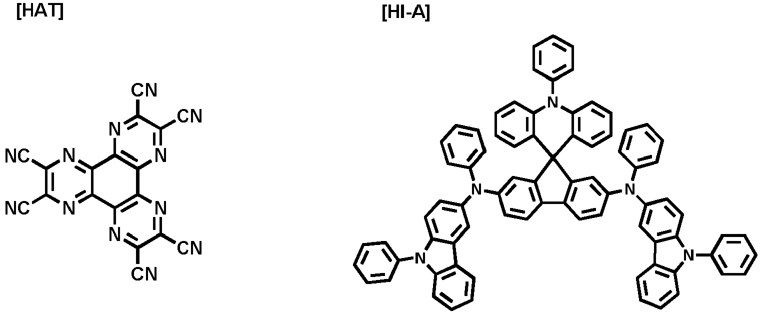

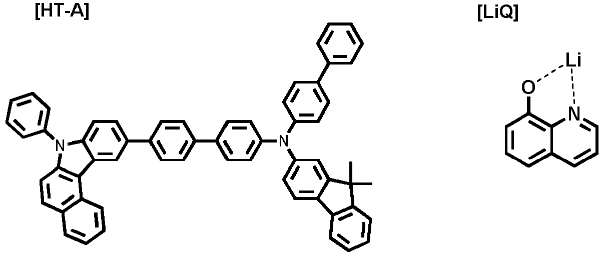

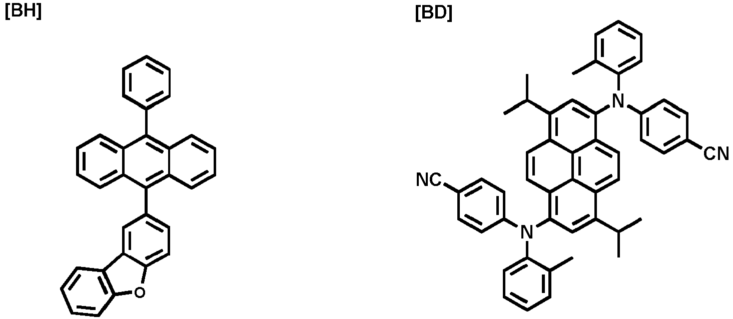

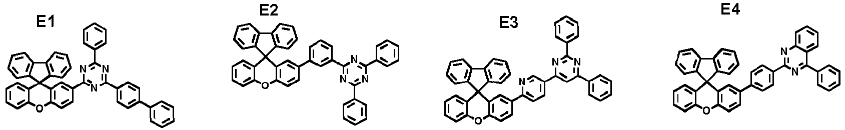

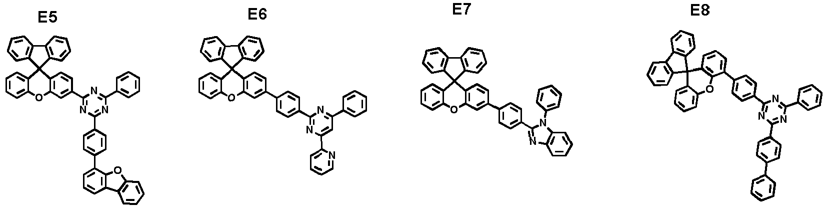

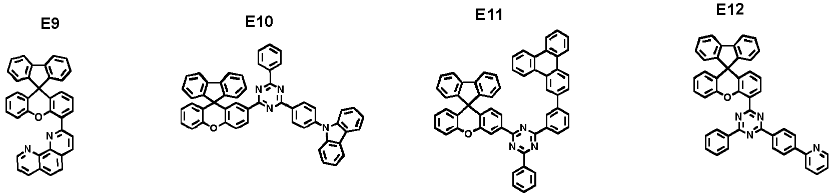

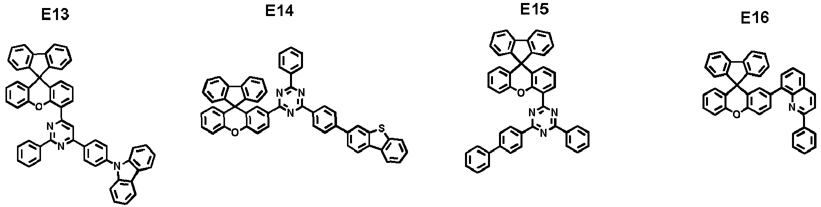

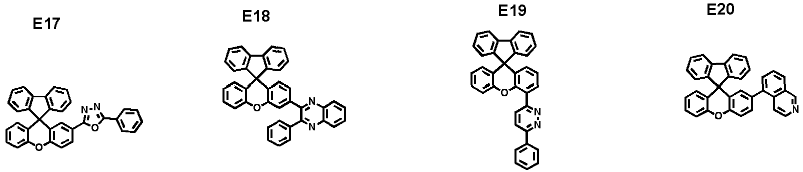

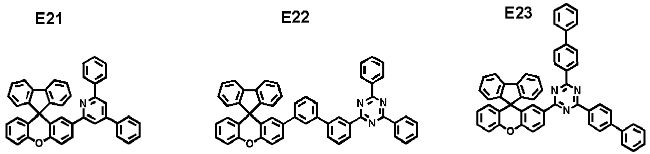

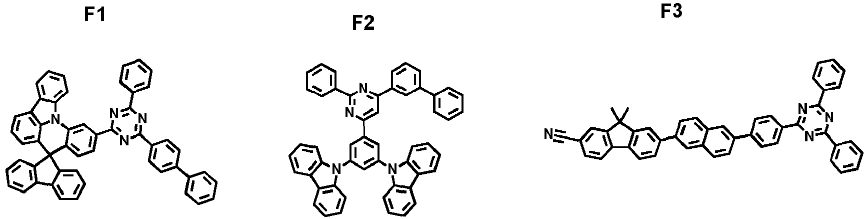

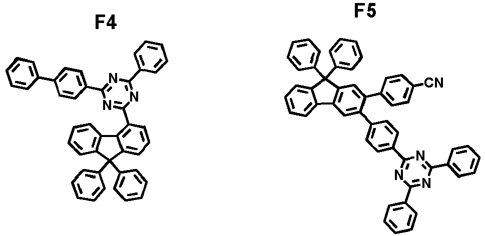

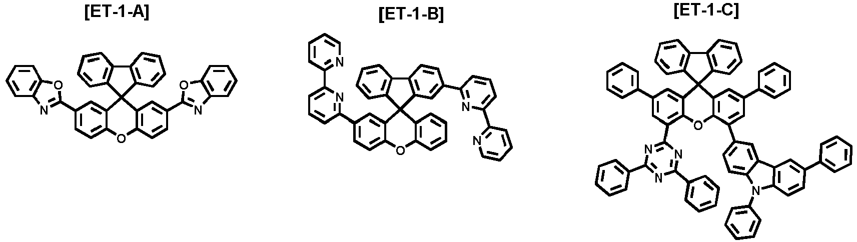

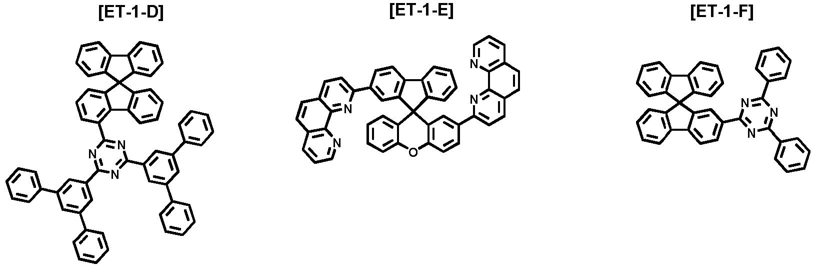

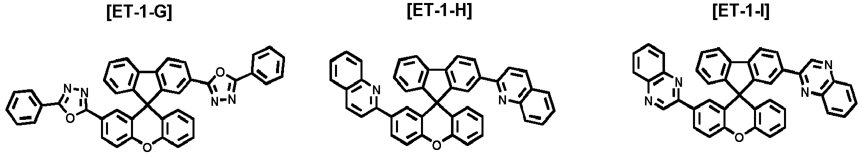

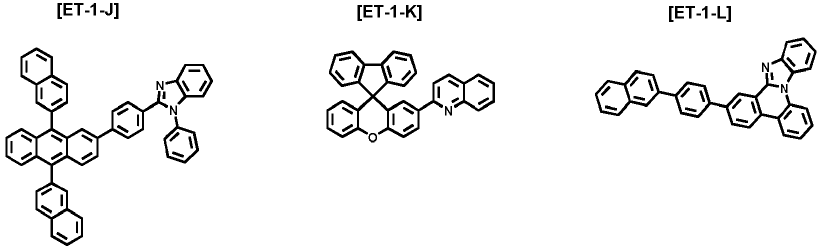

### <Example 1-2>

An organic light emitting device was manufactured in the same manner as in Example 1-1 except that Compound E2 was used instead of Compound E1.

### <Example 1-3>

An organic light emitting device was manufactured in the same manner as in Example 1-1 except that Compound E3 was used instead of Compound E1.

### <Example 1-4>

An organic light emitting device was manufactured in the same manner as in Example 1-1 except that Compound E4 was used instead of Compound E1.

### <Example 1-5>

An organic light emitting device was manufactured in the same manner as in Example 1-1 except that Compound F2 was used instead of Compound F1.

### <Example 1-6>

An organic light emitting device was manufactured in the same manner as in Example 1-2 except that Compound F2 was used instead of Compound F1.

### <Example 1-7>

An organic light emitting device was manufactured in the same manner as in Example 1-3 except that Compound F2 was used instead of Compound F1.

### <Example 1-8>

An organic light emitting device was manufactured in the same manner as in Example 1-4 except that Compound F2 was used instead of Compound F1.

### <Example 1-9>

An organic light emitting device was manufactured in the same manner as in Example 1-1 except that Compound F3 was used instead of Compound F1.

### <Example 1-10>

An organic light emitting device was manufactured in the same manner as in Example 1-2 except that Compound F3 was used instead of Compound F1.

### <Example 1-11>

An organic light emitting device was manufactured in the same manner as in Example 1-3 except that Compound F3 was used instead of Compound F1.

### <Example 1-12>

An organic light emitting device was manufactured in the same manner as in Example 1-4 except that Compound F3 was used instead of Compound F1.

### <Example 1-13>

An organic light emitting device was manufactured in the same manner as in Example 1-1 except that Compound F4 was used instead of Compound F1.

### <Example 1-14>

An organic light emitting device was manufactured in the same manner as in Example 1-2 except that Compound F4 was used instead of Compound F1.

### <Example 1-15>

An organic light emitting device was manufactured in the same manner as in Example 1-3 except that Compound F4 was used instead of Compound F1.

### <Example 1-16>

An organic light emitting device was manufactured in the same manner as in Example 1-4 except that Compound F4 was used instead of Compound F1.

### <Example 1-17>

An organic light emitting device was manufactured in the same manner as in Example 1-1 except that Compound F5 was used instead of Compound F1.

### <Example 1-18>

An organic light emitting device was manufactured in the same manner as in Example 1-2 except that Compound F5 was used instead of Compound F1.

### <Example 1-19>

An organic light emitting device was manufactured in the same manner as in Example 1-3 except that Compound F5 was used instead of Compound F1.

### <Example 1-20>

An organic light emitting device was manufactured in the same manner as in Example 1-4 except that Compound F5 was used instead of Compound F1.

### <Example 1-21>

An organic light emitting device was manufactured in the same manner as in Example 1-1 except that Compound E5 was used instead of Compound E1.

### <Example 1-22>

An organic light emitting device was manufactured in the same manner as in Example 1-1 except that Compound E6 was used instead of Compound E1.

### <Example 1-23>

An organic light emitting device was manufactured in the same manner as in Example 1-1 except that Compound E7 was used instead of Compound E1.

### <Example 1-24>

An organic light emitting device was manufactured in the same manner as in Example 1-1 except that Compound E8 was used instead of Compound E1.

### <Example 1-25>

An organic light emitting device was manufactured in the same manner as in Example 1-5 except that Compound E9 was used instead of Compound E1.

### <Example 1-26>

An organic light emitting device was manufactured in the same manner as in Example 1-5 except that Compound E10 was used instead of Compound E1.

### <Example 1-27>

An organic light emitting device was manufactured in the same manner as in Example 1-5 except that Compound E11 was used instead of Compound E1.

### <Example 1-28>

An organic light emitting device was manufactured in the same manner as in Example 1-5 except that Compound E12 was used instead of Compound E1.

### <Example 1-29>

An organic light emitting device was manufactured in the same manner as in Example 1-9 except that Compound E13 was used instead of Compound E1.

### <Example 1-30>

An organic light emitting device was manufactured in the same manner as in Example 1-9 except that Compound E14 was used instead of Compound E1.

### <Example 1-31>

An organic light emitting device was manufactured in the same manner as in Example 1-9 except that Compound E15 was used instead of Compound E1.

### <Example 1-32>

An organic light emitting device was manufactured in the same manner as in Example 1-9 except that Compound E16 was used instead of Compound E1.

### <Example 1-33>

An organic light emitting device was manufactured in the same manner as in Example 1-13 except that Compound E17 was used instead of Compound E1.

### <Example 1-34>

An organic light emitting device was manufactured in the same manner as in Example 1-13 except that Compound E18 was used instead of Compound E1.

### <Example 1-35>

An organic light emitting device was manufactured in the same manner as in Example 1-13 except that Compound E19 was used instead of Compound E1.

### <Example 1-36>

An organic light emitting device was manufactured in the same manner as in Example 1-13 except that Compound E20 was used instead of Compound E1.

### <Example 1-37>

An organic light emitting device was manufactured in the same manner as in Example 1-17 except that Compound E21 was used instead of Compound E1.

### <Example 1-38>

An organic light emitting device was manufactured in the same manner as in Example 1-17 except that Compound E22 was used instead of Compound E1.

### <Example 1-39>

An organic light emitting device was manufactured in the same manner as in Example 1-17 except that Compound E23 was used instead of Compound E1.

### <Comparative Example 1-1>

An organic light emitting device was manufactured in the same manner as in Example 1-1 except that Compound ET-1-A was used instead of Compound E1.

### <Comparative Example 1-2>

An organic light emitting device was manufactured in the same manner as in Example 1-1 except that Compound ET-1-B was used instead of Compound E1.

### <Comparative Example 1-3>

An organic light emitting device was manufactured in the same manner as in Example 1-1 except that Compound ET-1-C was used instead of Compound E1.

### <Comparative Example 1-4>

An organic light emitting device was manufactured in the same manner as in Example 1-5 except that Compound ET-1-D was used instead of Compound E1.

### <Comparative Example 1-5>

An organic light emitting device was manufactured in the same manner as in Example 1-5 except that Compound ET-1-E was used instead of Compound E1.

### <Comparative Example 1-6>

An organic light emitting device was manufactured in the same manner as in Example 1-9 except that Compound ET-1-F was used instead of Compound E1.

### <Comparative Example 1-7>

An organic light emitting device was manufactured in the same manner as in Example 1-13 except that Compound ET-1-G was used instead of Compound E1.

### <Comparative Example 1-8>

An organic light emitting device was manufactured in the same manner as in Example 1-13 except that Compound ET-1-H was used instead of Compound E1.

### <Comparative Example 1-9>

An organic light emitting device was manufactured in the same manner as in Example 1-13 except that Compound ET-1-I was used instead of Compound E1.

### <Comparative Example 1-10>

An organic light emitting device was manufactured in the same manner as in Example 1-17 except that Compound ET-1-J was used instead of Compound E1.

### <Comparative Example 1-11>

An organic light emitting device was manufactured in the same manner as in Example 1-13 except that Compound ET-1-K was used instead of Compound E1.

### <Comparative Example 1-12>

An organic light emitting device was manufactured in the same manner as in Example 1-1 except that Compound ET-1-L was used instead of Compound F1.

### <Comparative Example 1-13>

An organic light emitting device was manufactured in the same manner as in Example 1-2 except that Compound ET-1-L was used instead of Compound F1.

### <Comparative Example 1-14>

An organic light emitting device was manufactured in the same manner as in Example 1-3 except that Compound ET-1-L was used instead of Compound F1.

### <Comparative Example 1-15>

An organic light emitting device was manufactured in the same manner as in Example 1-4 except that Compound ET-1-L was used instead of Compound F1.

### <Comparative Example 1-16>

An organic light emitting device was manufactured in the same manner as in Example 1-1 except that the electron transfer layer was formed to a thickness of 360 Å by vacuum depositing Compound F1 and LiQ in a weight ratio of 1:1 without the electron control layer.

### <Comparative Example 1-17>

An organic light emitting device was manufactured in the same manner as in Comparative Example 1-16 except that Compound F2 was used instead of Compound F1.

### <Comparative Example 1-18>

An organic light emitting device was manufactured in the same manner as in Comparative Example 1-16 except that Compound F3 was used instead of Compound F1.

### <Comparative Example 1-19>

An organic light emitting device was manufactured in the same manner as in Comparative Example 1-16 except that Compound F4 was used instead of Compound F1.

### <Comparative Example 1-20>

An organic light emitting device was manufactured in the same manner as in Comparative Example 1-16 except that Compound F5 was used instead of Compound F1.

For the organic light emitting devices manufactured using the methods of Examples 1-1 to 1-39 and Comparative Examples 1-1 to 1-20 described above, a driving voltage and light emission efficiency were measured at current density of 10 mA/cm², and time taken for the luminance decreasing to 90% compared to its initial luminance (T₉₀) was measured at current density of 20 mA/cm². The results are shown in the following Table 1.

**[Table 1]**

| | Compound (Electron control layer) | Compound (Electron Transfer Layer) | Voltage (V@10 mA/cm²) | Efficiency (cd/A@10 mA/cm²) | Color Coordinate (x,y) | Lifetime (h) T₉₀ at 20 mA/Cm² |
|---|---|---|---|---|---|---|
| Example 1-1 | E1 | F1 | 3.8 | 5.8 | (0.142, 0.097) | 300 |
| Example 1-2 | E2 | F1 | 3.75 | 5.82 | (0.142, 0.096) | 295 |
| Example 1-3 | E3 | F1 | 3.70 | 5.90 | (0.142, 0.096) | 280 |
| Example 1-4 | E4 | F1 | 3.91 | 5.66 | (0.142, 0.096) | 275 |
| Example 1-5 | E1 | F2 | 3.76 | 5.83 | (0.142, 0.096) | 299 |
| Example | E2 | F2 | 3.74 | 5.84 | (0.142, | 290 |
| 1-6 | | | | | 0.097) | |
| Example 1-7 | E3 | F2 | 3.69 | 5.92 | (0.142, 0.096) | 277 |
| Example 1-8 | E4 | F2 | 3.90 | 5.68 | (0.142, 0.099) | 269 |
| Example 1-9 | E1 | F3 | 3.76 | 5.80 | (0.142, 0.096) | 323 |
| Example 1-10 | E2 | F3 | 3.76 | 5.80 | (0.142, 0.098) | 314 |
| Example 1-11 | E3 | F3 | 3.75 | 5.91 | (0.142, 0.097) | 299 |
| Example 1-12 | E4 | F3 | 3.90 | 5.69 | (0.142, 0.096) | 277 |
| Example 1-13 | E1 | F4 | 3.75 | 5.81 | (0.142, 0.097) | 300 |
| Example 1-14 | E2 | F4 | 3.7 | 5.82 | (0.142, 0.097) | 291 |
| Example 1-15 | E3 | F4 | 3.76 | 5.89 | (0.142, 0.097) | 282 |
| Example 1-16 | E4 | F4 | 3.89 | 5.68 | (0.142, 0.097) | 268 |
| Example 1-17 | E1 | F5 | 3.75 | 5.82 | (0.142, 0.097) | 319 |
| Example 1-18 | E2 | F5 | 3.72 | 5.84 | (0.142, 0.096) | 311 |
| Example 1-19 | E3 | F5 | 3.75 | 5.90 | (0.142, 0.096) | 302 |
| Example 1-20 | E4 | F5 | 3.91 | 5.65 | (0.142, 0.096) | 278 |
| Example 1-21 | E5 | F1 | 3.80 | 5.75 | (0.142, 0.096) | 330 |
| Example 1-22 | E6 | F1 | 3.82 | 5.77 | (0.142, 0.098) | 312 |
| Example 1-23 | E7 | F1 | 3.92 | 5.62 | (0.142, 0.102) | 270 |
| Example | E8 | F1 | 3.75 | 3.86 | (0.142, | 320 |
| 1-24 | | | | | 0.096) | |
| Example 1-25 | E9 | F2 | 3.89 | 5.63 | (0.142, 0.096) | 260 |
| Example 1-26 | E10 | F2 | 3.85 | 5.74 | (0.142, 0.096) | 327 |
| Example 1-27 | E11 | F2 | 3.76 | 3.75 | (0.142, 0.096) | 308 |
| Example 1-28 | E12 | F2 | 3.74 | 5.74 | (0.142, 0.096) | 319 |
| Example 1-29 | E13 | F3 | 3.77 | 5.88 | (0.142, 0.096) | 311 |
| Example 1-30 | E14 | F3 | 3.80 | 5.70 | (0.142, 0.096) | 340 |
| Example 1-31 | E15 | F3 | 3.75 | 5.83 | (0.142, 0.096) | 326 |
| Example 1-32 | E16 | F3 | 3.79 | 5.76 | (0.142, 0.097) | 331 |
| Example 1-33 | E17 | F4 | 3.82 | 5.62 | (0.142, 0.096) | 265 |
| Example 1-34 | E18 | F4 | 3.81 | 5.63 | (0.142, 0.096) | 266 |
| Example 1-35 | E19 | F4 | 3.76 | 5.78 | (0.142, 0.096) | 300 |
| Example 1-36 | E20 | F4 | 3.83 | 5.60 | (0.142, 0.096) | 261 |
| Example 1-37 | E21 | F5 | 3.84 | 5.66 | (0.142, 0.097) | 277 |
| Example 1-38 | E22 | F5 | 3.69 | 5.92 | (0.142, 0.096) | 299 |
| Example 1-39 | E23 | F5 | 3.71 | 5.80 | (0.142, 0.097) | 307 |
| Comparative Example 1-1 | ET-1-A | F1 | 4.81 | 3.78 | (0.142, 0.096) | 75 |
| Comparative Example 1-2 | ET-1-B | F1 | 4.88 | 3.99 | (0.142, | 79 |
| Comparative Example 1-3 | ET-1-C | F1 | 4.99 | 3.80 | (0.142, 0.097) | 83 |
| Comparative Example 1-4 | ET-1-D | F2 | 4.75 | 4.00 | (0.142, 0.096) | 55 |
| Comparative Example 1-5 | ET-1-E | F2 | 5.02 | 3.50 | (0.142, 0.097) | 65 |
| Comparative Example 1-6 | ET-1-F | F3 | 4.70 | 4.22 | (0.142, 0.097) | 41 |
| Comparative Example 1-7 | ET-1-G | F4 | 5.44 | 3.00 | (0.142, 0.097) | 60 |
| Comparative Example 1-8 | ET-1-H | F4 | 5.48 | 3.01 | (0.142, 0.097) | 52 |
| Comparative Example 1-9 | ET-1-I | F4 | 5.58 | 3.02 | (0.142, 0.097) | 50 |
| Comparative Example 1-10 | ET-1-J | F5 | 5.50 | 3.89 | (0.142, 0.096) | 70 |
| Comparative Example 1-11 | ET-1-K | F4 | 5.01 | 4.10 | (0.142, 0.096) | 88 |
| Comparative Example 1-12 | E1 | ET-1-L | 4.00 | 4.94 | (0.142, 0.096) | 77 |
| Comparative Example 1-13 | E2 | ET-1-L | 4.01 | 4.87 | (0.142, 0.096) | 68 |
| Comparative Example 1-14 | E3 | ET-1-L | 4.21 | 4.61 | (0.142, 0.096) | 89 |
| Comparative Example 1-15 | E4 | ET-1-L | 4.55 | 4.00 | (0.142, 0.096) | 57 |
| Comparative Example 1-16 | - | F1 | 4.00 | 4.01 | (0.142, 0.096) | 200 |
| Comparative Example 1-17 | - | F2 | 4.03 | 4.00 | (0.142, 0.096) | 204 |
| Comparative Example 1-18 | - | F3 | 4.00 | 4.10 | (0.142, 0.096) | 224 |
| Comparative Example 1-19 | - | F4 | 4.01 | 4.22 | (0.142, 0.096) | 180 |
| Comparative Example 1-20 | - | F5 | 4.01 | 4.15 | (0.142, 0.096) | 217 |

Based on the results of Table 1, it was identified that, when comparing Examples 1-1 to 1-39 with Comparative Examples 1-1, 1-2, 1-3, 1-5, 1-7, 1-8 and 1-9, the compound in which only one heteroaryl group substitutes in the spiro fluorene xanthen skeleton as in Chemical Formula 1 had excellent properties in terms of driving voltage, efficiency and lifetime in an organic light emitting device compared to the compound having two or more substituents in the spiro fluorene xanthen skeleton.

When referring to FIG. 10 and FIG. 11 presenting 3D structures of Compounds E9 and E18 according to one embodiment of the present specification, it was identified that the molecules of the compounds had a horizontal structure, and when referring to FIG. 12 and FIG. 13 presenting 3D structures of Compounds ET-1-E and ET-1-I, it was identified that the A axis and the B axis were almost perpendicular to each other in each compound, and the molecule was very out of a horizontal structure.

As a result, when comparing FIG. 10 and FIG. 11 presenting 3D structures of Compounds E9 and E18 according to one embodiment of the present specification and FIG. 12 and FIG. 13 presenting 3D structures of Compounds ET-1-E and ET-1-I, it was seen that the heterocyclic compound represented by Chemical Formula 1 according to one embodiment of the present specification had a more horizontal structure due to a difference in orientation in the molecular 3D structure. Accordingly, the compound in which only one heteroaryl group substitutes in the spiro fluorene xanthen skeleton as in Chemical Formula 1 of Examples 1-1 to 1-39 had a strong tendency toward a horizontal structure of the molecule compared to the compound having two or more substituents in the spiro fluorene xanthen skeleton resulting in an increase in the electron mobility, and effects of low driving voltage, high efficiency and long lifetime are obtained in an organic light emitting device.

In addition, when comparing Examples 1-1 to 1-39 with Comparative Examples 1-4 and 1-6, it was identified that the structure of Chemical Formula 1 including spiro fluorene xanthen exhibited excellent properties in an organic light emitting device compared to the structure including a spiro fluorene group.

In addition, when comparing Example 1-32 with Comparative Example 1-11, it was identified that, depending on the bonding position of quinoline in spiro fluorene xanthene of the structure of Chemical Formula 1 including the spiro fluorene xanthene, the structure of Chemical Formula 1 in which a benzene ring that does not include N bonds to the spiro fluorene xanthene exhibited more superior properties in the organic light emitting device compared to the compound in which a benzene ring that includes N bonds to spiro fluorene xanthene.

The heterocyclic compound represented by Chemical Formula 1 according to one embodiment of the present specification is capable of having excellent properties by having excellent thermal stability, a deep HOMO level of 6.0 eV or higher, high triplet energy (ET) and hole stability.

In addition, in Examples 1-1 to 1-3, 1-5 to 1-7, 1-9 to 1-11, 1-13 to 1-15, 1-17 to 1-19, 1-21, 1-22, 1-24, 1-26 to 1-31, 1-38 and 1-39, that is, when Ar1 is a triazine group or a pyrimidine group in Chemical Formula 1, the HOMO energy was deep of 6.1 eV or greater, and particularly, a role as the electron control layer (hole blocking layer) was smoothly performed, and excellent properties were obtained in terms of driving voltage, efficiency and lifetime when used in the organic light emitting device due to high electron mobility. Specifically, it was identified that, Examples 1-1 to 1-3, 1-5 to 1-7, 1-9 to 1-11, 1-13 to 1-15, 1-17 to 1-19, 1-21, 1-22, 1-24, 1-26 to 1-31, 1-38 and 1-39 exhibited significantly superior properties in terms of driving voltage, efficiency and lifetime compared to Example 1-37 in which Ar1 is a pyridine group (one N).

Particularly, when comparing Examples 1-1 to 1-39 with Comparative Examples 1-16 to 1-20, it was identified that excellent properties were obtained in the organic light emitting device when using the compound group formed with Chemical Formula 1 as the electron control layer (hole blocking layer) and using the compound formed with Chemical Formula 3 as the electron transfer layer, compared to when using the compound formed with Chemical Formula 3 alone as the electron transfer layer.

Accordingly, the heterocyclic compound represented by Chemical Formula 1 and/or Chemical Formula 3 according to one embodiment of the present specification has low driving voltage and high efficiency, and is capable of enhancing device stability by hole stability of the compound.

### <Example 2>

HOMO energy and LUMO energy values of the following Compound E1 and Compound E2 corresponding to the compound represented by Chemical Formula 1 according to one embodiment of the present specification, Compound F3 corresponding to the compound represented by Chemical Formula 3, and Compounds ET-1-J and ET-1-L of comparative example are shown in the following Table 2.

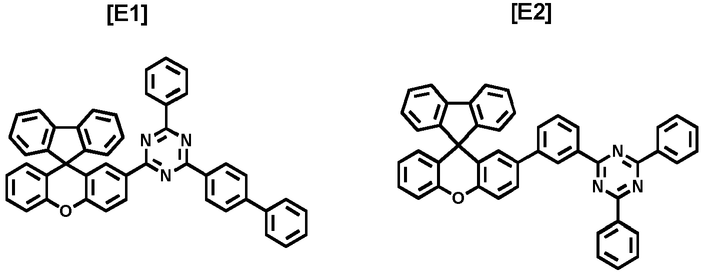

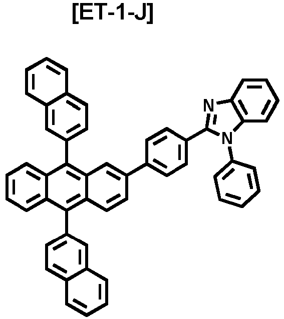

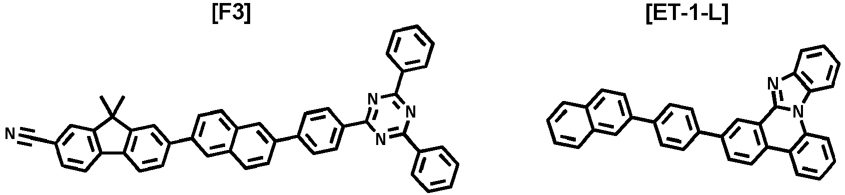

In the Examples of the present specification, the HOMO level was measured using an optoelectronic spectrometer (manufactured by RIKEN KEIKI Co., Ltd.: AC3) under the atmosphere.

In the Examples of the present specification, the LUMO energy level was calculated as a wavelength value measured through photoluminescence (PL).

**[Table 2]**

| Compound | HOMO (eV) | LUMO (eV) |
|---|---|---|
| E1 | 6.20 | 2.70 |
| E2 | 6.16 | 2.92 |
| ET-1-J | 5.70 | 2.87 |
| F3 | 6.10 | 3.16 |
| ET-1-L | 5.78 | 2.89 |

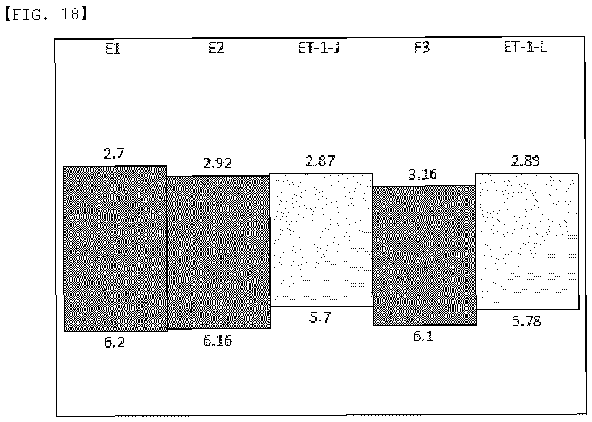

The graph presenting the HOMO energy and the LUMO energy values measured in Example 2 are shown in FIG. 18.

Compounds E1 and E2 had a deep HOMO energy level of 6.0 eV or greater, and specifically, the HOMO energy level was deep of 6.1 eV or greater. It was identified that Compounds E1 and E2 also had a bandgap of 3.0 eV or greater. Accordingly, it was seen that, when using the compound represented by Chemical Formula 1 in the electron control layer (hole block layer) in the organic light emitting device, excellent properties were obtained in terms of driving voltage, efficiency and lifetime due to high electron mobility.

Hereinbefore, preferred embodiments of the present disclosure have been described, however, the present disclosure is not limited thereto, and various modifications may be made within the scope of the claims and detailed descriptions of the disclosure, and these also fall within the category of the disclosure.

### [Reference Numerals]

- 10, 11, 12:: Organic Light Emitting Device
- 20:: Substrate
- 30:: Anode
- 40:: Light Emitting Layer
- 50:: Cathode
- 60:: Hole Injection Layer
- 70:: Hole Transfer Layer
- 80:: Electron Transfer Layer
- 90:: Electron Injection Layer
- 100:: Electron control layer

## Claims

1. An organic light emitting device comprising:
an anode (30);
a cathode (50); and
a light emitting layer (40) provided between the anode (30) and the cathode (50), the device further comprising:
an electron control layer (100) provided between the light emitting layer (40) and the cathode (50) and including a compound represented by the following Chemical Formula 1; and
an electron transfer layer (80) provided between the electron control layer (100) and the cathode (50) and including a compound represented by the following Chemical Formula 3: 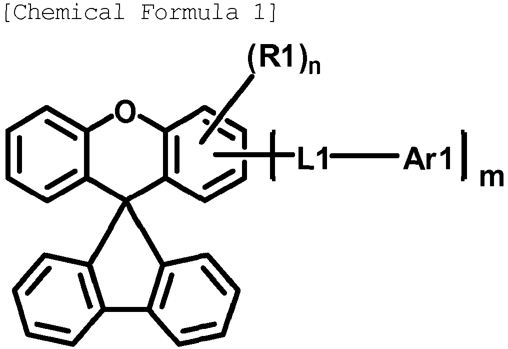 wherein, in Chemical Formula 1,
R1 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group;
L1 is a direct bond; a substituted or unsubstituted arylene group; or a substituted or unsubstituted heteroarylene group;
Ar1 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; a substituted or unsubstituted monocyclic heterocyclic group; a substituted or unsubstituted tricyclic or higher heterocyclic group; a substituted or unsubstituted dicyclic heterocyclic group including two or more Ns; a substituted or unsubstituted isoquinolyl group; or a structure represented by the following Chemical Formula 2;
m is an integer of 1 to 4, n is an integer of 0 to 3, and 1≤n+m≤4; and
when m and n are each an integer of 2 or greater, structures in the two or more parentheses are the same as or different from each other, 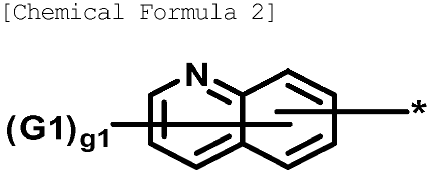
in Chemical Formula 2,
G1 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group;
g1 is an integer of 1 to 6, and when g1 is 2 or greater, G1s are the same as or different from each other; and
* is a site bonding to L1 of Chemical Formula 1, 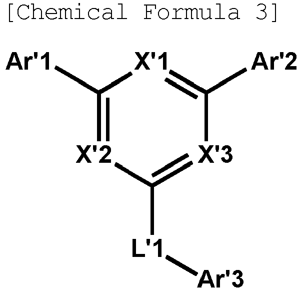
in Chemical Formula 3,
Ar'1 and Ar'2 are the same as or different from each other, and each independently a substituted or unsubstituted aryl group; or a substituted or unsubstituted heteroaryl group;
X'1 is N or CR'1, X'2 is N or CR'2, and X'3 is N or CR'3;
at least two of X'1 to X'3 are N;
L'1 is a direct bond; a substituted or unsubstituted arylene group; or a substituted or unsubstituted heteroarylene group;
R'1 to R'3 are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group; and
Ar'3 is represented by the following Chemical Formula 4a, 4b or 4c:
[Chemical Formula 4a] ****-(L'2)n1-Ar'4** 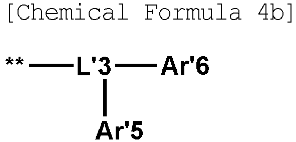 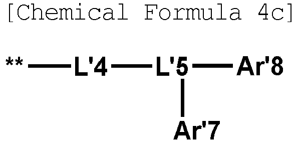
in Chemical Formulae 4a to 4c,
****** is a site bonding to L'1 of Chemical Formula 3;
n1 is an integer of 1 to 3;
L'2 and L'4 are the same as or different from each other, and each independently a direct bond; a substituted or unsubstituted alkylene group; a substituted or unsubstituted arylene group; or a substituted or unsubstituted heteroarylene group;
L'3 and L'5 are the same as or different from each other, and each independently a substituted or unsubstituted trivalent aryl group; or a substituted or unsubstituted trivalent heteroaryl group;
Ar'4 to Ar'8 are the same as or different from each other, and each independently a nitrile group; an aryl group unsubstituted or substituted with one, two or more substituents selected from the group consisting of a substituted or unsubstituted alkyl group, a substituted or unsubstituted aryl group, a substituted or unsubstituted pyridyl group, a substituted or unsubstituted carbazole group and a nitrile group; or a substituted or unsubstituted heteroaryl group.

2. The organic light emitting device of Claim 1, wherein the electron transfer layer further includes a compound represented by the following Chemical Formula 5: 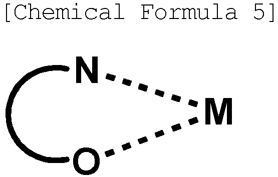 in Chemical Formula 5,
M is an alkali metal or an alkaline-earth metal;
a curve connecting N and O represents bonds or atoms required to form a substituted or unsubstituted ring including N or O; and
a dotted line means N and O forming a metal complex with M.

3. The organic light emitting device of Claim 1, wherein Ar1 is a nitrile group; a substituted or unsubstituted alkoxy group; a substituted or unsubstituted phosphine oxide group; a substituted or unsubstituted silyl group; a substituted or unsubstituted aryl group; a substituted or unsubstituted monocyclic heterocyclic group; a substituted or unsubstituted tricyclic or higher heterocyclic group; a substituted or unsubstituted dicyclic heterocyclic group including two or more Ns; a substituted or unsubstituted isoquinolyl group; or the structure represented by Chemical Formula 2.

4. The organic light emitting device of Claim 1, wherein Ar1 is represented by any one of Chemical Formula 2 and the following Chemical Formulae 6 to 15: 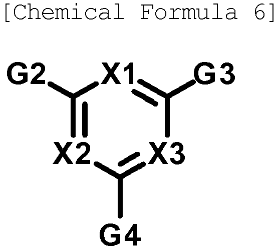 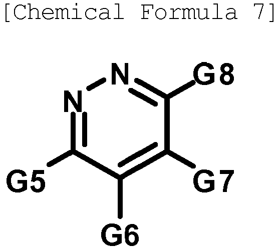 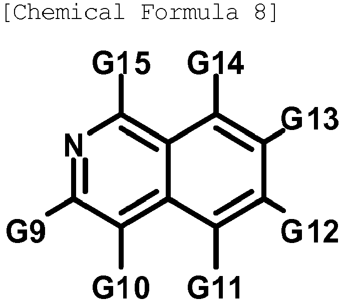 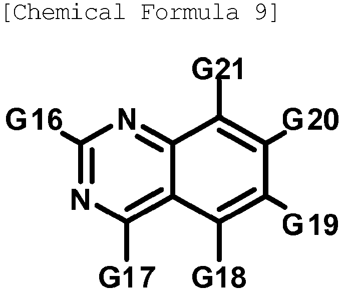 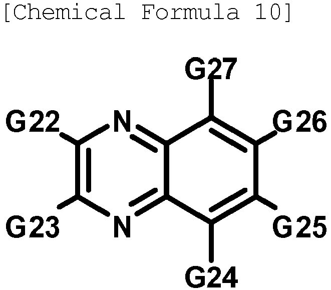 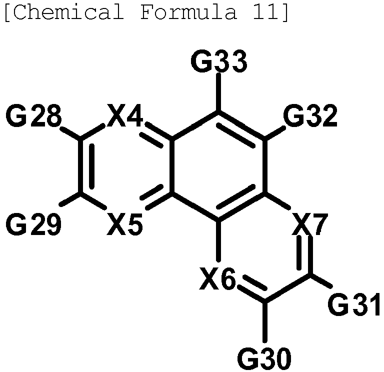 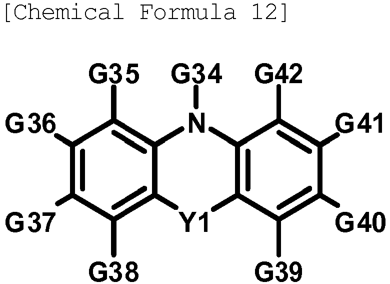 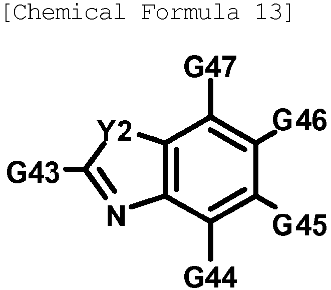 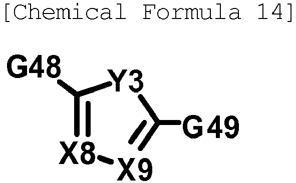 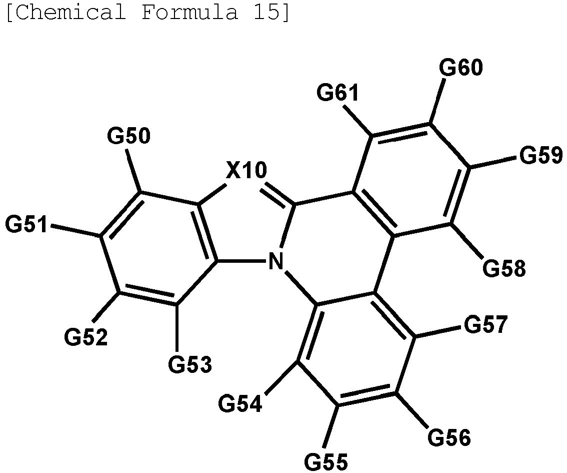 in Chemical Formulae 6 to 15,
X1 is N or CR11, X2 is N or CR12, X3 is N or CR13, X4 is N or CR14, X5 is N or CR15, X6 is N or CR16, X7 is N or CR17, X8 is N or CR18, X9 is N or CR19, and X10 is N or CR20;
at least two of X1 to X3 are N, and at least one of X4 to X7 is N;
Y1 is O; S; NQ1; or CQ2Q3, Y2 is O; S; NQ4; or CQ5Q6, and Y3 is O; S; or NQ7;
any one of G2 to G4 and R11 to R13, any one of G5 to G8, any one of G9 to G15, any one of G16 to G21, any one of G22 to G27, any one of G28 to G33 and R14 to R17, any one of G34 to G42, any one of G43 to G47, any one of G48, G49, R18 and R19, and any one of G50 to G61 are a site bonding to L1 of Chemical Formula 1; and
the rest of G2 to G61 and R11 to R19 other than the site bonding to L1 of Chemical Formula 1, R20 and Q1 to Q7 are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group.

5. The organic light emitting device of Claim 1, wherein Chemical Formula 1 is represented by any one of the following Chemical Formulae 1-1 to 1-4: 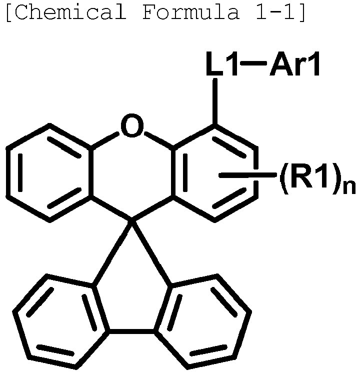 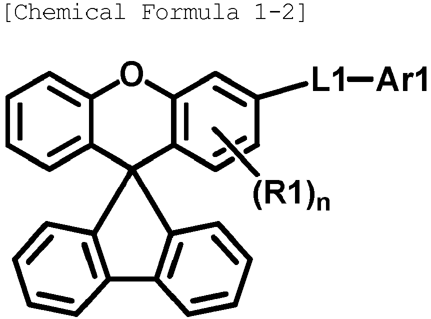 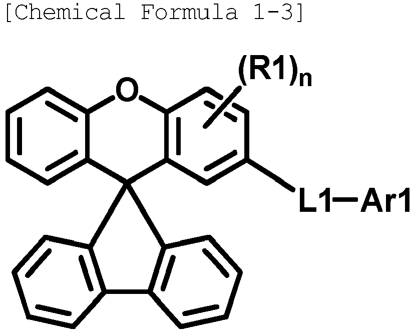 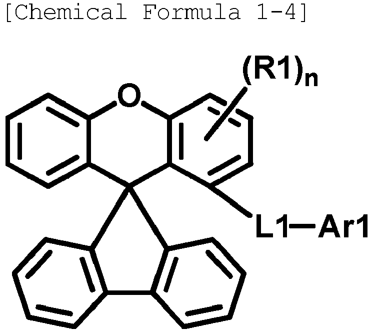 in Chemical Formulae 1-1 to 1-4,
L1, Ar1, R1 and n have the same definitions as in Chemical Formula 1.

6. The organic light emitting device of Claim 1, wherein L1 is a direct bond; a substituted or unsubstituted phenylene group; a substituted or unsubstituted biphenylene group; a substituted or unsubstituted naphthylene group; a substituted or unsubstituted terphenylene group; a substituted or unsubstituted quaterphenylene group; a substituted or unsubstituted anthracenylene group; a substituted or unsubstituted phenanthrenylene group; a substituted or unsubstituted triphenylenylene group; a substituted or unsubstituted pyrenylene group; a substituted or unsubstituted fluorenylene group; a substituted or unsubstituted spiro cyclopentane fluorenylene group; a substituted or unsubstituted dibenzofuranylene group; a substituted or unsubstituted divalent dibenzothiophene group; a substituted or unsubstituted carbazolene group; a substituted or unsubstituted pyridylene group; a substituted or unsubstituted divalent furan group; or a substituted or unsubstituted divalent thiophene group.

7. The organic light emitting device of Claim 1, wherein L'1 is a direct bond; a substituted or unsubstituted phenylene group; a substituted or unsubstituted biphenylene group; a substituted or unsubstituted terphenylene group; a substituted or unsubstituted naphthylene group; or a substituted or unsubstituted fluorenylene group, L'2 and L'4 are the same as or different from each other, and each independently a direct bond; a substituted or unsubstituted methylene group; a substituted or unsubstituted ethylene group; a substituted or unsubstituted propylene group; a substituted or unsubstituted phenylene group; a substituted or unsubstituted biphenylene group; a substituted or unsubstituted terphenylene group; a substituted or unsubstituted naphthylene group; or a substituted or unsubstituted fluorenylene group; and
L'3 and L'5 are the same as or different from each other, and each independently a substituted or unsubstituted trivalent phenyl group; a substituted or unsubstituted trivalent biphenyl group; a substituted or unsubstituted trivalent terphenyl group; a substituted or unsubstituted trivalent naphthyl group; or a substituted or unsubstituted trivalent fluorenyl group.

8. The organic light emitting device of Claim 1, wherein Ar'1 and Ar'2 are the same as or different from each other, and each independently a substituted or unsubstituted phenyl group; a substituted or unsubstituted biphenyl group; a substituted or unsubstituted naphthyl group; or a substituted or unsubstituted fluorenyl group.

9. The organic light emitting device of Claim 1, wherein Ar'4 to Ar'8 are the same as or different from each other, and each independently represented by a nitrile group; an aryl group unsubstituted or substituted with one, two or more substituents selected from the group consisting of a substituted or unsubstituted alkyl group, a substituted or unsubstituted aryl group, a substituted or unsubstituted pyridyl group, a substituted or unsubstituted carbazole group and a nitrile group; a triazine group unsubstituted or substituted with a substituted or unsubstituted aryl group; or any one selected from among the following Chemical Formulae 16 to 18: 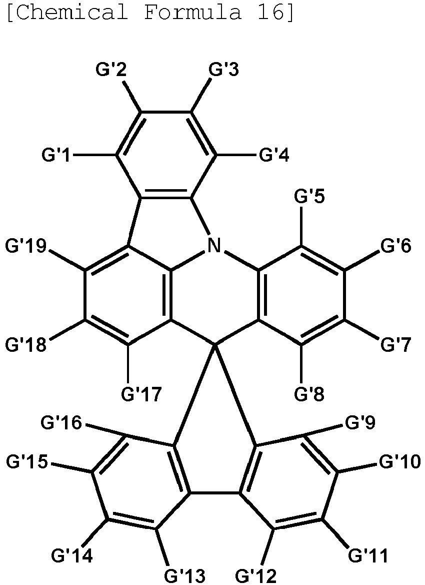 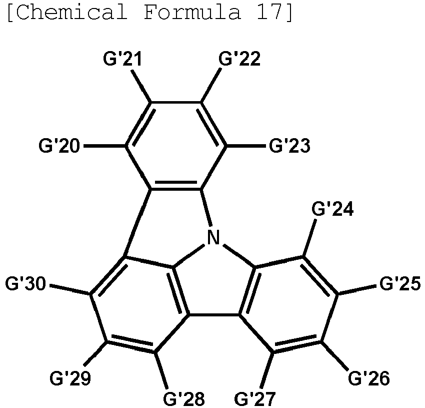 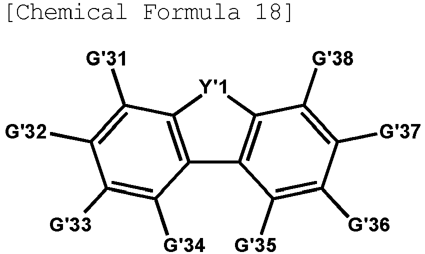 in Chemical Formulae 16 to 18,
Y'1 is O; S; or NR'4;
any one of G'1 to G'19, any one of G'20 to G'30, and any one of G'31 to G'38 and R'4 are a site bonding to L'2 of Chemical Formula 4a, L'3 of Chemical Formula 4b or L'5 of Chemical Formula 4c; and
the rest of G'1 to G'38 and R'4 other than the site bonding to L'2 of Chemical Formula 4a, L'3 of Chemical Formula 4b or L'5 of Chemical Formula 4c are the same as or different from each other, and each independently hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group.

10. The organic light emitting device of Claim 2, wherein Chemical Formula 5 is represented by the following Chemical Formula 5-1: 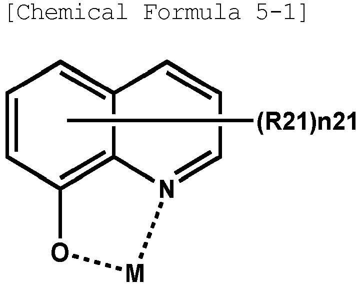 in Chemical Formula 5-1,
R21 is hydrogen; deuterium; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heteroaryl group;
n21 is an integer of 1 to 6, and when n21 is an integer of 2 or greater, substituents in the parentheses are the same as or different from each other; and
the remaining substituents have the same definitions as in Chemical Formula 5.

11. The organic light emitting device of Claim 1, wherein Chemical Formula 1 is any one selected from among the following compounds:

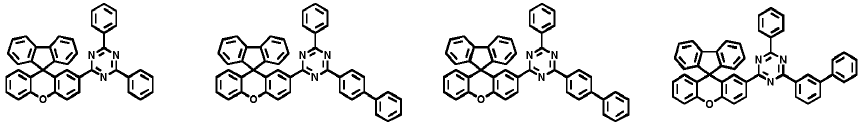

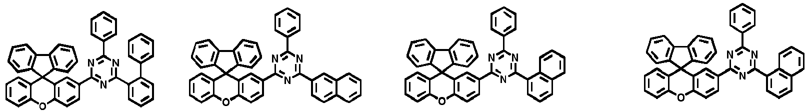

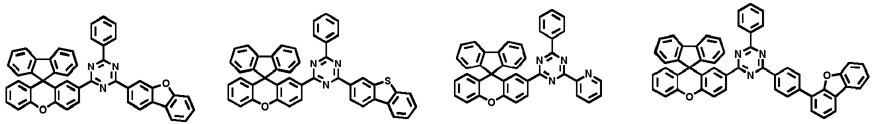

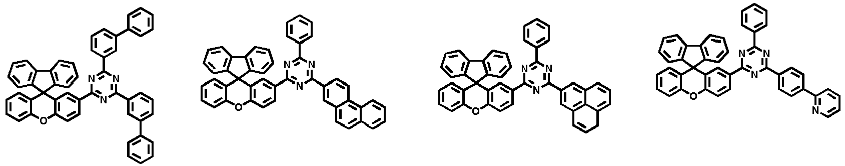

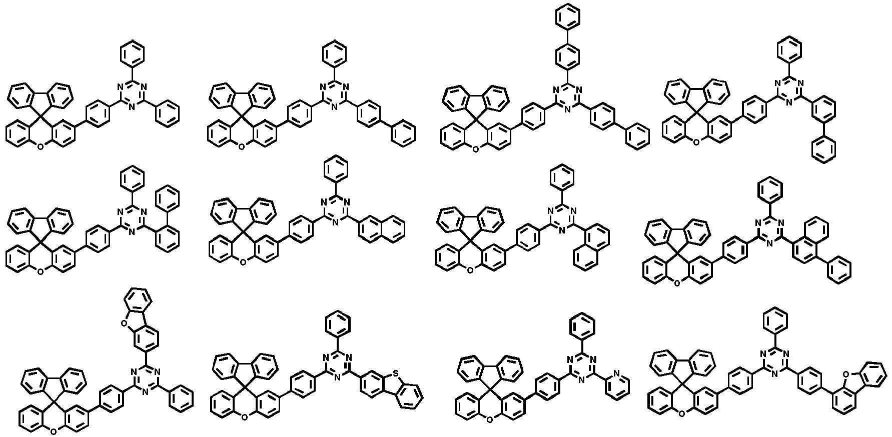

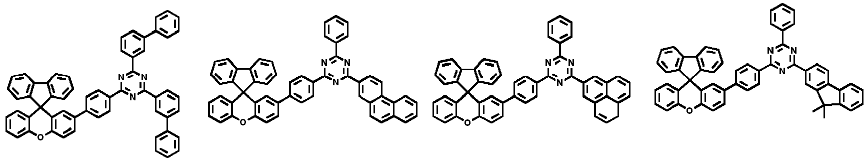

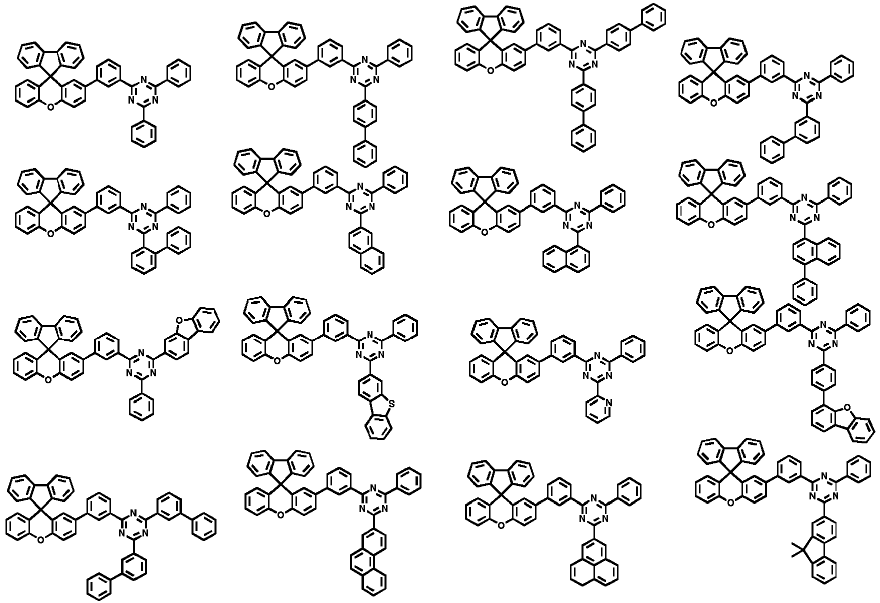

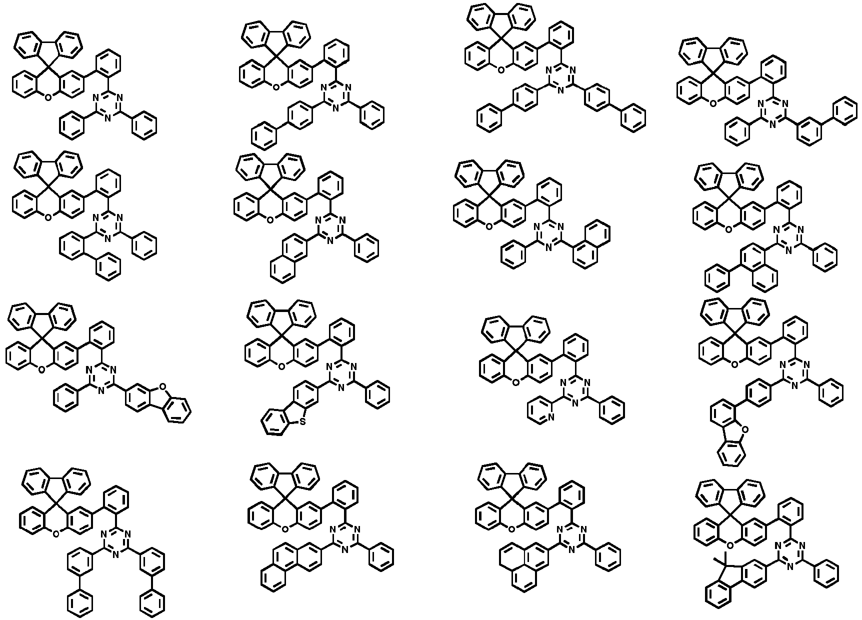

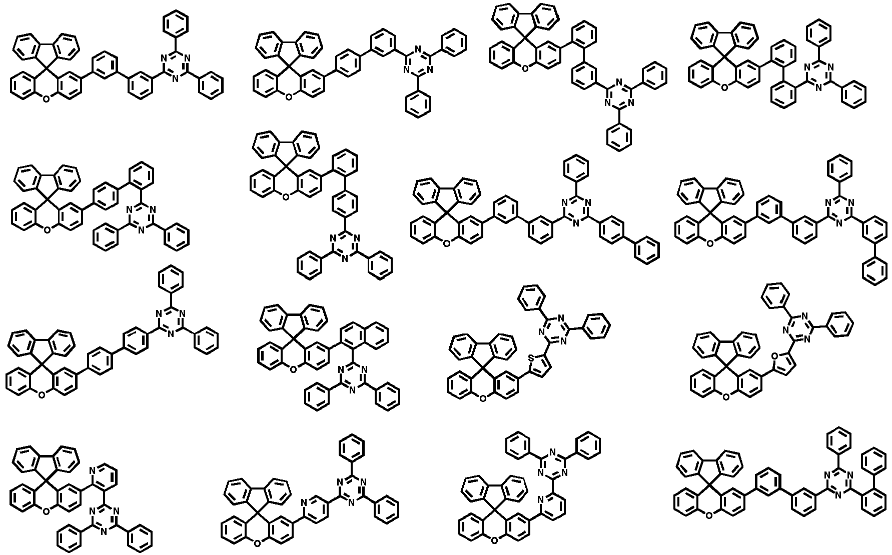

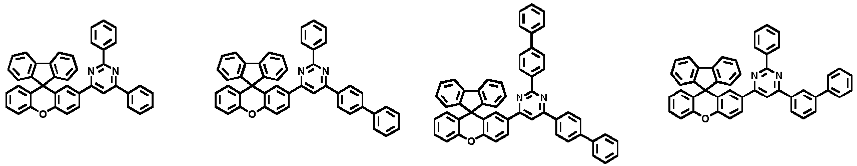

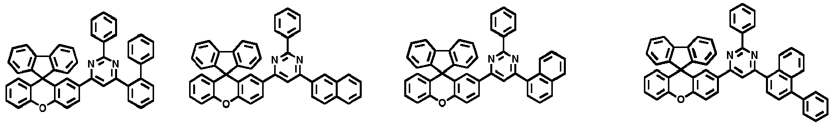

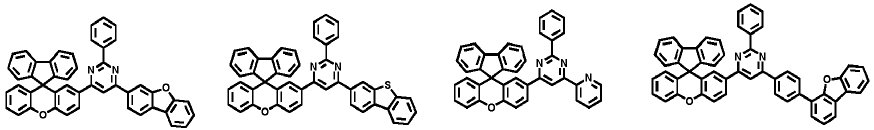

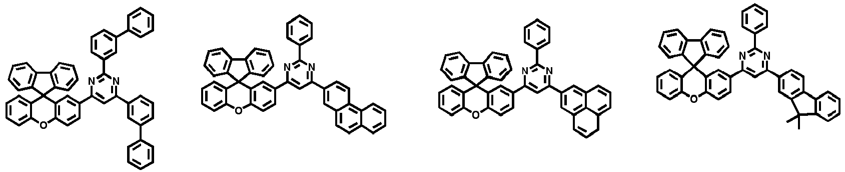

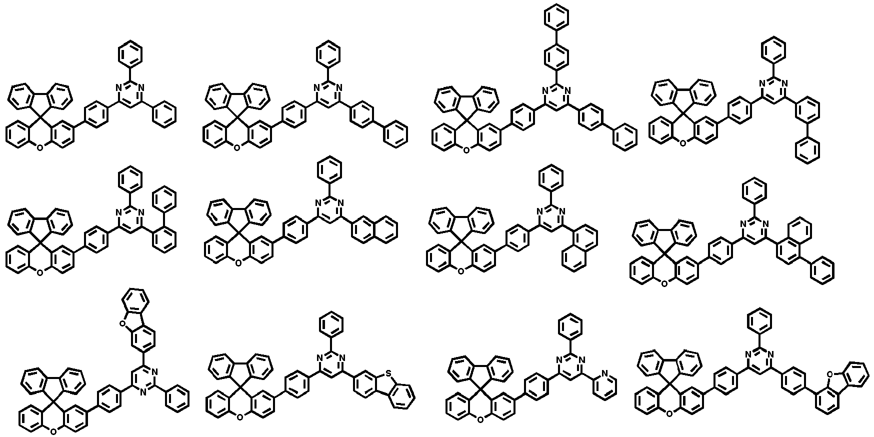

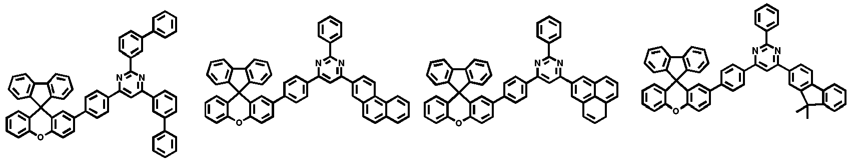

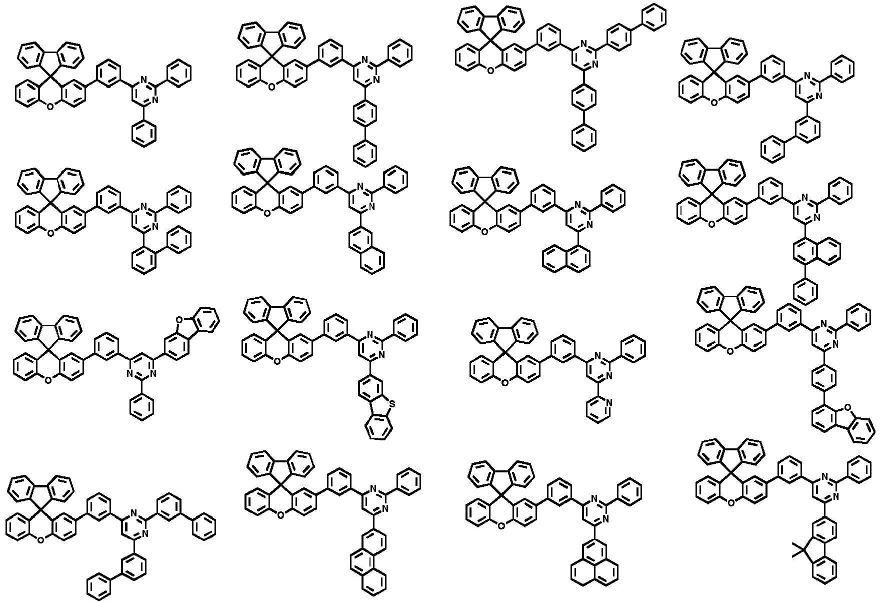

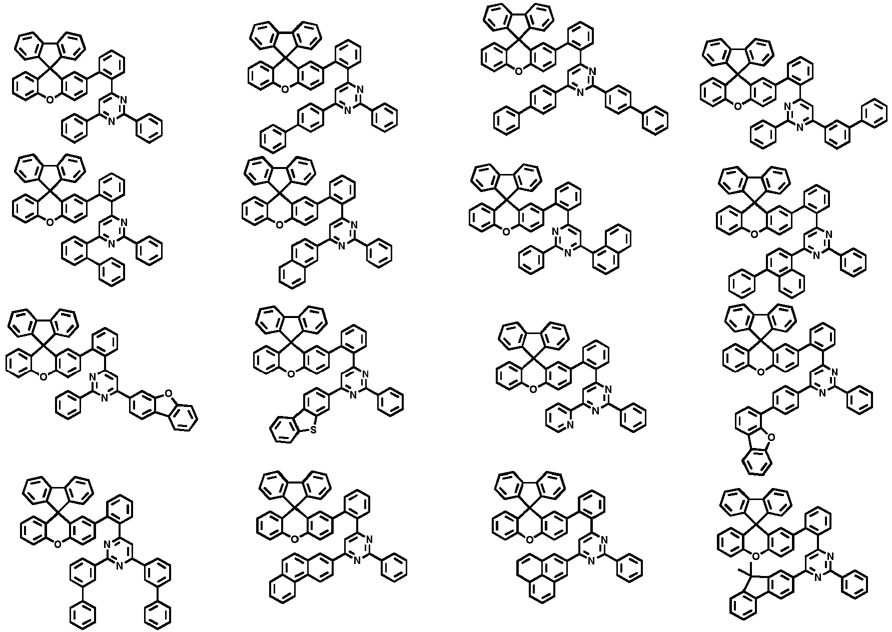

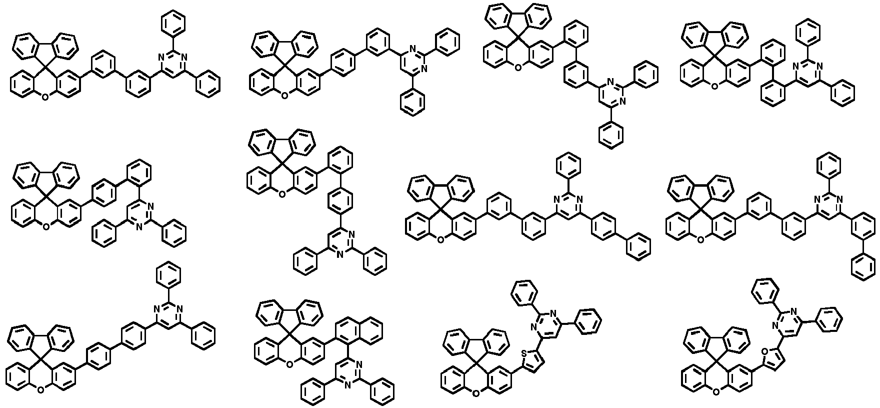

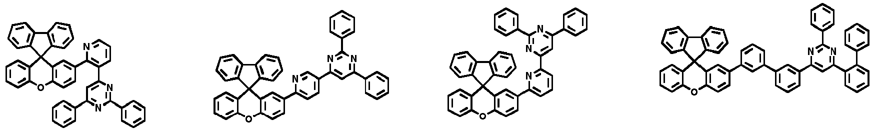

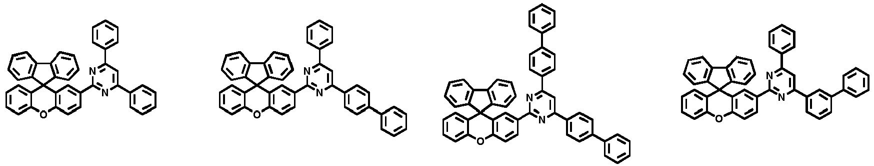

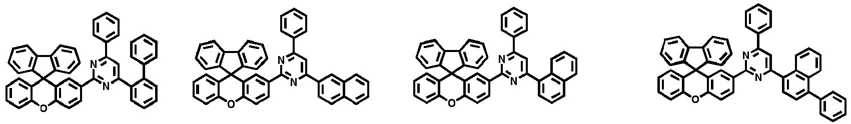

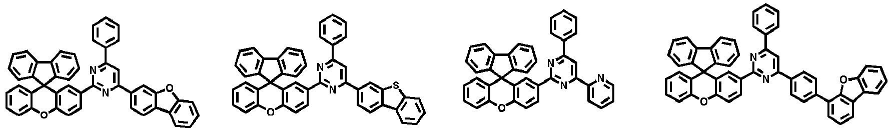

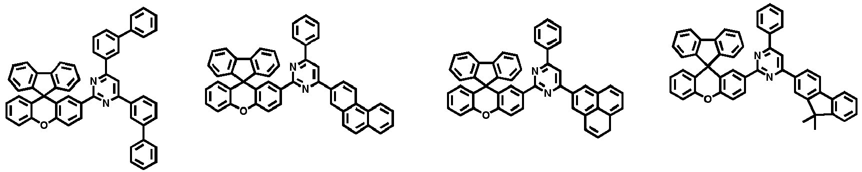

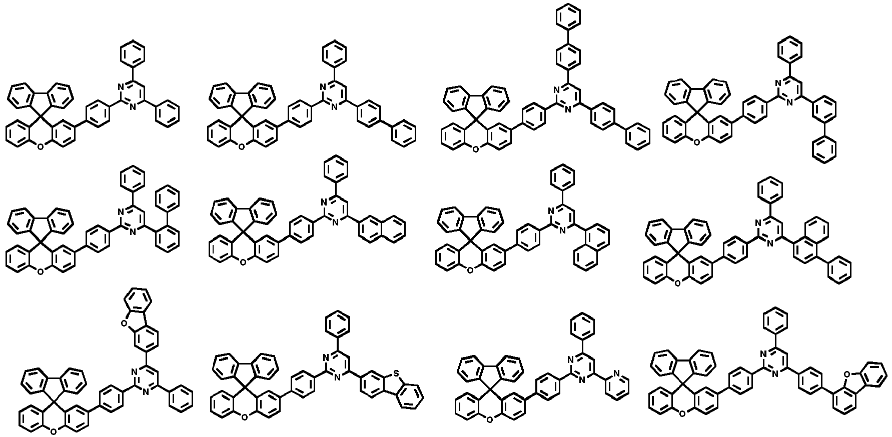

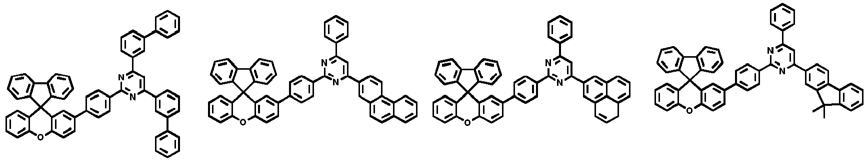

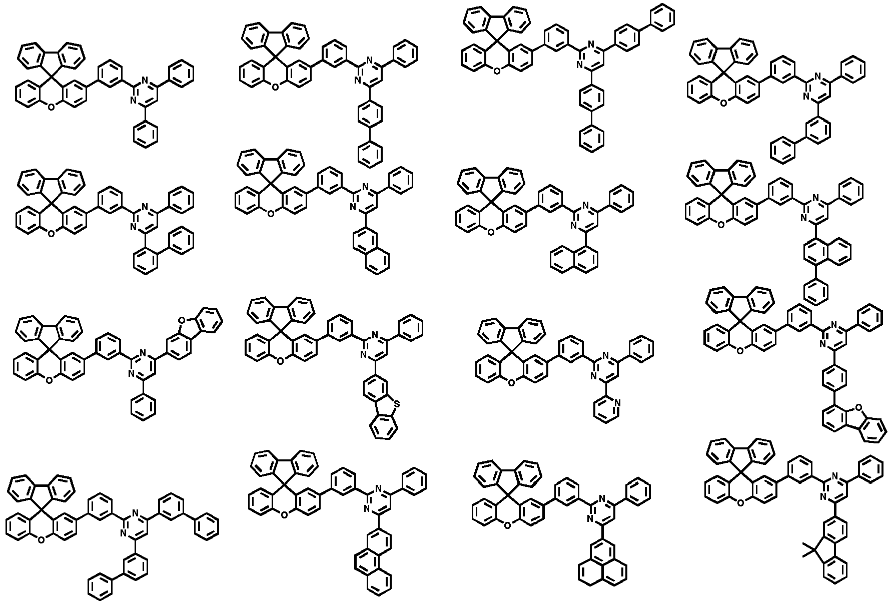

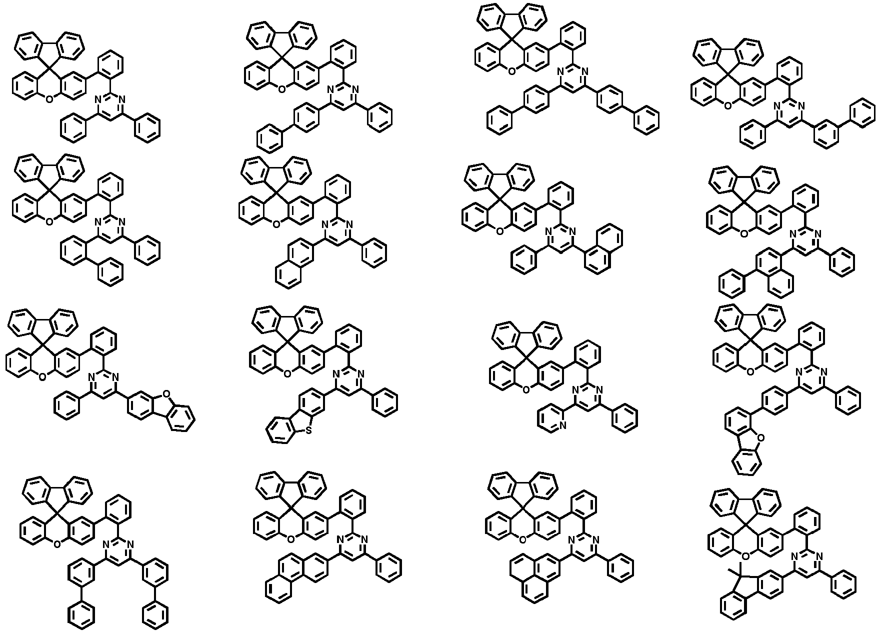

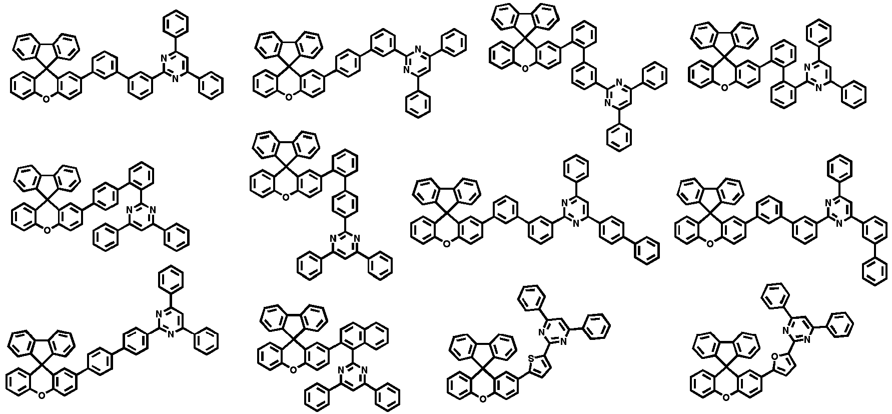

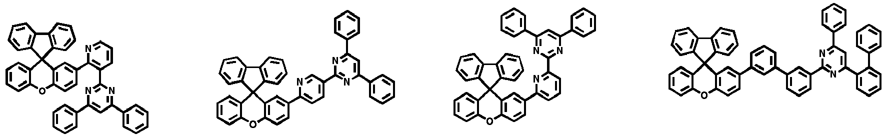

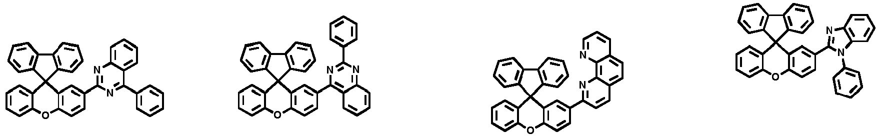

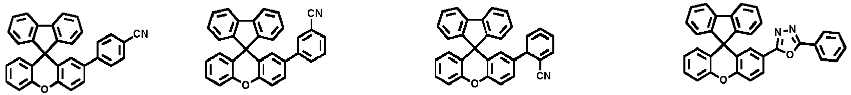

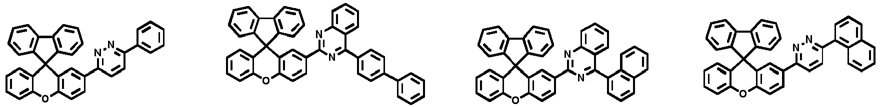

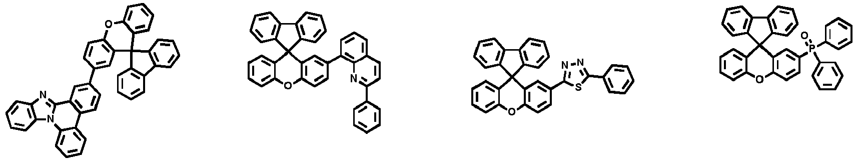

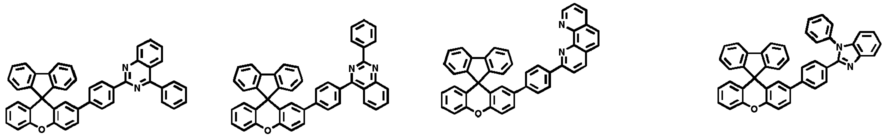

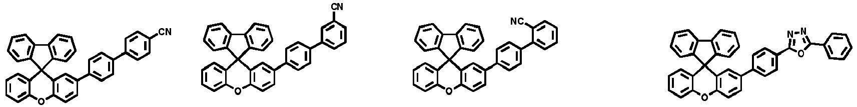

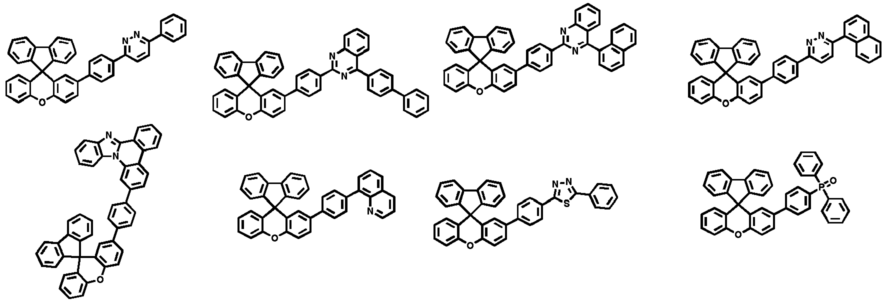

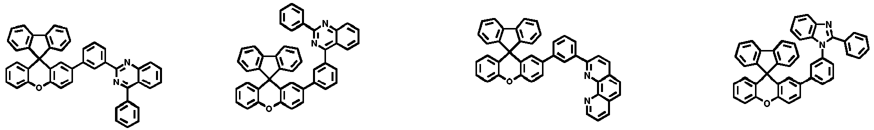

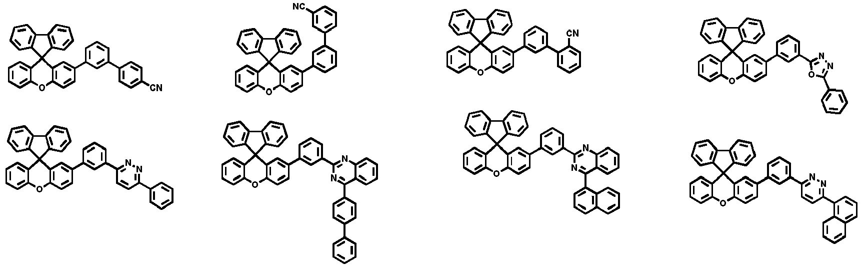

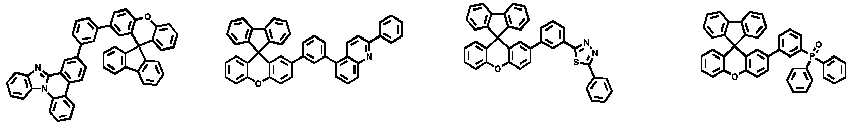

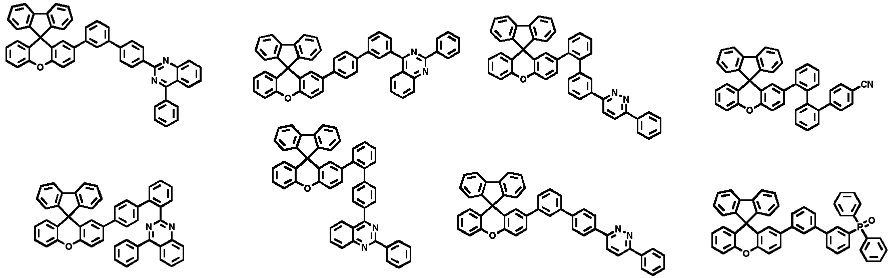

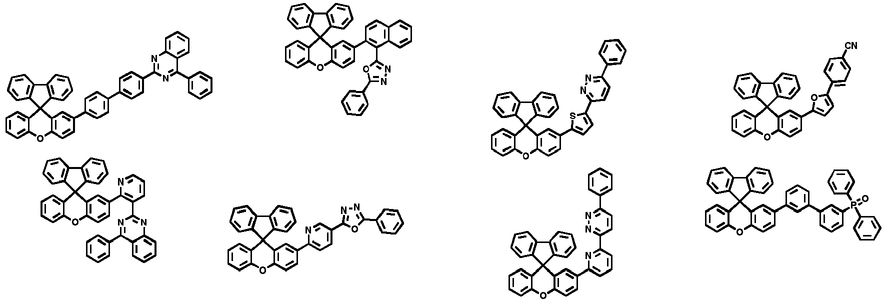

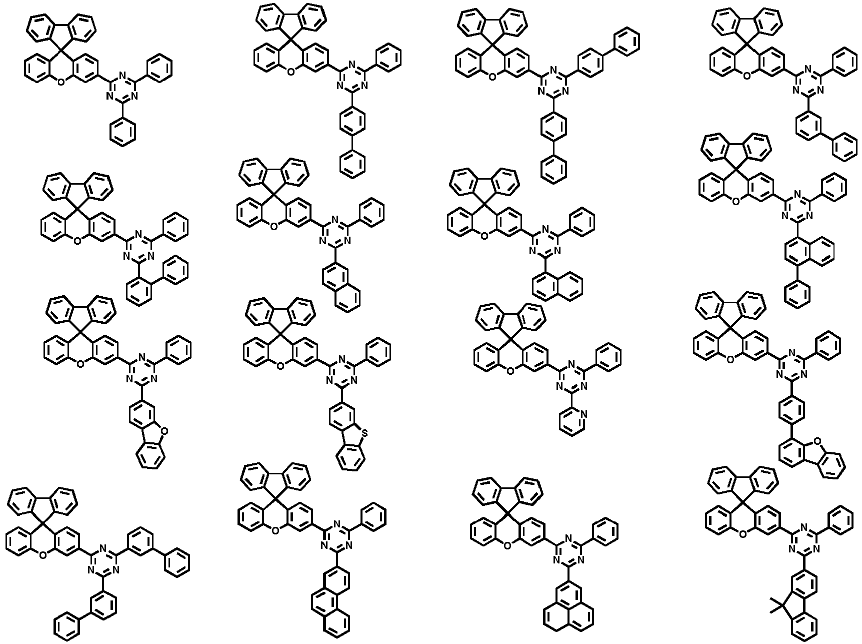

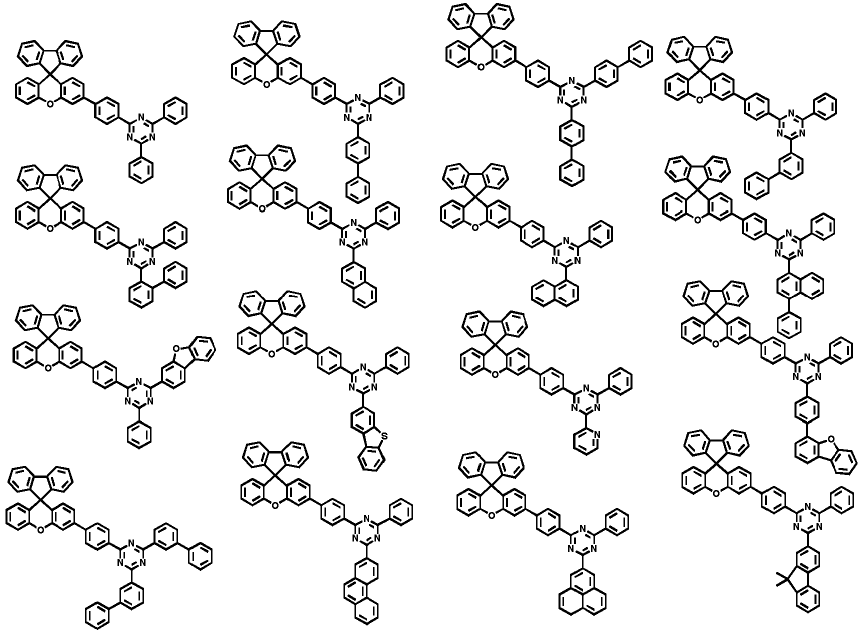

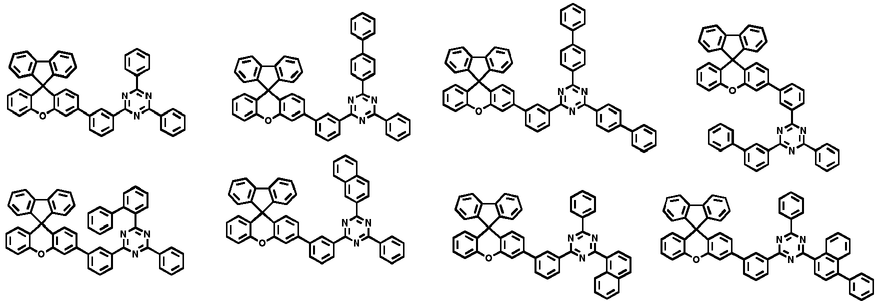

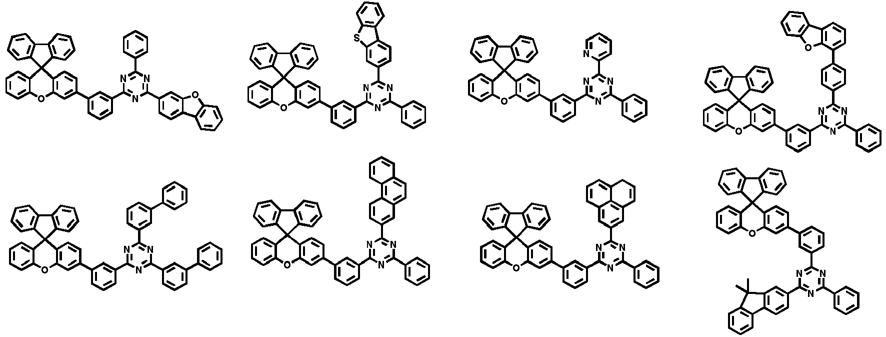

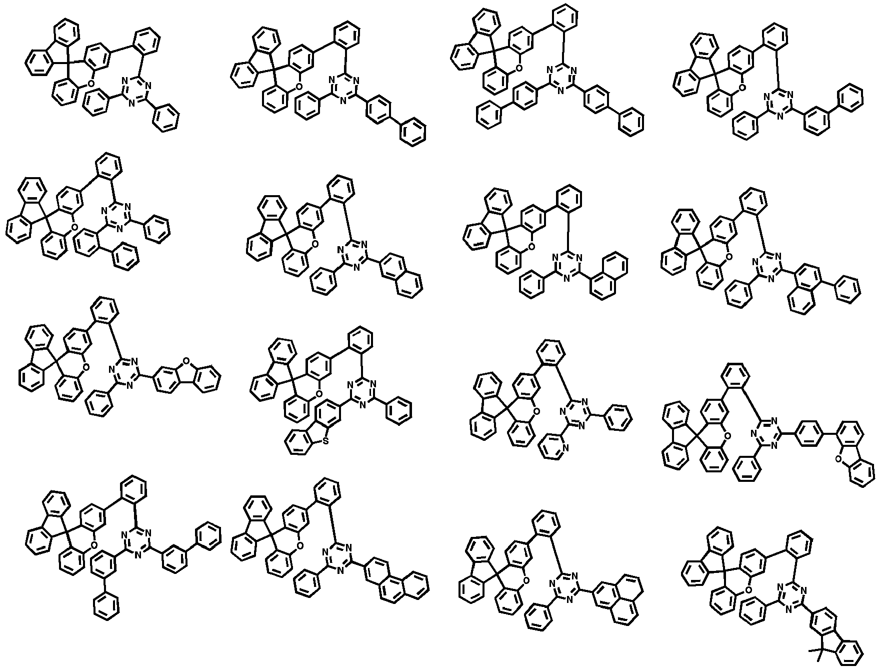

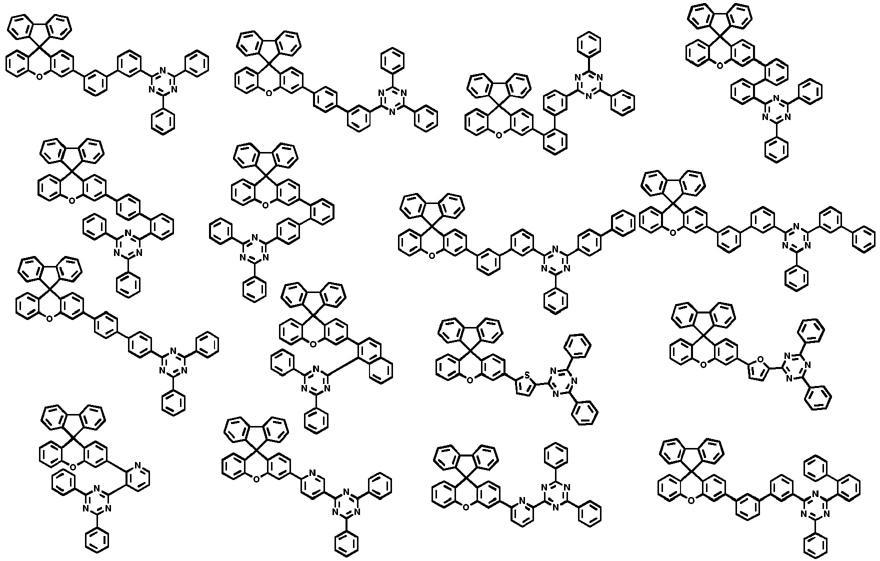

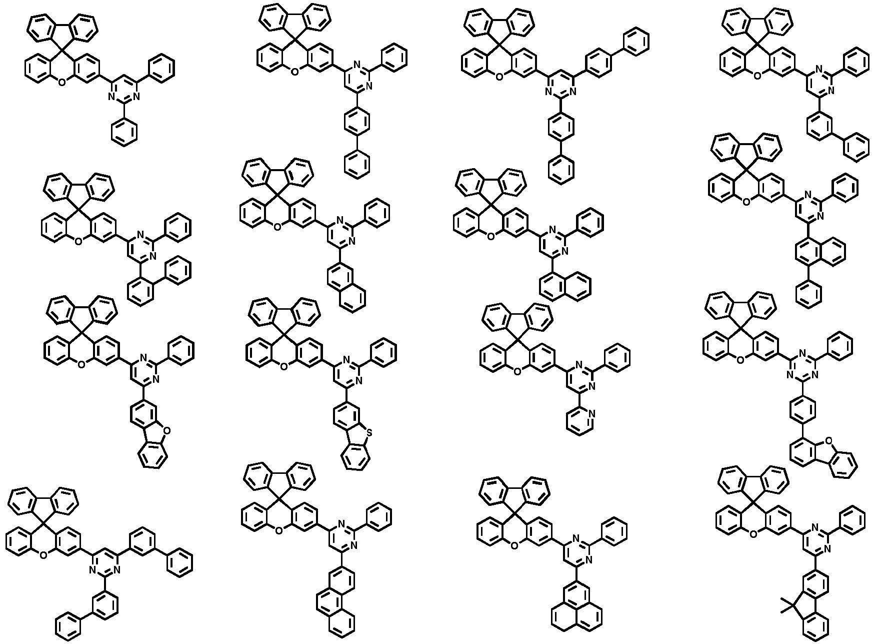

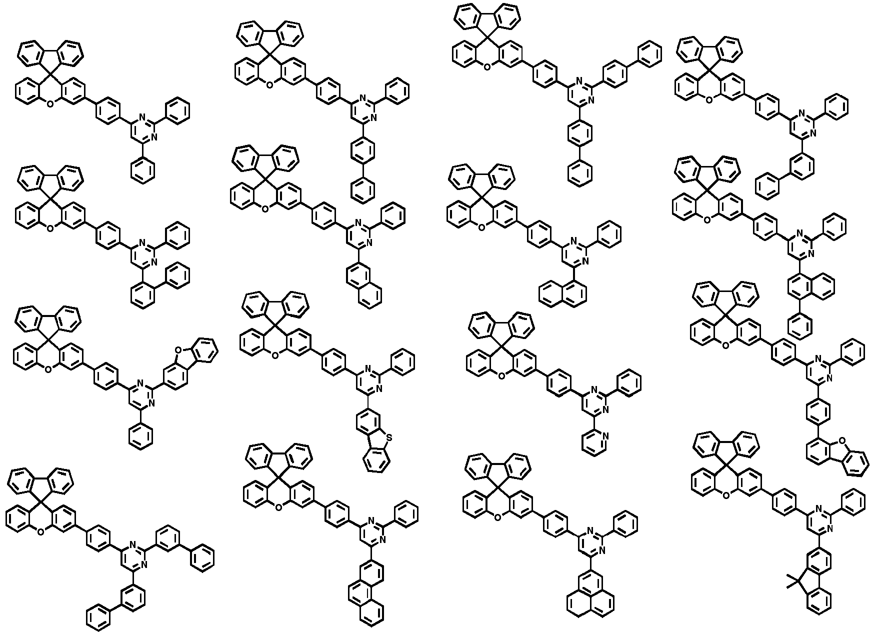

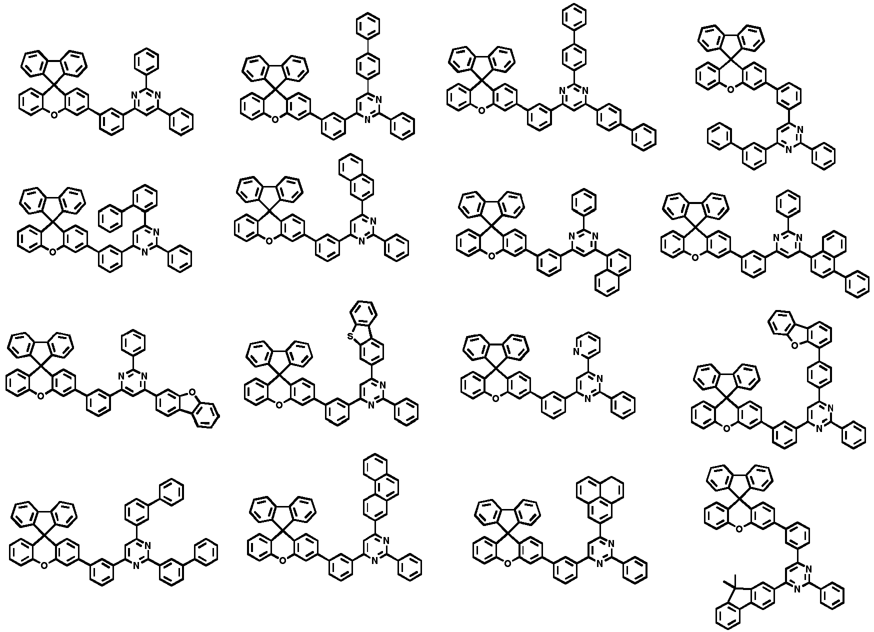

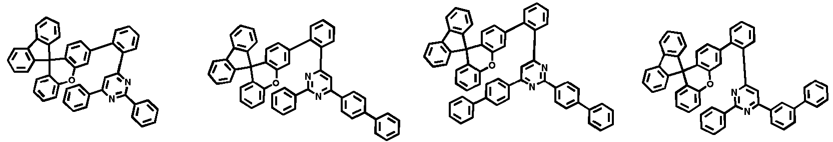

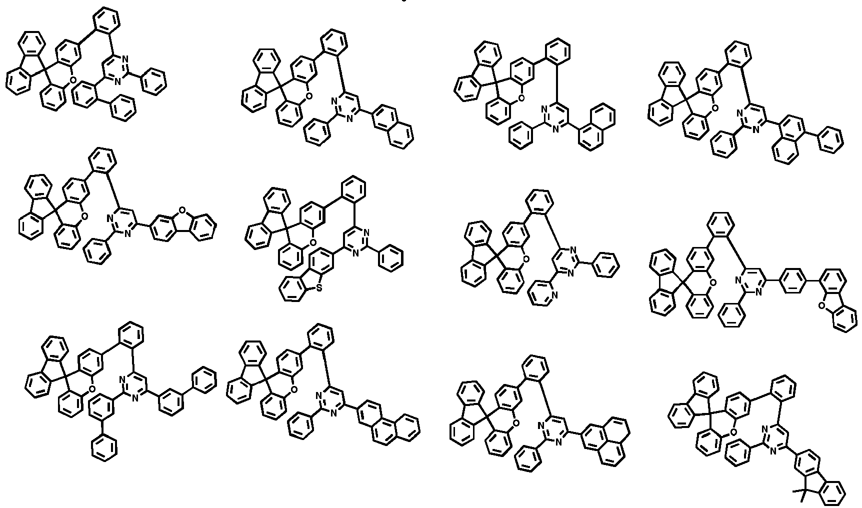

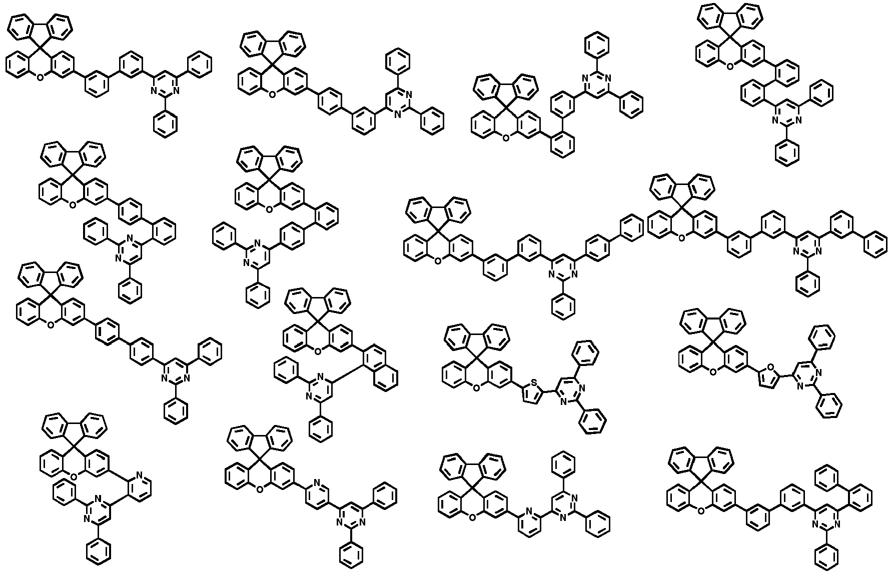

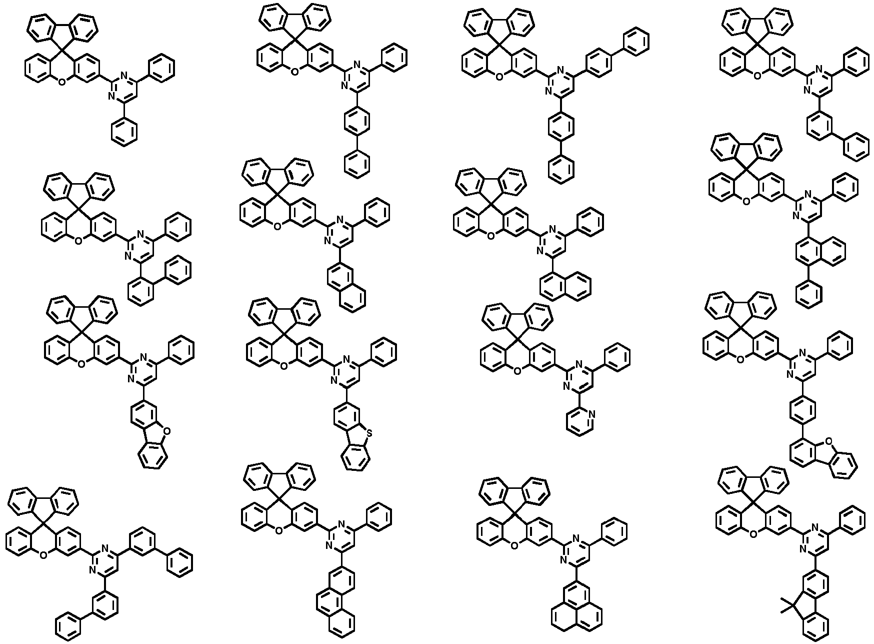

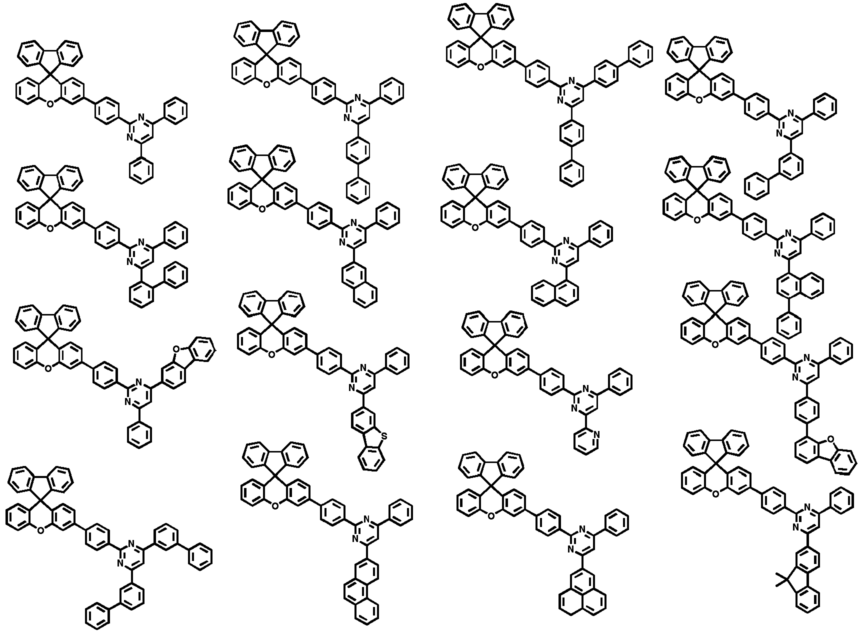

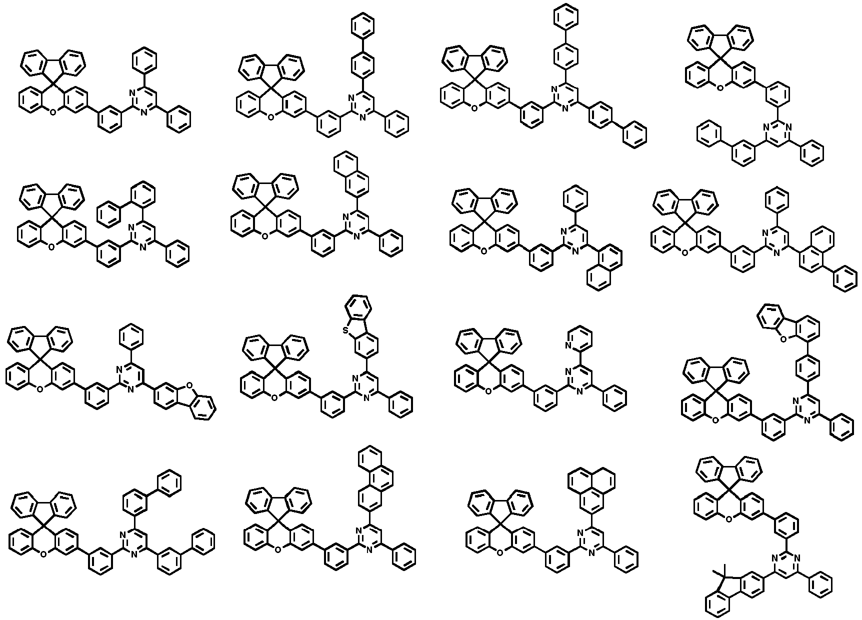

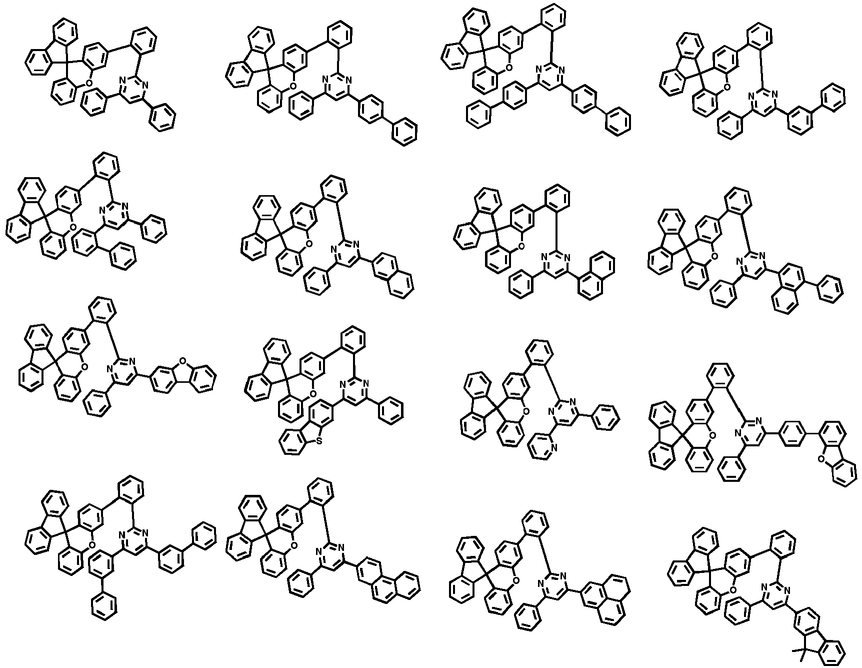

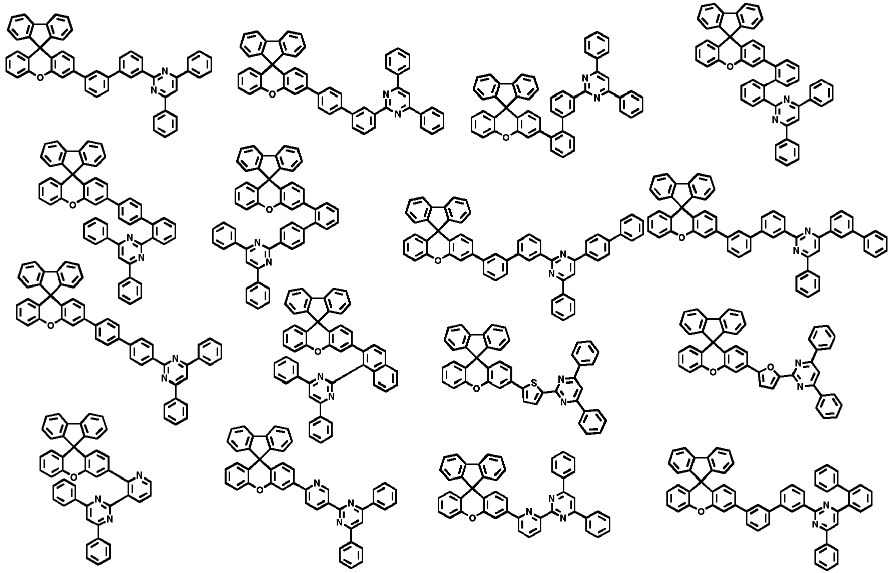

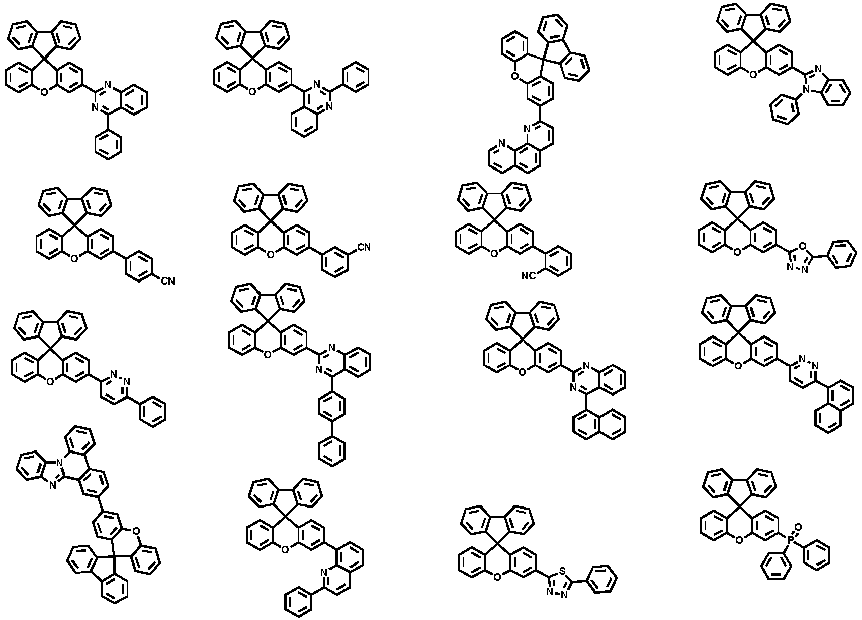

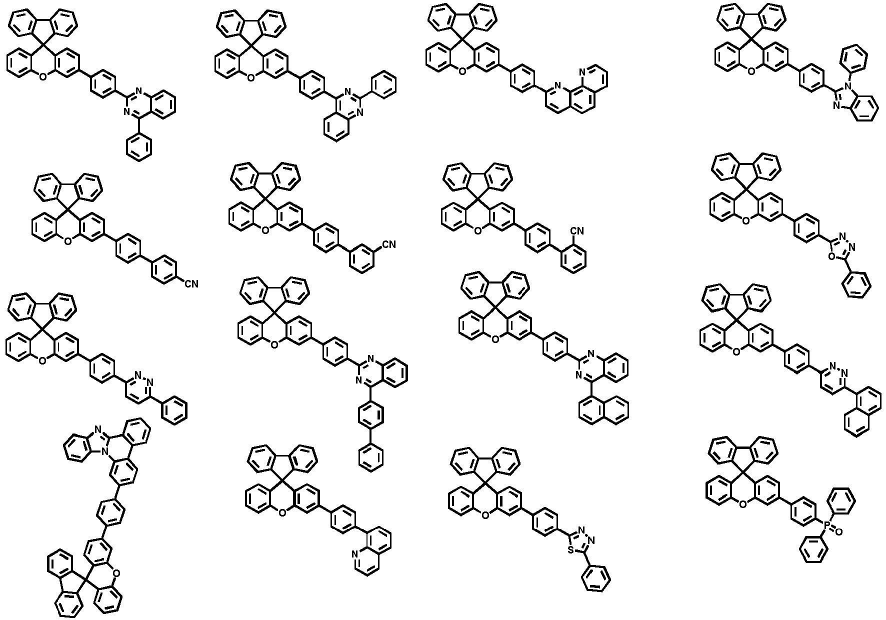

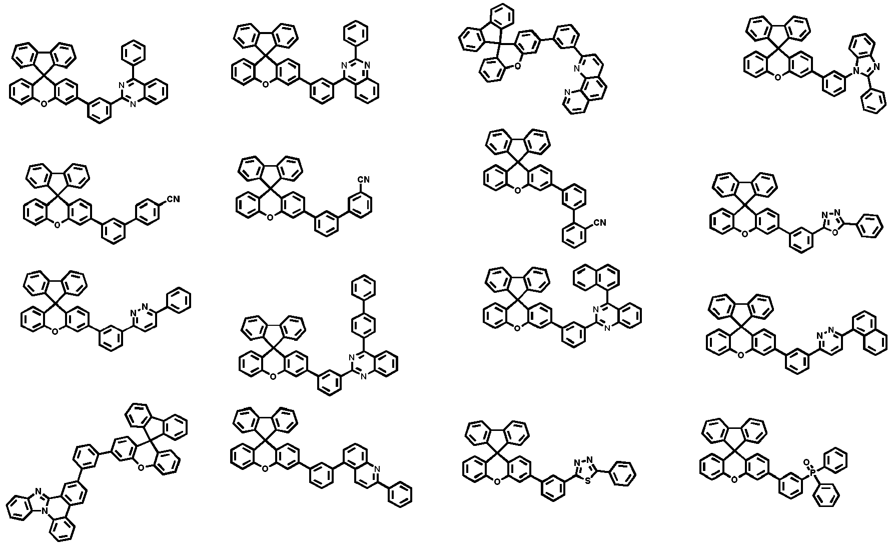

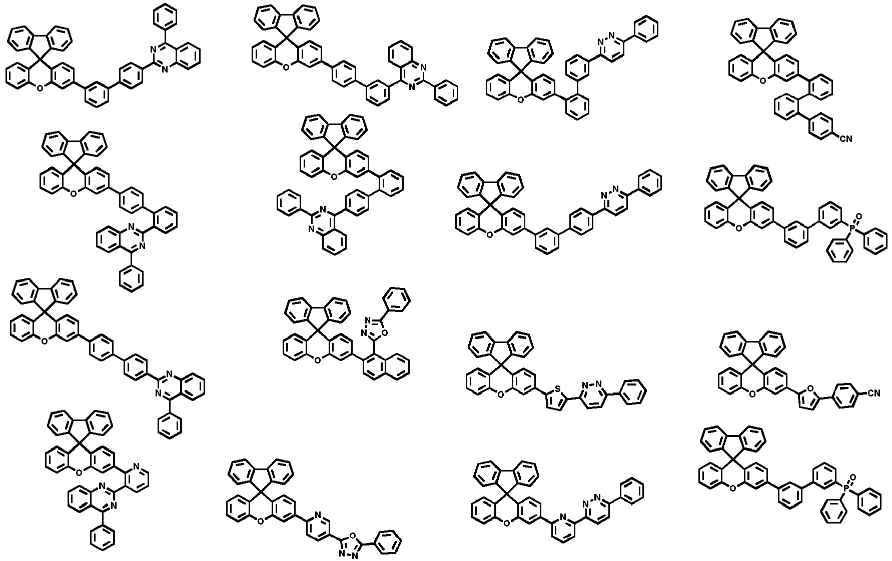

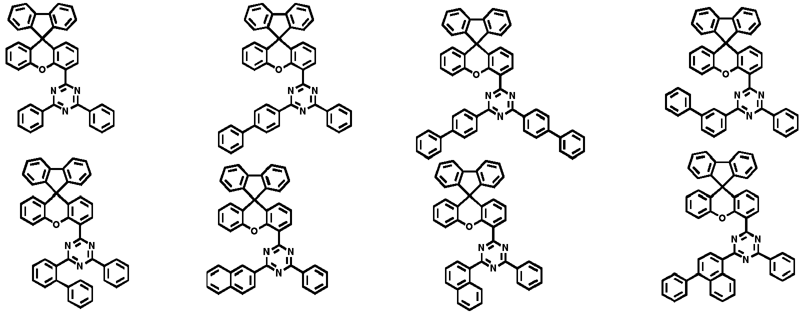

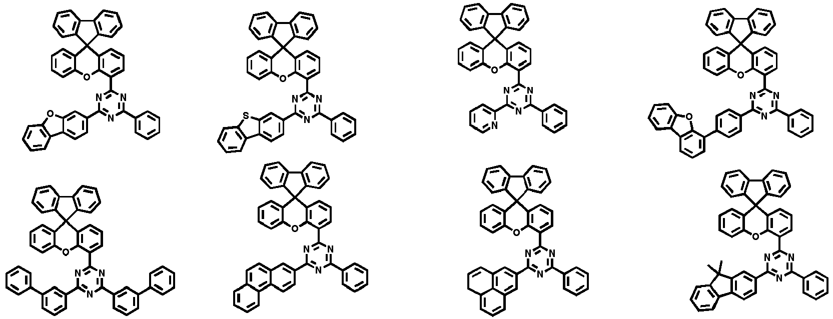

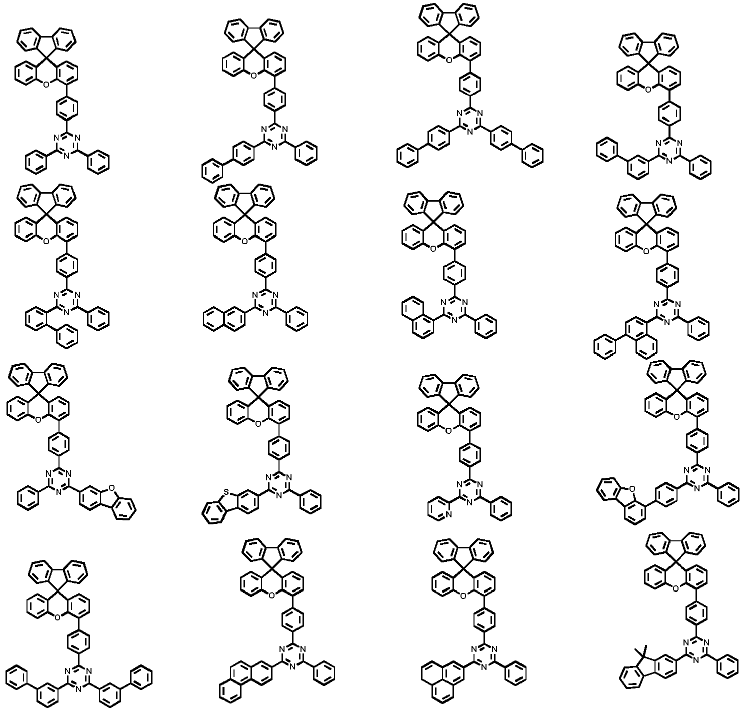

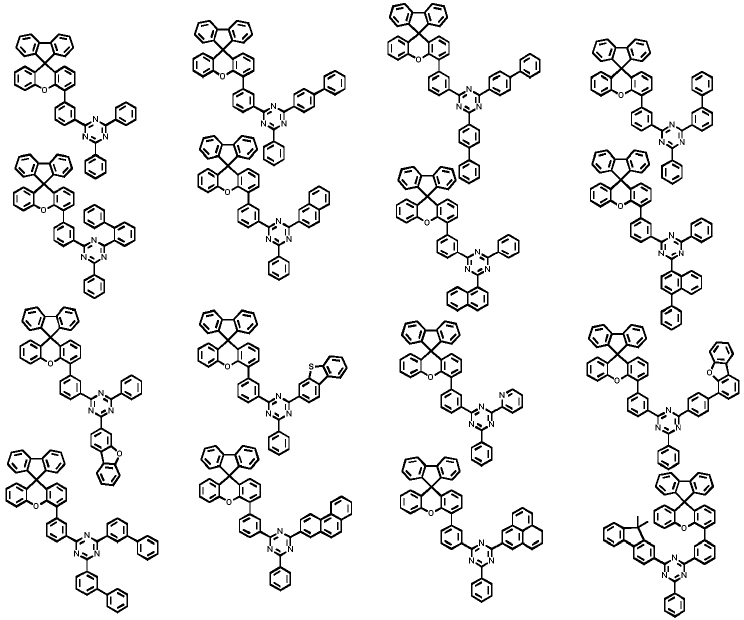

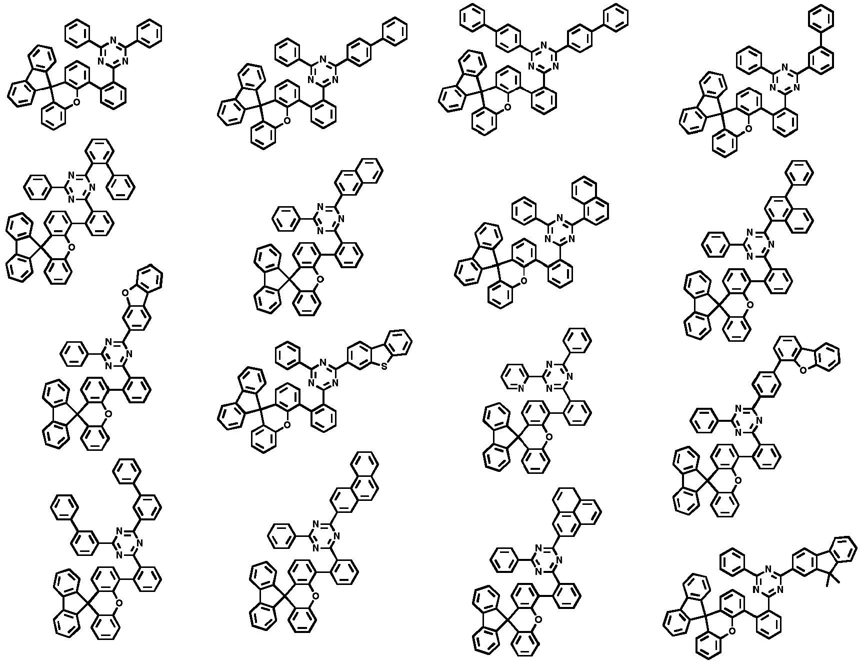

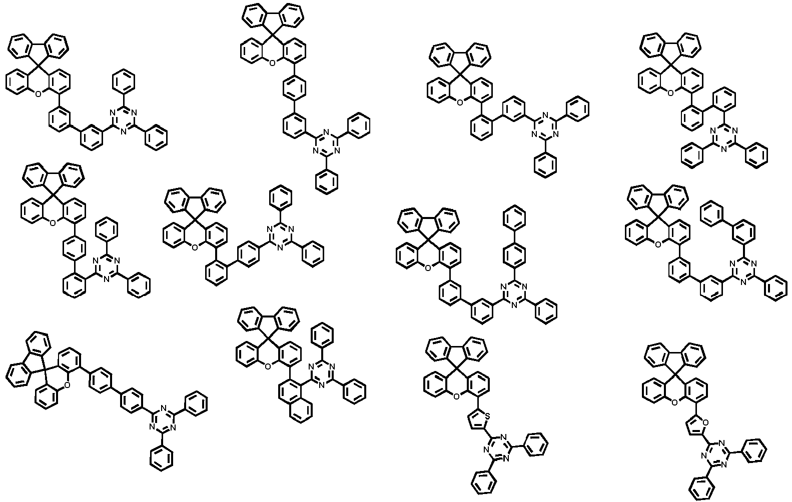

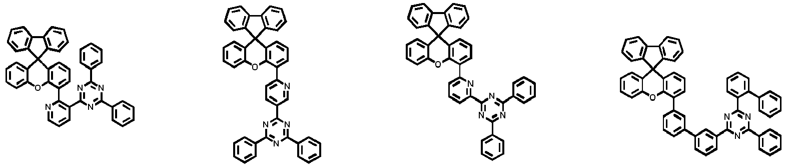

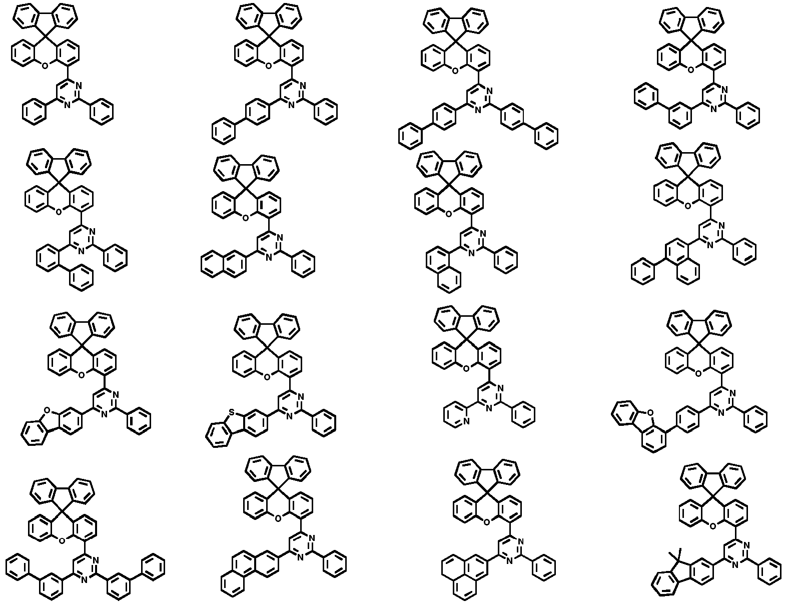

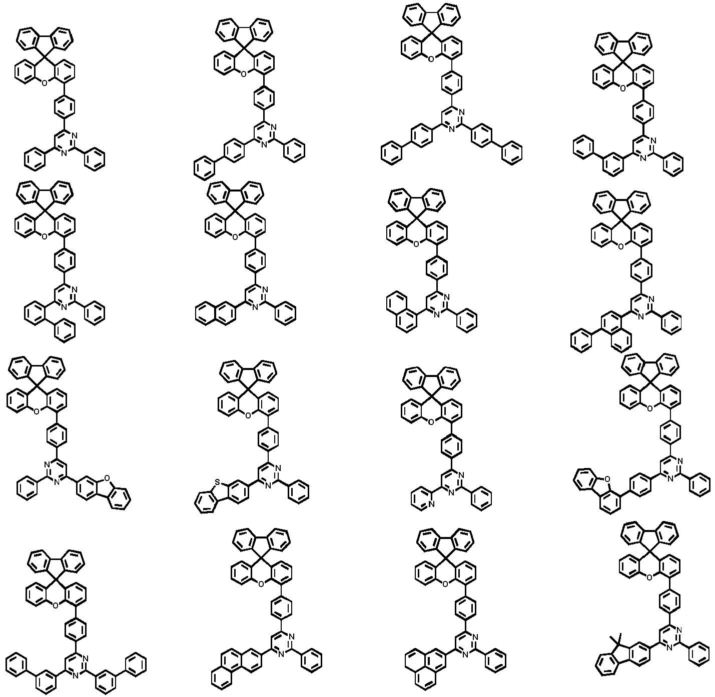

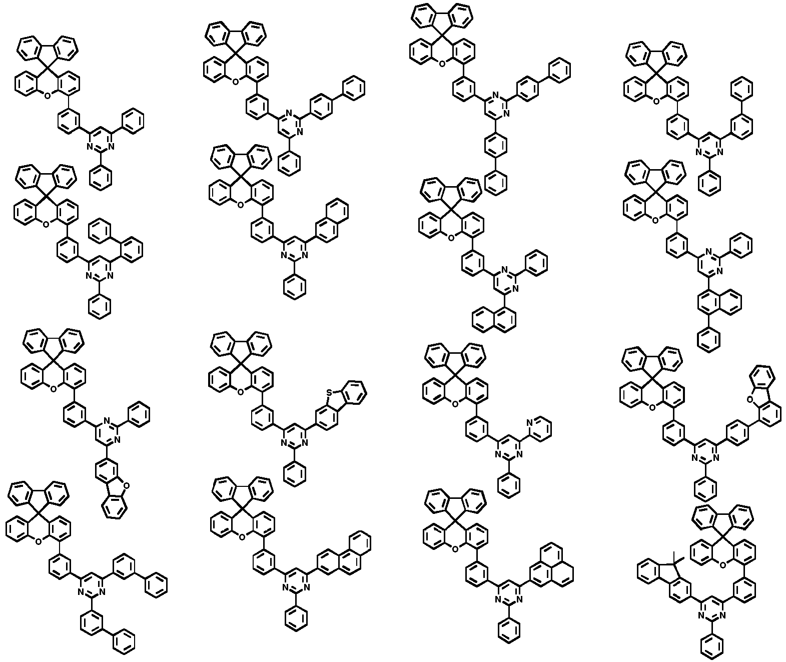

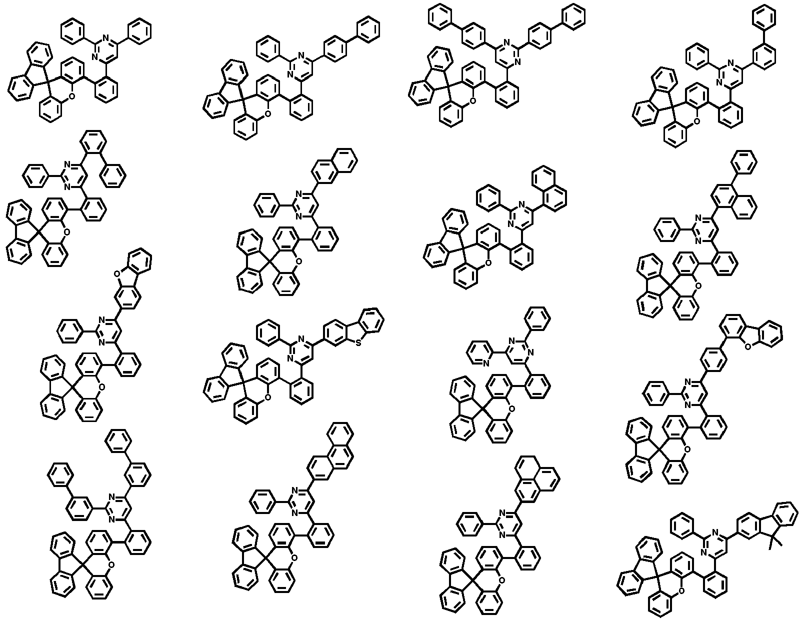

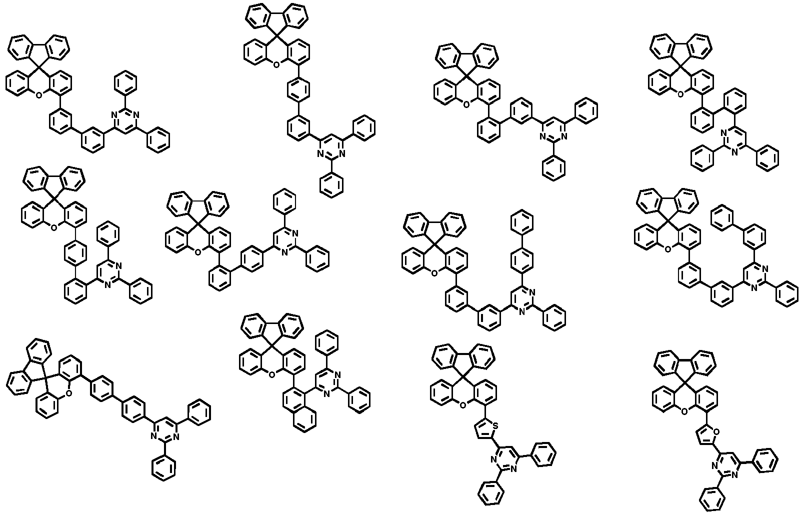

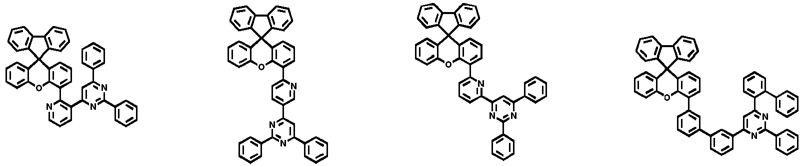

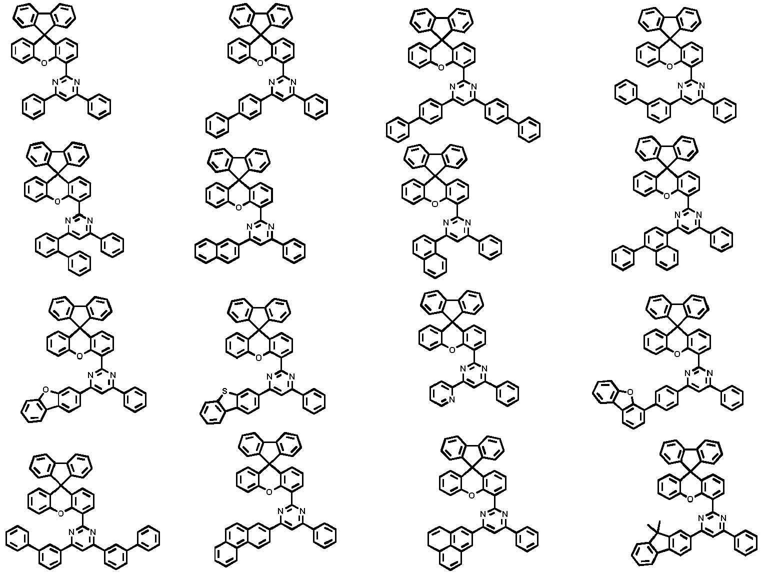

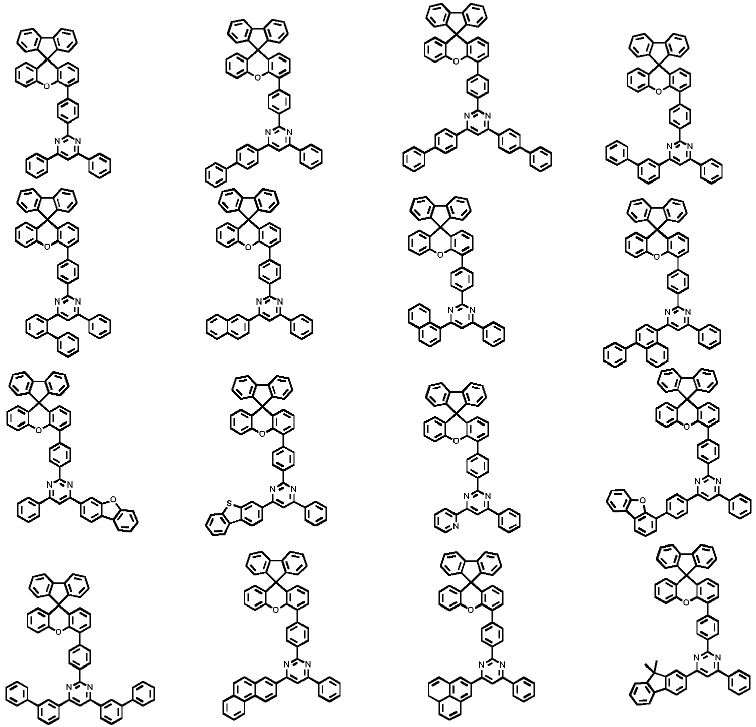

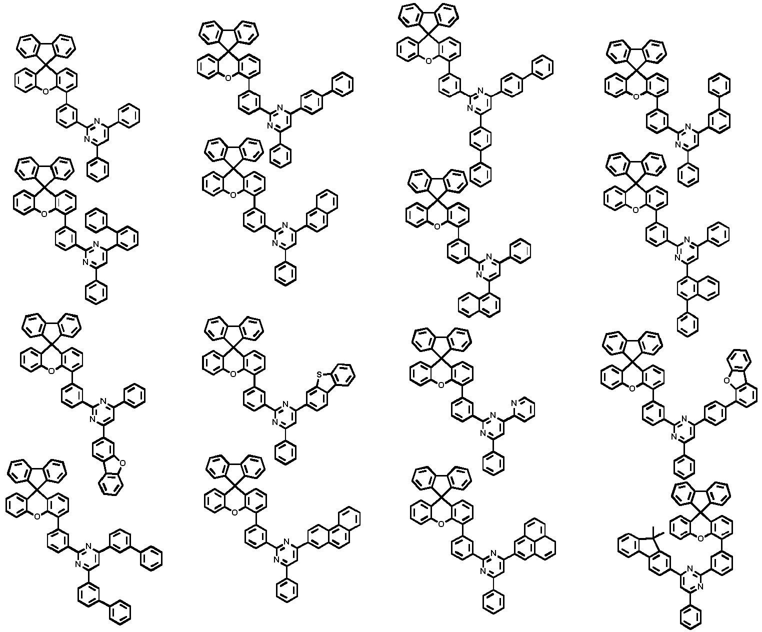

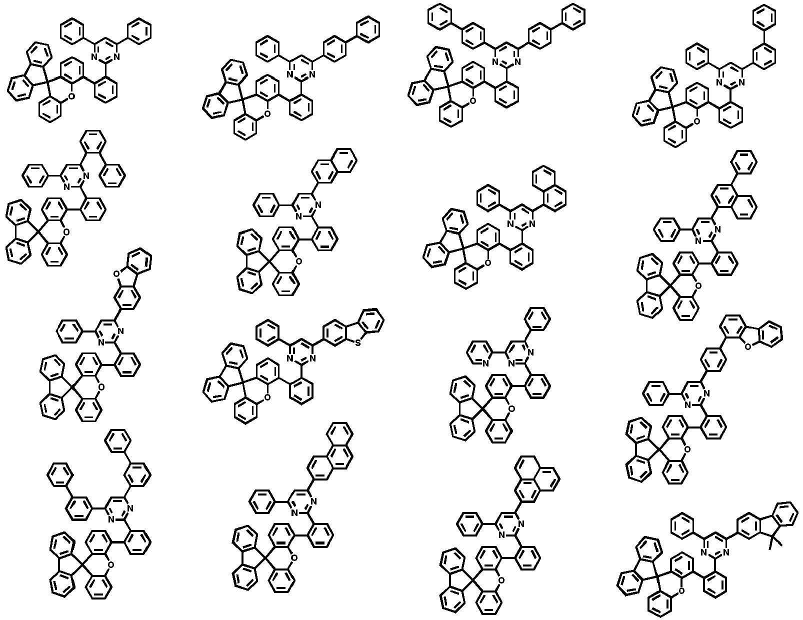

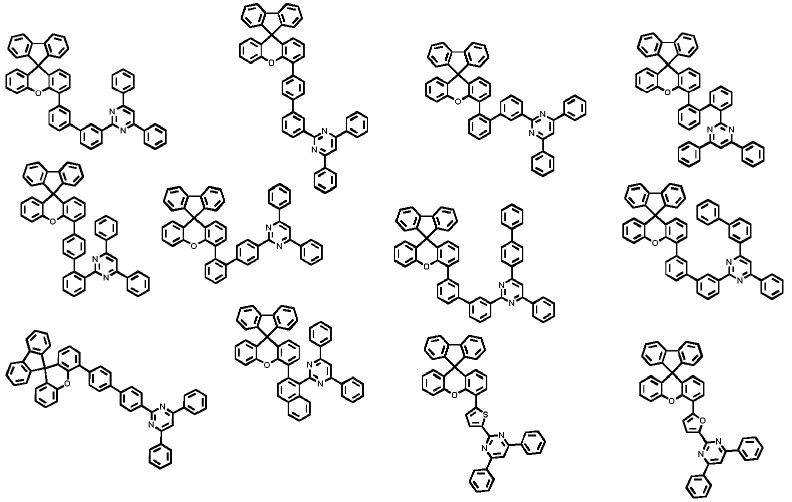

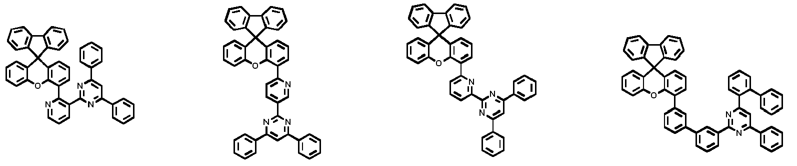

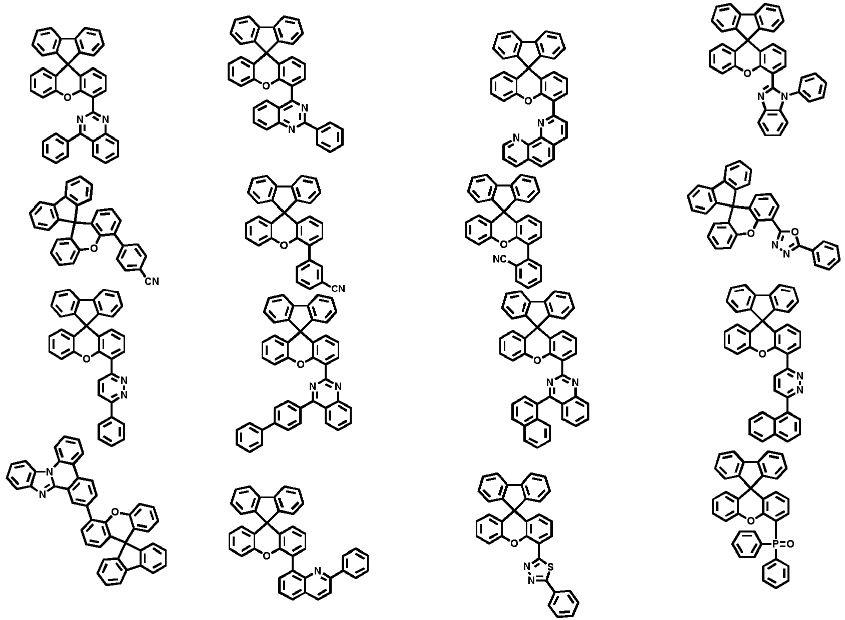

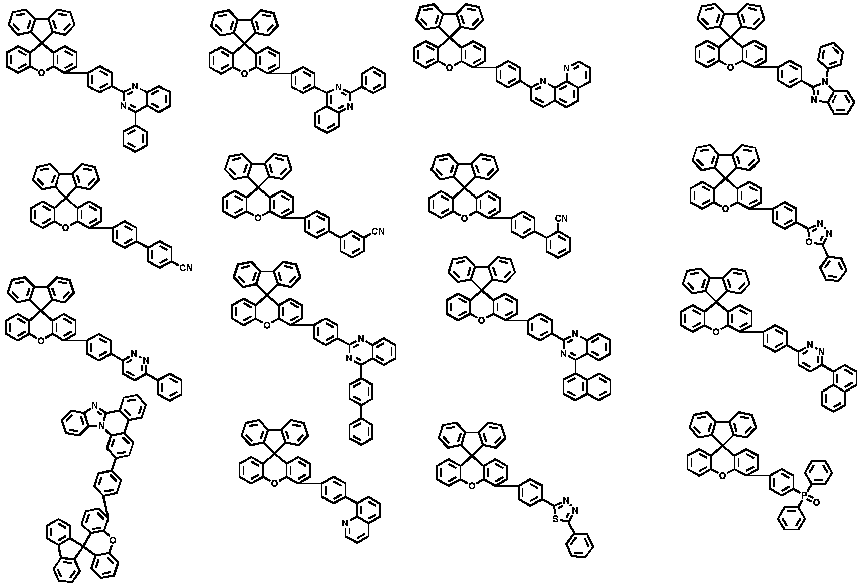

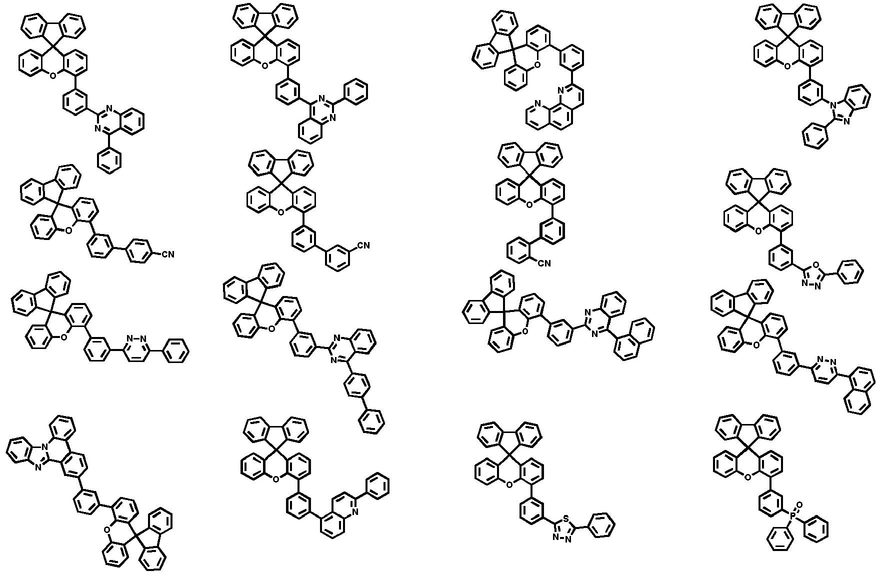

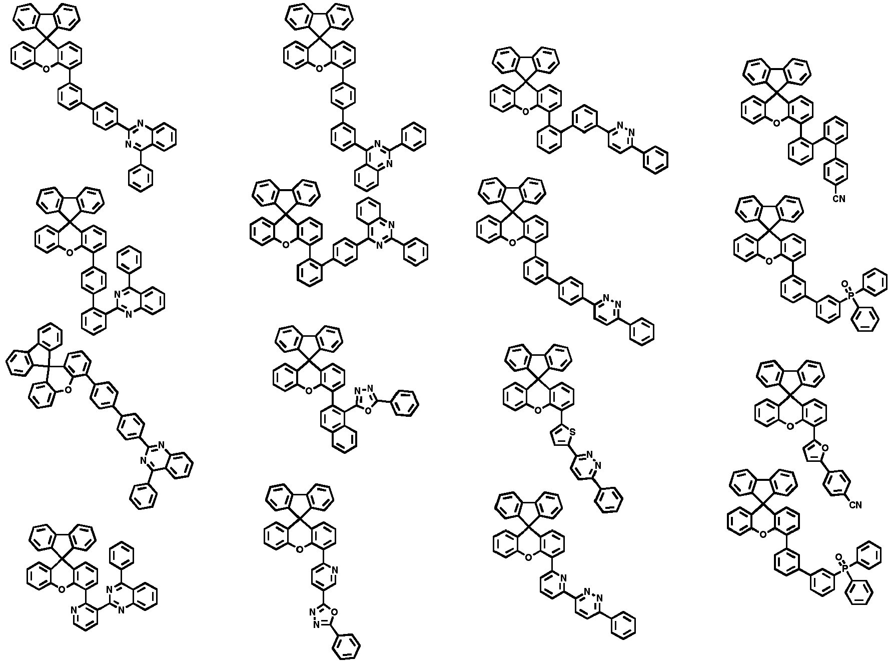

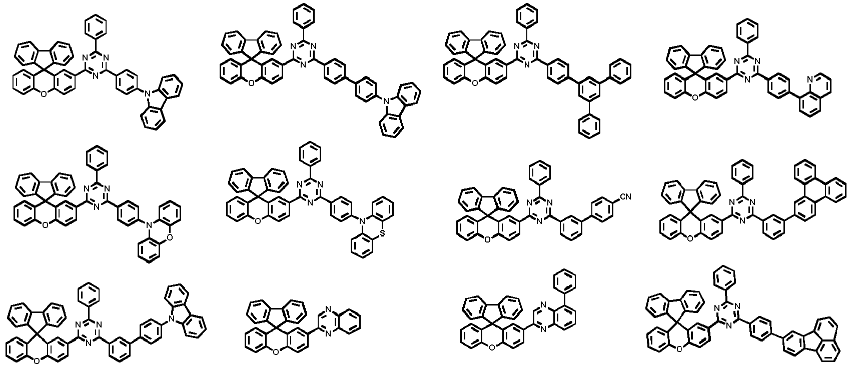

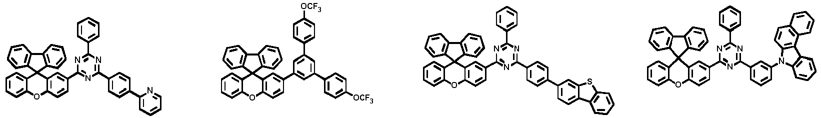

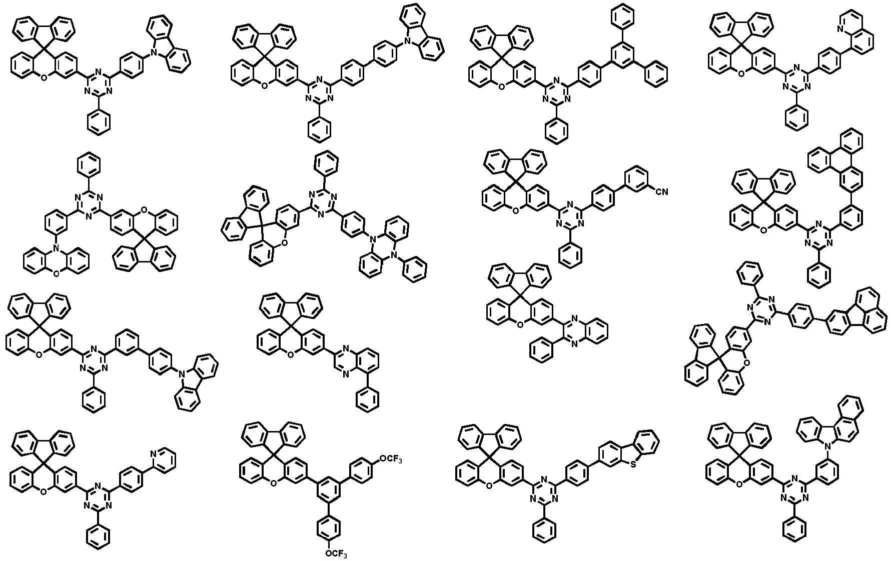

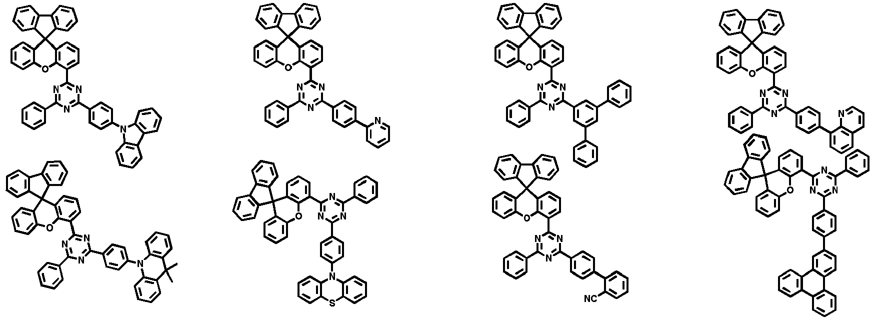

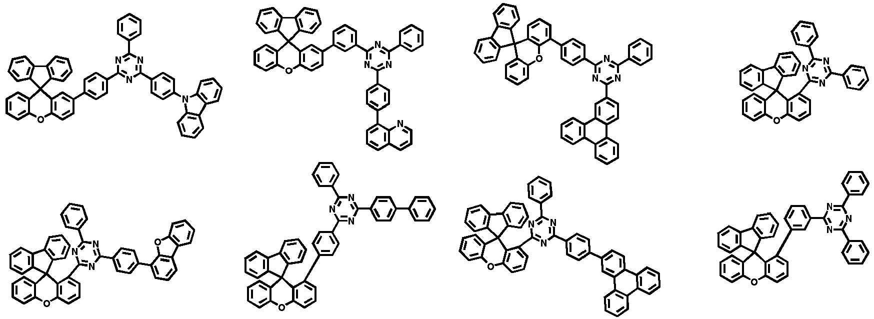

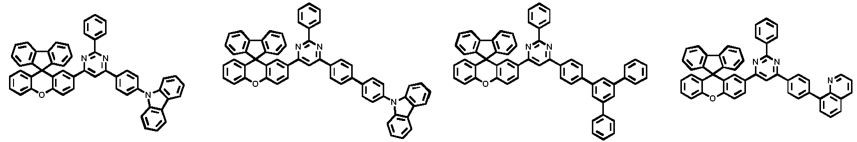

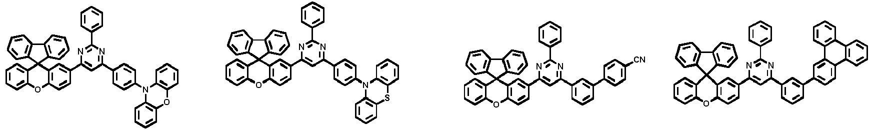

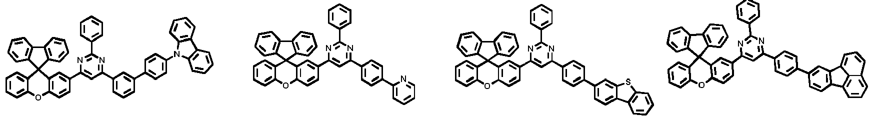

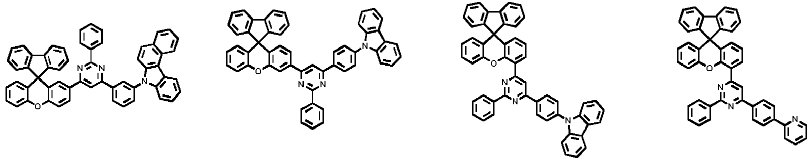

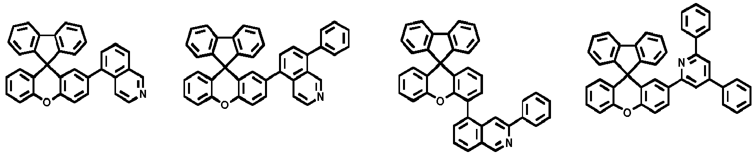

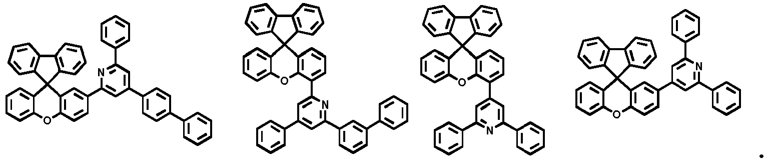

12. The organic light emitting device of Claim 1, wherein Chemical Formula 3 is any one selected from among the following compounds:

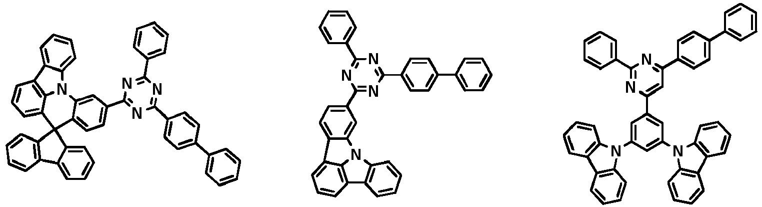

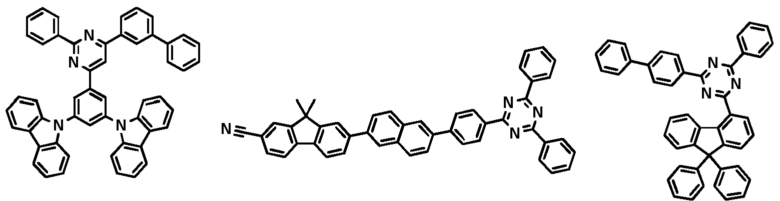

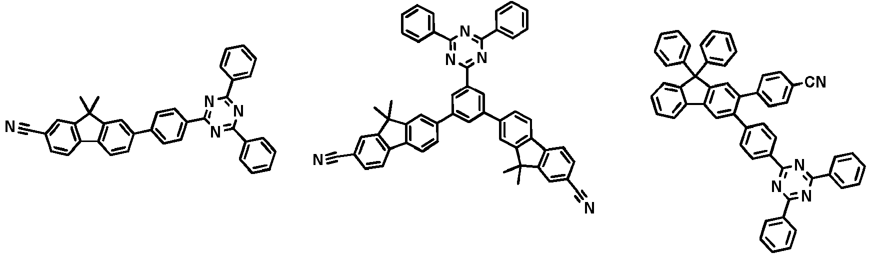

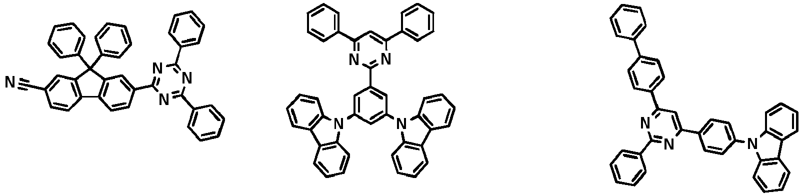

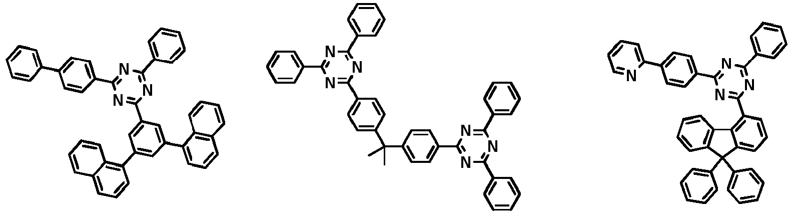

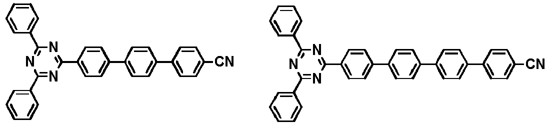

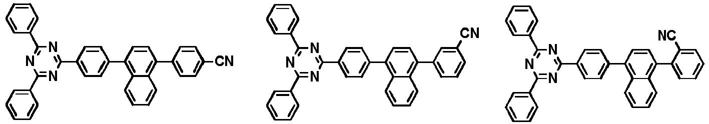

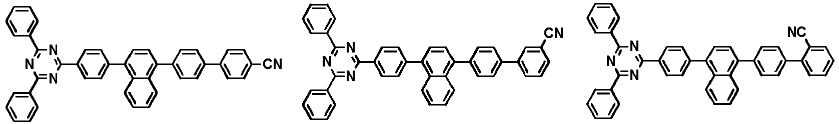

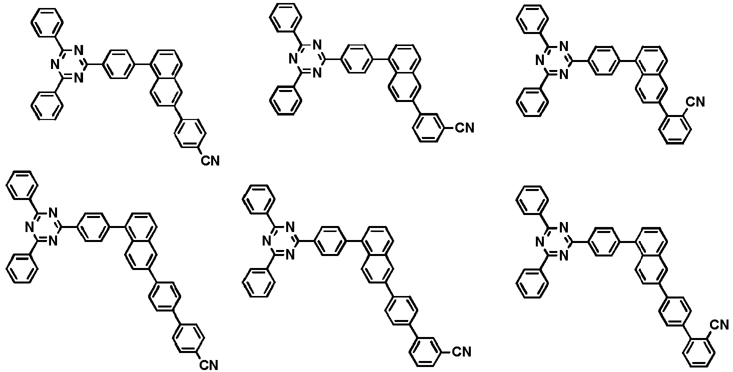

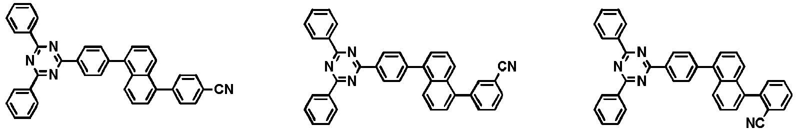

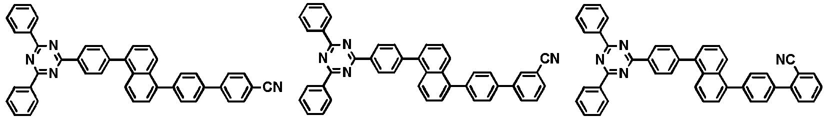

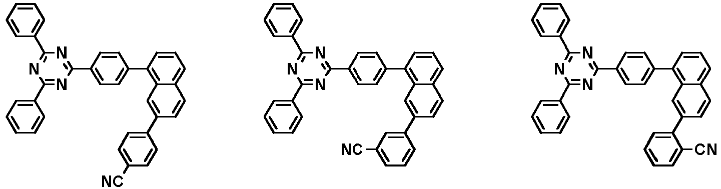

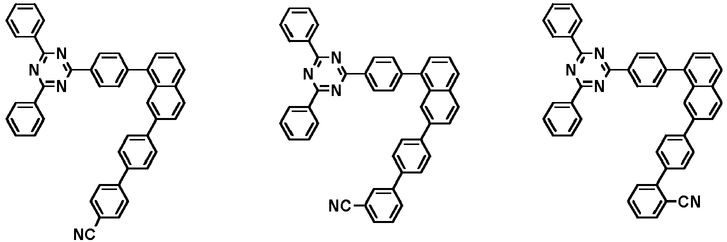

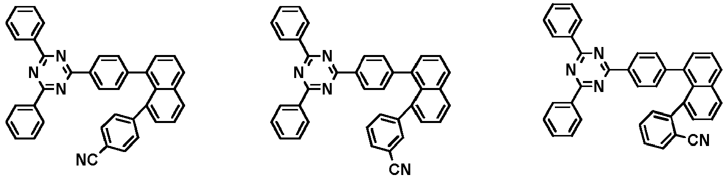

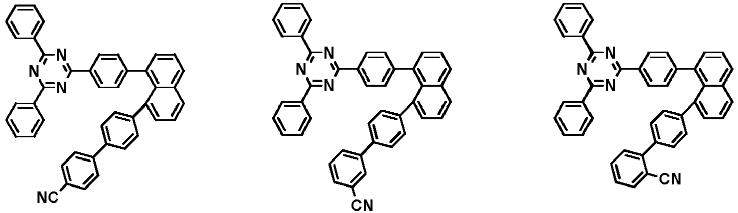

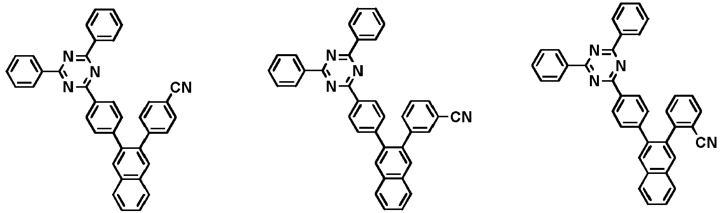

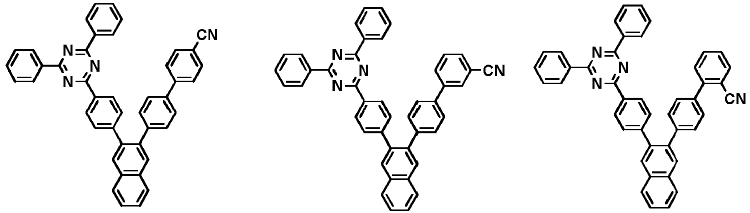

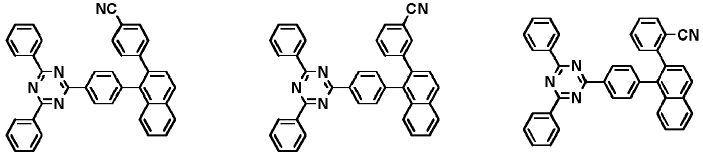

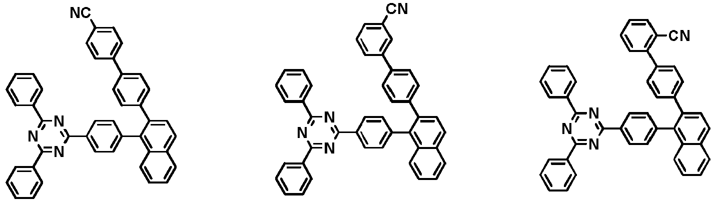

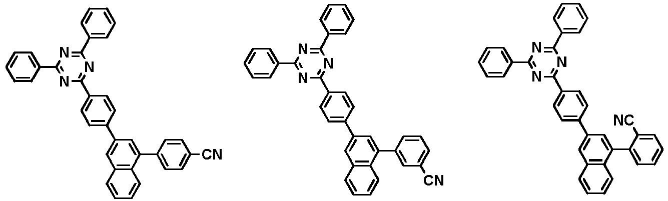

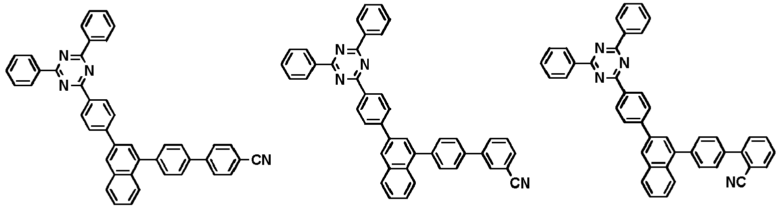

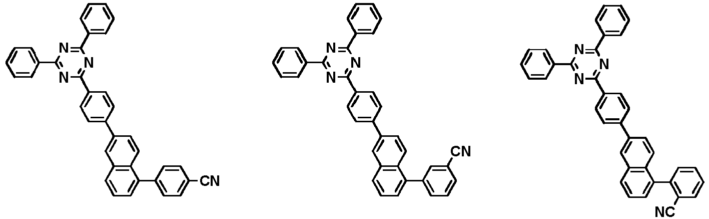

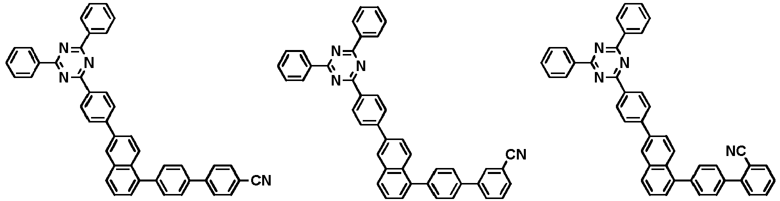

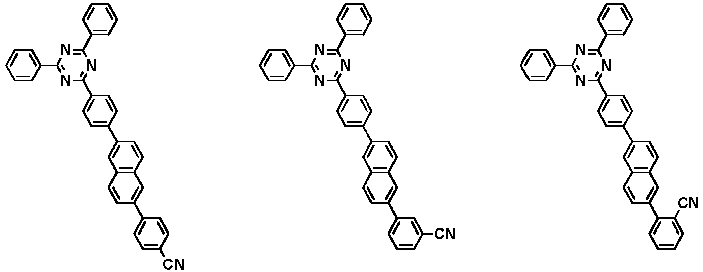

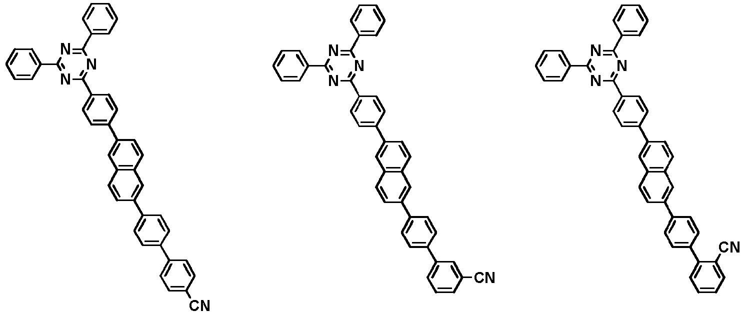

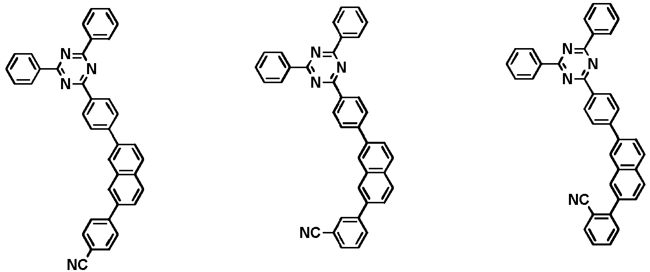

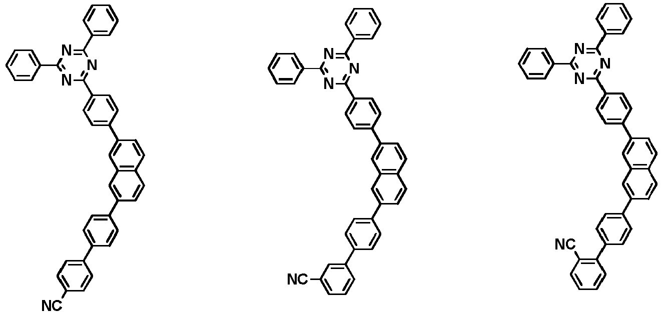

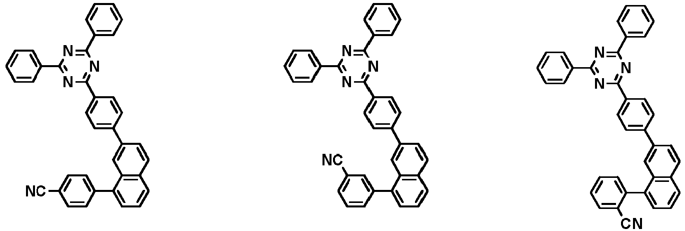

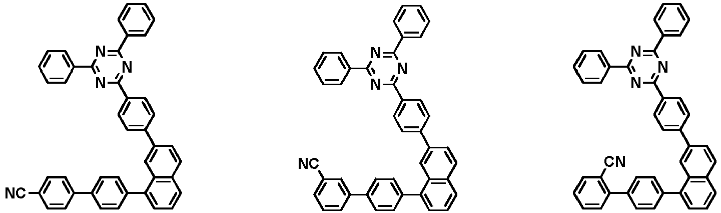

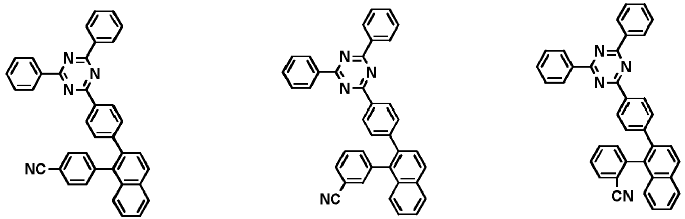

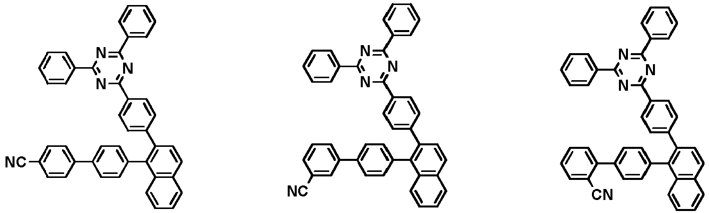

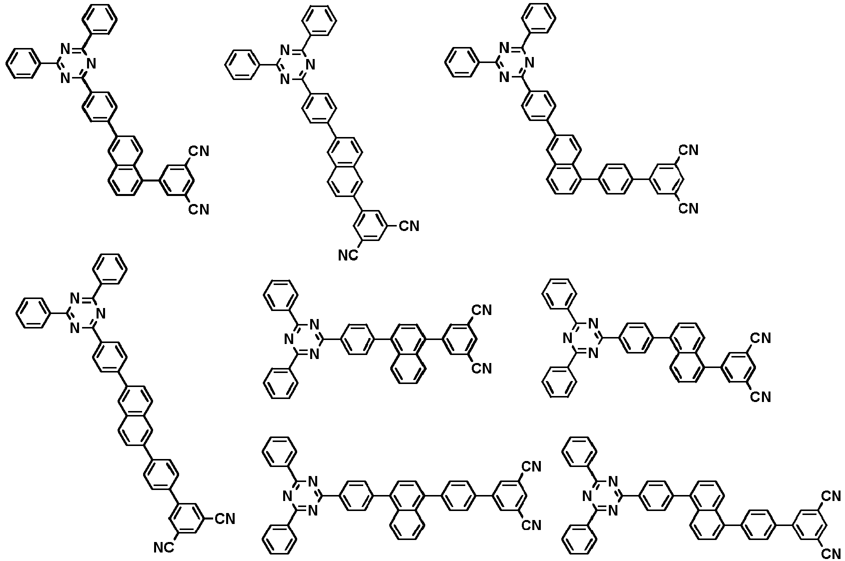

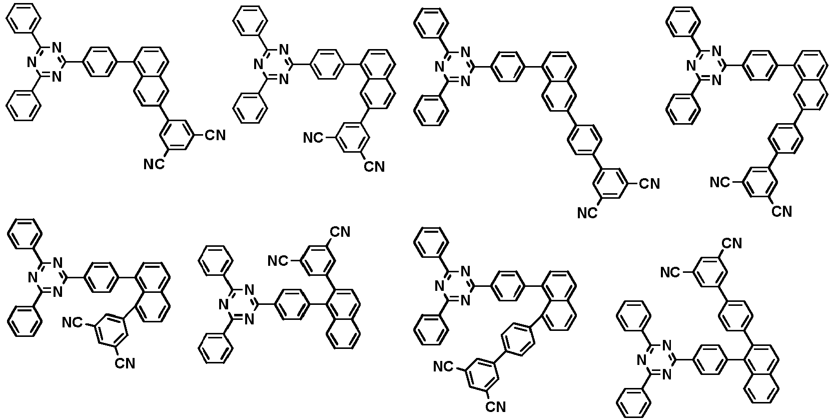

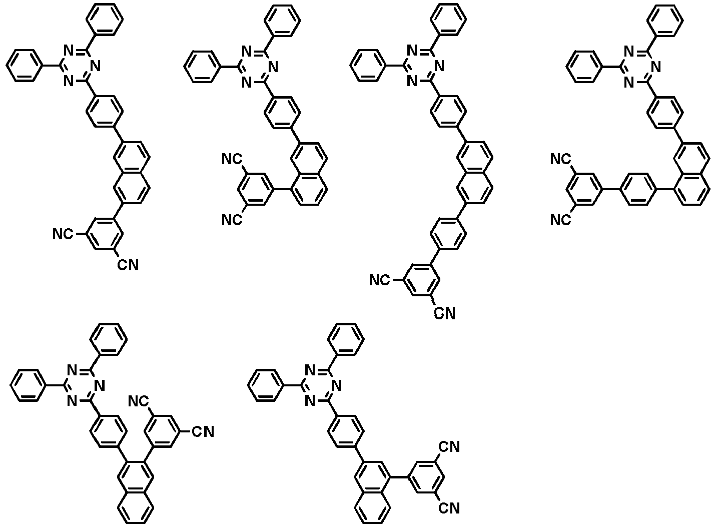

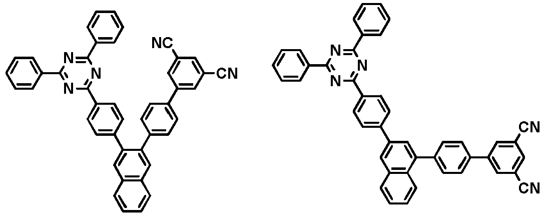

13. The organic light emitting device of Claim 1, wherein the compound represented by Chemical Formula 1 has a bandgap of 3.0 eV or greater.

14. The organic light emitting device of Claim 1, wherein the organic light emitting device further includes one or more organic material layers selected from among a hole injection layer, a hole transfer layer and an electron injection layer.

## Patentansprüche

1. Organische lichtemittierende Vorrichtung, umfassend:
eine Anode (30),
eine Kathode (50) und
eine lichtemittierende Schicht (40), die zwischen der Anode (30) und der Kathode (50) angeordnet ist, wobei die Vorrichtung ferner umfasst:
eine Elektronensteuerungsschicht (100), die zwischen der lichtemittierenden Schicht (40) und der Kathode (50) angeordnet ist und eine durch die folgende chemische Formel 1 dargestellte Verbindung einschließt, und
eine Elektronentransferschicht (80), die zwischen der Elektronensteuerungsschicht (100) und der Kathode (50) angeordnet ist und eine durch die folgende chemische Formel 3 dargestellte Verbindung einschließt: 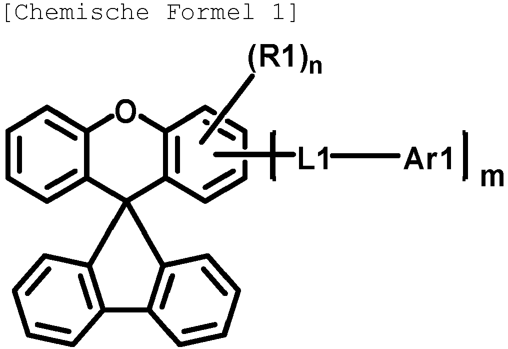 wobei in der chemischen Formel 1
R1 Wasserstoff, Deuterium, eine Nitrilgruppe, eine Nitrogruppe, eine Hydroxylgruppe, eine Carbonylgruppe, eine Estergruppe, eine Imidgruppe, eine Amidgruppe, eine substituierte oder unsubstituierte Alkylgruppe, eine substituierte oder unsubstituierte Cycloalkylgruppe, eine substituierte oder unsubstituierte Alkoxygruppe, eine substituierte oder unsubstituierte Aryloxygruppe, eine substituierte oder unsubstituierte Alkylthioxygruppe, eine substituierte oder unsubstituierte Arylthioxygruppe, eine substituierte oder unsubstituierte Alkylsulfoxygruppe, eine substituierte oder unsubstituierte Arylsulfoxygruppe, eine substituierte oder unsubstituierte Alkenylgruppe, eine substituierte oder unsubstituierte Silylgruppe, eine substituierte oder unsubstituierte Borgruppe, eine substituierte oder unsubstituierte Amingruppe, eine substituierte oder unsubstituierte Arylphosphingruppe, eine substituierte oder unsubstituierte Phosphinoxidgruppe, eine substituierte oder unsubstituierte Arylgruppe oder eine substituierte oder unsubstituierte Heteroarylgruppe ist,
L1 eine direkte Bindung, eine substituierte oder unsubstituierte Arylengruppe oder eine substituierte oder unsubstituierte Heteroarylengruppe ist,
Ar1 Wasserstoff, Deuterium, eine Nitrilgruppe, eine Nitrogruppe, eine Hydroxylgruppe, eine Carbonylgruppe, eine Estergruppe, eine Imidgruppe, eine Amidgruppe, eine substituierte oder unsubstituierte Alkylgruppe, eine substituierte oder unsubstituierte Cycloalkylgruppe, eine substituierte oder unsubstituierte Alkoxygruppe, eine substituierte oder unsubstituierte Aryloxygruppe, eine substituierte oder unsubstituierte Alkylthioxygruppe, eine substituierte oder unsubstituierte Arylthioxygruppe, eine substituierte oder unsubstituierte Alkylsulfoxygruppe, eine substituierte oder unsubstituierte Arylsulfoxygruppe, eine substituierte oder unsubstituierte Alkenylgruppe, eine substituierte oder unsubstituierte Silylgruppe, eine substituierte oder unsubstituierte Borgruppe, eine substituierte oder unsubstituierte Amingruppe, eine substituierte oder unsubstituierte Arylphosphingruppe, eine substituierte oder unsubstituierte Phosphinoxidgruppe, eine substituierte oder unsubstituierte Arylgruppe, eine substituierte oder unsubstituierte monocyclische heterocyclische Gruppe, eine substituierte oder unsubstituierte tricyclische oder höhere heterocyclische Gruppe, eine substituierte oder unsubstituierte dicyclische heterocyclische Gruppe einschließlich zwei oder mehr N, eine substituierte oder unsubstituierte Isochinolylgruppe oder eine durch die folgende chemische Formel 2 dargestellte Struktur ist,
m eine ganze Zahl von 1 bis 4 ist, n eine ganze Zahl von 0 bis 3 ist und 1≤n+m≤4 ist und
wenn m und n jeweils eine ganze Zahl von 2 oder größer sind, Strukturen in den zwei oder mehr Klammern gleich oder verschieden voneinander sind, 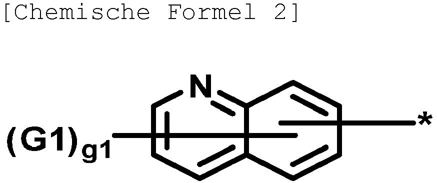
in der chemischen Formel 2
G1 Wasserstoff, Deuterium, eine Nitrilgruppe, eine Nitrogruppe, eine Hydroxylgruppe, eine Carbonylgruppe, eine Estergruppe, eine Imidgruppe, eine Amidgruppe, eine substituierte oder unsubstituierte Alkylgruppe, eine substituierte oder unsubstituierte Cycloalkylgruppe, eine substituierte oder unsubstituierte Alkoxygruppe, eine substituierte oder unsubstituierte Aryloxygruppe, eine substituierte oder unsubstituierte Alkylthioxygruppe, eine substituierte oder unsubstituierte Arylthioxygruppe, eine substituierte oder unsubstituierte Alkylsulfoxygruppe, eine substituierte oder unsubstituierte Arylsulfoxygruppe, eine substituierte oder unsubstituierte Alkenylgruppe, eine substituierte oder unsubstituierte Silylgruppe, eine substituierte oder unsubstituierte Borgruppe, eine substituierte oder unsubstituierte Amingruppe, eine substituierte oder unsubstituierte Arylphosphingruppe, eine substituierte oder unsubstituierte Phosphinoxidgruppe, eine substituierte oder unsubstituierte Arylgruppe oder eine substituierte oder unsubstituierte Heteroarylgruppe ist,
g1 eine ganze Zahl von 1 bis 6 ist, und wenn g1 2 oder größer ist, die G1 gleich oder verschieden voneinander sind, und
* eine Stelle ist, die an L1 der chemischen Formel 1 bindet, 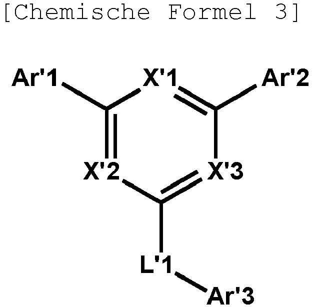
in der chemischen Formel 3
Ar'1 und Ar'2 gleich oder verschieden voneinander und jeweils unabhängig eine substituierte oder unsubstituierte Arylgruppe oder eine substituierte oder unsubstituierte Heteroarylgruppe sind,
X'1 N oder CR'1 ist, X'2 N oder CR'2 ist und X'3 N oder CR'3 ist,
mindestens zwei von X'1 bis X'3 N sind,
L'1 eine direkte Bindung, eine substituierte oder unsubstituierte Arylengruppe oder eine substituierte oder unsubstituierte Heteroarylengruppe ist,
R'1 bis R'3 gleich oder verschieden voneinander und jeweils unabhängig Wasserstoff, Deuterium, eine Nitrilgruppe, eine Nitrogruppe, eine Hydroxylgruppe, eine Carbonylgruppe, eine Estergruppe, eine Imidgruppe, eine Amidgruppe, eine substituierte oder unsubstituierte Alkylgruppe, eine substituierte oder unsubstituierte Cycloalkylgruppe, eine substituierte oder unsubstituierte Alkoxygruppe, eine substituierte oder unsubstituierte Aryloxygruppe, eine substituierte oder unsubstituierte Alkylthioxygruppe, eine substituierte oder unsubstituierte Arylthioxygruppe, eine substituierte oder unsubstituierte Alkylsulfoxygruppe, eine substituierte oder unsubstituierte Arylsulfoxygruppe, eine substituierte oder unsubstituierte Alkenylgruppe, eine substituierte oder unsubstituierte Silylgruppe, eine substituierte oder unsubstituierte Borgruppe, eine substituierte oder unsubstituierte Amingruppe, eine substituierte oder unsubstituierte Arylphosphingruppe, eine substituierte oder unsubstituierte Phosphinoxidgruppe, eine substituierte oder unsubstituierte Arylgruppe oder eine substituierte oder unsubstituierte Heteroarylgruppe sind und
Ar'3 durch die folgende chemische Formel 4a, 4b oder 4c dargestellt ist:
[Chemische Formel 4a] ****-(L'2)n1-Ar'4** 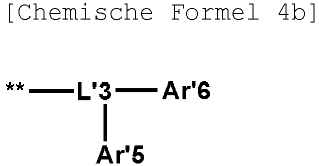 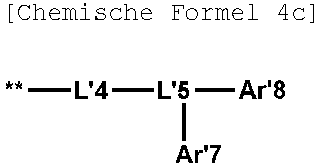
in den chemischen Formeln 4a bis 4c
** eine Stelle ist, die an L'1 der chemischen Formel 3 bindet,
n1 eine ganze Zahl von 1 bis 3 ist,
L'2 und L'4 gleich oder verschieden voneinander und jeweils unabhängig eine direkte Bindung, eine substituierte oder unsubstituierte Alkylengruppe, eine substituierte oder unsubstituierte Arylengruppe oder eine substituierte oder unsubstituierte Heteroarylengruppe sind,
L'3 und L'5 gleich oder verschieden voneinander und jeweils unabhängig eine substituierte oder unsubstituierte trivalente Arylgruppe oder eine substituierte oder unsubstituierte trivalente Heteroarylgruppe sind,
Ar'4 bis Ar'8 gleich oder verschieden voneinander und jeweils unabhängig eine Nitrilgruppe, eine Arylgruppe, die unsubstituiert oder mit einem, zwei oder mehr Substituenten, ausgewählt aus der Gruppe, bestehend aus einer substituierten oder unsubstituierten Alkylgruppe, einer substituierten oder unsubstituierten Arylgruppe, einer substituierten oder unsubstituierten Pyridylgruppe, einer substituierten oder unsubstituierten Carbazolgruppe und einer Nitrilgruppe, substituiert ist, oder eine substituierte oder unsubstituierte Heteroarylgruppe sind.

2. Organische lichtemittierende Vorrichtung gemäß Anspruch 1, worin die Elektronentransferschicht ferner eine durch die folgende chemische Formel 5 dargestellte Verbindung einschließt: 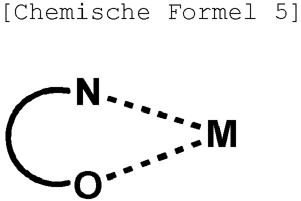 in der chemischen Formel 5
M ein Alkalimetall oder ein Erdalkalimetall ist,
eine Kurve, die N und O verbindet, Bindungen oder Atome darstellt, die erforderlich sind, um einen substituierten oder unsubstituierten Ring, der N oder O einschließt, zu bilden, und
eine gestrichelte Linie bedeutet, dass N und O einen Metallkomplex mit M bilden.

3. Organische lichtemittierende Vorrichtung gemäß Anspruch 1, worin Ar1 eine Nitrilgruppe, eine substituierte oder unsubstituierte Alkoxygruppe, eine substituierte oder unsubstituierte Phosphinoxidgruppe, eine substituierte oder unsubstituierte Silylgruppe, eine substituierte oder unsubstituierte Arylgruppe, eine substituierte oder unsubstituierte monocyclische heterocyclische Gruppe, eine substituierte oder unsubstituierte tricyclische oder höhere heterocyclische Gruppe, eine substituierte oder unsubstituierte dicyclische heterocyclische Gruppe, die zwei oder mehr N einschließt, eine substituierte oder unsubstituierte Isochinolylgruppe oder die durch die chemische Formel 2 dargestellte Struktur ist.

4. Organische lichtemittierende Vorrichtung gemäß Anspruch 1, worin Ar1 durch irgendeine von der chemischen Formel 2 und den folgenden chemischen Formeln 6 bis 15 dargestellt ist: 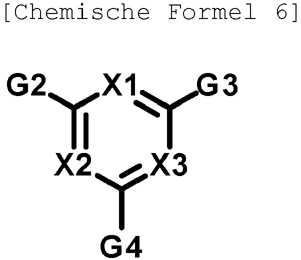 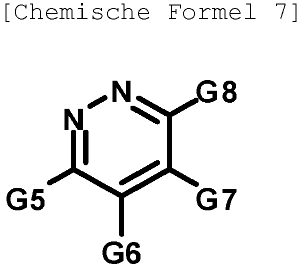 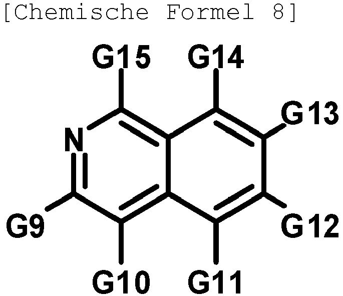 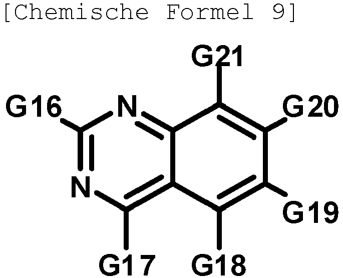 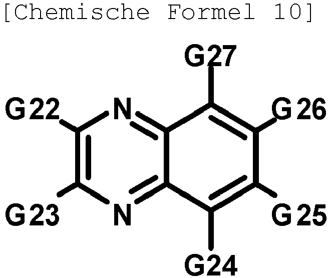 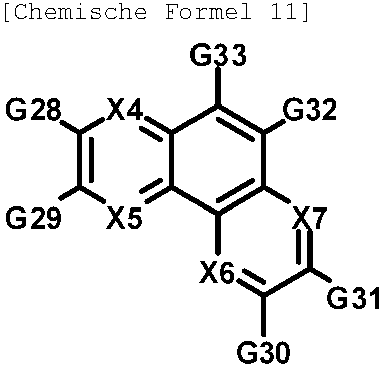 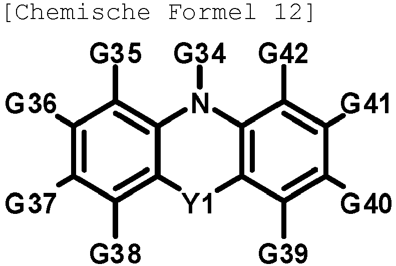 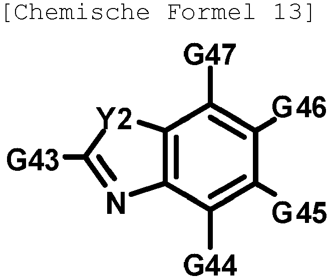 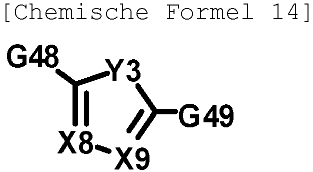 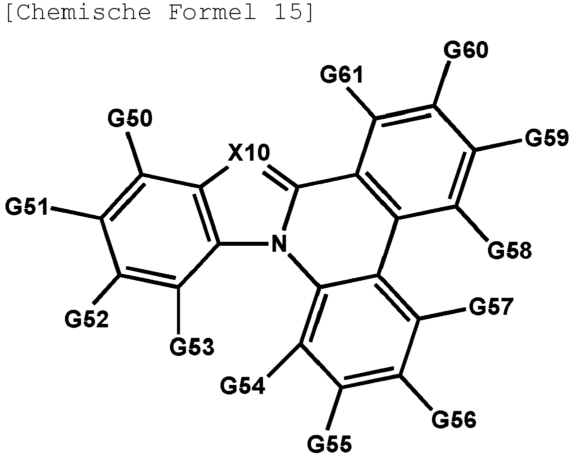 in den chemischen Formeln 6 bis 15
X1 N oder CR11 ist, X2 N oder CR12 ist, X3 N oder CR13 ist, X4 N oder CR14 ist, X5 N oder CR15 ist, X6 N oder CR16 ist, X7 N oder CR17 ist, X8 N oder CR18 ist, X9 N oder CR19 ist und X10 N oder CR20 ist,
mindestens zwei von X1 bis X3 N sind und mindestens eines von X4 bis X7 N ist.
Y1 O, S, NQ1 oder CQ2Q3 ist, Y2 O, S, NQ4 oder CQ5Q6 ist und Y3 O, S oder NQ7 ist,
irgendeines von G2 bis G4 und R11 bis R13, irgendeines von G5 bis G8, irgendeines von G9 bis G15, irgendeines von G16 bis G21, irgendeines von G22 bis G27, irgendeines von G28 bis G33 und R14 bis R17, irgendeines von G34 bis G42, irgendeines von G43 bis G47, irgendeines von G48, G49, R18 und R19 und irgendeines von G50 bis G61 eine Stelle sind, die an L1 der chemischen Formel 1 bindet, und
der Rest von G2 bis G61 und R11 bis R19, die sich von der Stelle, die an L1 der chemischen Formel 1 bindet, unterscheiden, R20 und Q1 bis Q7 gleich oder verschieden voneinander und jeweils unabhängig Wasserstoff, Deuterium, eine Nitrilgruppe, eine Nitrogruppe, eine Hydroxylgruppe, eine Carbonylgruppe, eine Estergruppe, eine Imidgruppe, eine Amidgruppe, eine substituierte oder unsubstituierte Alkylgruppe, eine substituierte oder unsubstituierte Cycloalkylgruppe, eine substituierte oder unsubstituierte Alkoxygruppe, eine substituierte oder unsubstituierte Aryloxygruppe, eine substituierte oder unsubstituierte Alkylthioxygruppe, eine substituierte oder unsubstituierte Arylthioxygruppe, eine substituierte oder unsubstituierte Alkylsulfoxygruppe, eine substituierte oder unsubstituierte Arylsulfoxygruppe, eine substituierte oder unsubstituierte Alkenylgruppe, eine substituierte oder unsubstituierte Silylgruppe, eine substituierte oder unsubstituierte Borgruppe, eine substituierte oder unsubstituierte Amingruppe, eine substituierte oder unsubstituierte Arylphosphingruppe, eine substituierte oder unsubstituierte Phosphinoxidgruppe, eine substituierte oder unsubstituierte Arylgruppe oder eine substituierte oder unsubstituierte Heteroarylgruppe sind.

5. Organische lichtemittierende Vorrichtung gemäß Anspruch 1, worin die chemische Formel 1 durch irgendeine der folgenden chemischen Formeln 1-1 bis 1-4 dargestellt ist: 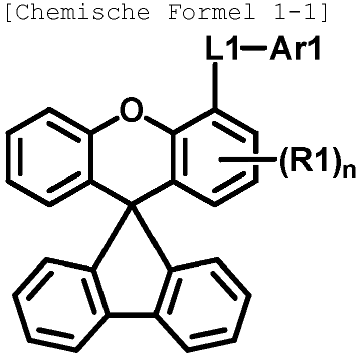 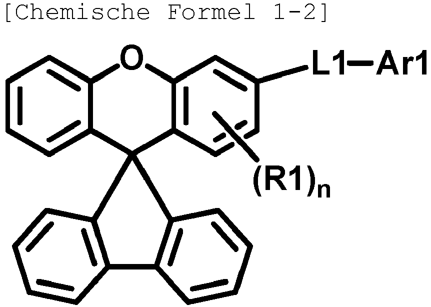 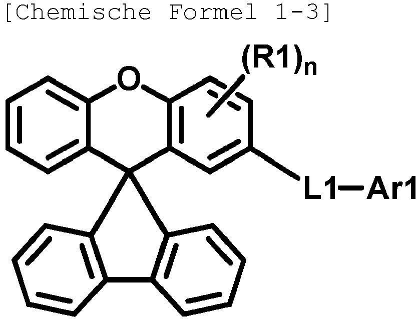 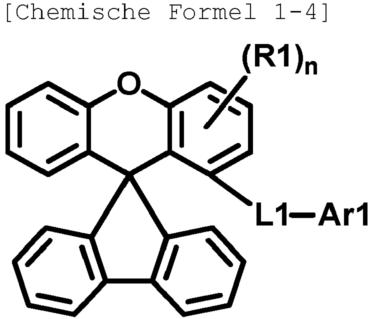 in den chemischen Formeln 1-1 bis 1-4
weisen L1, Ar1, R1 und n dieselben Definitionen wie in der chemischen Formel 1 auf.

6. Organische lichtemittierende Vorrichtung gemäß Anspruch 1, worin L1 eine direkte Bindung, eine substituierte oder unsubstituierte Phenylengruppe, eine substituierte oder unsubstituierte Biphenylengruppe, eine substituierte oder unsubstituierte Naphthylengruppe, eine substituierte oder unsubstituierte Terphenylengruppe, eine substituierte oder unsubstituierte Quaterphenylengruppe, eine substituierte oder unsubstituierte Anthracenylengruppe, eine substituierte oder unsubstituierte Phenanthrenylengruppe, eine substituierte oder unsubstituierte Triphenylenylengruppe, eine substituierte oder unsubstituierte Pyrenylengruppe, eine substituierte oder unsubstituierte Fluorenylengruppe, eine substituierte oder unsubstituierte Spirocyclopentanfluorenylengruppe, eine substituierte oder unsubstituierte Dibenzofuranylengruppe, eine substituierte oder unsubstituierte divalente Dibenzothiophengruppe, eine substituierte oder unsubstituierte Carbazolengruppe, eine substituierte oder unsubstituierte Pyridylengruppe, eine substituierte oder unsubstituierte divalente Furangruppe oder eine substituierte oder unsubstituierte divalente Thiophengruppe ist.

7. Organische lichtemittierende Vorrichtung gemäß Anspruch 1, worin L'1 eine direkte Bindung, eine substituierte oder unsubstituierte Phenylengruppe, eine substituierte oder unsubstituierte Biphenylengruppe, eine substituierte oder unsubstituierte Terphenylengruppe, eine substituierte oder unsubstituierte Naphthylengruppe oder eine substituierte oder unsubstituierte Fluorenylengruppe ist,
L'2 und L'4 gleich oder verschieden voneinander und jeweils unabhängig eine direkte Bindung, eine substituierte oder unsubstituierte Methylengruppe, eine substituierte oder unsubstituierte Ethylengruppe, eine substituierte oder unsubstituierte Propylengruppe, eine substituierte oder unsubstituierte Phenylengruppe, eine substituierte oder unsubstituierte Biphenylengruppe, eine substituierte oder unsubstituierte Terphenylengruppe, eine substituierte oder unsubstituierte Naphthylengruppe oder eine substituierte oder unsubstituierte Fluorenylengruppe sind und
L'3 und L'5 gleich oder verschieden voneinander und jeweils unabhängig eine substituierte oder unsubstituierte trivalente Phenylgruppe, eine substituierte oder unsubstituierte trivalente Biphenylgruppe, eine substituierte oder unsubstituierte trivalente Terphenylgruppe, eine substituierte oder unsubstituierte trivalente Naphthylgruppe oder eine substituierte oder unsubstituierte trivalente Fluorenylgruppe sind.

8. Organische lichtemittierende Vorrichtung gemäß Anspruch 1, worin Ar'1 und Ar'2 gleich oder verschieden voneinander und jeweils unabhängig eine substituierte oder unsubstituierte Phenylgruppe, eine substituierte oder unsubstituierte Biphenylgruppe, eine substituierte oder unsubstituierte Naphthylgruppe oder eine substituierte oder unsubstituierte Fluorenylgruppe sind.

9. Organische lichtemittierende Vorrichtung gemäß Anspruch 1, worin Ar'4 bis Ar'8 gleich oder verschieden voneinander und jeweils unabhängig durch eine Nitrilgruppe, eine Arylgruppe, die unsubstituiert oder mit einem oder zwei oder mehr Substituenten, ausgewählt aus der Gruppe, bestehend aus einer substituierten oder unsubstituierten Alkylgruppe, einer substituierten oder unsubstituierten Arylgruppe, einer substituierten oder unsubstituierten Pyridylgruppe, einer substituierten oder unsubstituierten Carbazolgruppe und einer Nitrilgruppe, substituiert ist, eine Triazingruppe, die unsubstituiert oder mit einer substituierten oder unsubstituierten Arylgruppe substituiert ist, oder irgendeine, ausgewählt unter den folgenden chemischen Formeln 16 bis 18, dargestellt sind: 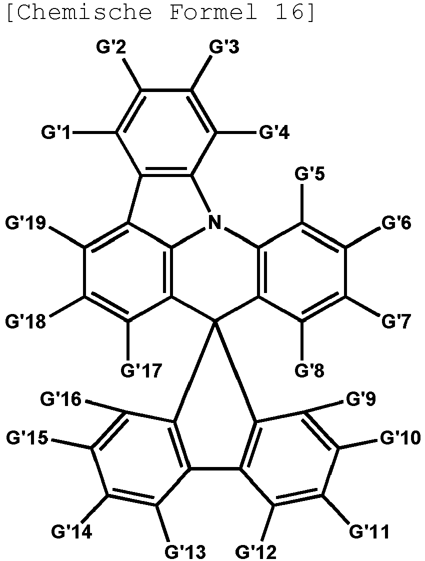 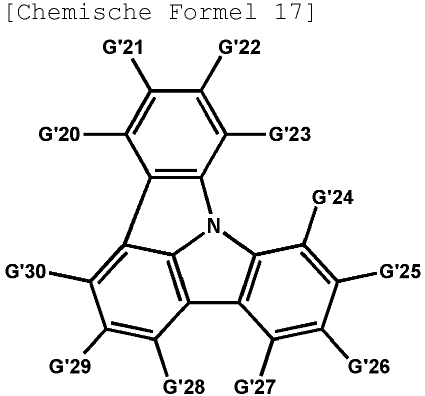 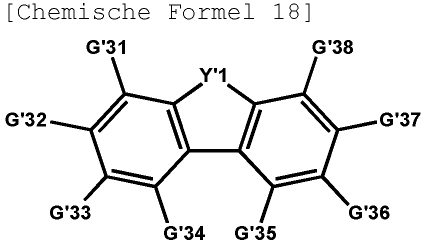 in den chemischen Formeln 16 bis 18
Y'1 O, S oder NR'4 ist,
irgendeines von G'1 bis G'19, irgendeines von G'20 bis G'30 und irgendeines von G'31 bis G'38 und R'4 eine Stelle sind, die an L'2 der chemischen Formel 4a, L'3 der chemischen Formel 4b oder L'5 der chemischen Formeln 4c bindet, und
der Rest von G'1 bis G'38 und R'4, die sich von der Stelle, die an L'2 der chemischen Formel 4a, L'3 der chemischen Formel 4b oder L'5 der chemischen Formel 4c bindet, unterscheiden, gleich oder verschieden voneinander und jeweils unabhängig Wasserstoff, Deuterium, eine Nitrilgruppe, eine Nitrogruppe, eine Hydroxylgruppe, eine Carbonylgruppe, eine Estergruppe, eine Imidgruppe, eine Amidgruppe, eine substituierte oder unsubstituierte Alkylgruppe, eine substituierte oder unsubstituierte Cycloalkylgruppe, eine substituierte oder unsubstituierte Alkoxygruppe, eine substituierte oder unsubstituierte Aryloxygruppe, eine substituierte oder unsubstituierte Alkylthioxygruppe, eine substituierte oder unsubstituierte Arylthioxygruppe, eine substituierte oder unsubstituierte Alkylsulfoxygruppe, eine substituierte oder unsubstituierte Arylsulfoxygruppe, eine substituierte oder unsubstituierte Alkenylgruppe, eine substituierte oder unsubstituierte Silylgruppe, eine substituierte oder unsubstituierte Borgruppe, eine substituierte oder unsubstituierte Amingruppe, eine substituierte oder unsubstituierte Arylphosphingruppe, eine substituierte oder unsubstituierte Phosphinoxidgruppe, eine substituierte oder unsubstituierte Arylgruppe oder eine substituierte oder unsubstituierte Heteroarylgruppe sind.

10. Organische lichtemittierende Vorrichtung gemäß Anspruch 2, worin die chemische Formel 5 durch die folgende chemische Formel 5-1 dargestellt ist: 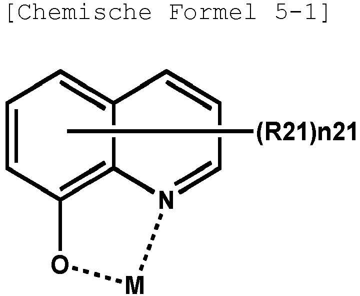 in der chemischen Formel 5-1
R21 Wasserstoff, Deuterium, eine Nitrilgruppe, eine Nitrogruppe, eine Hydroxylgruppe, eine Carbonylgruppe, eine Estergruppe, eine Imidgruppe, eine Amidgruppe, eine substituierte oder unsubstituierte Alkylgruppe, eine substituierte oder unsubstituierte Cycloalkylgruppe, eine substituierte oder unsubstituierte Alkoxygruppe, eine substituierte oder unsubstituierte Aryloxygruppe, eine substituierte oder unsubstituierte Alkylthioxygruppe, eine substituierte oder unsubstituierte Arylthioxygruppe, eine substituierte oder unsubstituierte Alkylsulfoxygruppe, eine substituierte oder unsubstituierte Arylsulfoxygruppe, eine substituierte oder unsubstituierte Alkenylgruppe, eine substituierte oder unsubstituierte Silylgruppe, eine substituierte oder unsubstituierte Borgruppe, eine substituierte oder unsubstituierte Amingruppe, eine substituierte oder unsubstituierte Arylphosphingruppe, eine substituierte oder unsubstituierte Phosphinoxidgruppe, eine substituierte oder unsubstituierte Arylgruppe oder eine substituierte oder unsubstituierte Heteroarylgruppe ist,
n21 eine ganze Zahl von 1 bis 6 ist, und wenn n21 eine ganze Zahl von 2 oder größer ist, Substituenten in den Klammern gleich oder verschieden voneinander sind, und
die restlichen Substituenten dieselben Definitionen wie in der chemischen Formel 5 aufweisen.

11. Organische lichtemittierende Vorrichtung gemäß Anspruch 1, worin die chemische Formel 1 irgendeine, ausgewählt unter folgenden Verbindungen, ist:

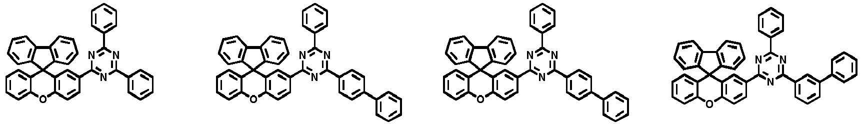

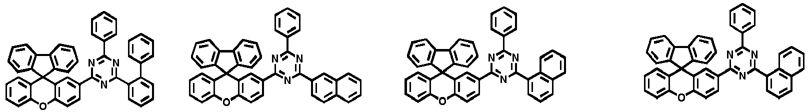

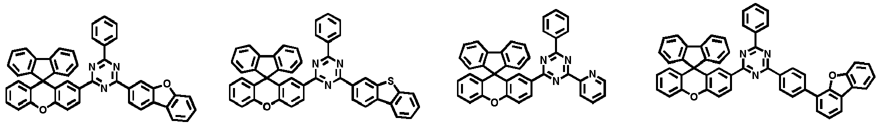

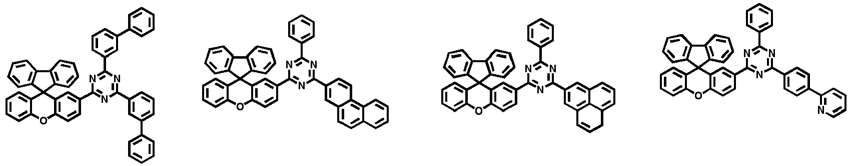

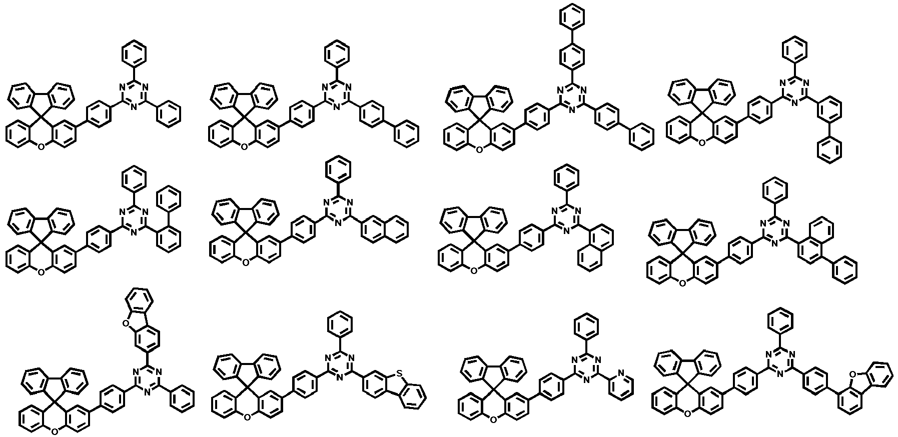

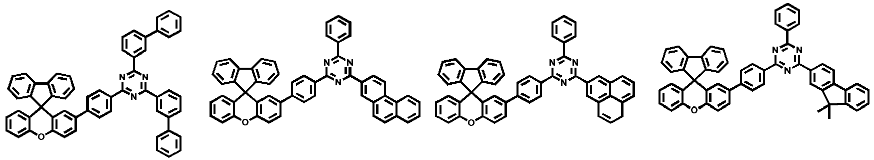

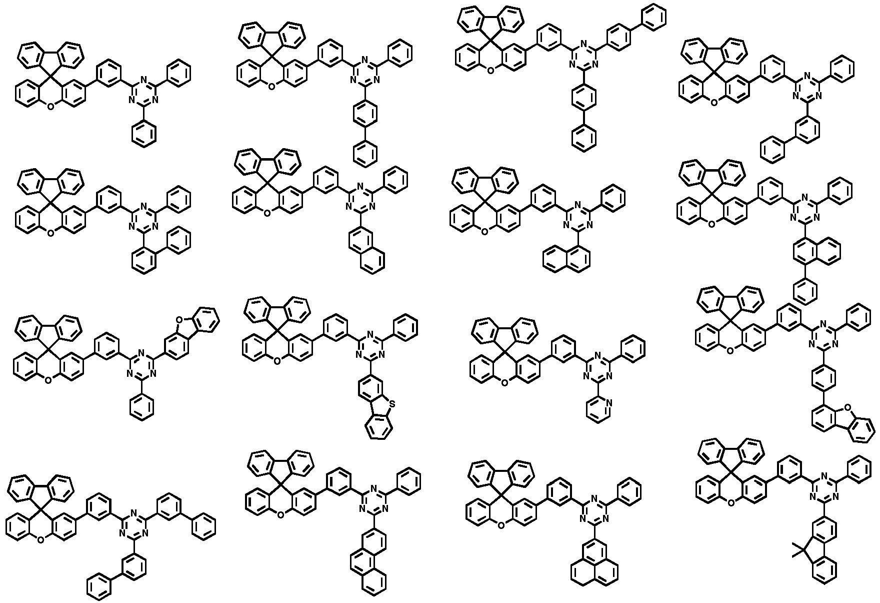

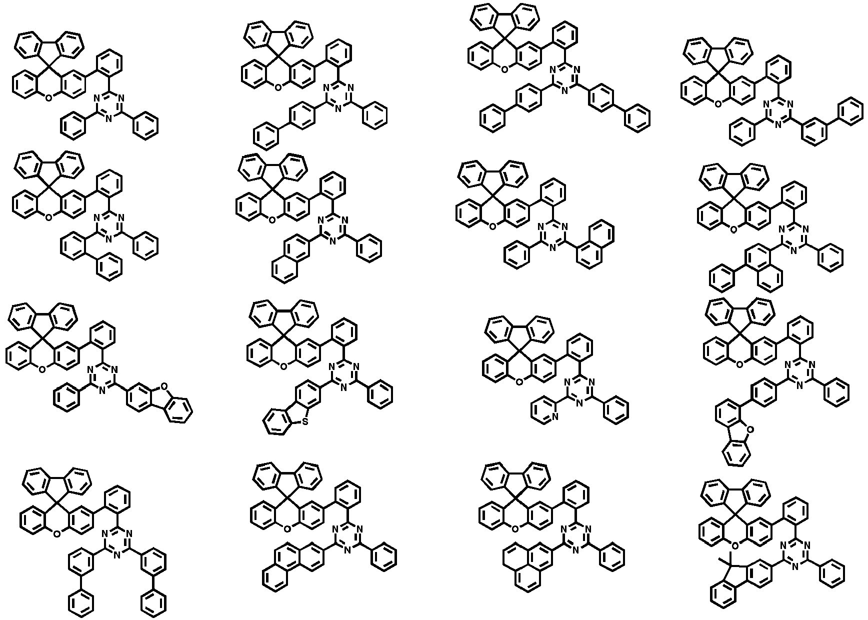

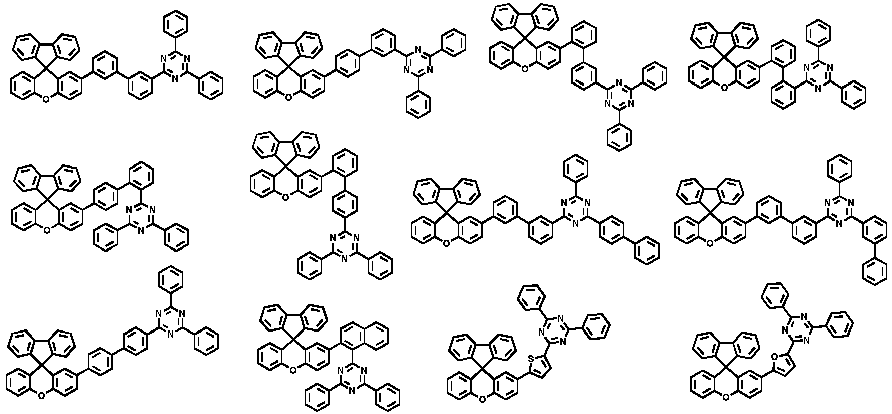

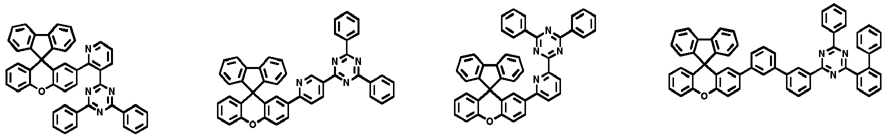

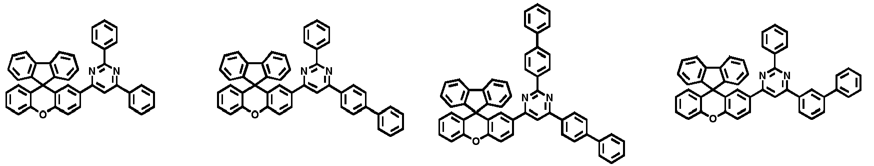

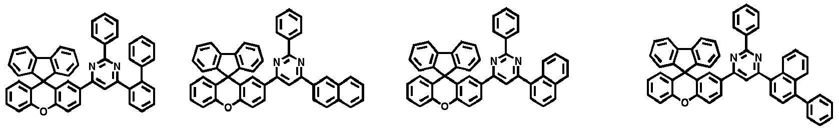

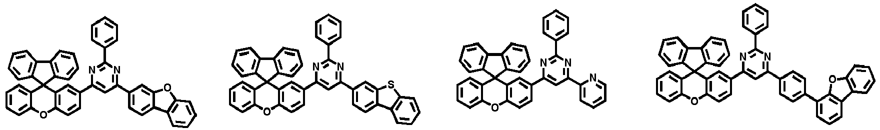

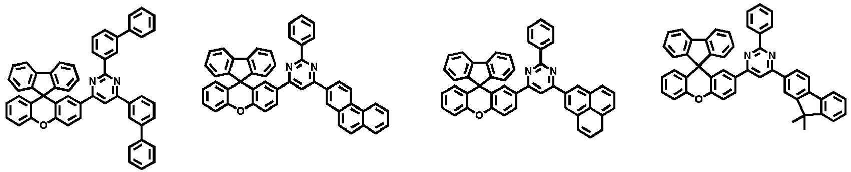

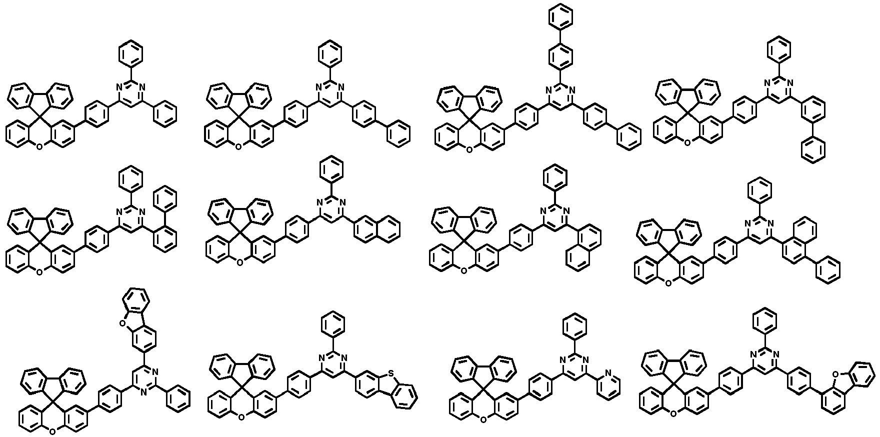

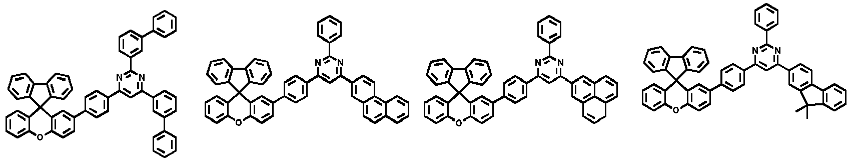

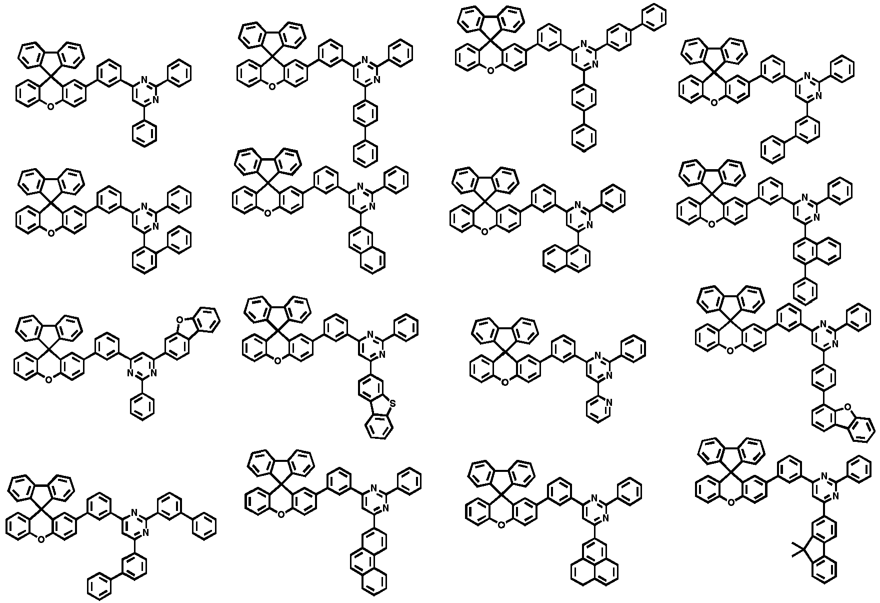

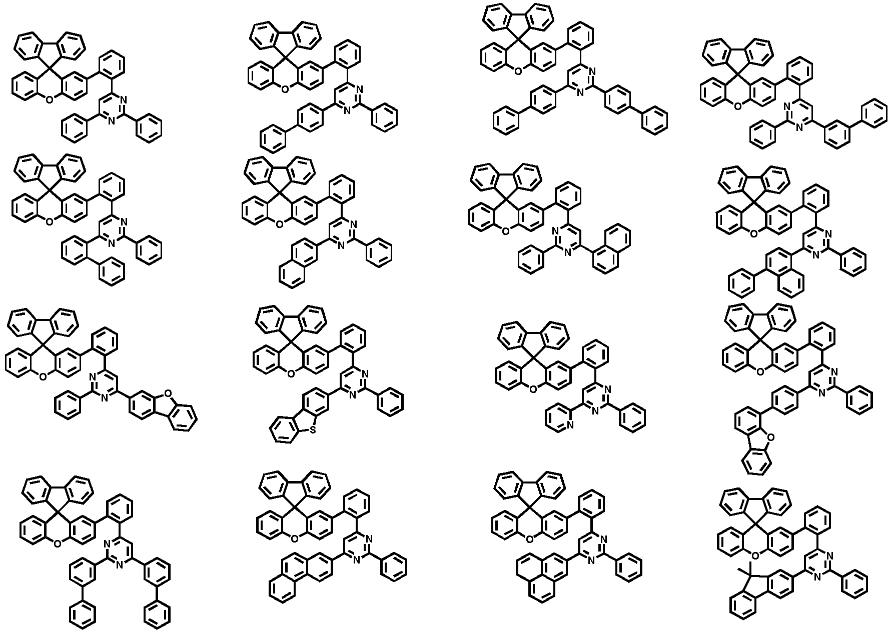

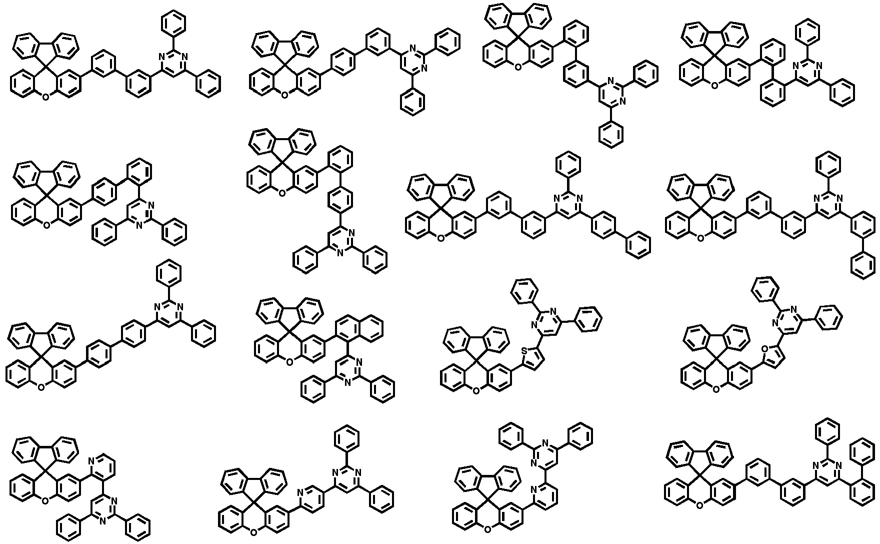

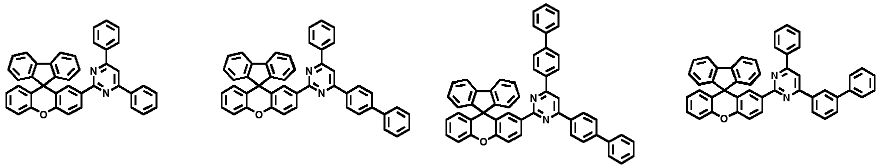

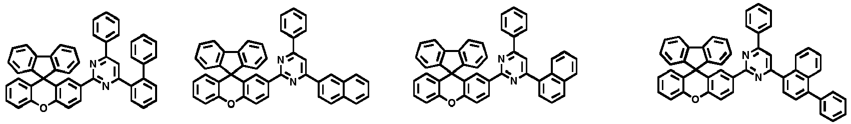

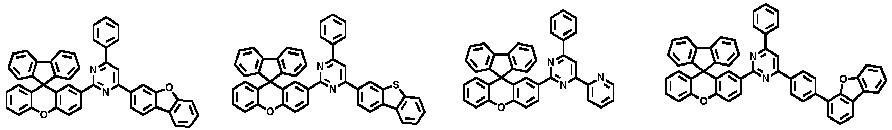

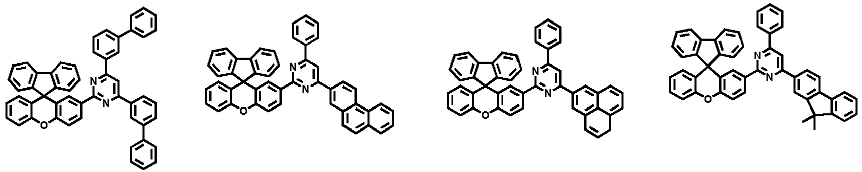

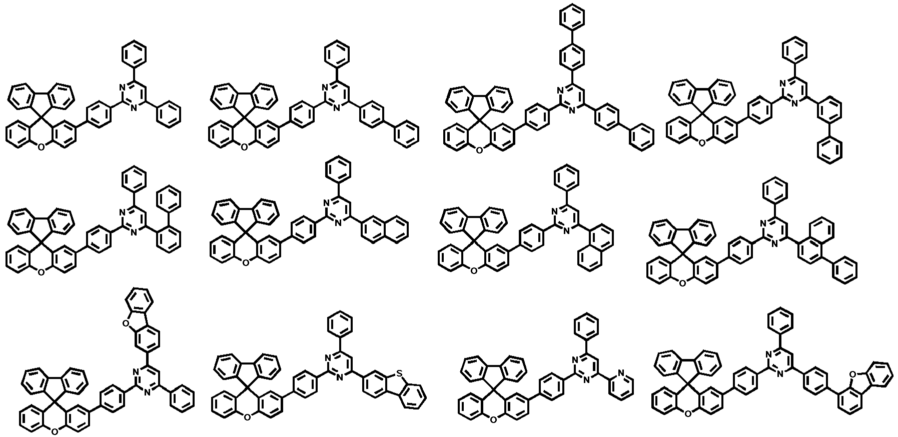

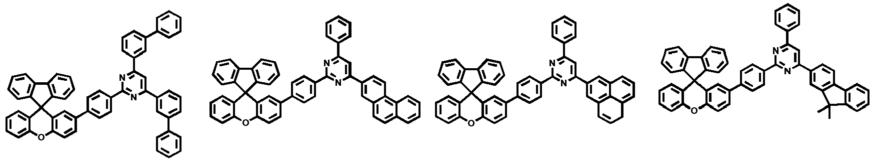

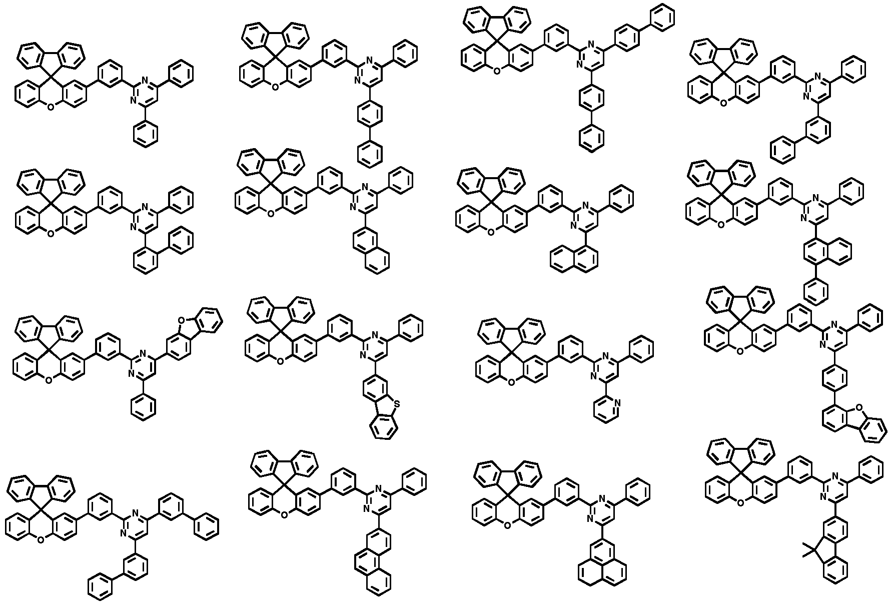

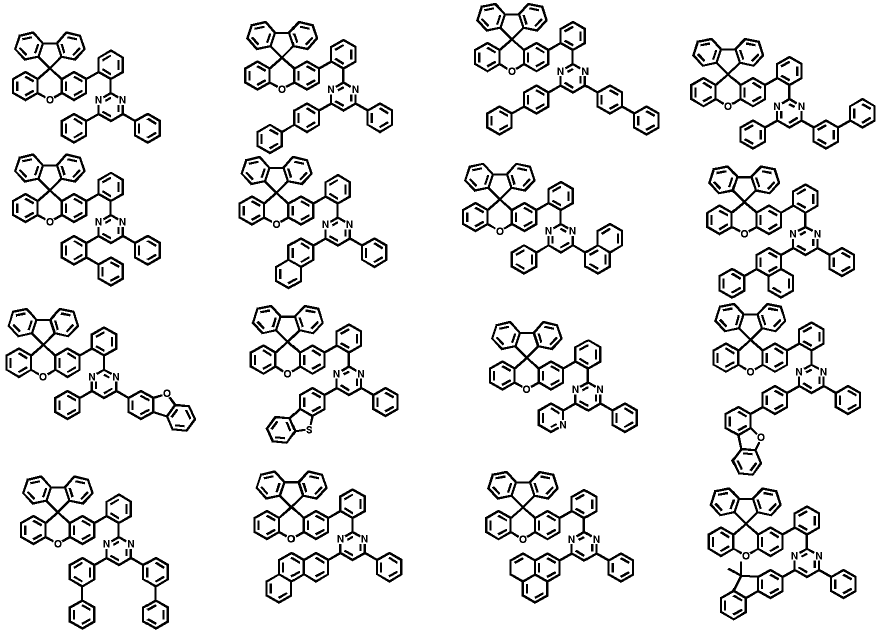

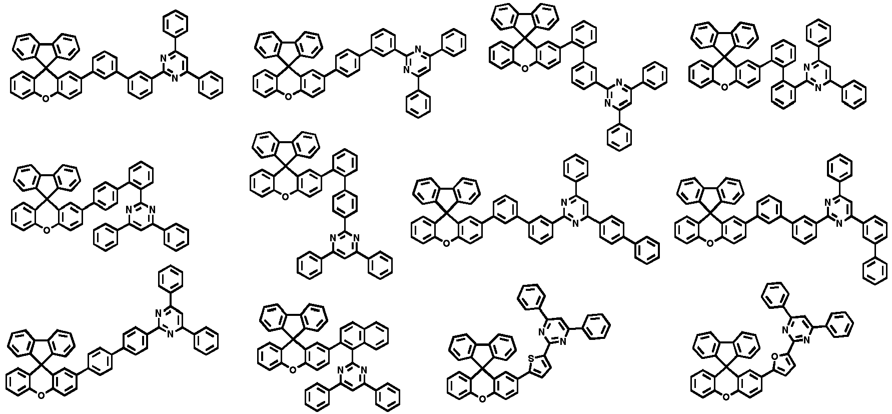

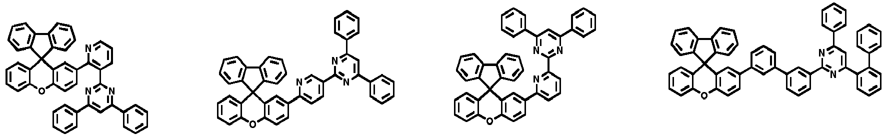

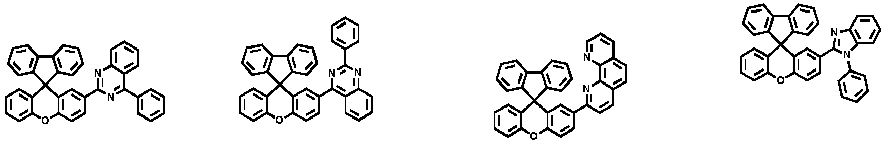

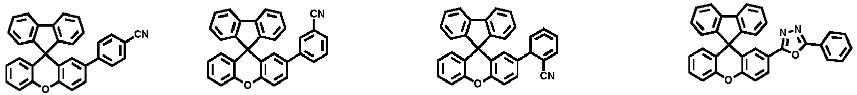

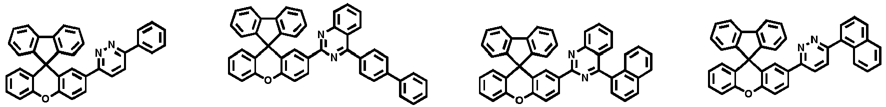

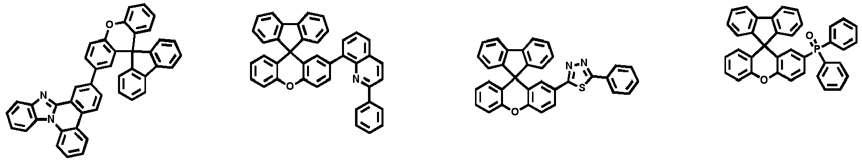

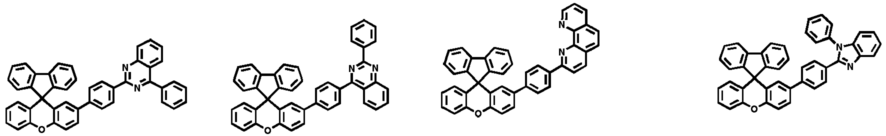

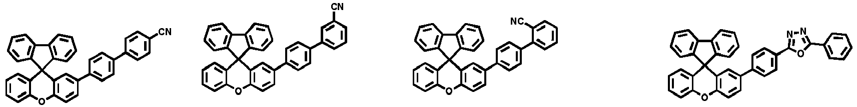

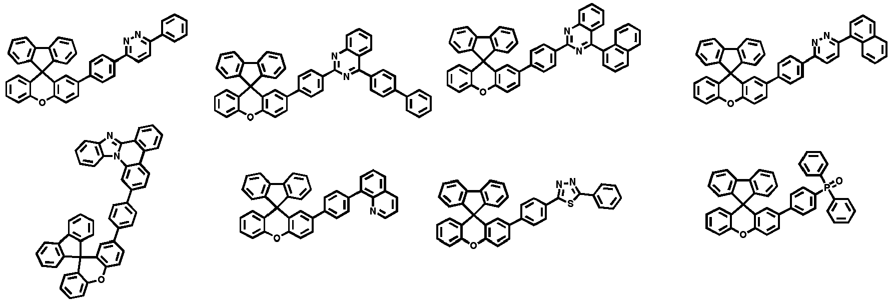

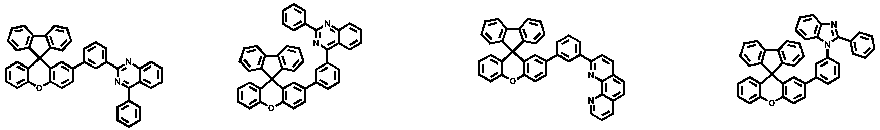

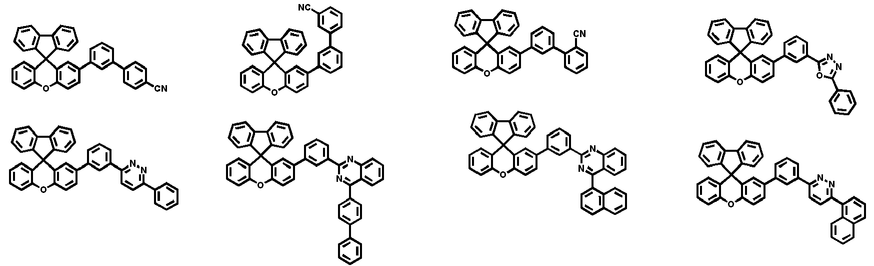

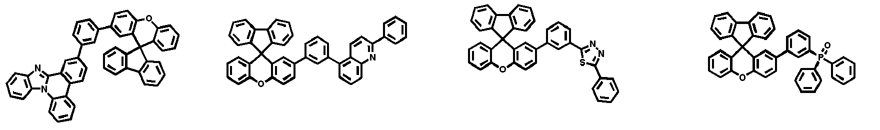

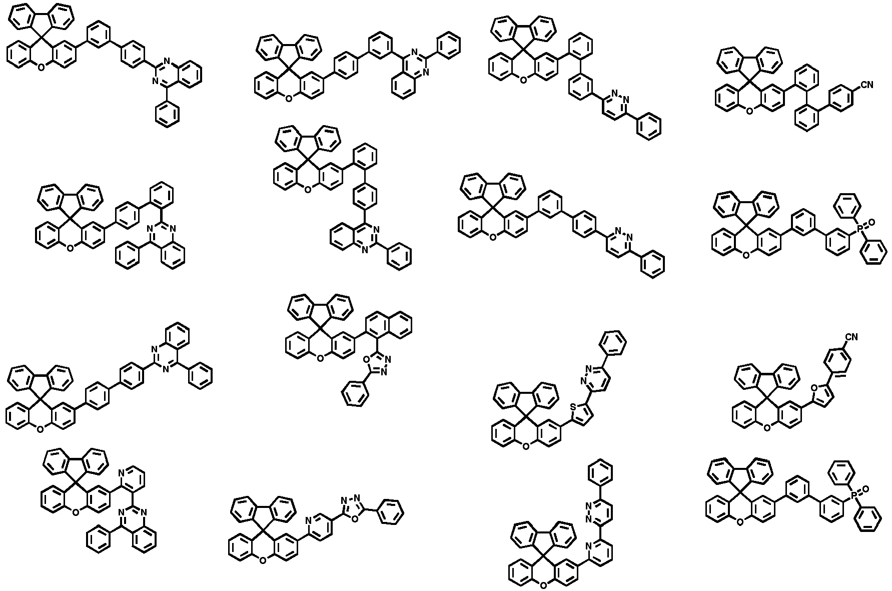

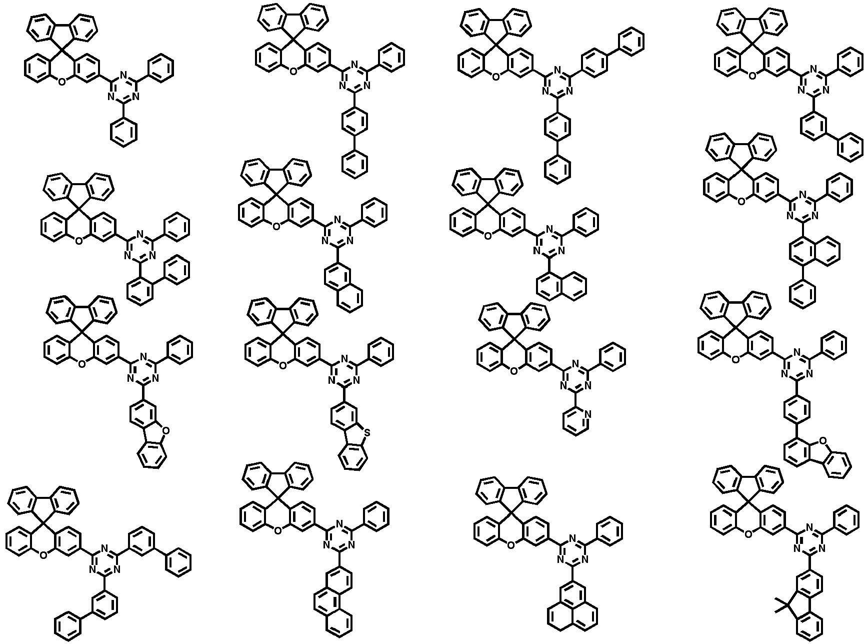

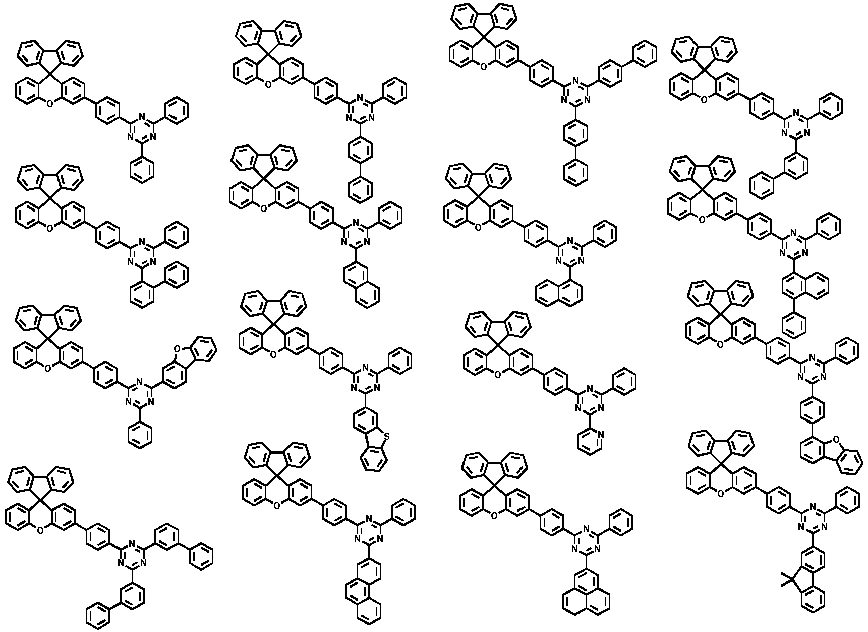

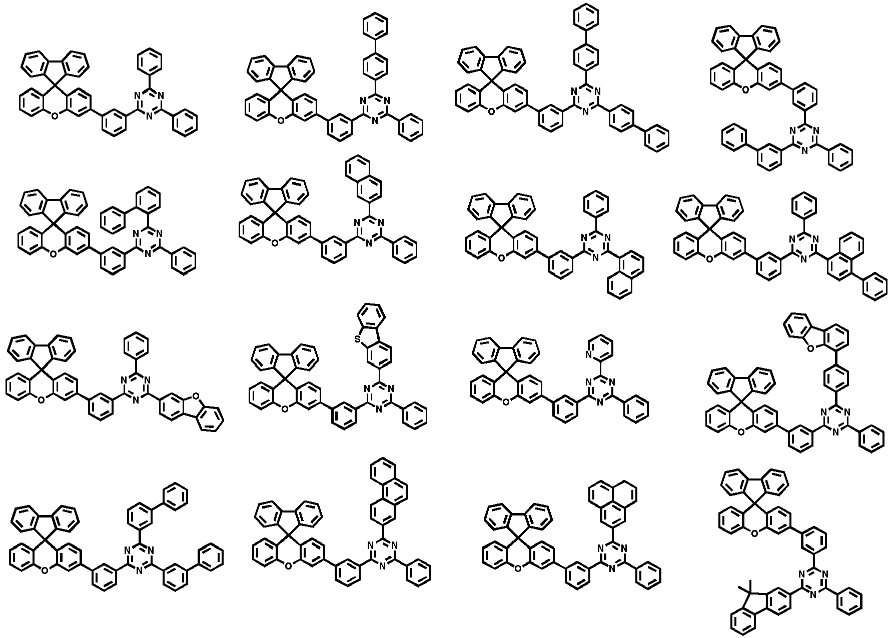

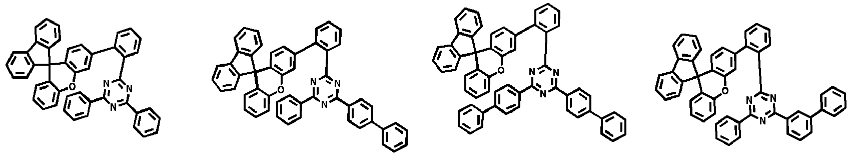

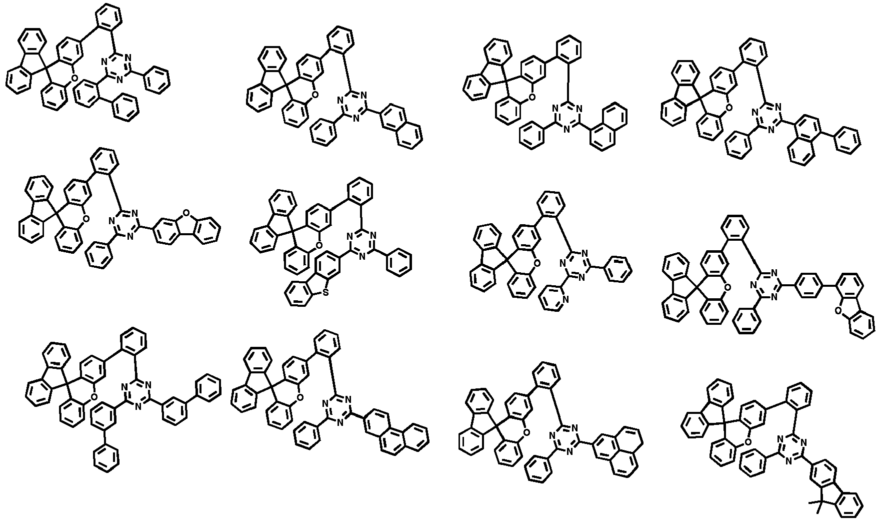

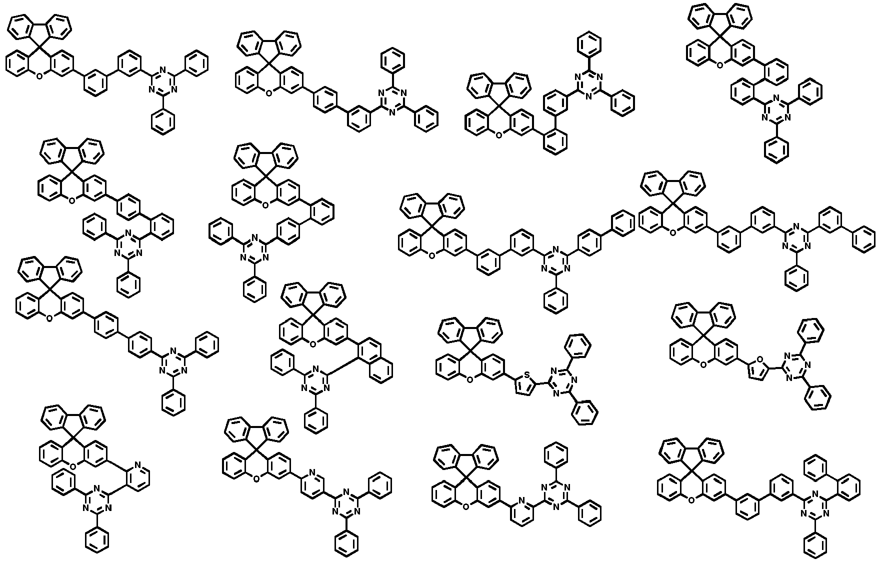

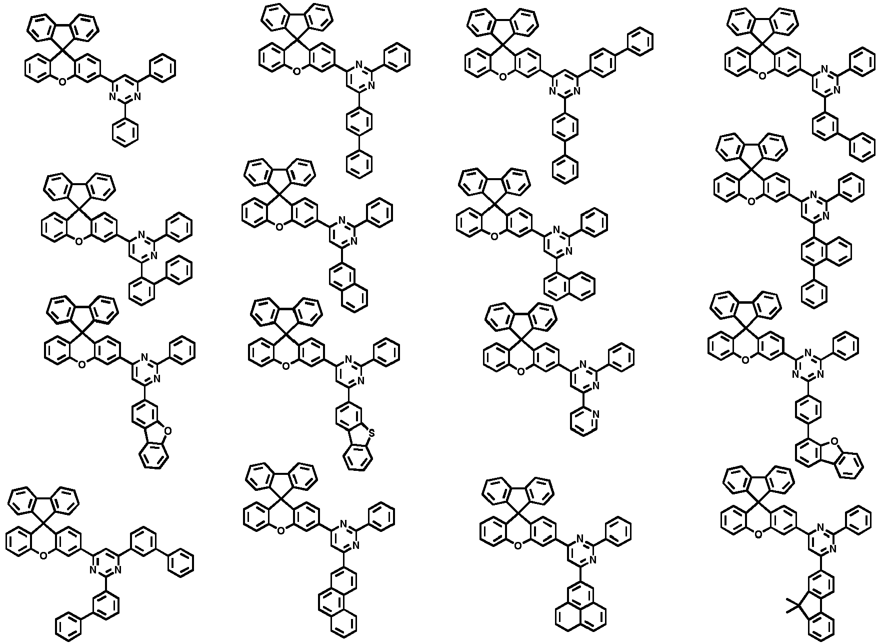

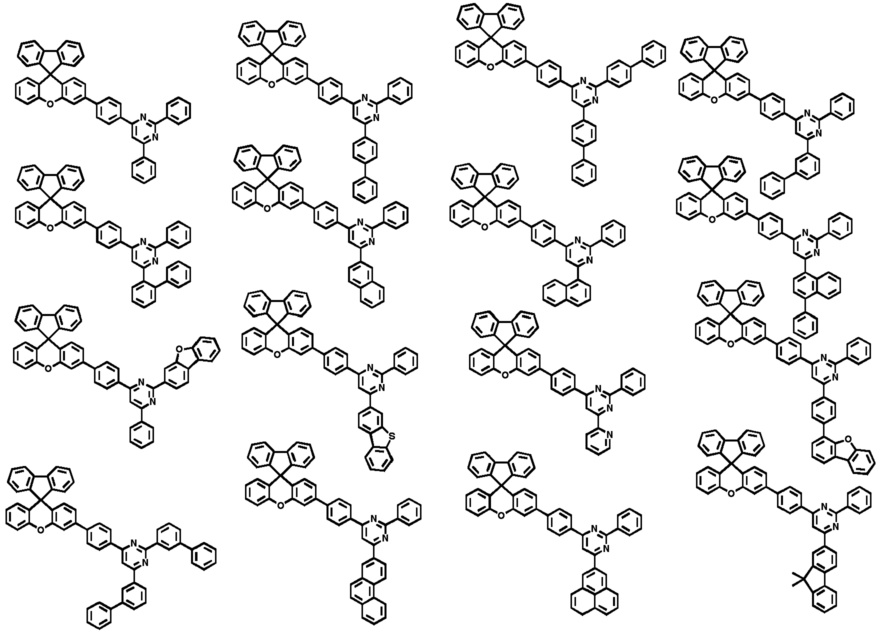

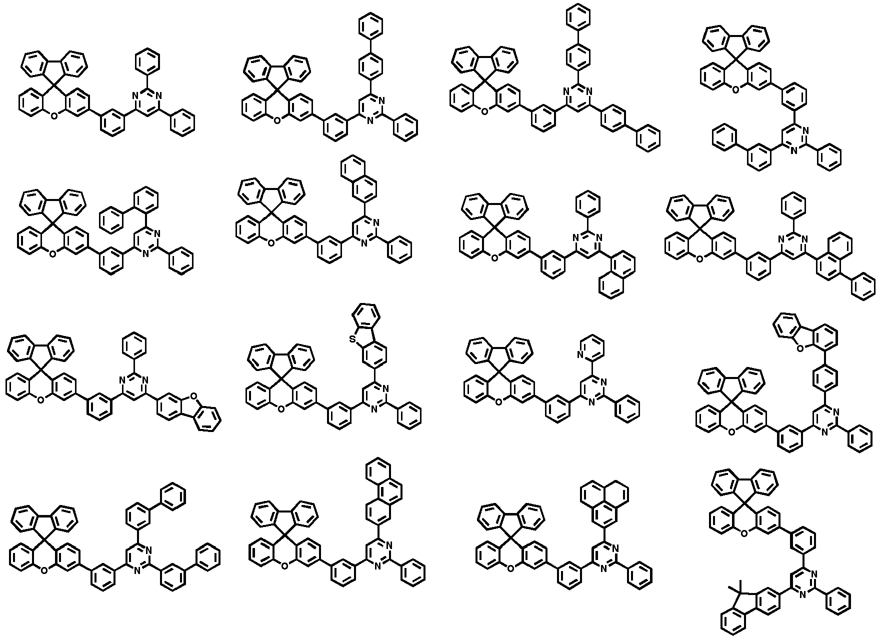

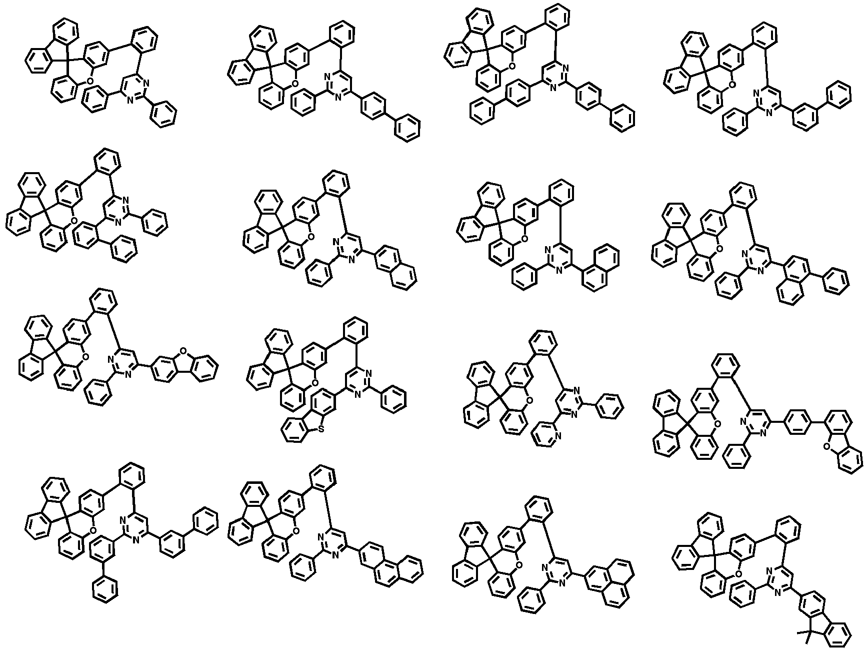

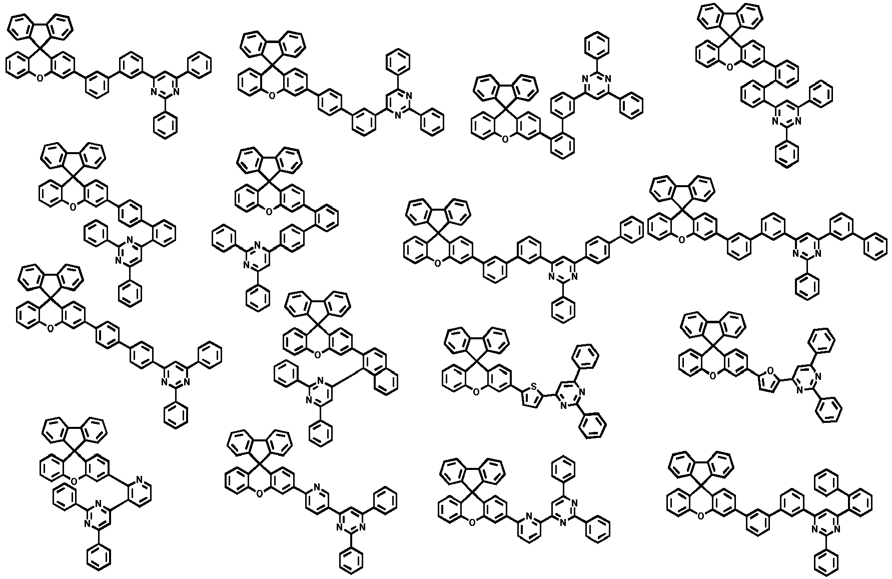

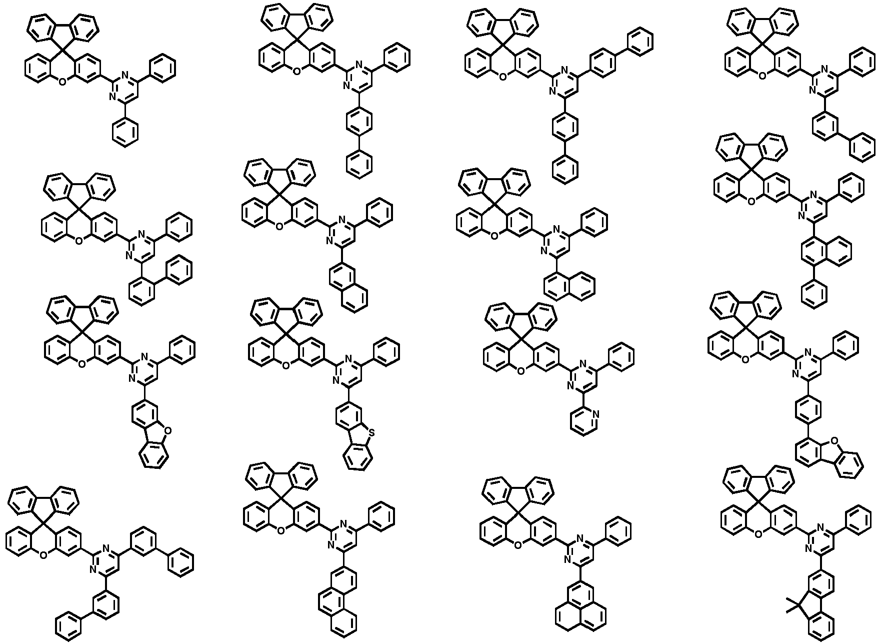

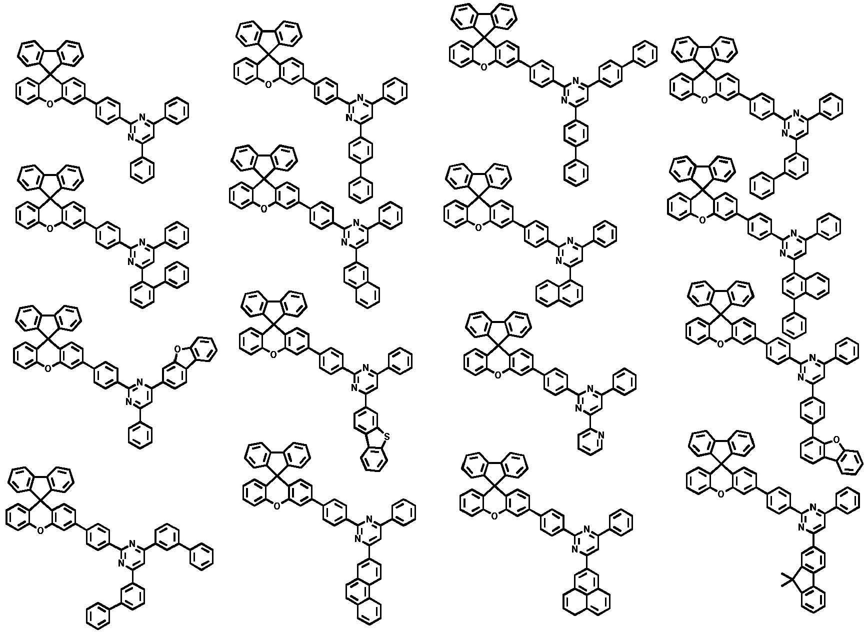

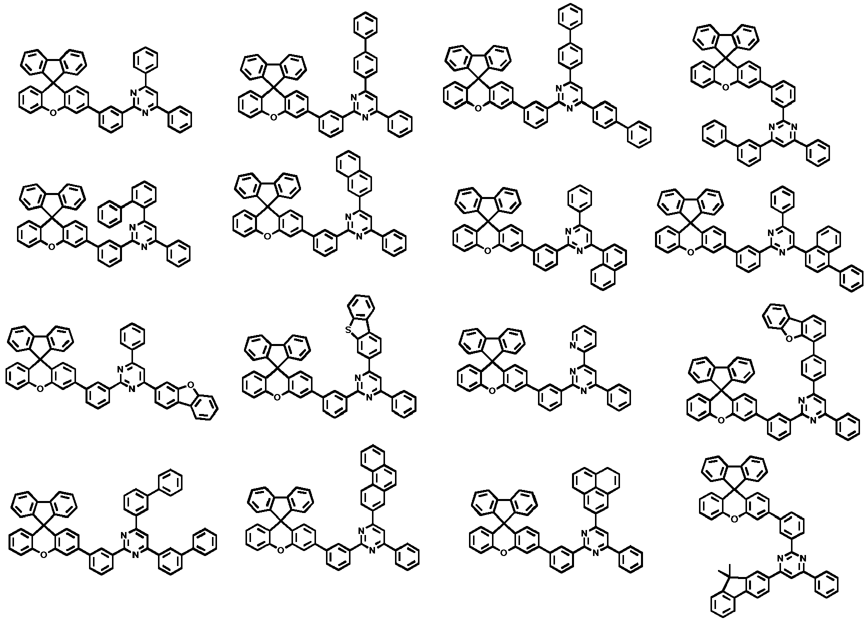

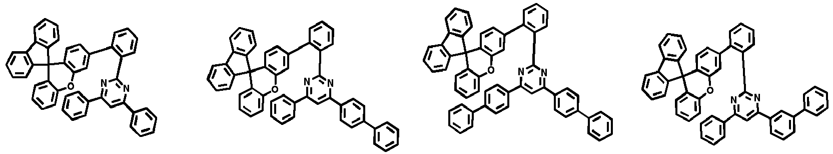

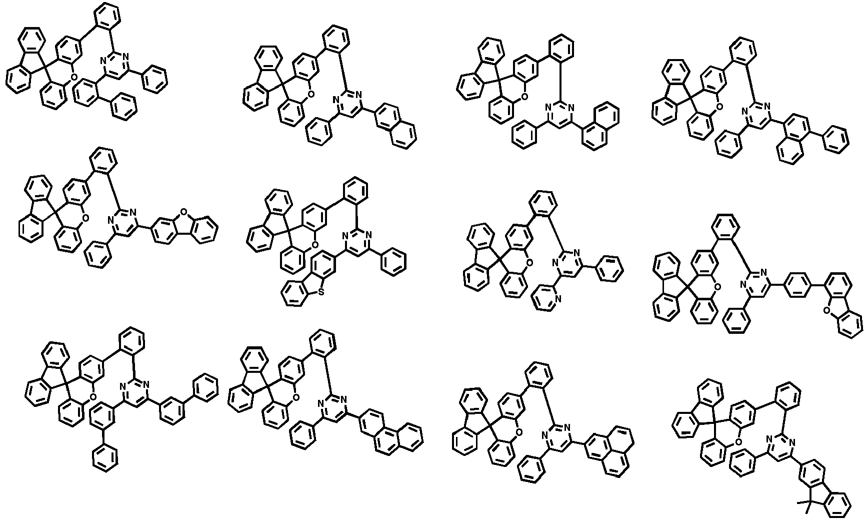

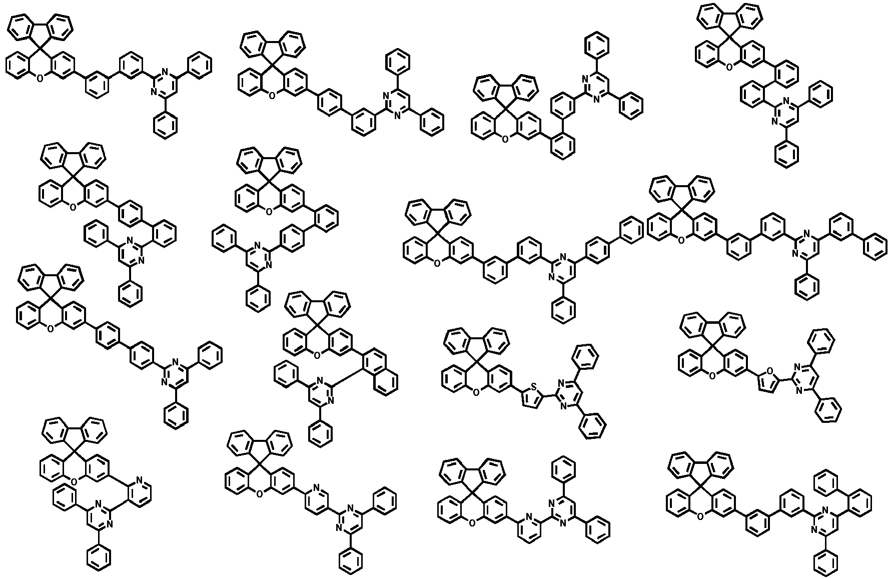

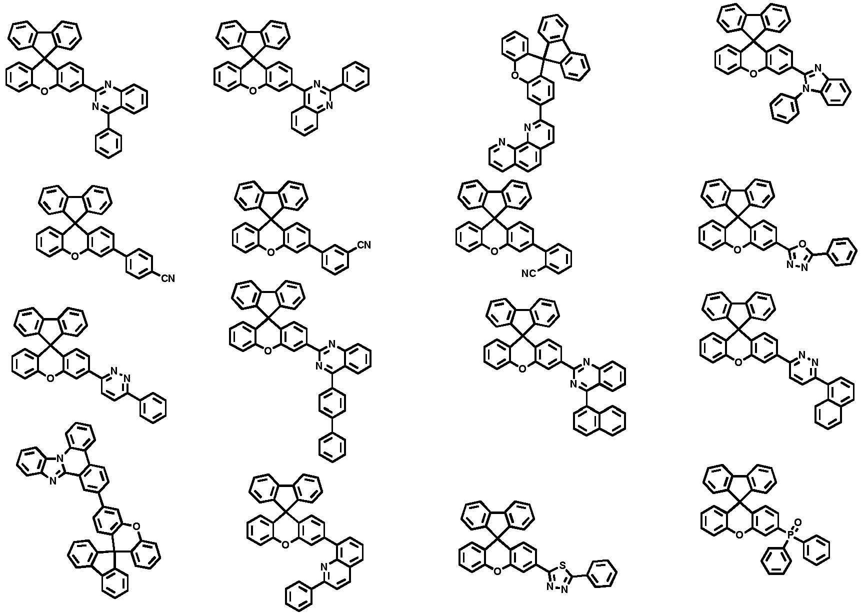

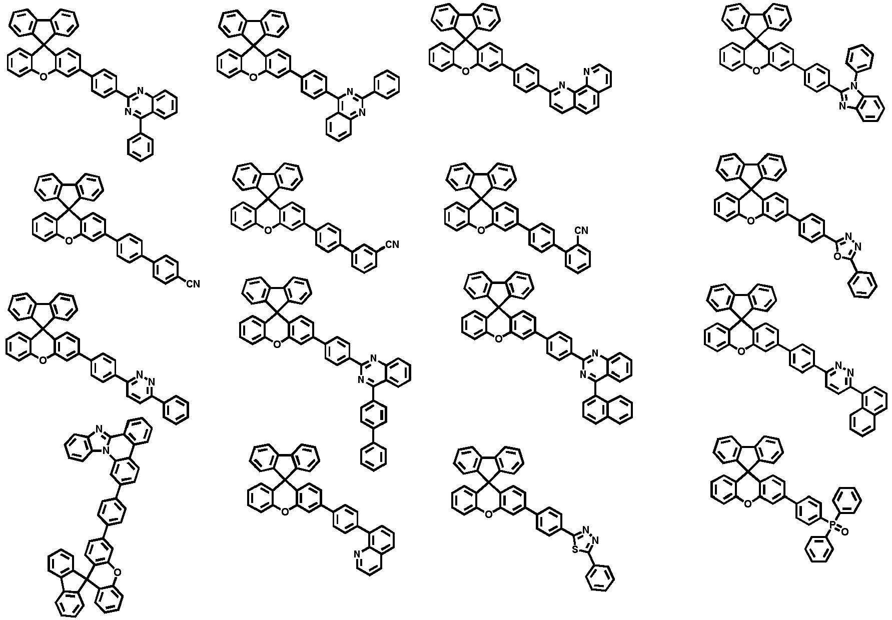

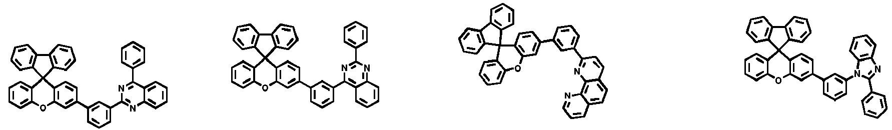

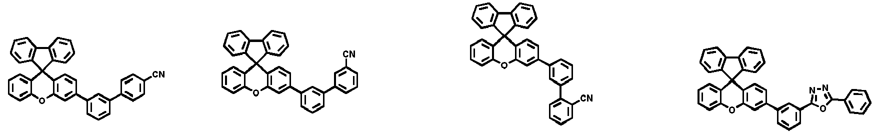

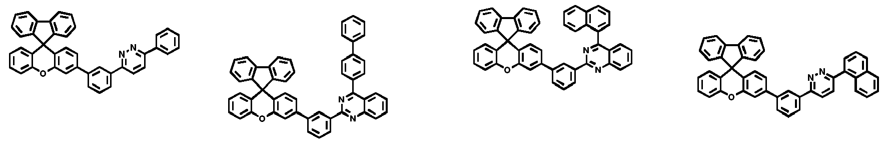

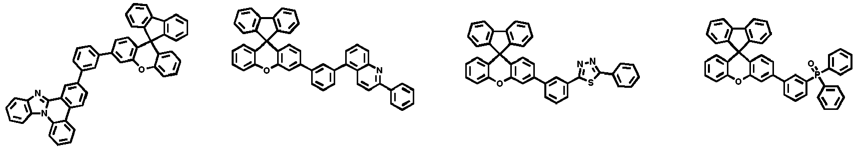

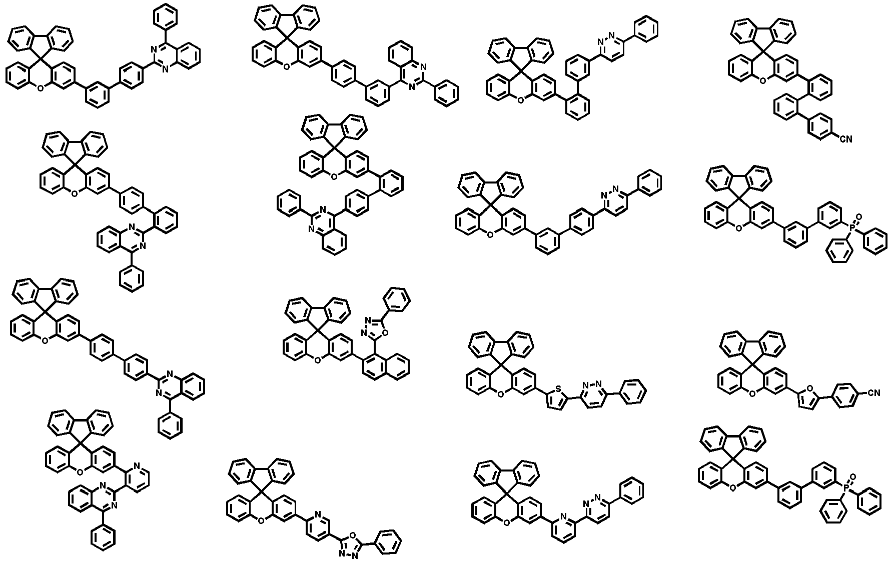

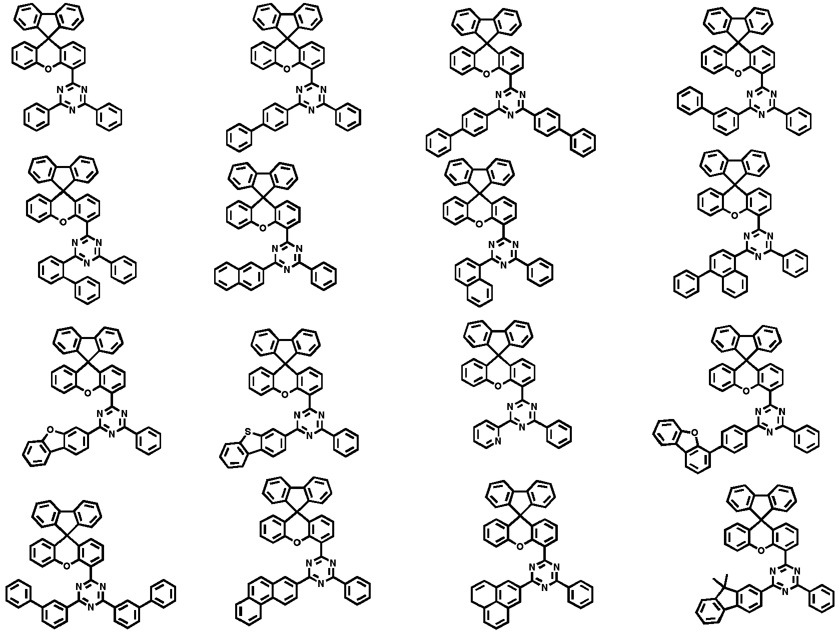

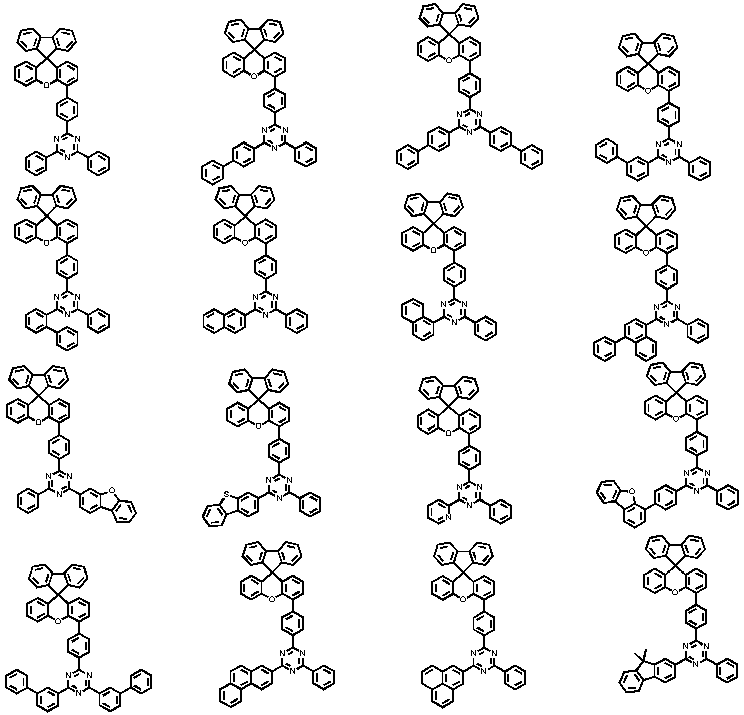

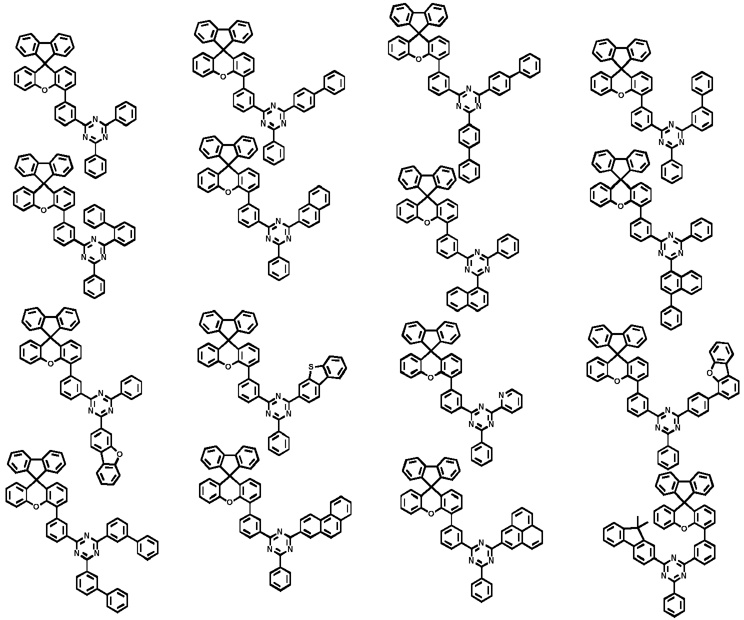

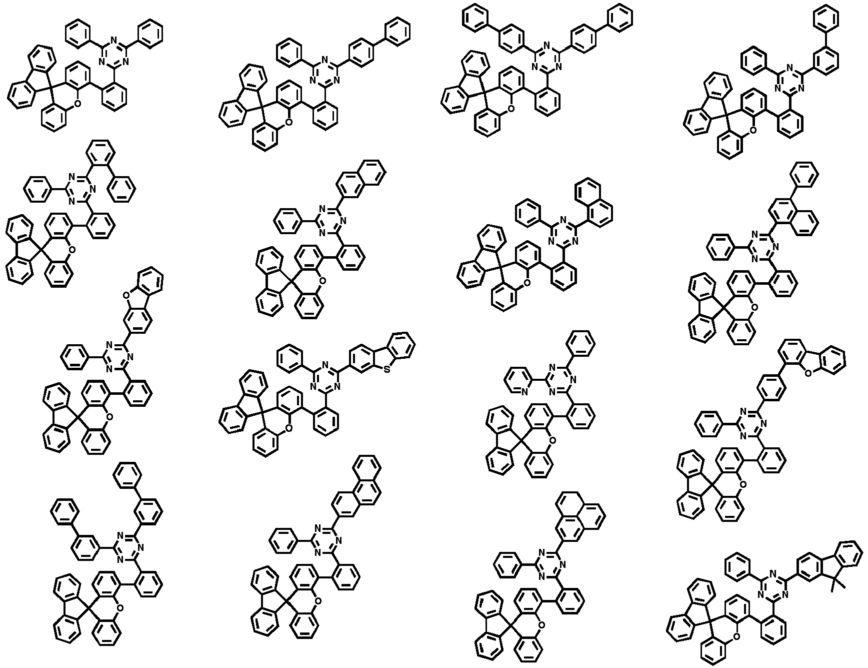

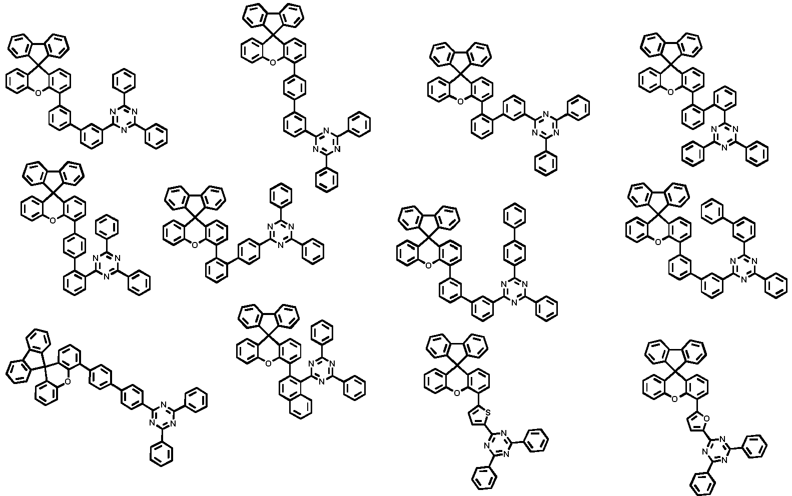

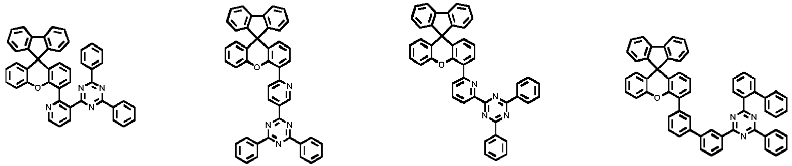

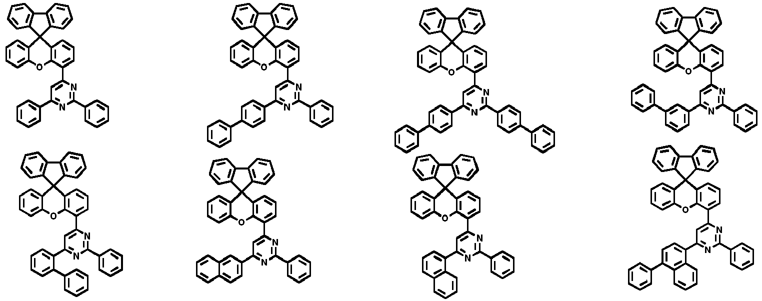

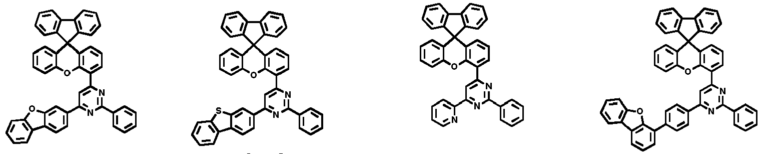

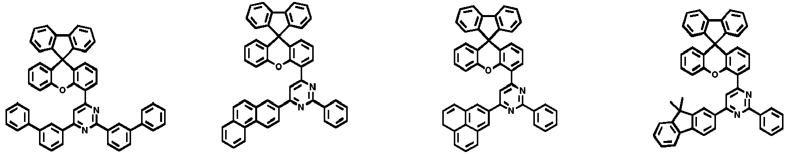

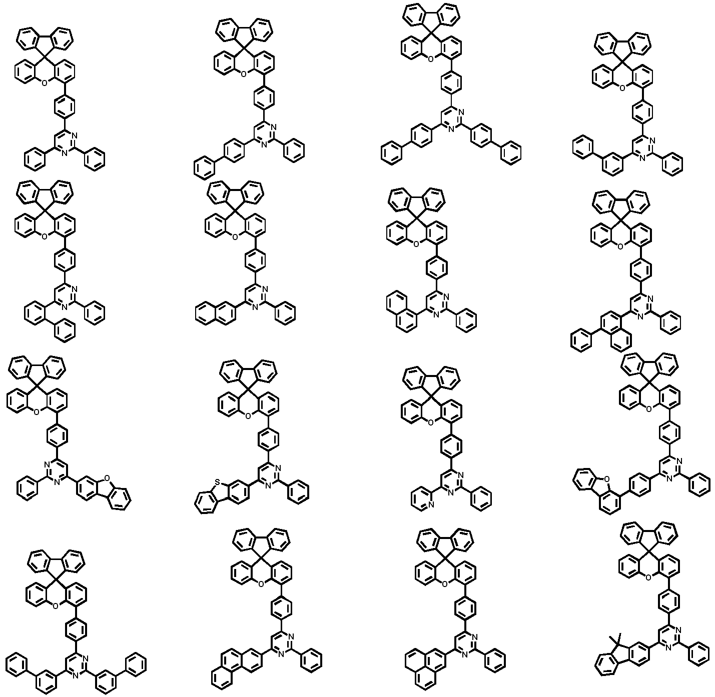

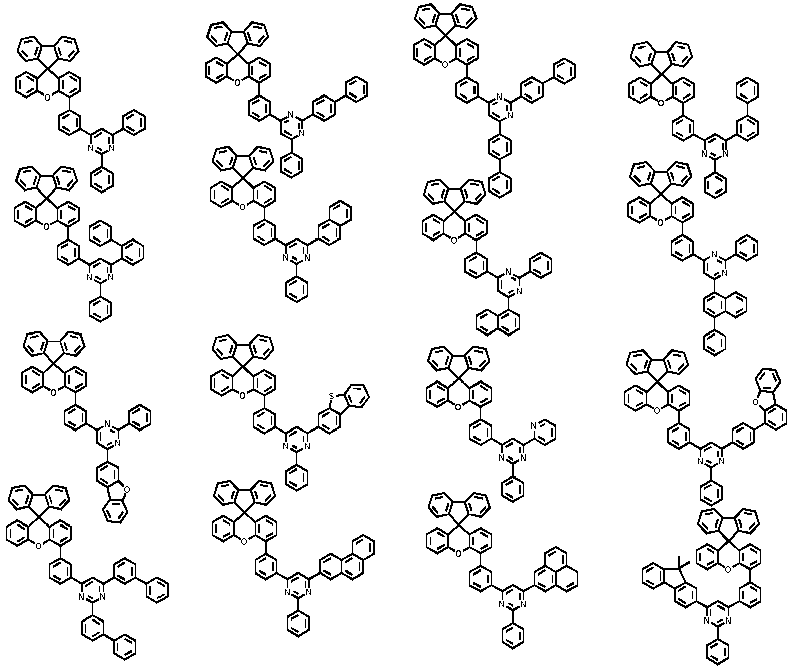

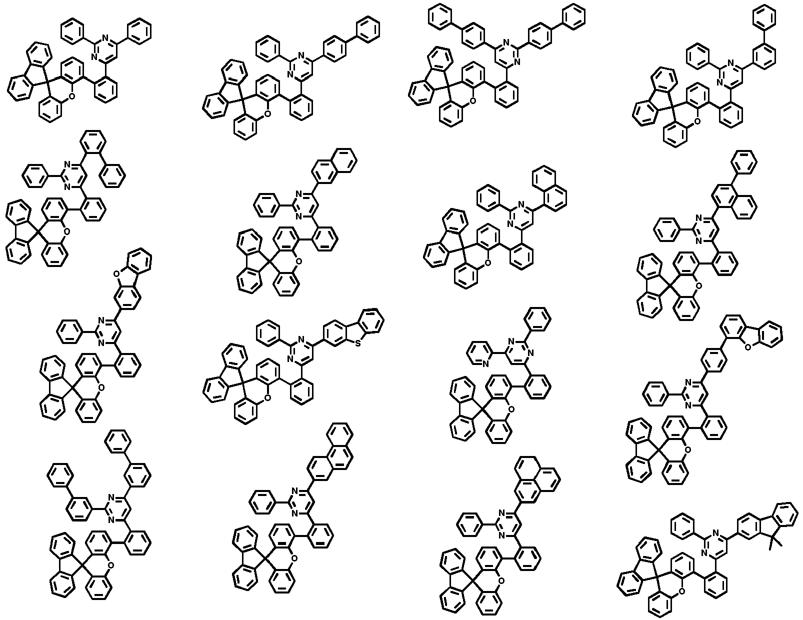

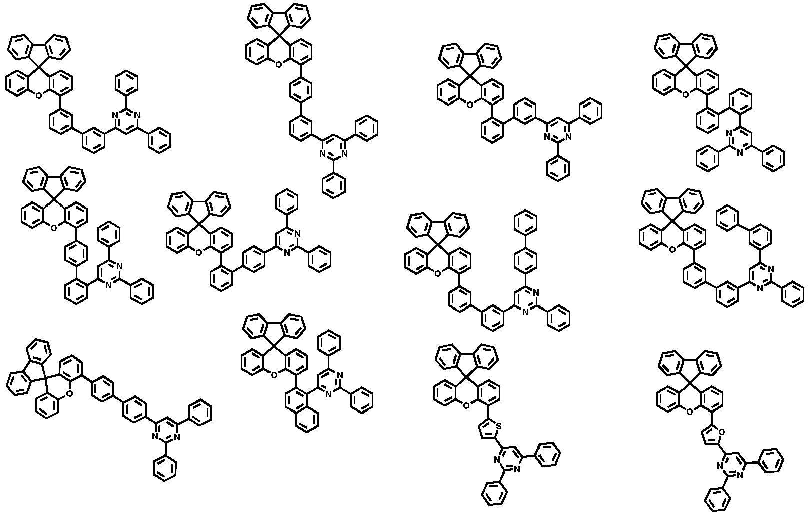

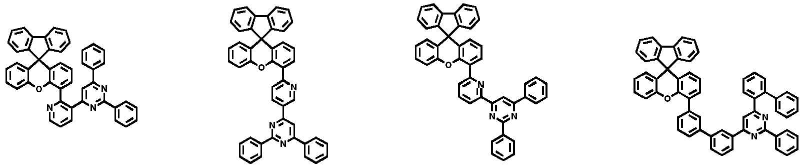

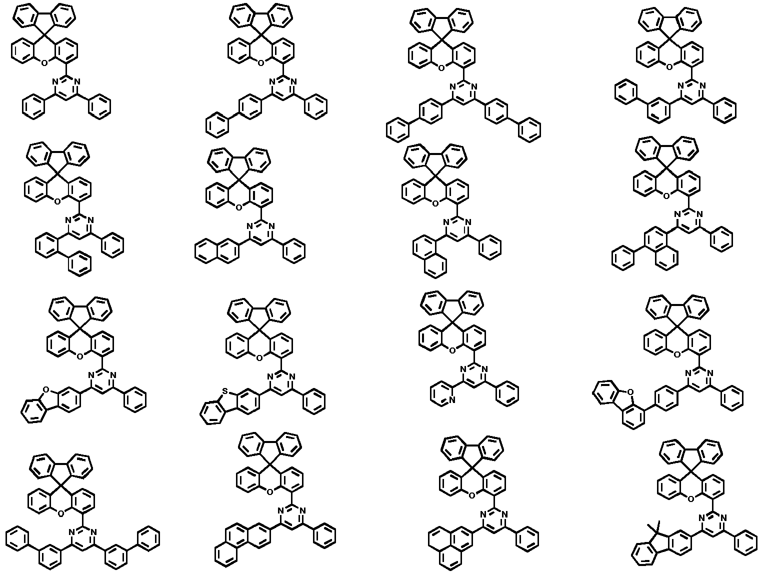

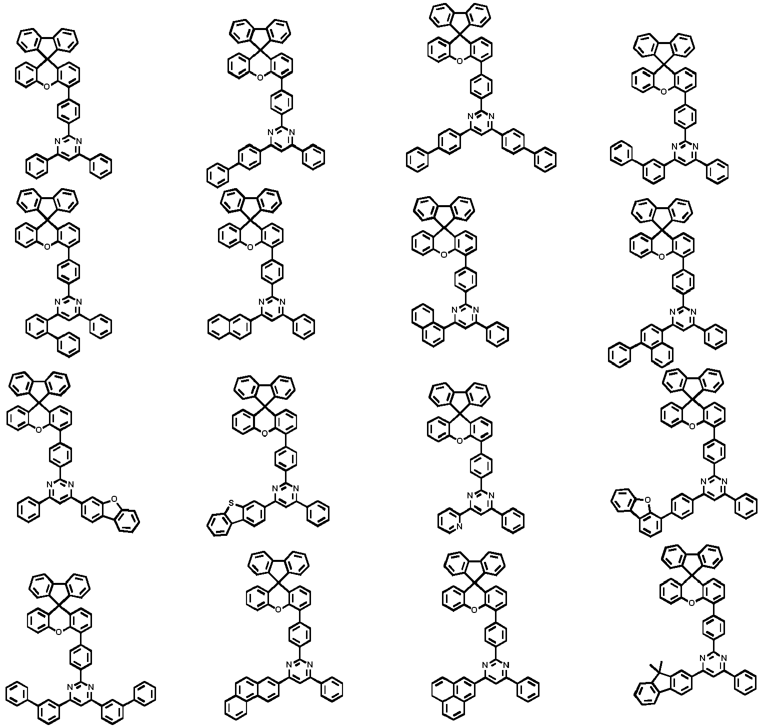

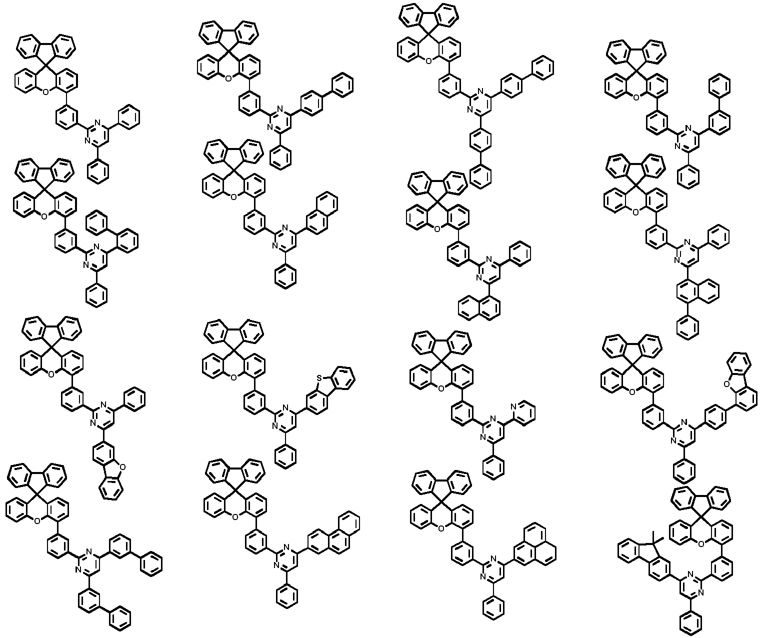

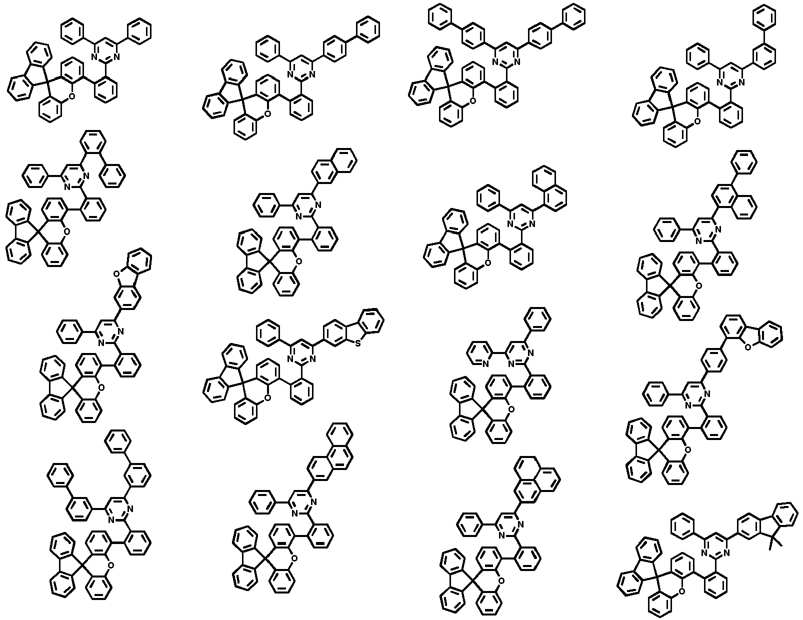

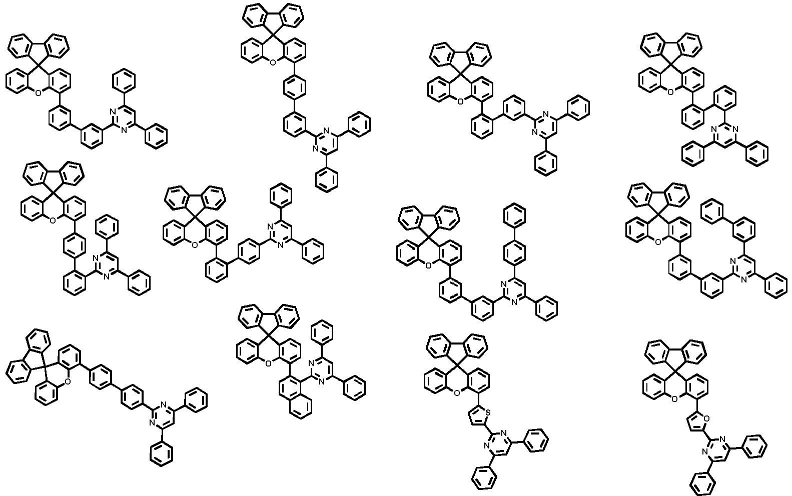

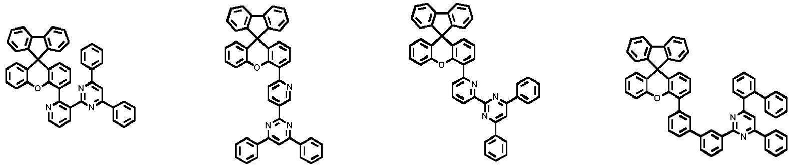

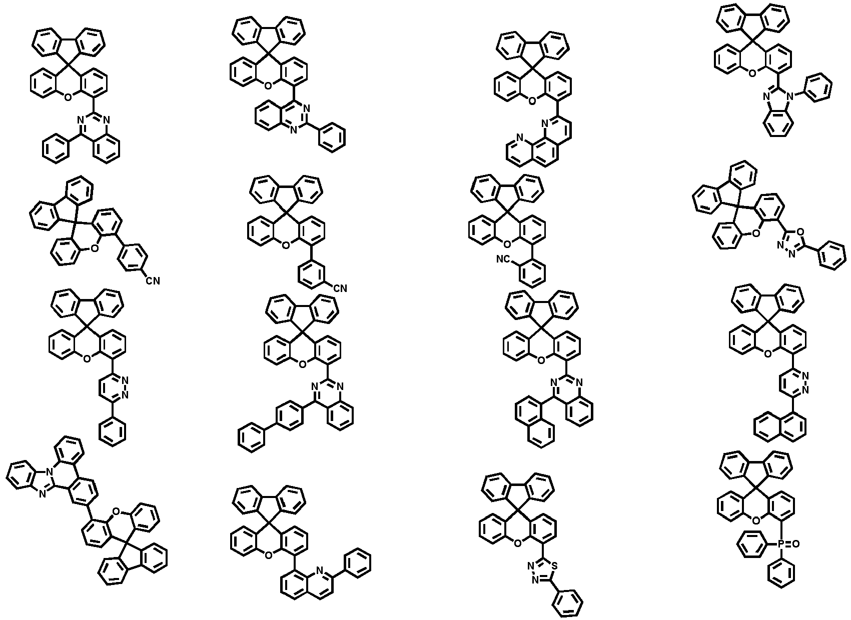

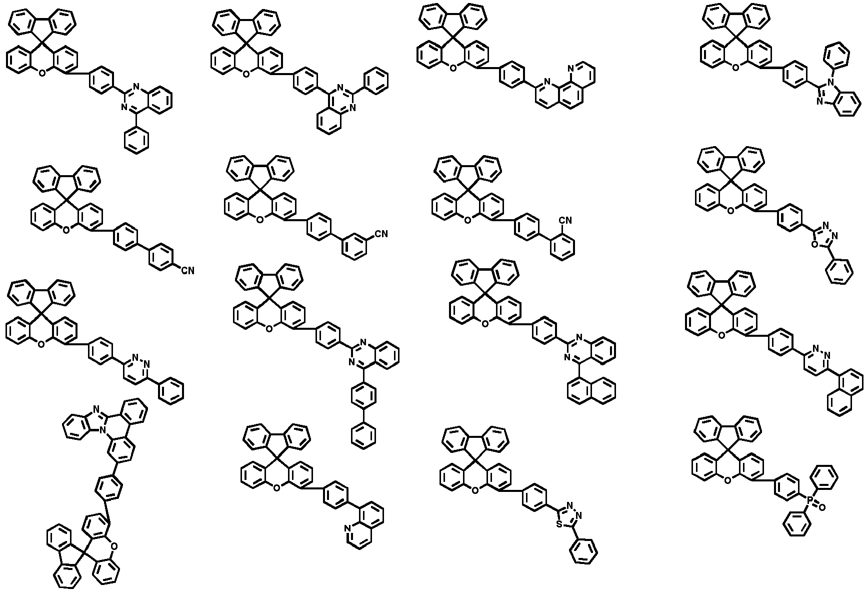

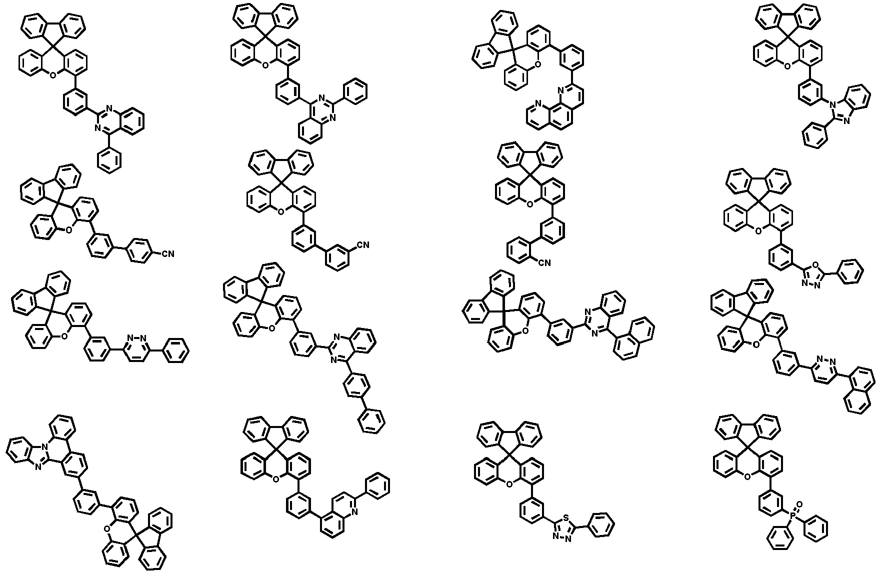

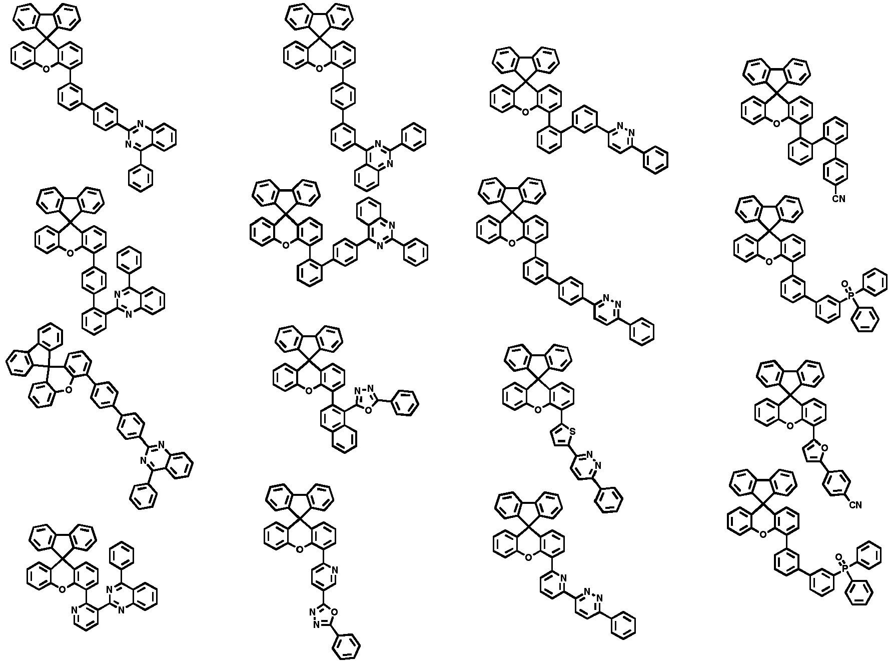

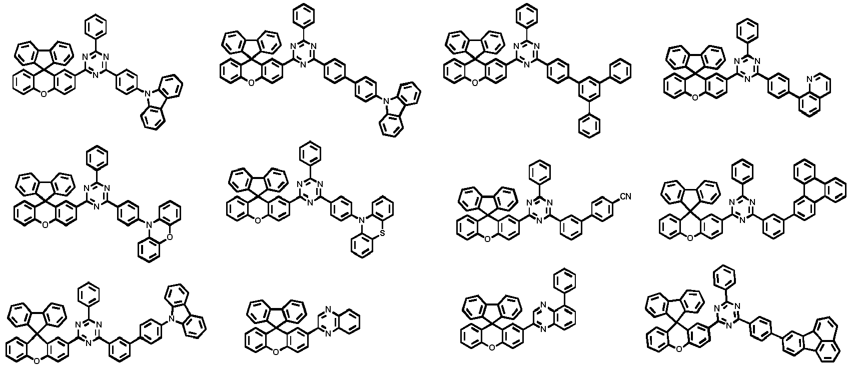

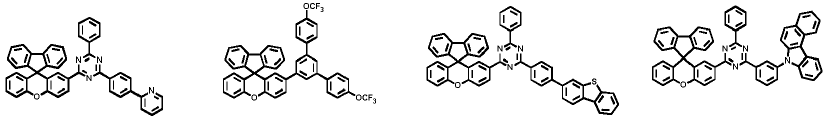

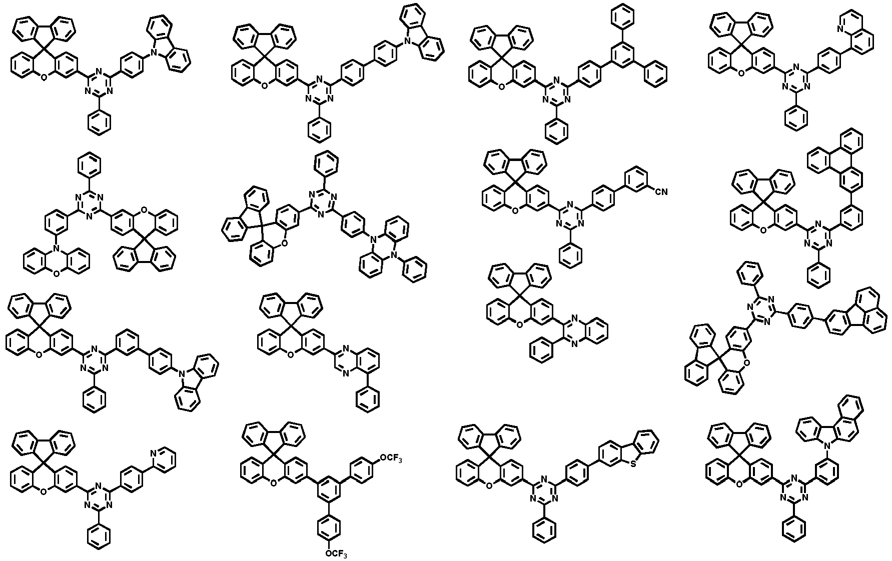

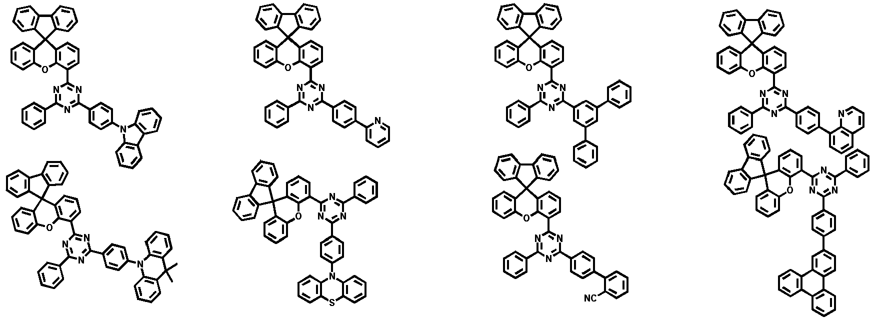

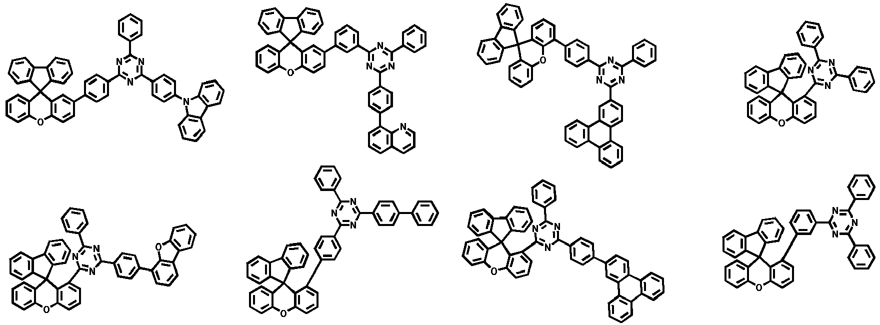

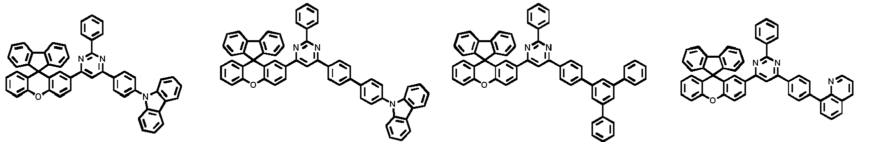

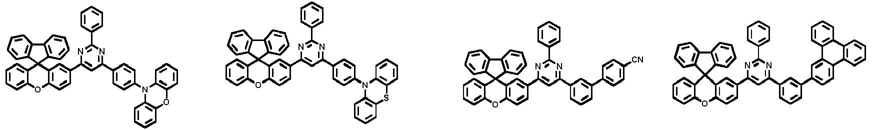

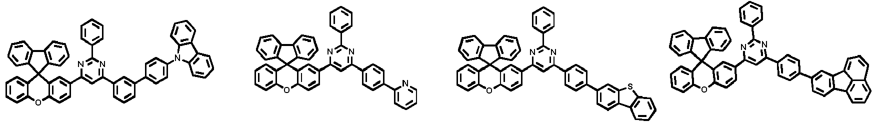

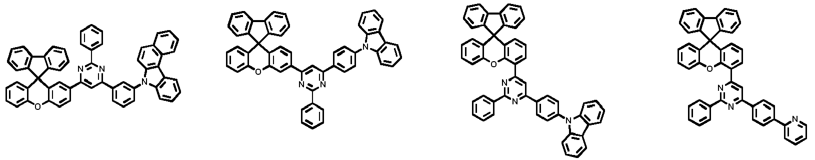

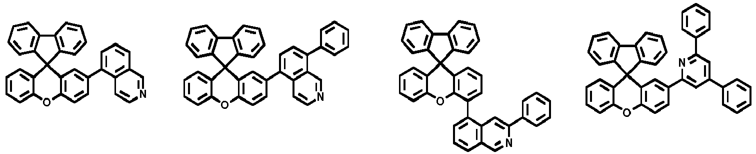

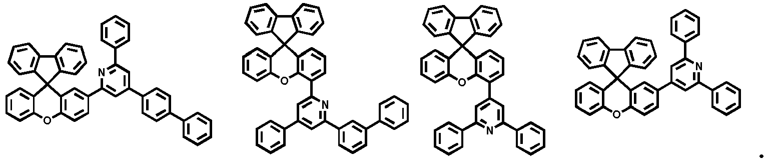

12. Organische lichtemittierende Vorrichtung gemäß Anspruch 1, worin die chemische Formel 3 irgendeine, ausgewählt unter folgenden Verbindungen, ist:

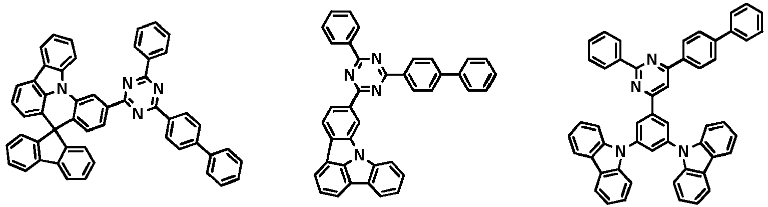

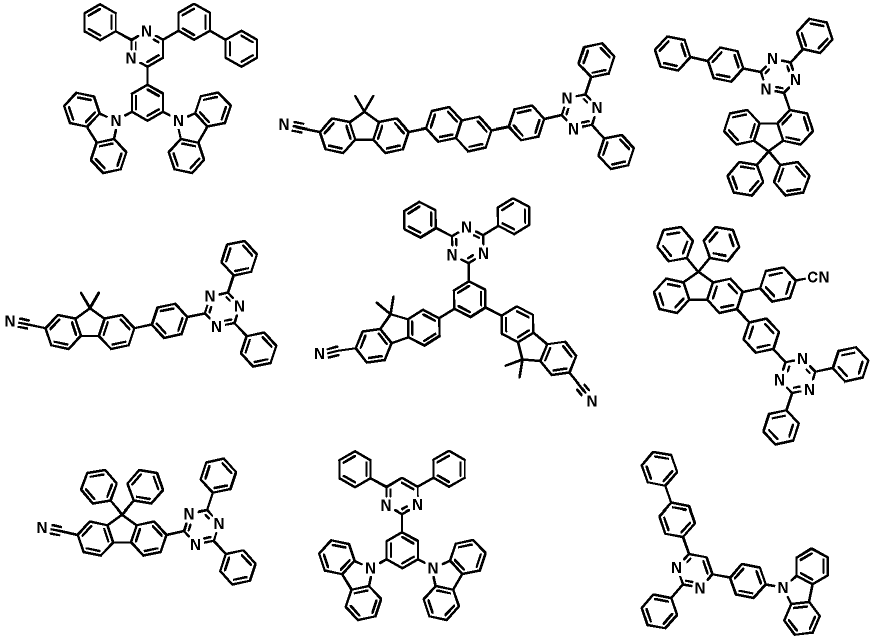

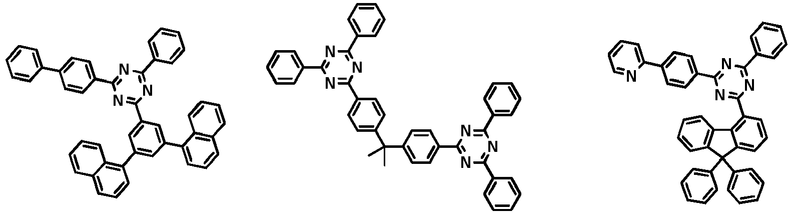

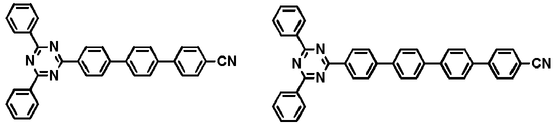

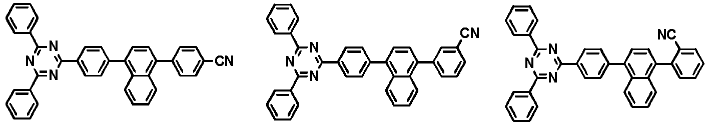

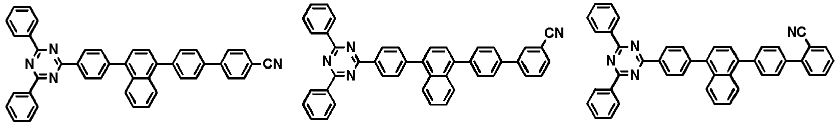

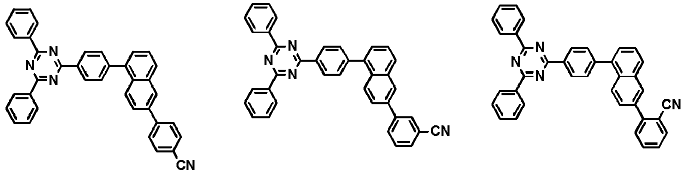

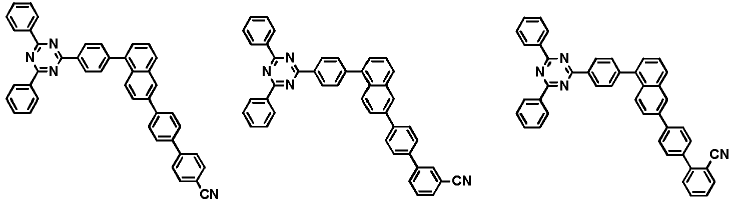

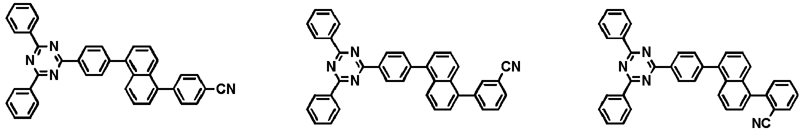

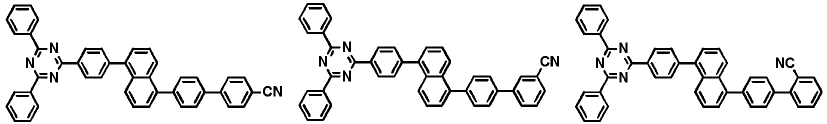

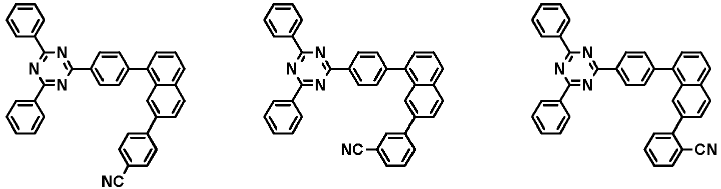

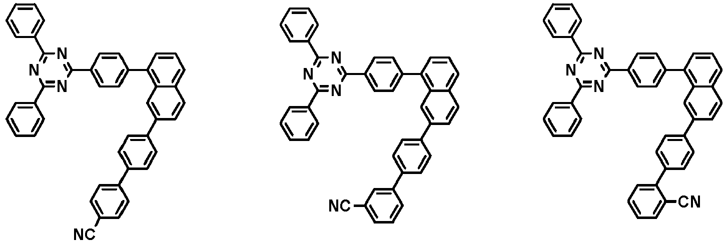

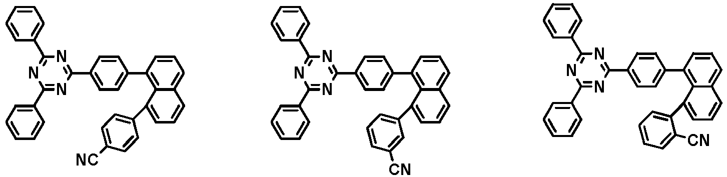

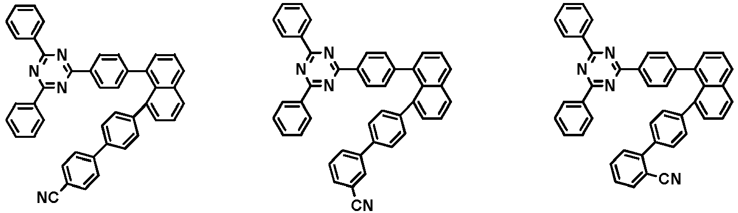

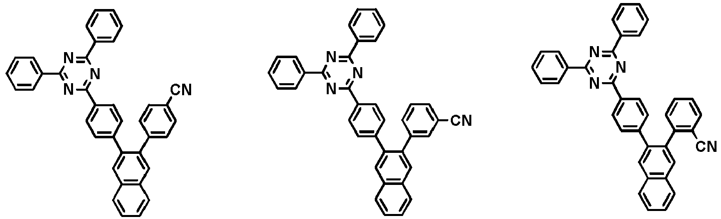

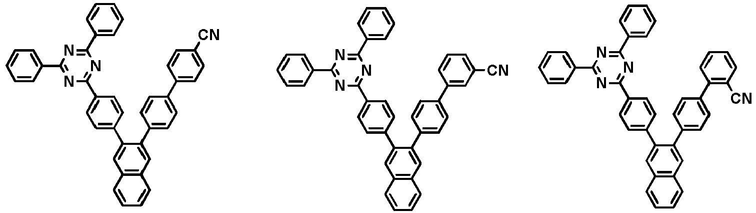

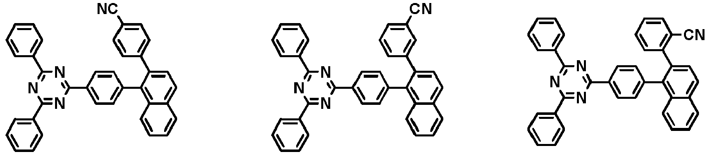

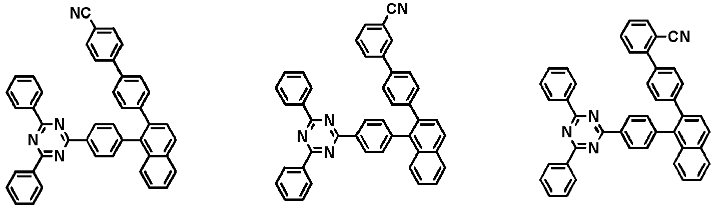

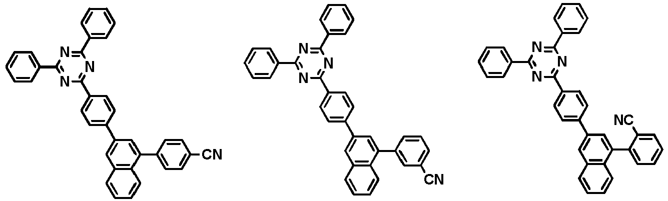

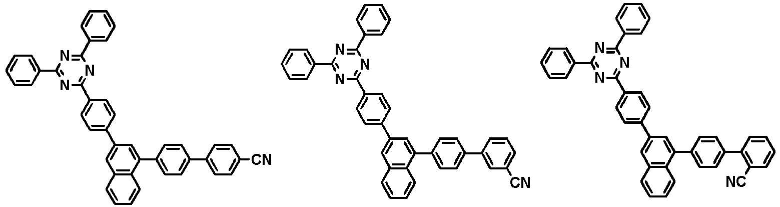

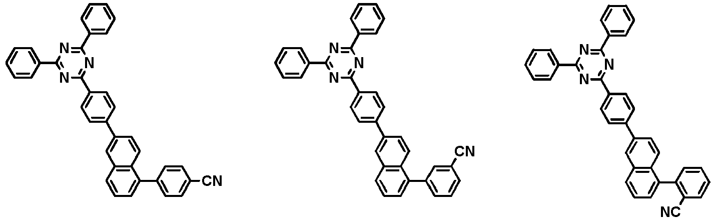

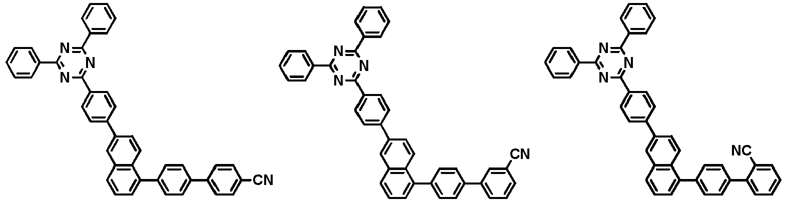

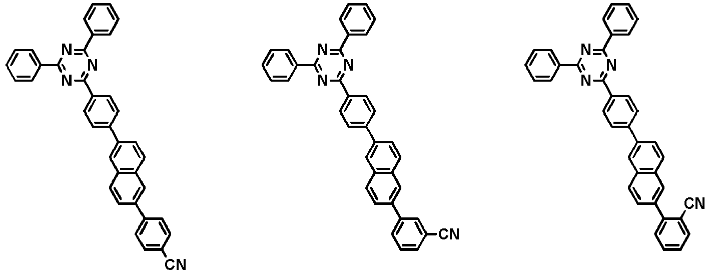

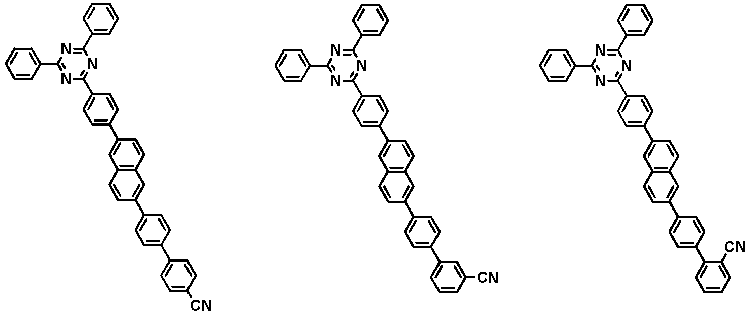

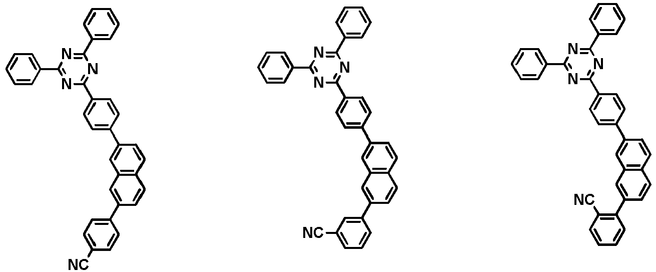

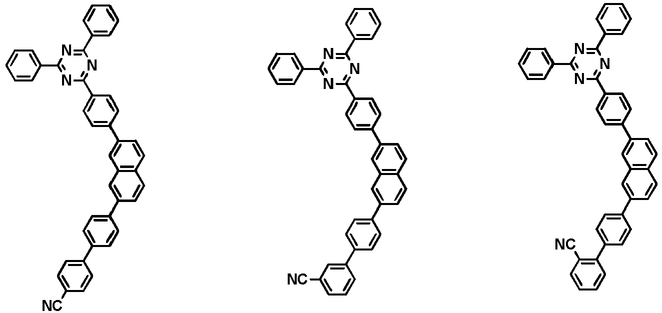

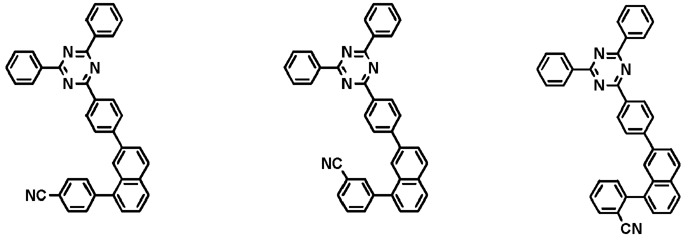

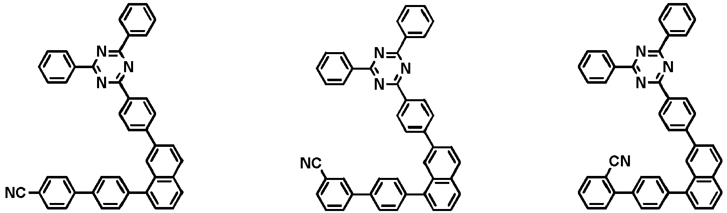

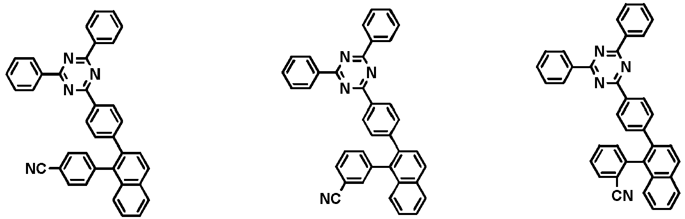

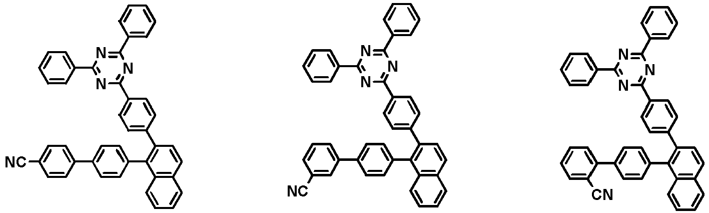

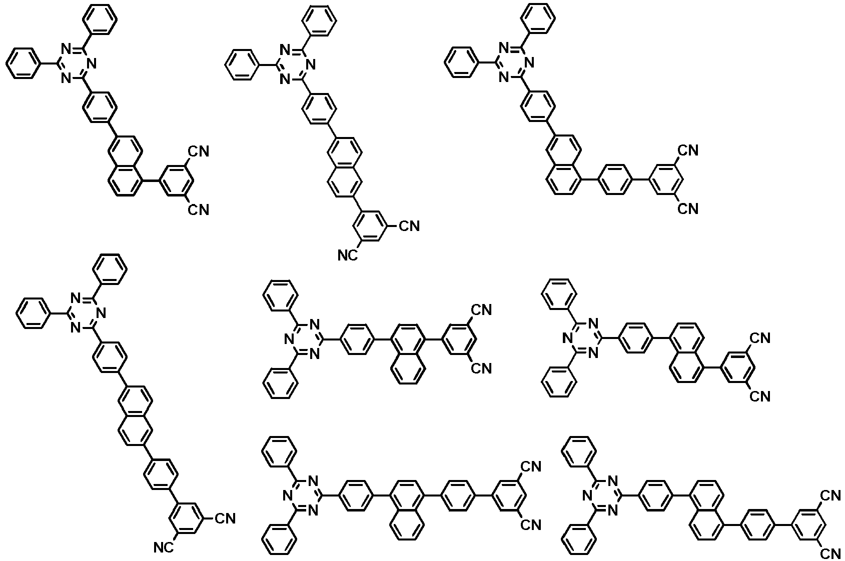

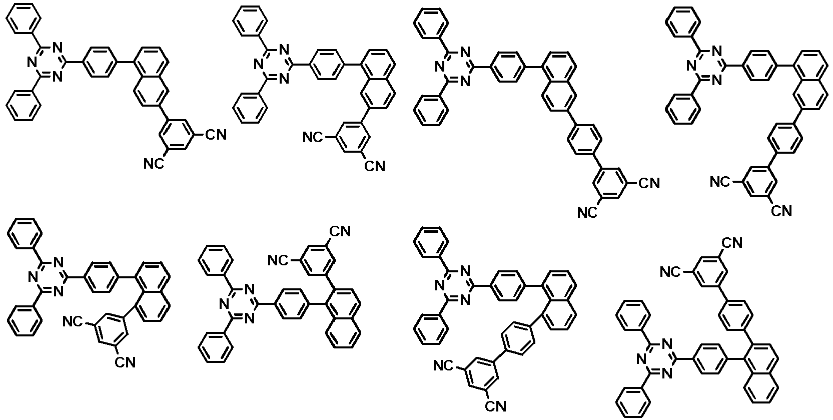

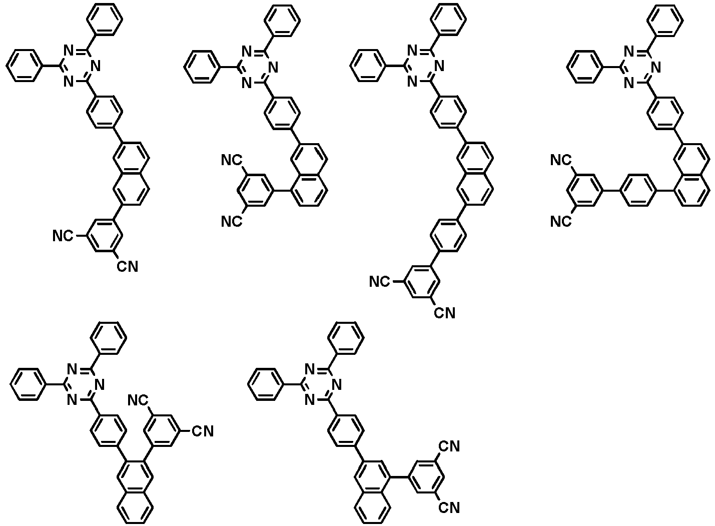

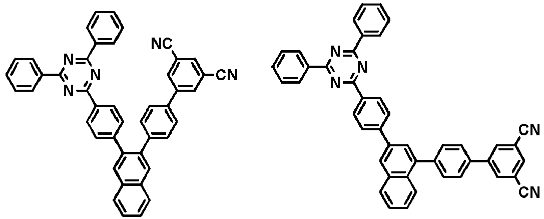

13. Organische lichtemittierende Vorrichtung gemäß Anspruch 1, worin die durch die chemische Formel 1 dargestellte Verbindung eine Bandlücke von 3,0 eV oder größer aufweist.

14. Organische lichtemittierende Vorrichtung gemäß Anspruch 1, wobei die organische lichtemittierende Vorrichtung ferner eine oder mehrere organische Materialschichten, ausgewählt unter einer Lochinjektionsschicht, einer Lochtransferschicht und einer Elektroneninjektionsschicht, einschließt.

## Revendications

1. Dispositif électroluminescent organique comprenant :
une anode (30) ;
un cathode (50) ; et
une couche électroluminescente (40) prévue entre l'anode (30) et la cathode (50), le dispositif comprenant en outre :
une couche de commande d'électrons (100) prévue entre la couche électroluminescente (40) et la cathode (50) et incluant un composé représenté par la formule chimique 1 suivante ; et
une couche de transfert d'électrons (80) prévue entre la couche de commande d'électrons (100) et la cathode (50) et incluant un composé représenté par la formule chimique 3 suivante : 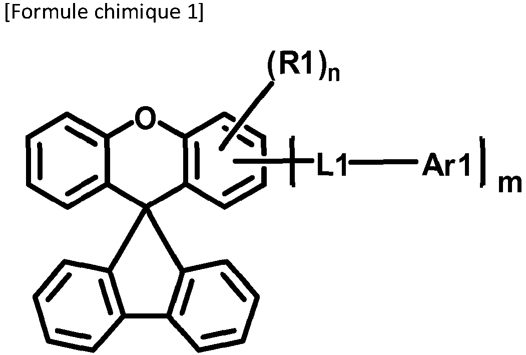 dans lequel, dans la formule chimique 1,
R1 est de l'hydrogène; du deutérium ; un groupe nitrile ; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétéroaryle substitué ou non substitué ;
L1 est une liaison directe ; un groupe arylène substitué ou non substitué ; ou un groupe hétéroarylène substitué ou non substitué ;
Ar1 est de l'hydrogène; du deutérium ; un groupe nitrile; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; un groupe hétérocyclique monocyclique substitué ou non substitué ; un groupe tricyclique ou hétérocyclique supérieur substitué ou non substitué ; un groupe hétérocyclique dicyclique substitué ou non substitué incluant deux N ou plus ; un groupe isoquinolyle substitué ou non substitué ; ou une structure représentée par la formule chimique 2 suivante ;
m est un entier de 1 à 4, n est un entier de 0 à 3, et 1 ≤ n + m ≤ 4 ; et
lorsque m et n sont chacun un entier égal ou supérieur à 2, les structures entre les deux parenthèses ou plus sont identiques ou mutuellement différentes, 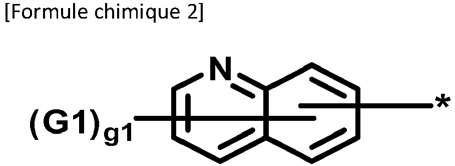
dans la formule chimique 2,
G1 est de l'hydrogène; du deutérium; un groupe nitrile; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétéroaryle substitué ou non substitué ;
g1 est un entier de 1 à 6, et lorsque g1 est égal ou supérieur à 2, les G1 sont identiques ou mutuellement différents ; et
* est un site lié à L1 de formule chimique 1, 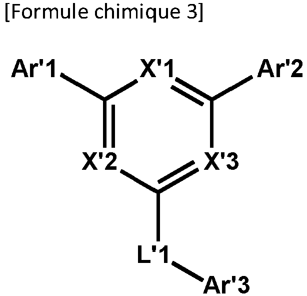
dans la formule chimique 3,
Ar'1 et Ar'2 sont identiques ou mutuellement différents, et chacun indépendamment un groupe aryle substitué ou non substitué ; ou un groupe hétéroaryle substitué ou non substitué ;
X'1 est N ou CR'1, X'2 est N ou CR'2, et X'3 est N ou CR'3 ;
au moins deux de X'1 à X'3 sont N ;
L'1 est une liaison directe ; un groupe arylène substitué ou non substitué ; ou un groupe hétéroarylène substitué ou non substitué ;
R'1 à R'3 sont identiques ou mutuellement différents, et chacun indépendamment de l'hydrogène ; du deutérium ; un groupe nitrile ; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétéroaryle substitué ou non substitué ; et
Ar'3 est représenté par la formule chimique 4a, 4b ou 4c suivante :
[Formule chimique 4a] ****(L'2)n1-Ar'4** 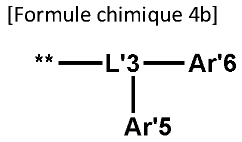 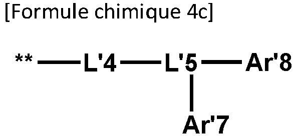
dans les formules chimiques 4a à 4c,
****** est un site lié à L'1 de formule chimique 3 ;
n1 est un entier de 1 à 3 ;
L'2 et L'4 sont identiques ou mutuellement différents, et chacun indépendamment une liaison directe ; un groupe alkylène substitué ou non substitué ; un groupe arylène substitué ou non substitué ; ou un groupe hétéroarylène substitué ou non substitué ;
L'3 et L'5 sont identiques ou mutuellement différents, et chacun indépendamment un groupe aryle trivalent substitué ou non substitué ; ou un groupe hétéroaryle trivalent substitué ou non substitué ;
Ar'4 à Ar'8 sont identiques ou mutuellement différents, et chacun indépendamment un groupe nitrile ; un groupe aryle non substitué ou substitué par un, deux ou plus de deux substituants choisis dans le groupe constitué d'un groupe alkyle substitué ou non substitué, d'un groupe aryle substitué ou non substitué, ud'n groupe pyridyle substitué ou non substitué, d'un groupe carbazole substitué ou non substitué et d'un groupe nitrile ; ou un groupe hétéroaryle substitué ou non substitué.

2. Dispositif électroluminescent organique selon la revendication 1, dans lequel la couche de transfert d'électrons inclut en outre un composé représenté par la formule chimique 5 suivante : 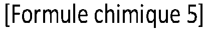 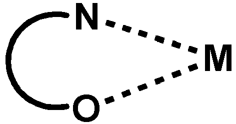 dans la formule chimique 5,
M est un métal alcalin ou un métal alcalino-terreux;
une courbe reliant N et O représente des liaisons ou des atomes nécessaires pour former un cycle substitué ou non substitué incluant N ou O ; et
une ligne pointillée signifie que N et O forment un complexe métallique avec M.

3. Dispositif électroluminescent organique selon la revendication 1, dans lequel Ar1 est un groupe nitrile ; un groupe alcoxy substitué ou non substitué ; un groupe oxyde de phosphine substitué ou non substitué ; un groupe silyle substitué ou non substitué ; un groupe aryle substitué ou non substitué ; un groupe hétérocyclique monocyclique substitué ou non substitué ; un groupe tricyclique ou hétérocyclique supérieur substitué ou non substitué ; un groupe hétérocyclique dicyclique substitué ou non substitué incluant deux N ou plus; un groupe isoquinolyle substitué ou non substitué; ou la structure représentée par la formule chimique 2.

4. Dispositif électroluminescent organique selon la revendication 1, dans lequel Ar1 est représenté par l'une quelconque de la formule chimique 2 et des formules chimiques 6 à 15 suivantes : 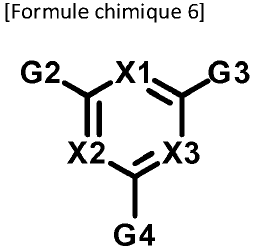 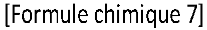 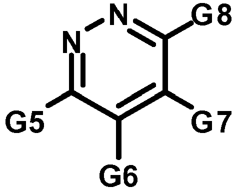 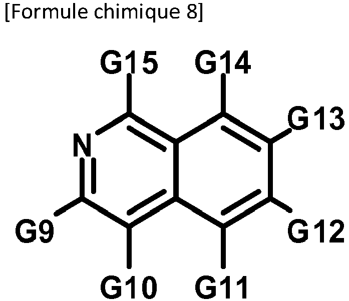 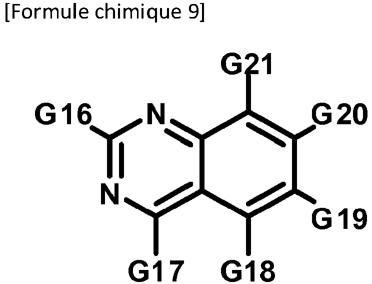 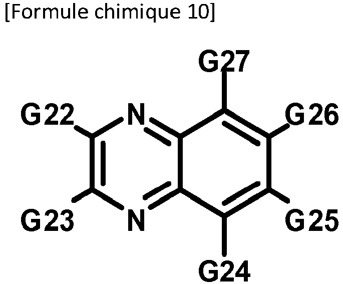 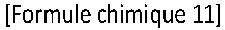 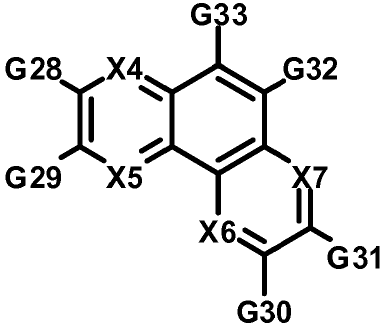 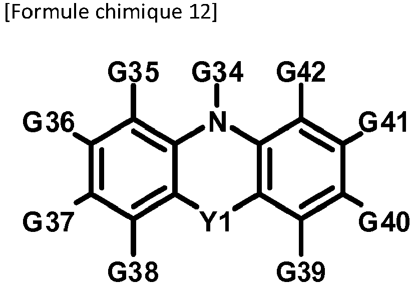 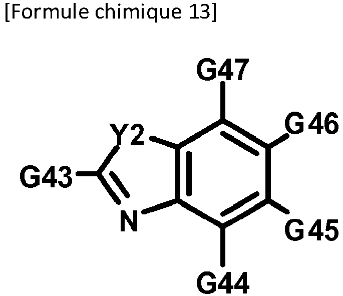 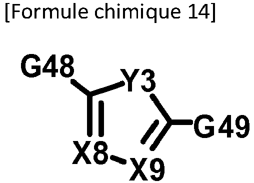 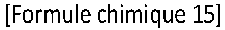 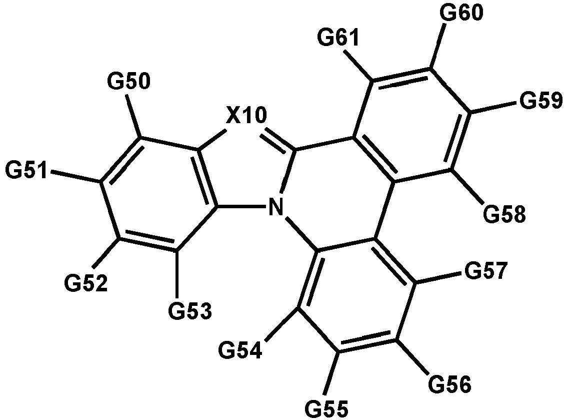 dans les formules chimiques 6 à 15,
X1 est N ou CR11, X2 est N ou CR12, X3 est N ou CR13, X4 est N ou CR14, X5 est N ou CR15, X6 est N ou CR16, X7 est N ou CR17, X8 est N ou CR18, X9 est N ou CR19, et X10 est N ou CR20 ;
au moins deux de X1 à X3 sont N, et au moins un de X4 à X7 est N ;
Y1 est O ; S ; NQ1 ; ou CQ2Q3, Y2 est O ; S ; NQ4 ; ou CQ5Q6, et Y3 est O ; S ; ou NQ7 ;
l'un quelconque de G2 à G4 et R11 à R13, l'un quelconque de G5 à G8, l'un quelconque de G9 à G15, l'un quelconque de G16 à G21, l'un quelconque de G22 à G27, l'un quelconque de G28 à G33 et R14 à R17, l'un quelconque de G34 à G42, l'un quelconque de G43 à G47, l'un quelconque de G48, G49, R18 et R19, et l'un quelconque de G50 à G61 sont un site lié à L1 de formule chimique 1 ; et
le reste de G2 à G61 et R11 à R19 autres que le site de liaison à L1 de formule chimique 1, R20 et Q1 à Q7 sont identiques ou mutuellement différents, et chacun indépendamment de l'hydrogène ; du deutérium ; un groupe nitrile ; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétéroaryle substitué ou non substitué.

5. Dispositif électroluminescent organique selon la revendication 1, dans lequel la formule chimique 1 est représentée par l'une quelconque des formules chimiques 1-1 à 1-4 suivantes : 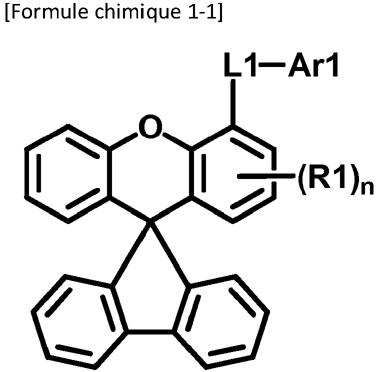 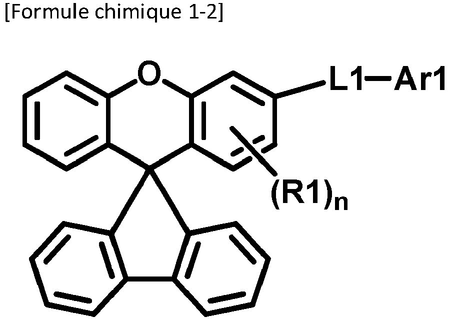 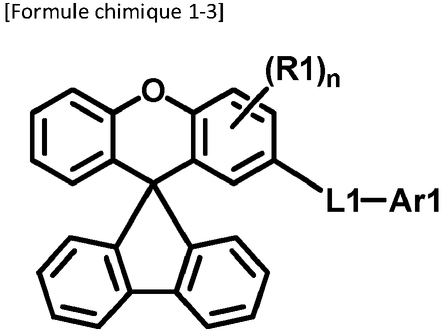 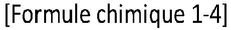 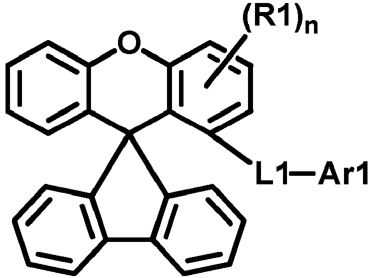 dans les formules chimiques 1-1 à 1-4,
L1, Ar1, R1 et n ont les mêmes définitions que dans la formule chimique 1.

6. Dispositif électroluminescent organique selon la revendication 1, dans lequel L1 est une liaison directe; un groupe phénylène substitué ou non substitué; un groupe biphénylène substitué ou non substitué ; un groupe naphtylène substitué ou non substitué ; un groupe terphénylène substitué ou non substitué ; un groupe quaterphénylène substitué ou non substitué ; un groupe anthracénylène substitué ou non substitué ; un groupe phénanthrénylène substitué ou non substitué ; un groupe triphénylénylène substitué ou non substitué ; un groupe pyrénylène substitué ou non substitué ; un groupe fluorénylène substitué ou non substitué ; un groupe spiro cyclopentane fluorénylène substitué ou non substitué ; un groupe dibenzofuranylène substitué ou non substitué; un groupe dibenzothiophène divalent substitué ou non substitué ; un groupe carbazolène substitué ou non substitué ; un groupe pyridylène substitué ou non substitué ; un groupe furane divalent substitué ou non substitué ; ou un groupe thiophène divalent substitué ou non substitué.

7. Dispositif électroluminescent organique selon la revendication 1, dans lequel L'1 est une liaison directe; un groupe phénylène substitué ou non substitué; un groupe biphénylène substitué ou non substitué ; un groupe terphénylène substitué ou non substitué ; un groupe naphtylène substitué ou non substitué ; ou un groupe fluorénylène substitué ou non substitué, L'2 et L'4 sont identiques ou mutuellement différents, et chacun indépendamment une liaison directe; un groupe méthylène substitué ou non substitué ; un groupe éthylène substitué ou non substitué ; un groupe propylène substitué ou non substitué ; un groupe phénylène substitué ou non substitué ; un groupe biphénylène substitué ou non substitué ; un groupe terphénylène substitué ou non substitué ; un groupe naphtylène substitué ou non substitué ; ou un groupe fluorénylène substitué ou non substitué ; et
L'3 et L'5 sont identiques ou mutuellement différents, et chacun indépendamment un groupe phényle trivalent substitué ou non substitué ; un groupe biphényle trivalent substitué ou non substitué ; un groupe terphényle trivalent substitué ou non substitué ; un groupe naphtyle trivalent substitué ou non substitué ; ou un groupe fluorényle trivalent substitué ou non substitué.

8. Dispositif électroluminescent organique selon la revendication 1, dans lequel Ar'1 et Ar'2 sont identiques ou mutuellement différents, et chacun indépendamment un groupe phényle substitué ou non substitué ; un groupe biphényle substitué ou non substitué ; un groupe naphtyle substitué ou non substitué ; ou un groupe fluorényle substitué ou non.

9. Dispositif électroluminescent organique selon la revendication 1, dans lequel Ar'4 à Ar'8 sont identiques ou mutuellement différents, et chacun représenté indépendamment par un groupe nitrile ; un groupe aryle non substitué ou substitué par un, deux ou plus de deux substituants choisis dans le groupe constitué d'un groupe alkyle substitué ou non substitué, d'un groupe aryle substitué ou non substitué, d'un groupe pyridyle substitué ou non substitué, d'un groupe carbazole substitué ou non substitué et d'un groupe nitrile ; un groupe triazine non substitué ou substitué par un groupe aryle substitué ou non substitué ; ou une quelconque choisie parmi les formules chimiques 16 à 18 suivantes : 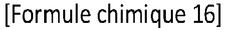 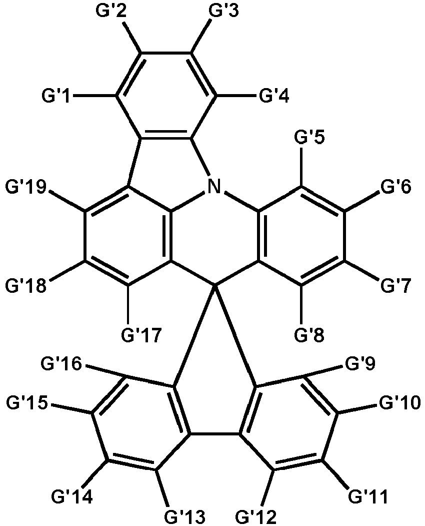 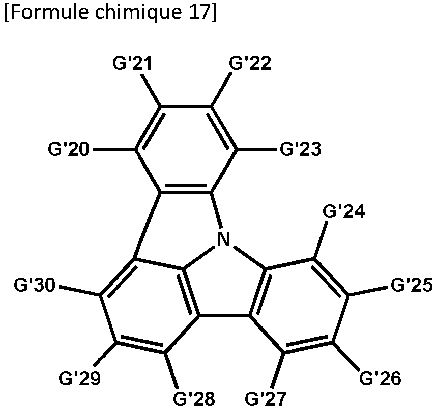 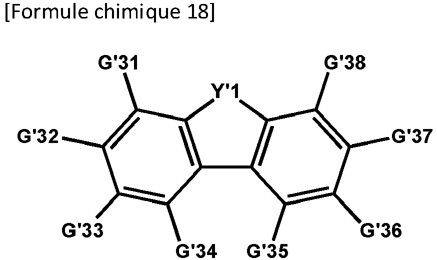 dans les formules chimiques 16 à 18,
Y'1 est O ; S; ou NR'4;
l'un quelconque de G'1 à G'19, l'un quelconque de G'20 à G'30, et l'un quelconque de G'31 à G'38 et R'4 sont un site lié à L'2 de formule chimique 4a, L'3 de formule chimique 4b ou L'5 de formule chimique 4c ; et
le reste de G'1 à G'38 et R'4 autre que le site de liaison à L'2 de formule chimique 4a, L'3 de formule chimique 4b ou L'5 de formule chimique 4c sont identiques ou mutuellement différents, et chacun indépendamment de l'hydrogène ; du deutérium ; un groupe nitrile ; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétéroaryle substitué ou non.

10. Dispositif électroluminescent organique selon la revendication 2, dans lequel la formule chimique 5 est représentée par la formule chimique 5-1 suivante : 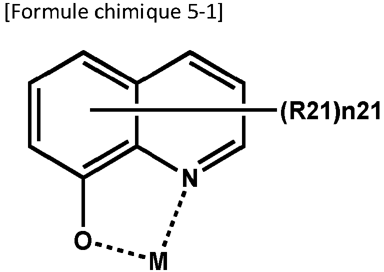 dans la formule chimique 5-1,
R21 est de l'hydrogène; du deutérium; un groupe nitrile; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétéroaryle substitué ou non substitué ;
n21 est un entier de 1 à 6, et lorsque n21 est un entier de 2 ou plus, des substituants entre parenthèses sont identiques ou mutuellement différents ; et
les substituants restants ont les mêmes définitions que dans la formule chimique 5.

11. Dispositif électroluminescent organique selon la revendication 1, dans lequel la formule chimique 1 est l'un quelconque choisi parmi les composés suivants :

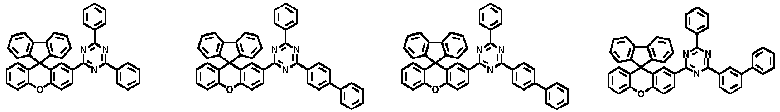

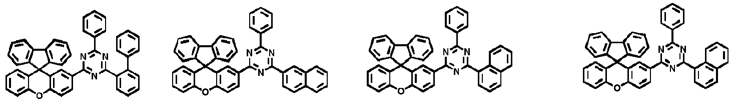

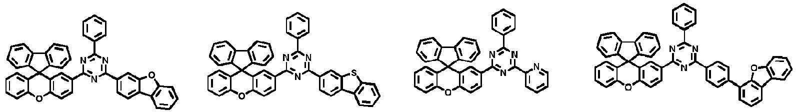

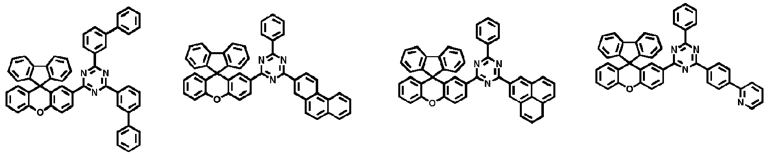

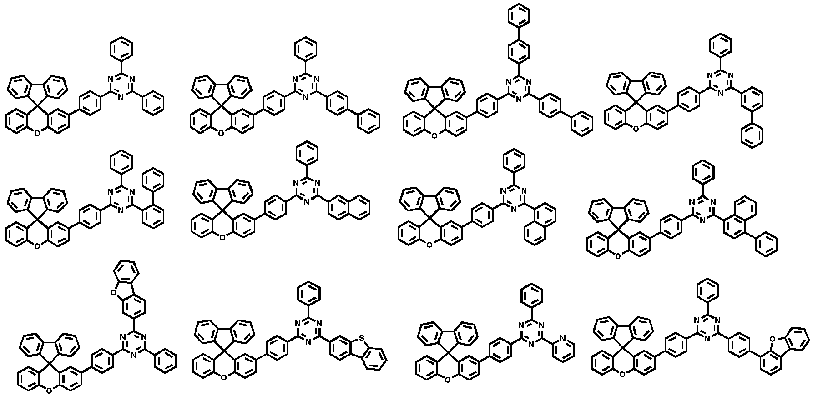

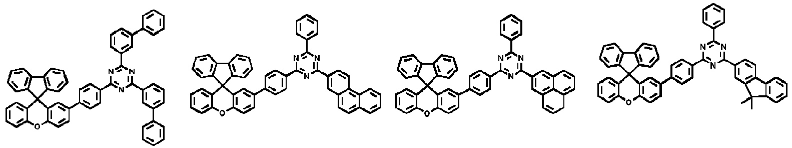

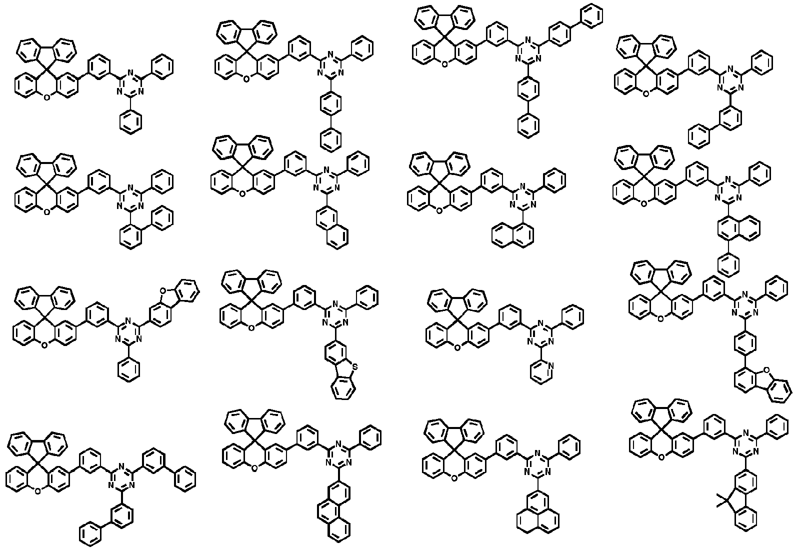

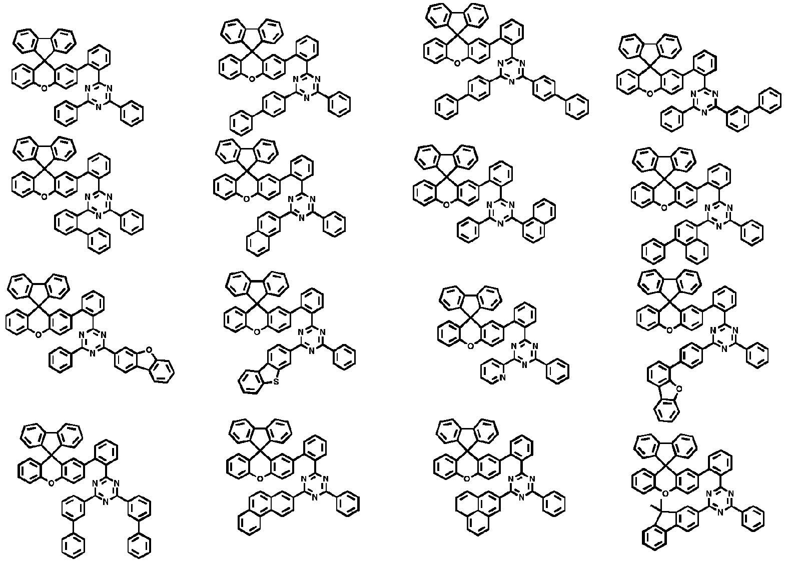

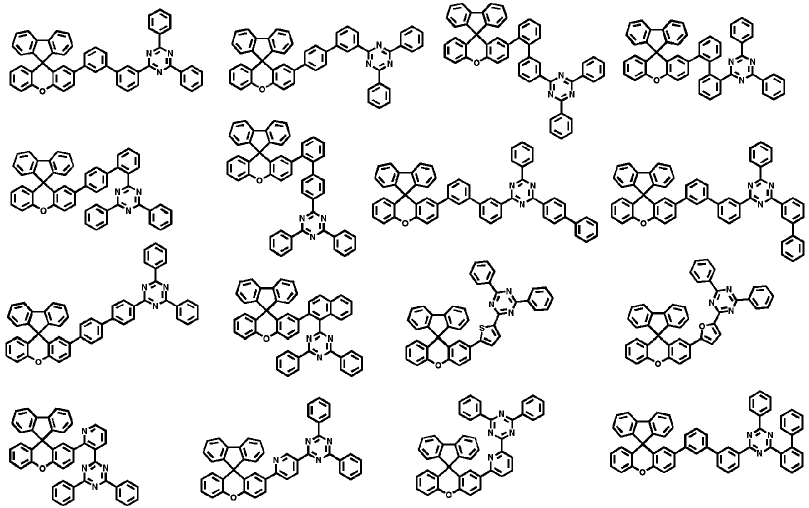

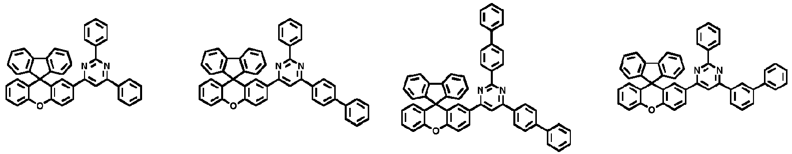

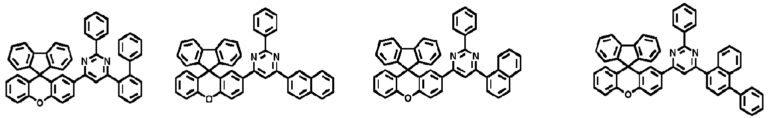

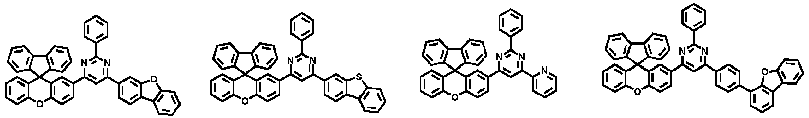

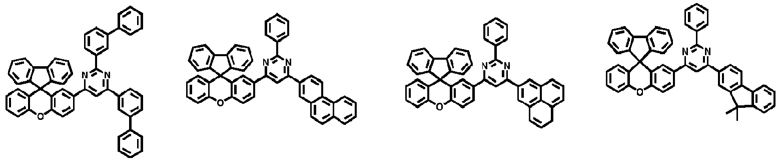

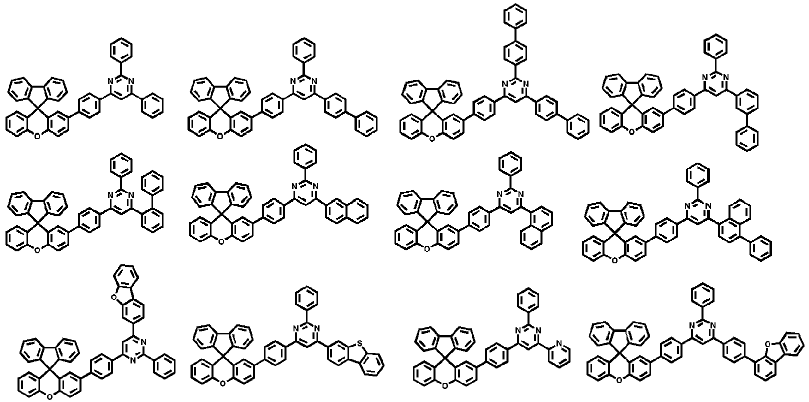

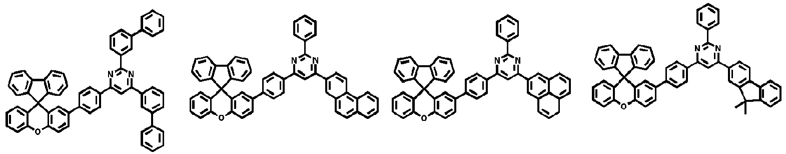

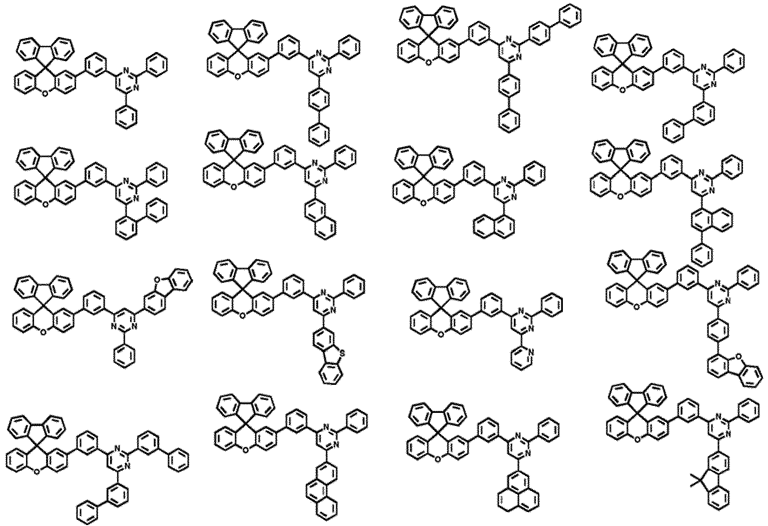

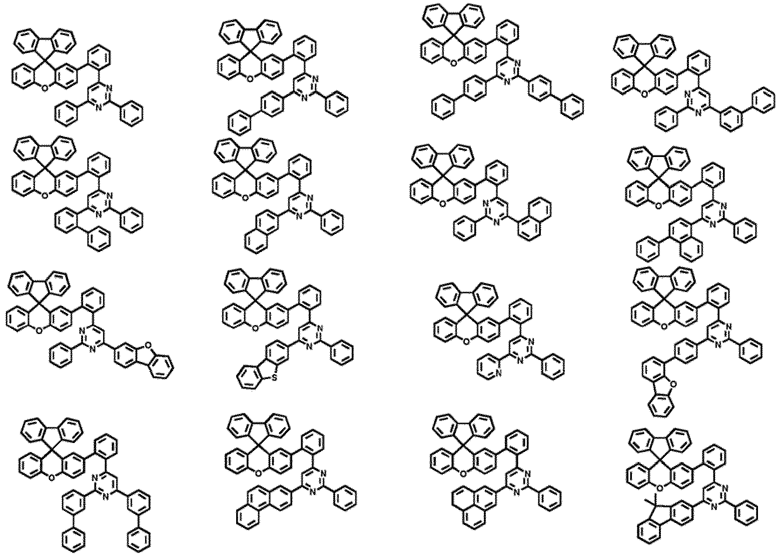

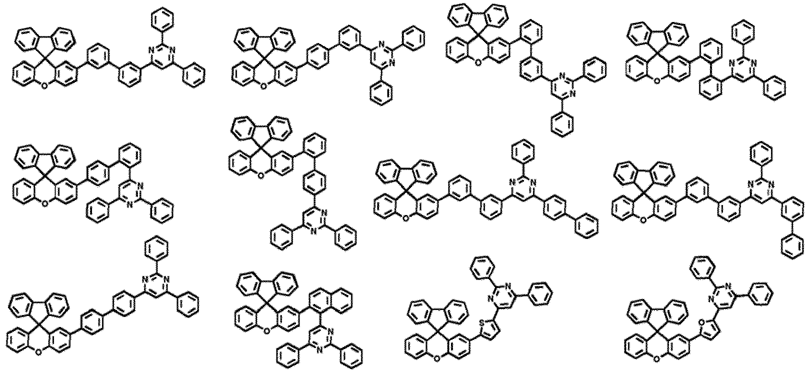

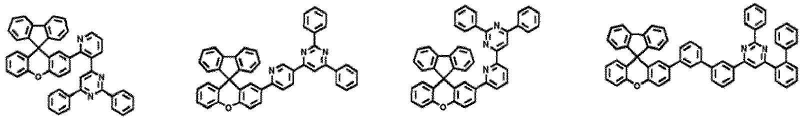

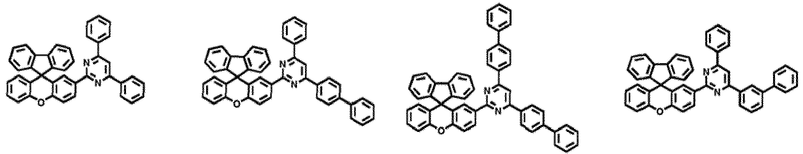

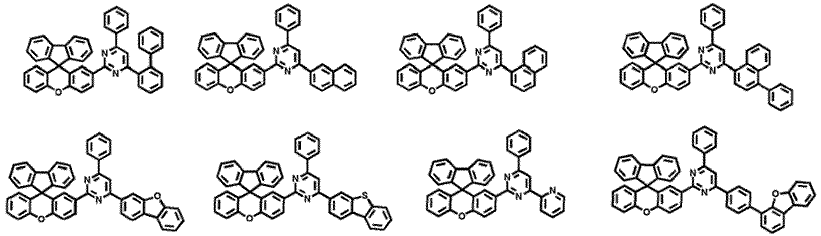

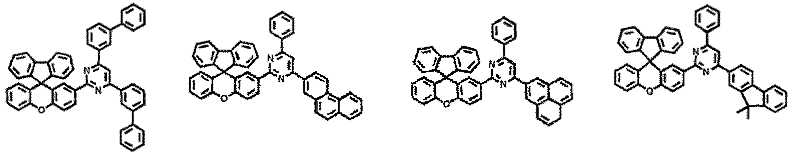

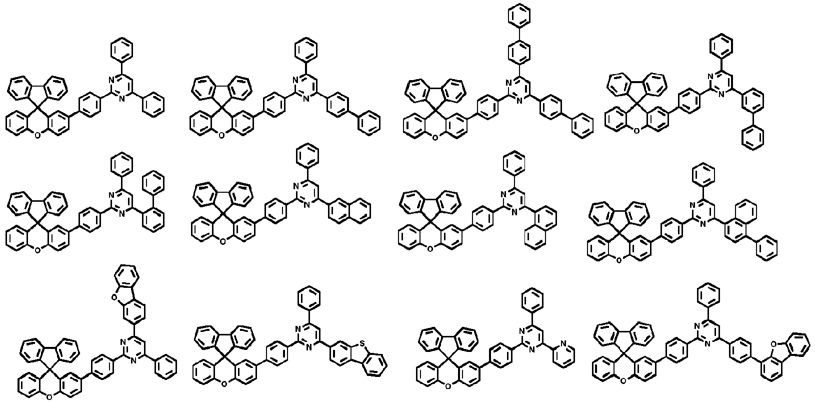

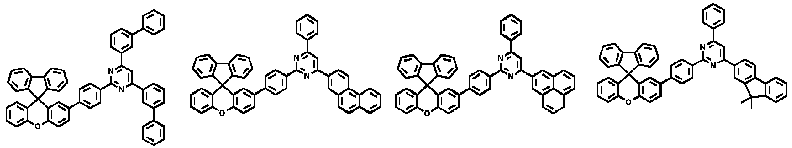

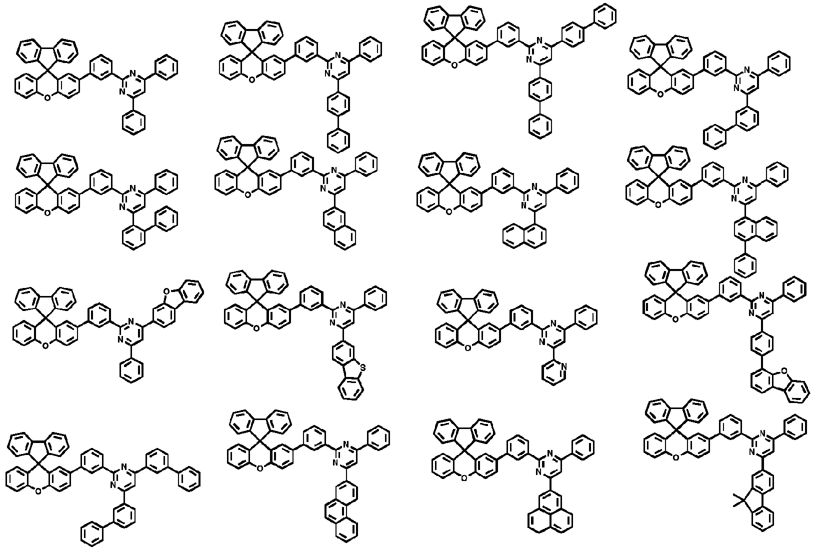

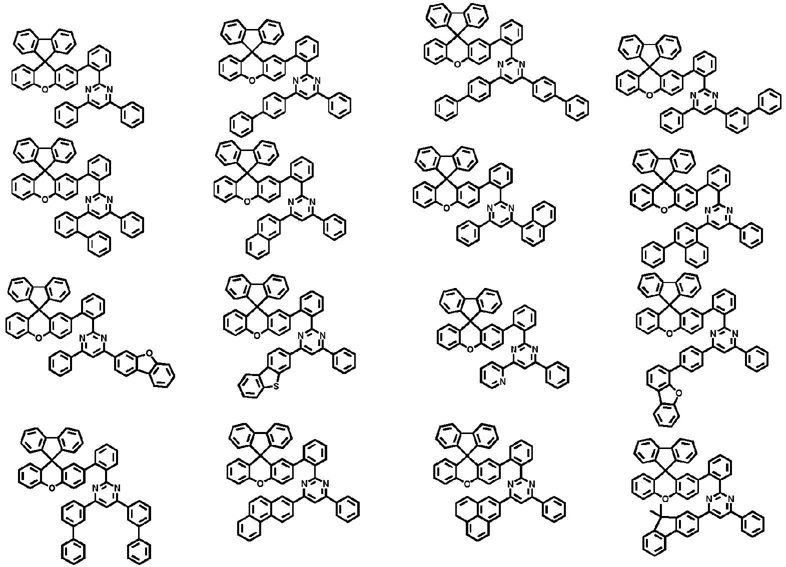

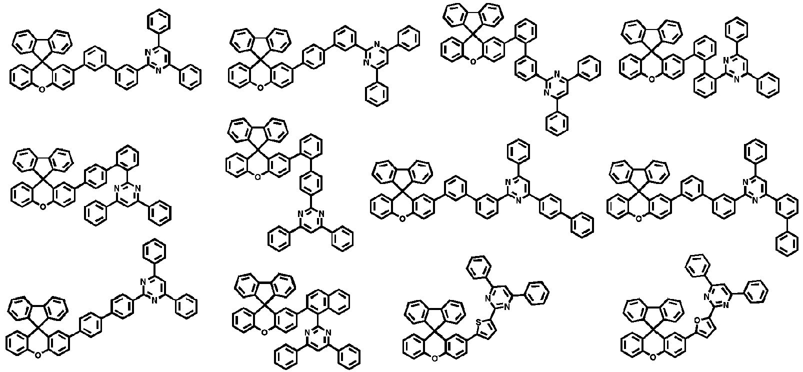

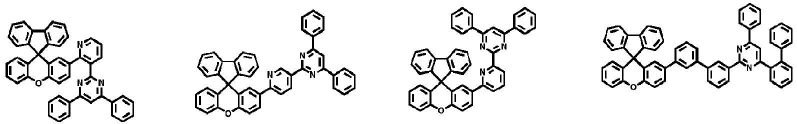

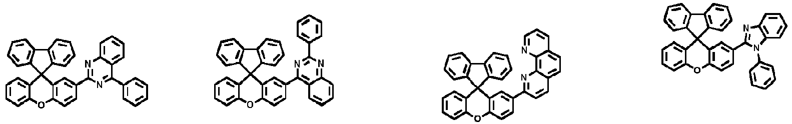

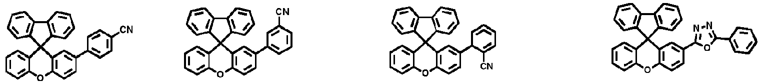

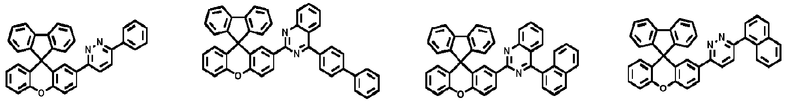

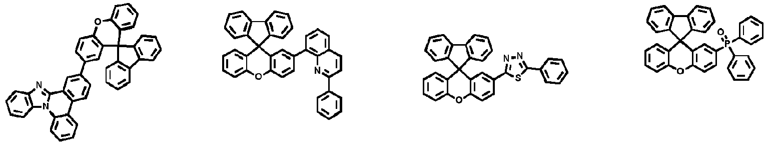

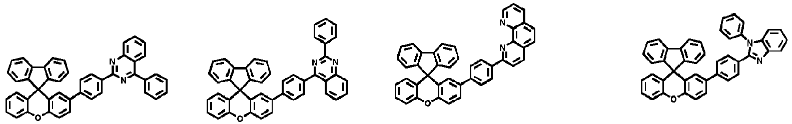

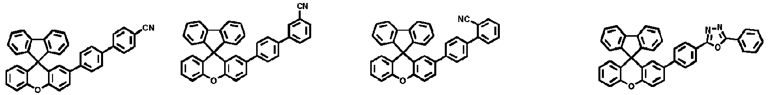

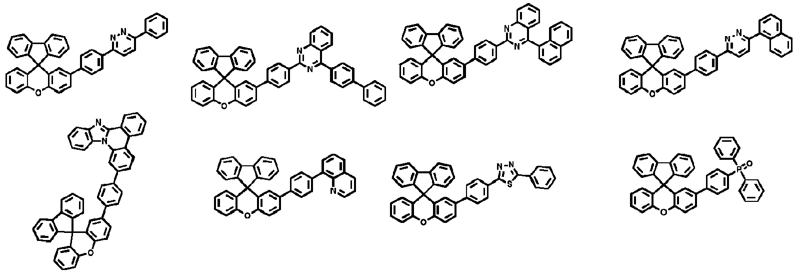

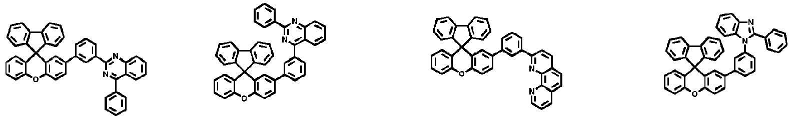

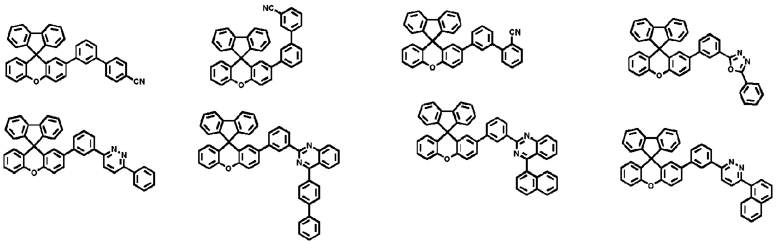

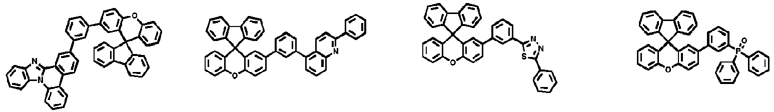

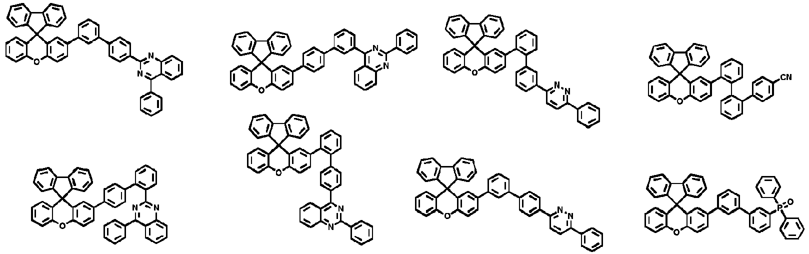

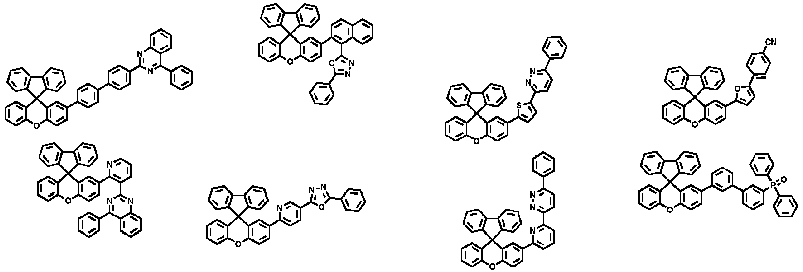

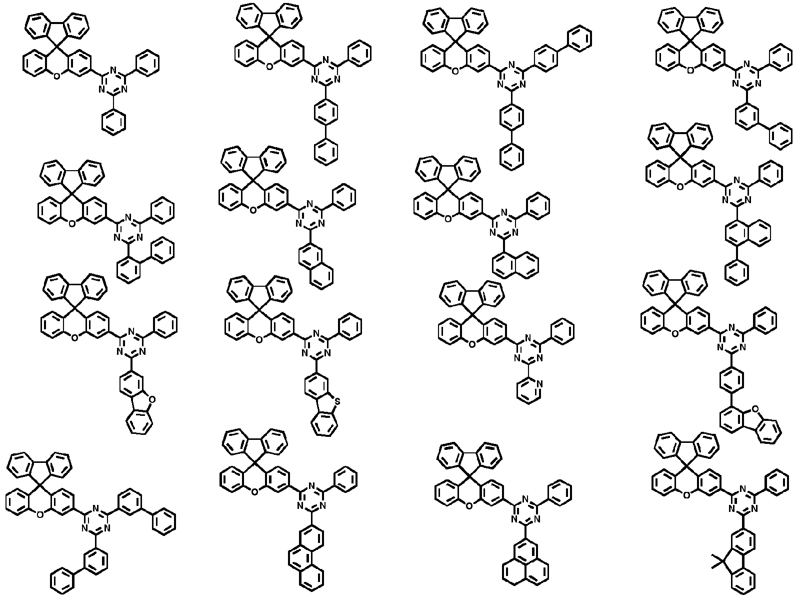

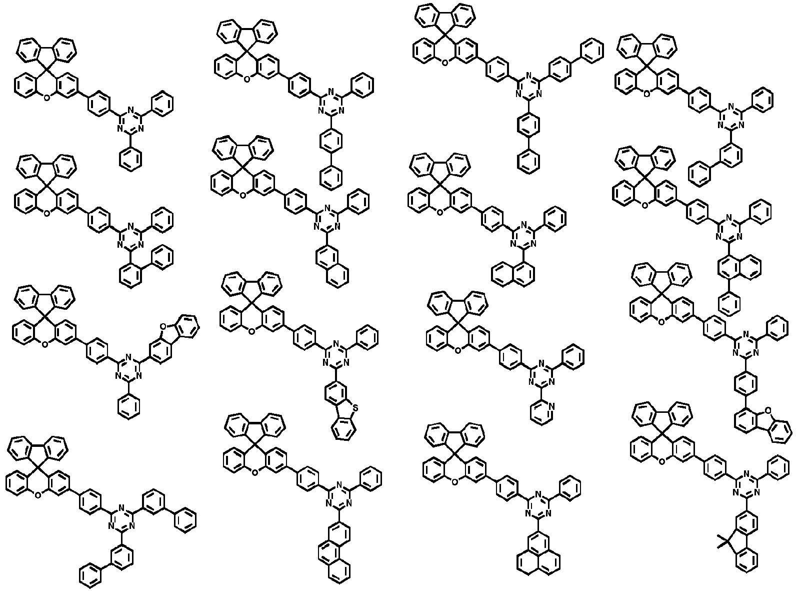

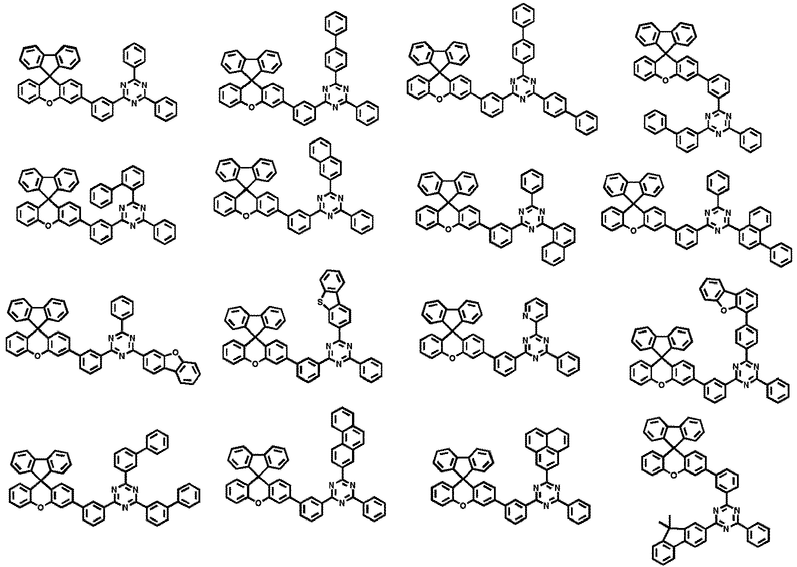

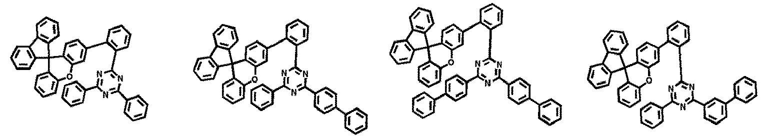

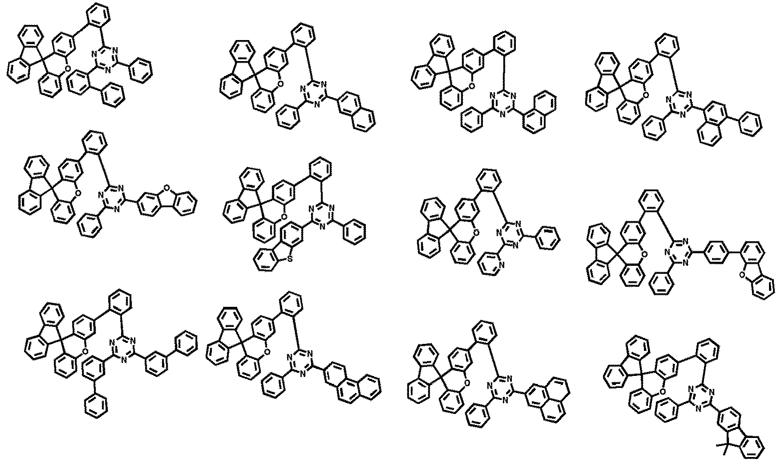

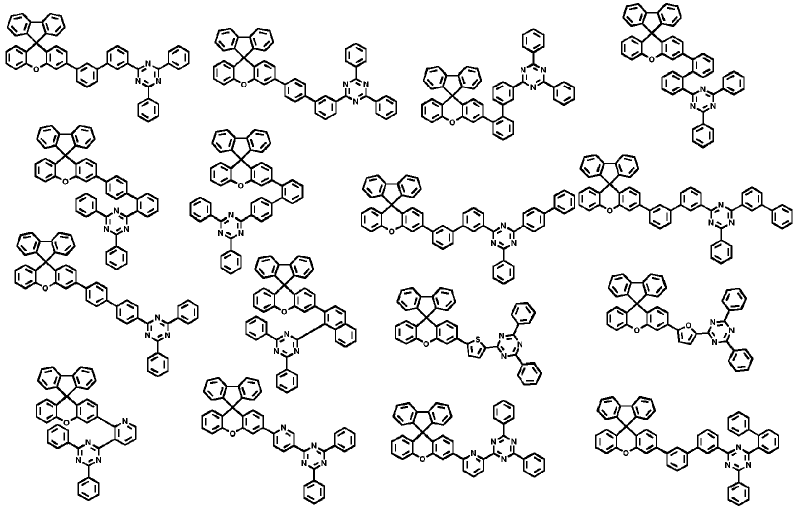

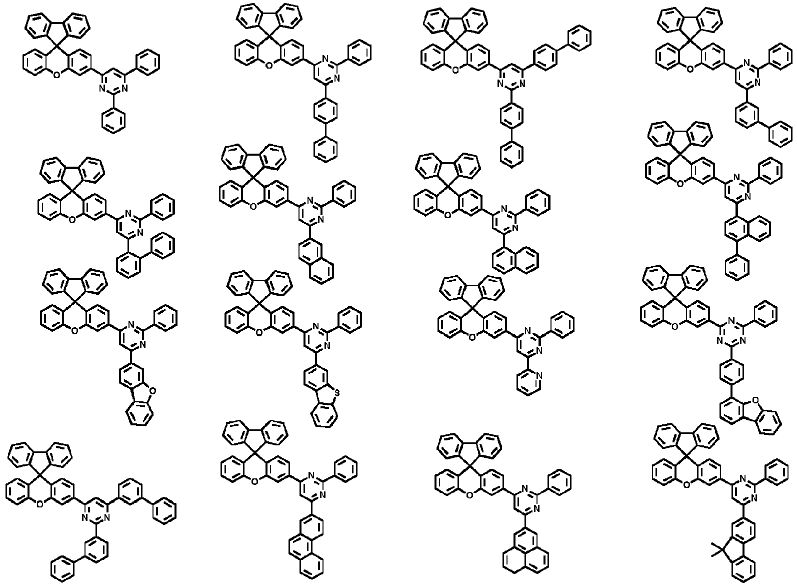

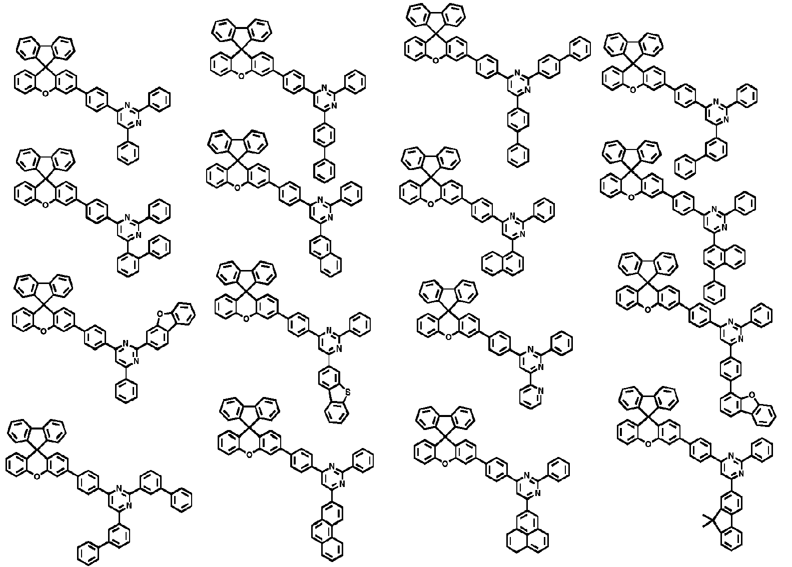

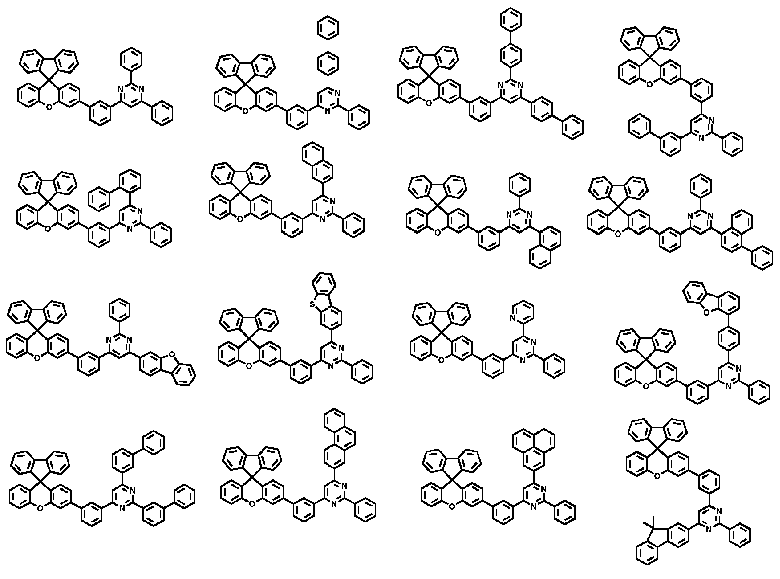

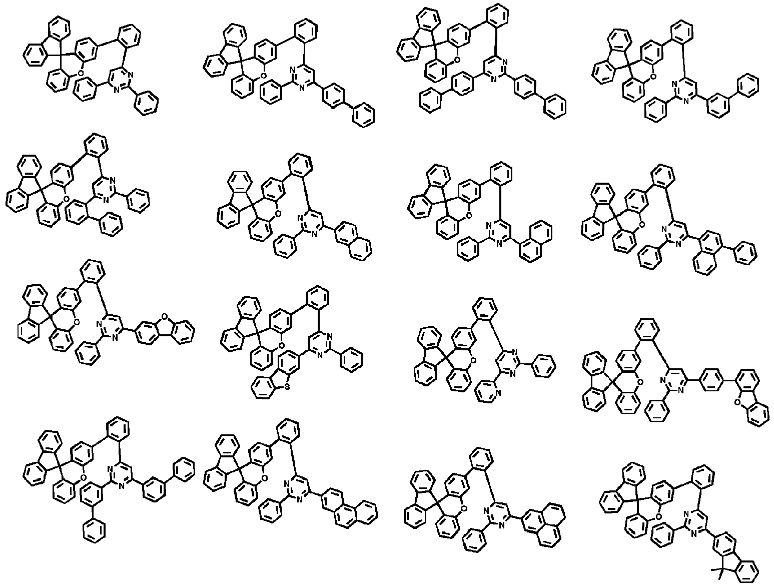

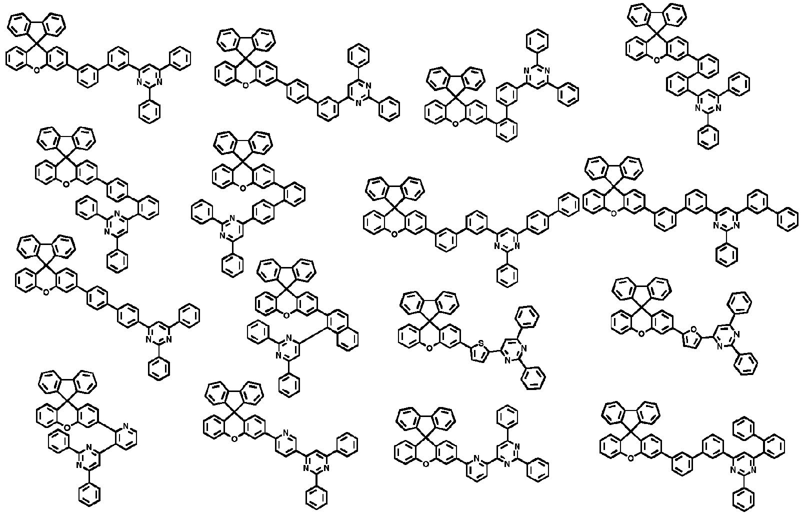

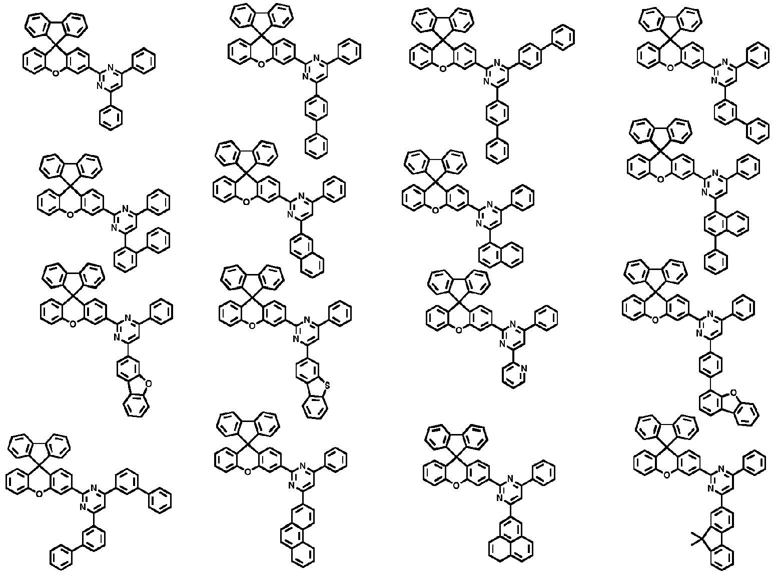

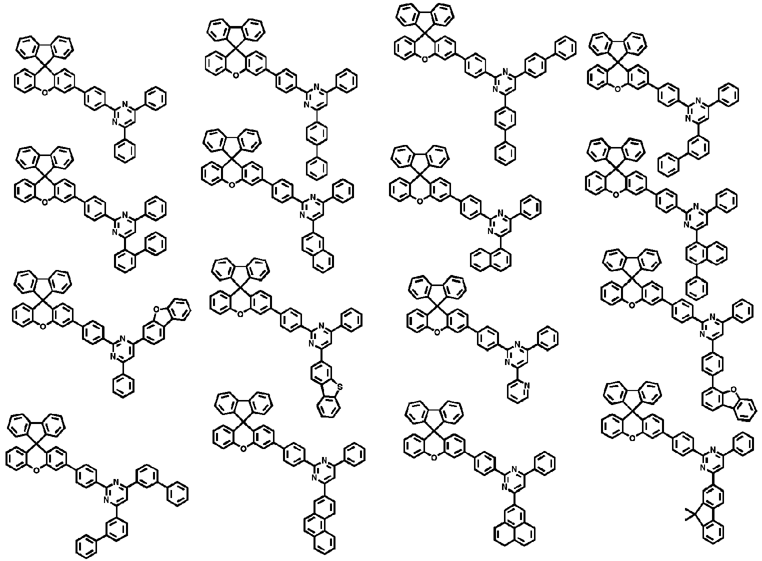

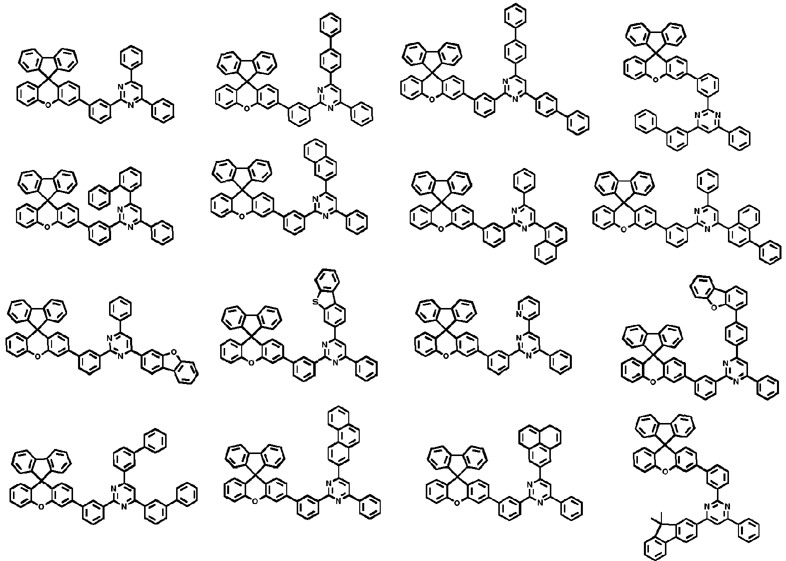

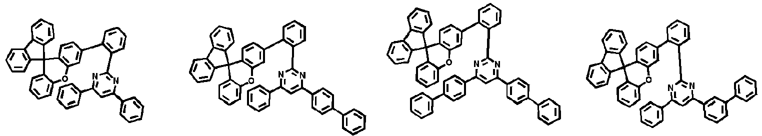

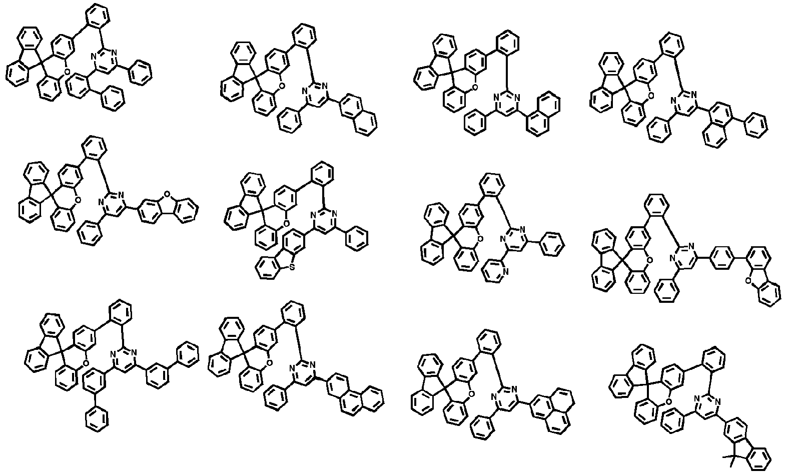

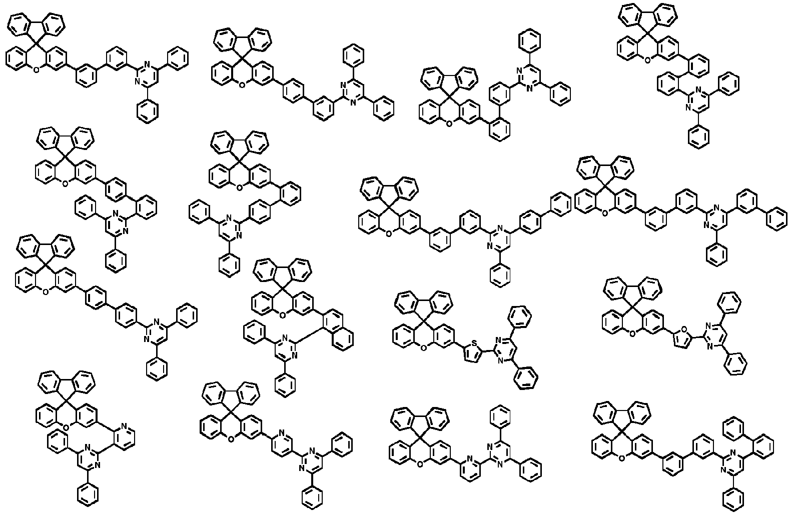

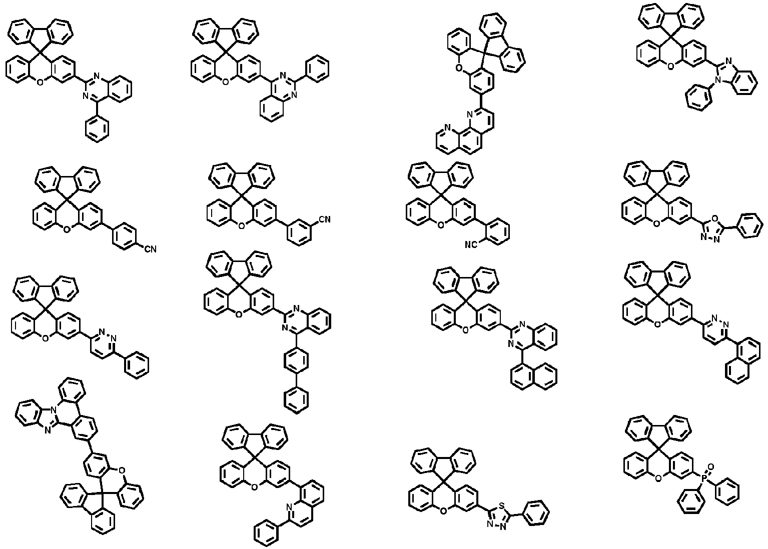

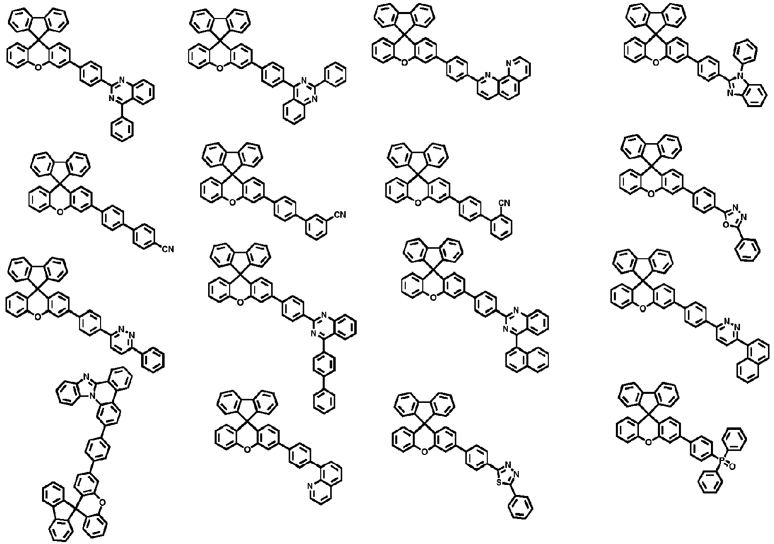

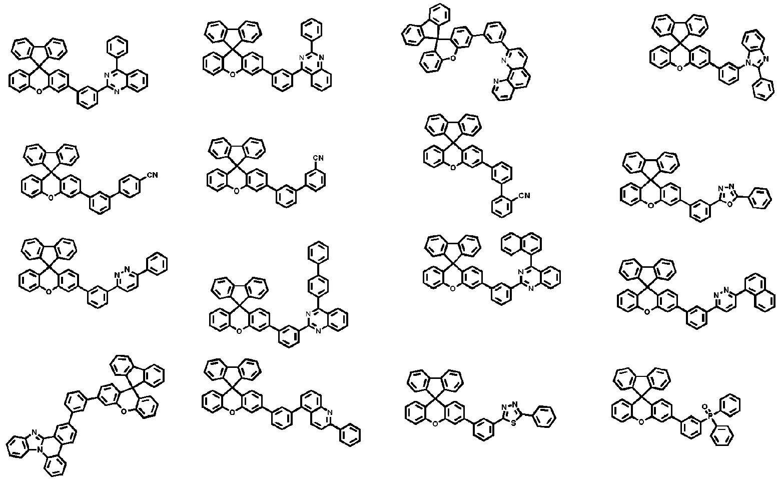

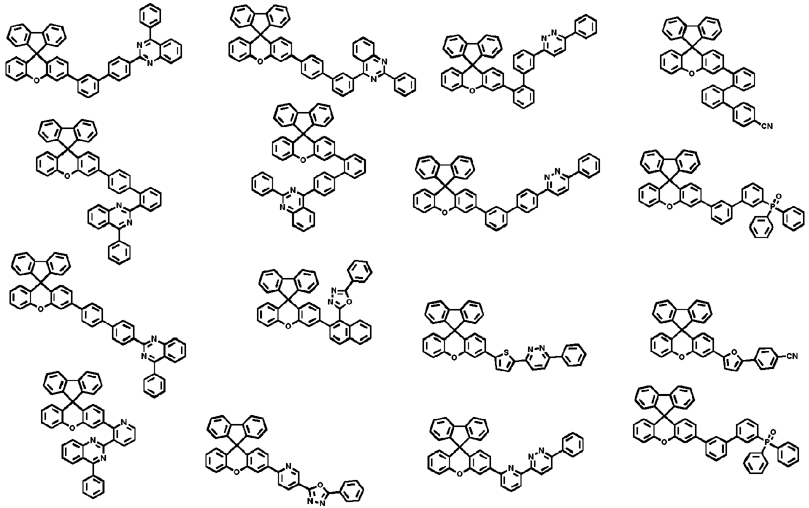

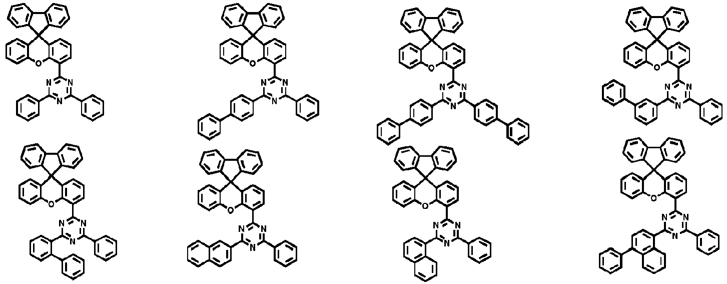

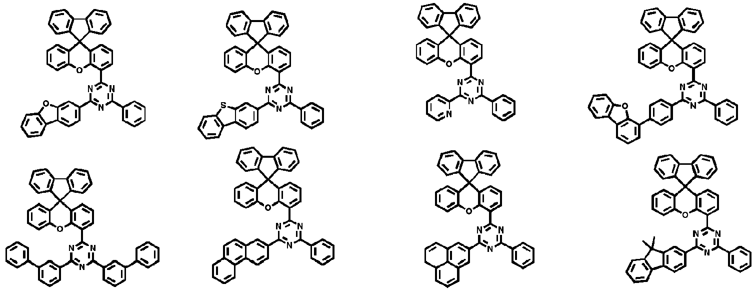

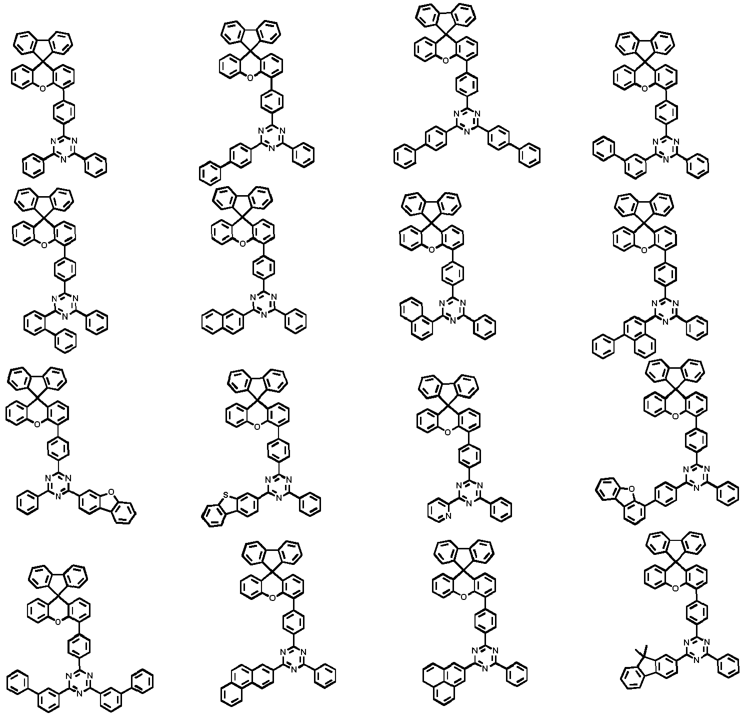

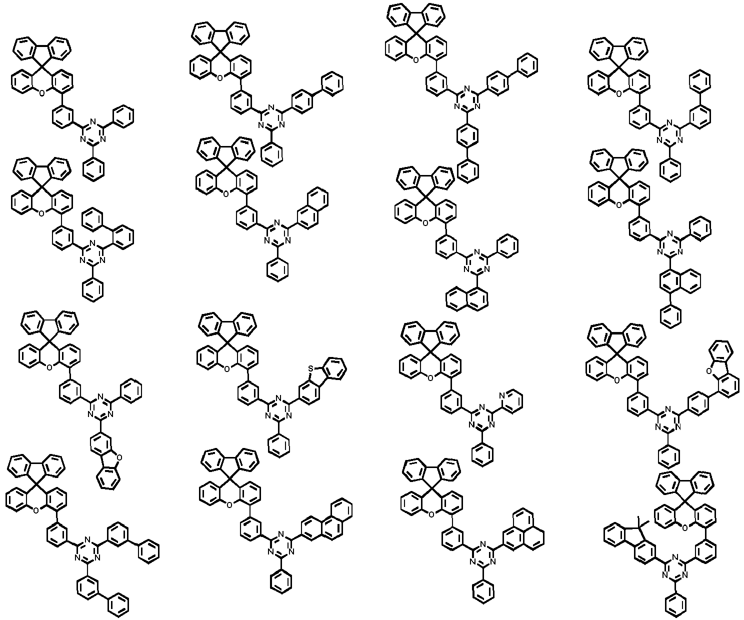

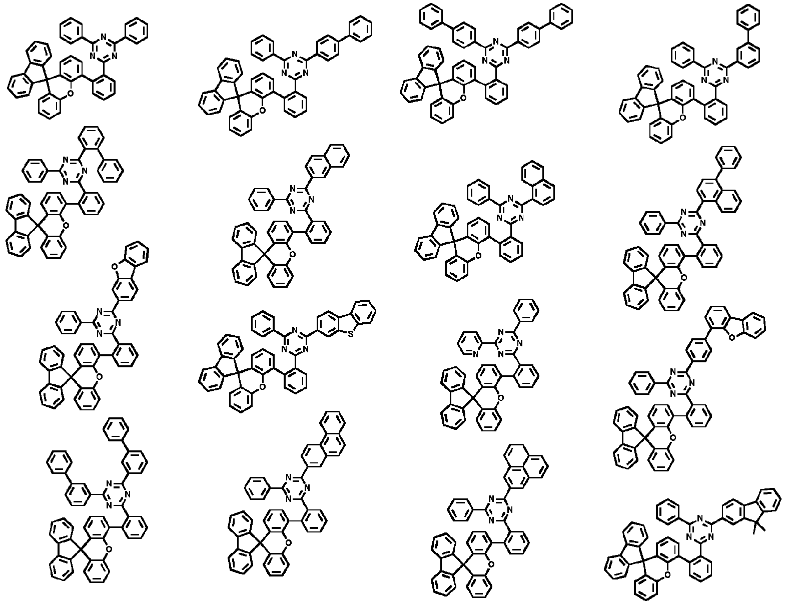

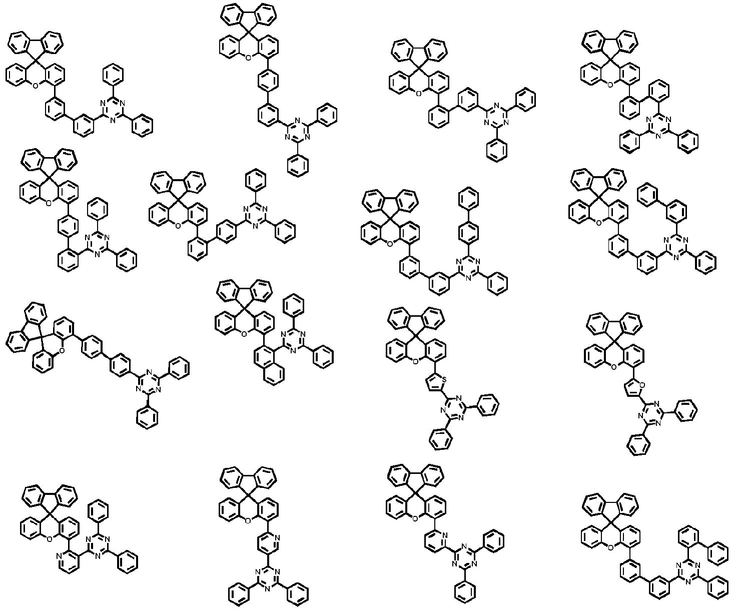

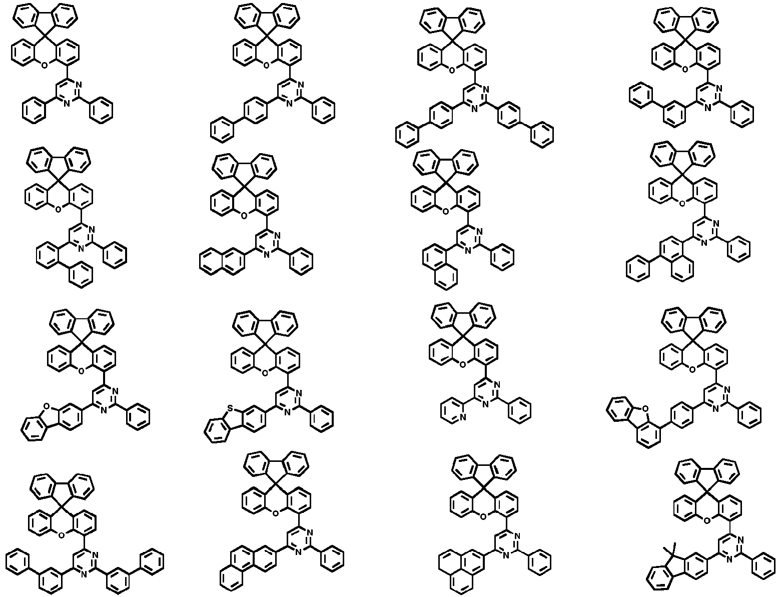

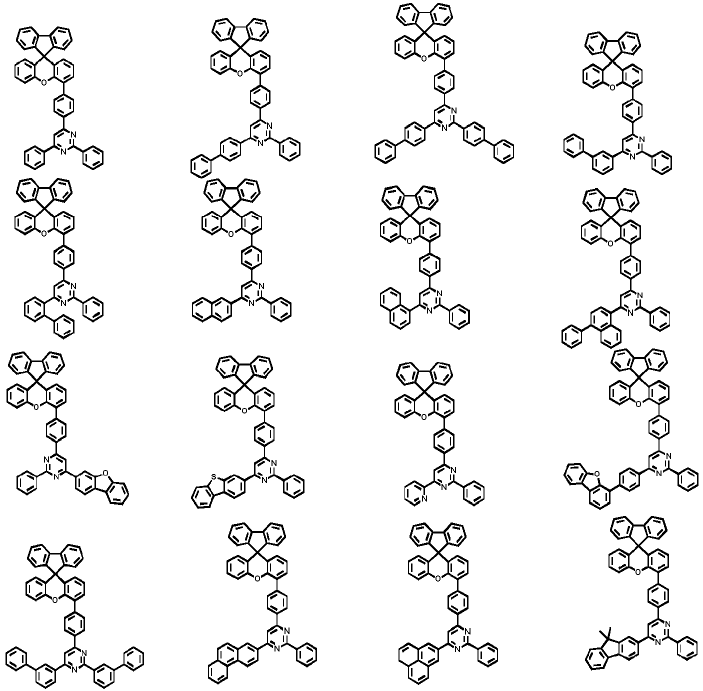

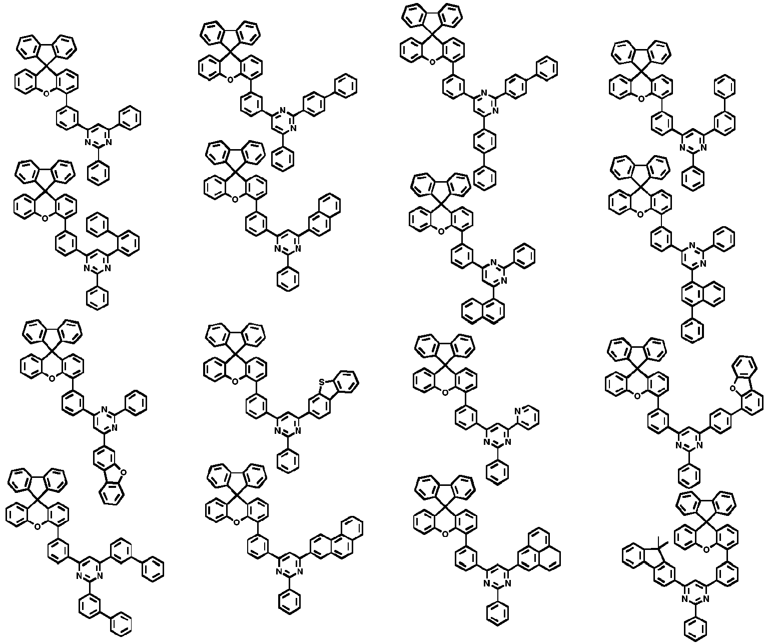

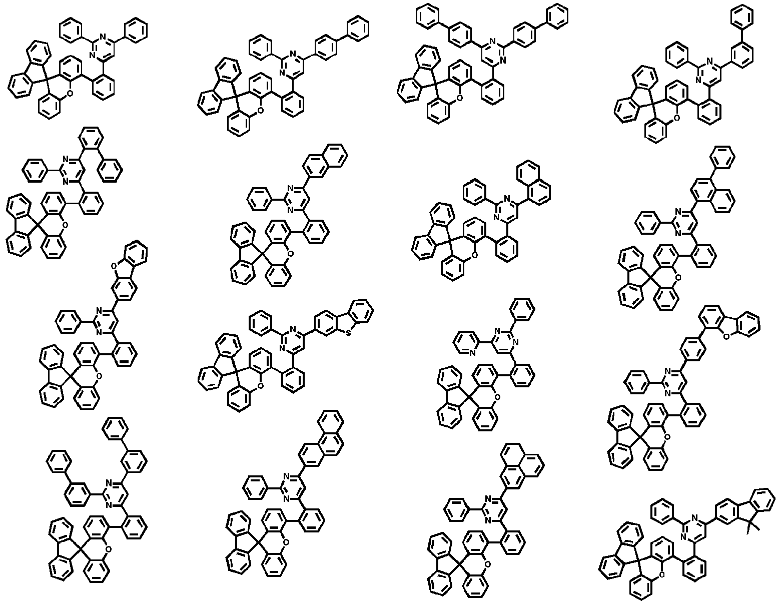

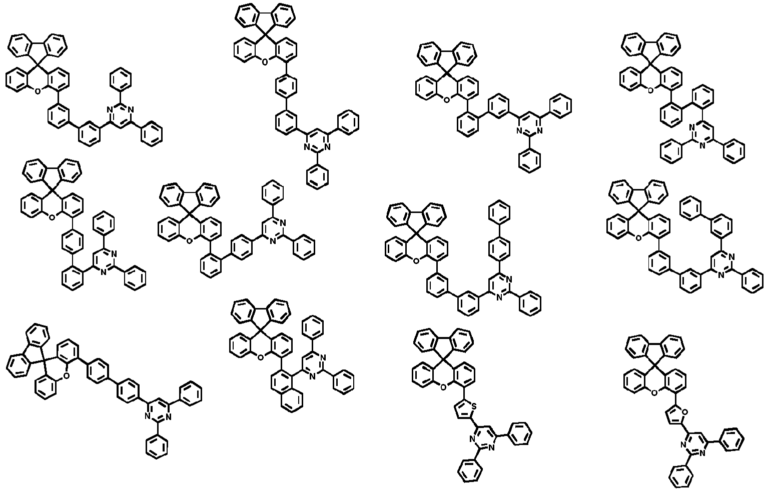

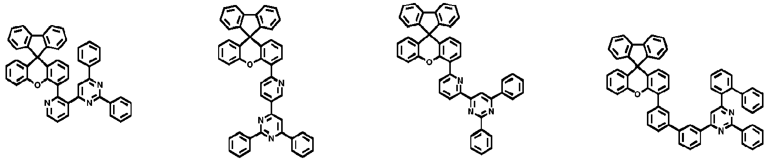

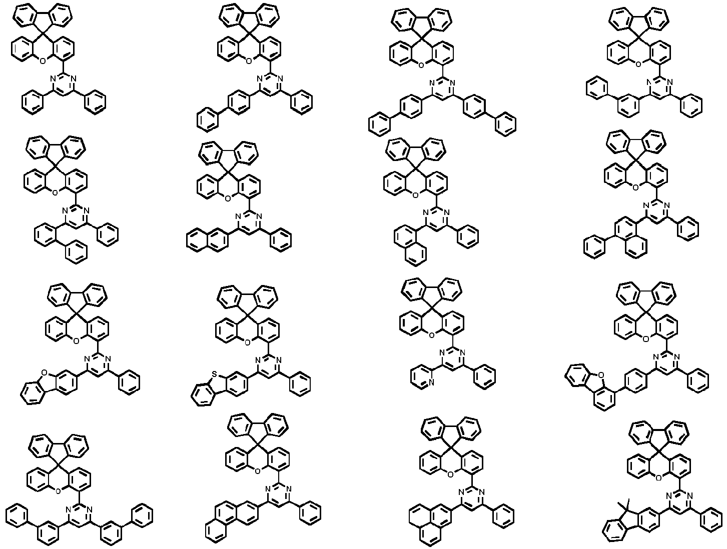

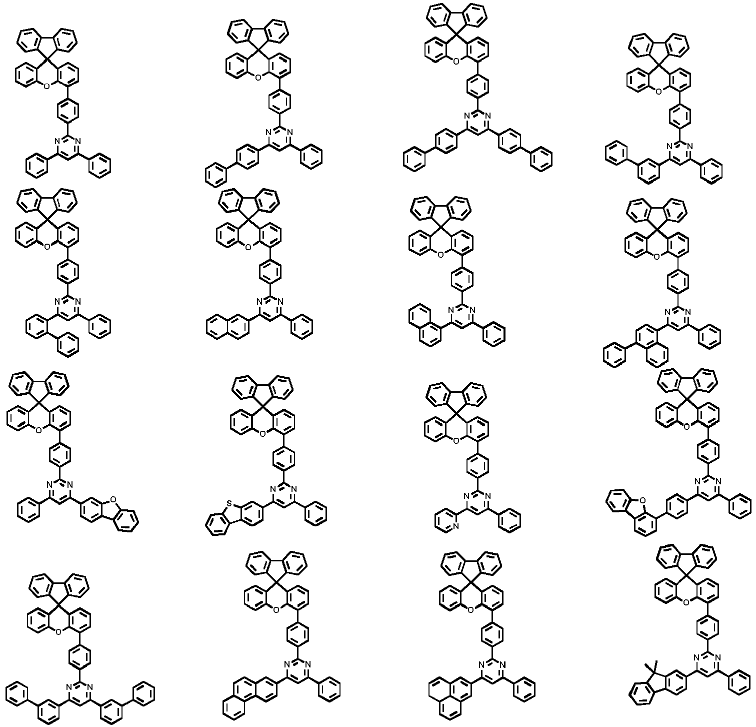

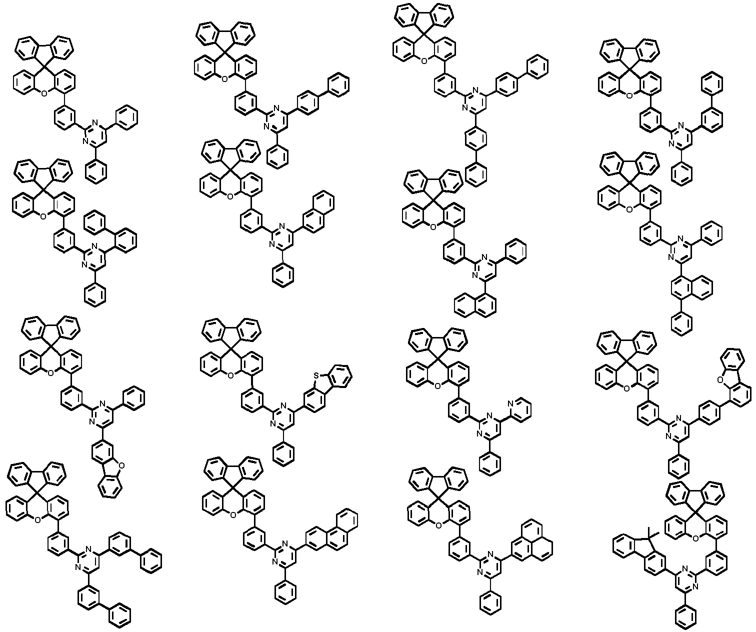

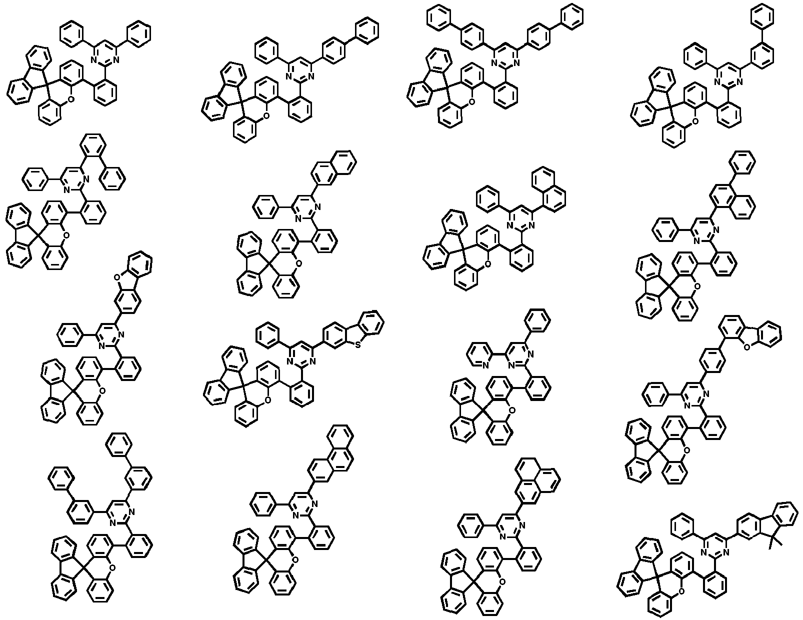

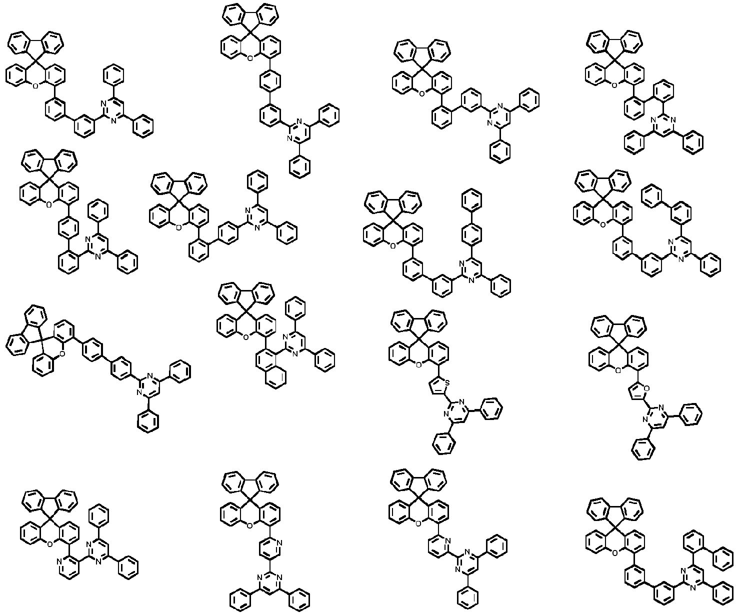

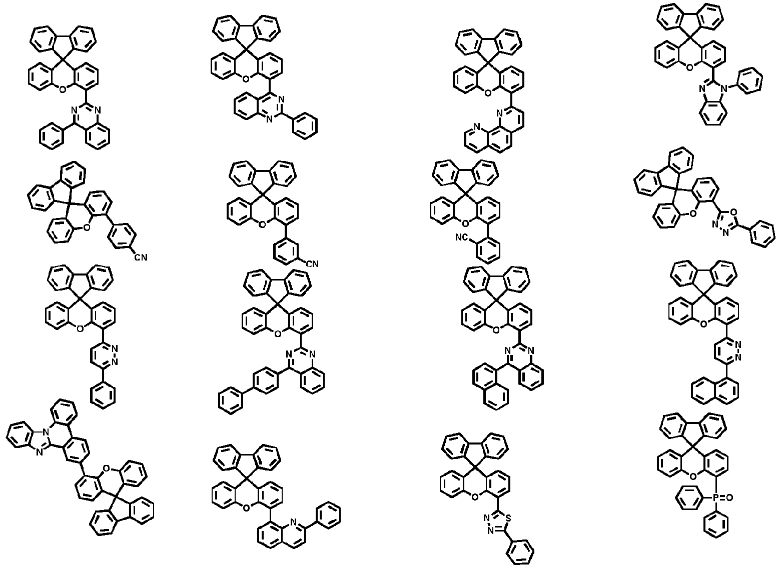

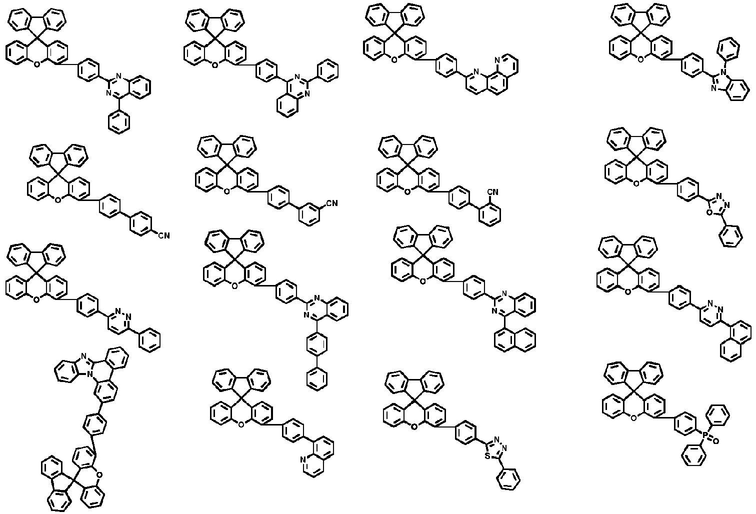

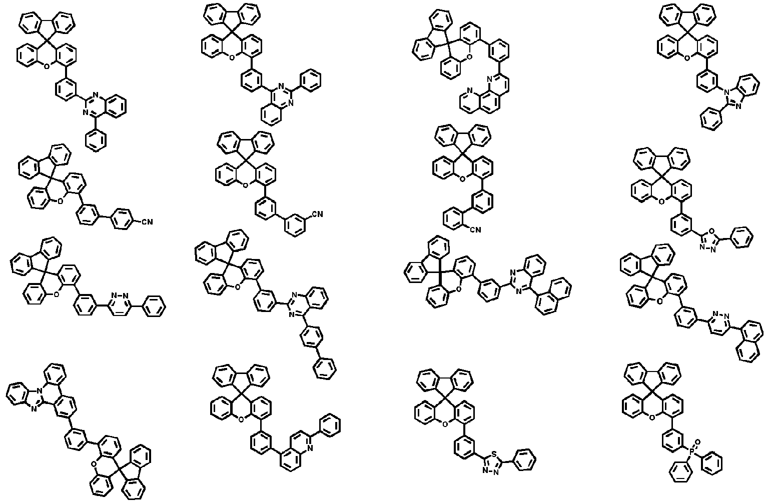

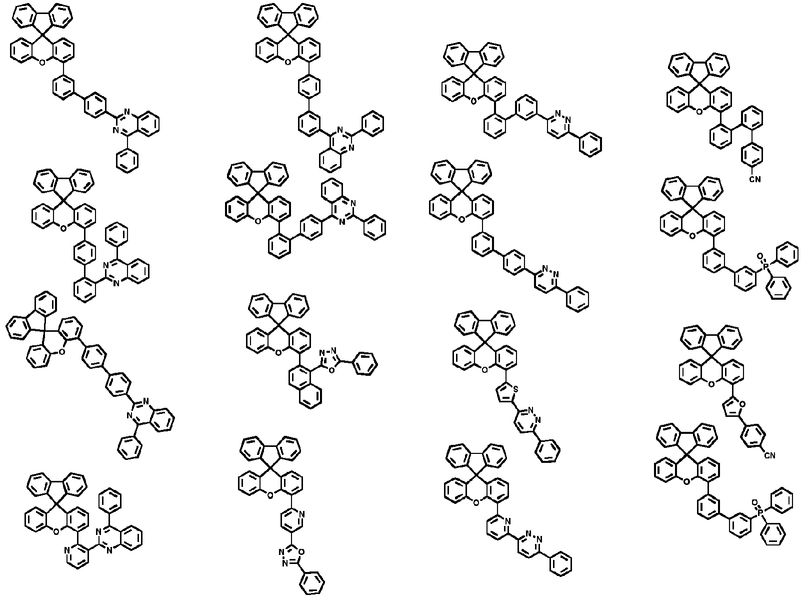

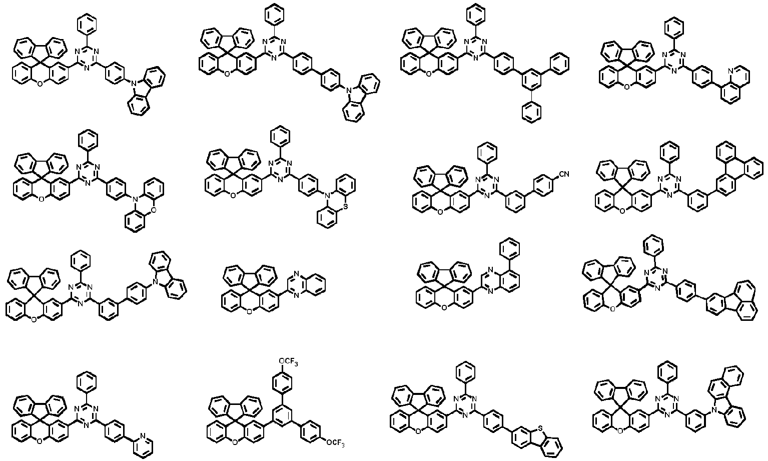

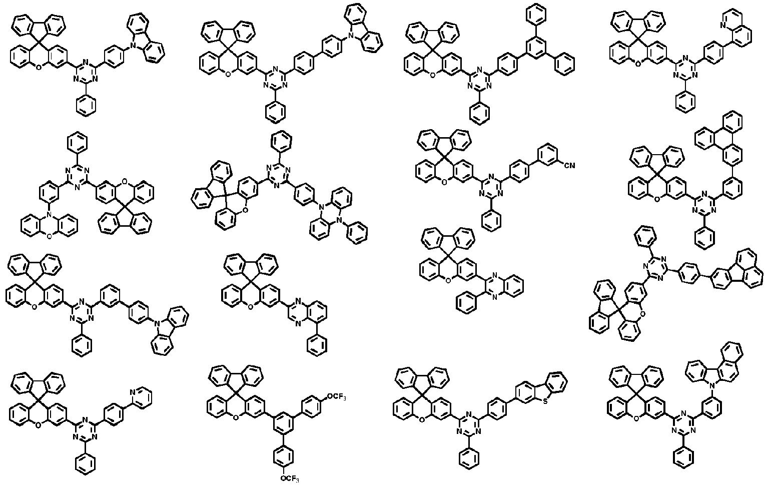

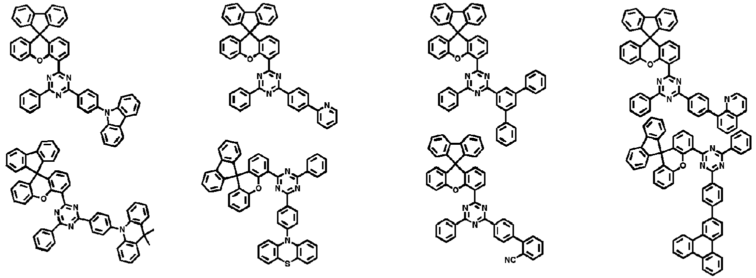

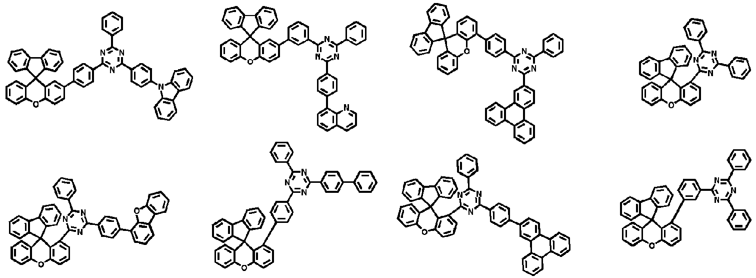

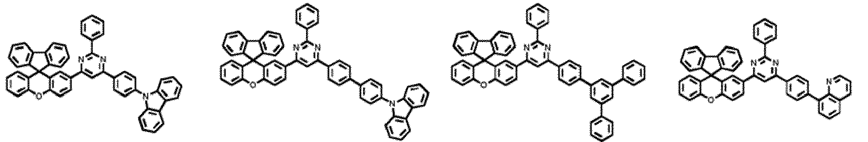

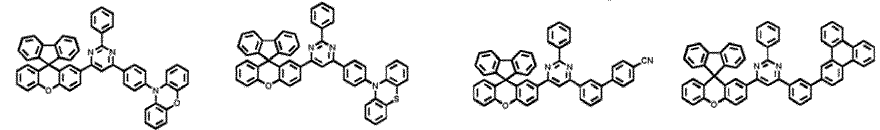

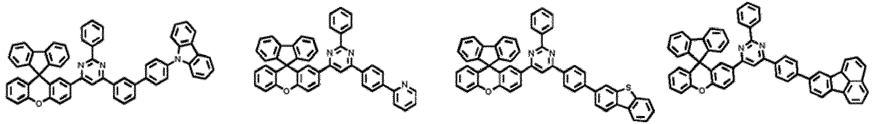

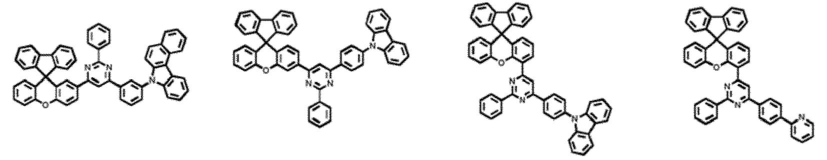

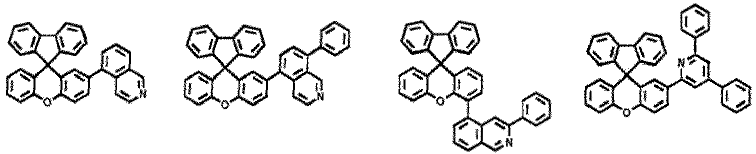

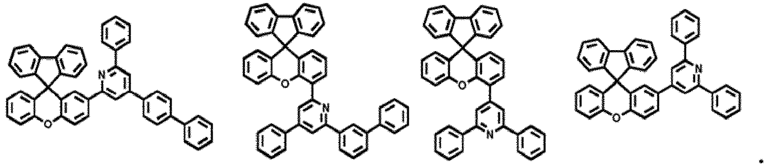

12. Dispositif électroluminescent organique selon la revendication 1, dans lequel la formule chimique 3 est l'un quelconque choisi parmi les composés suivants :

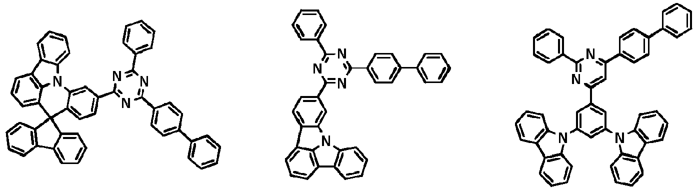

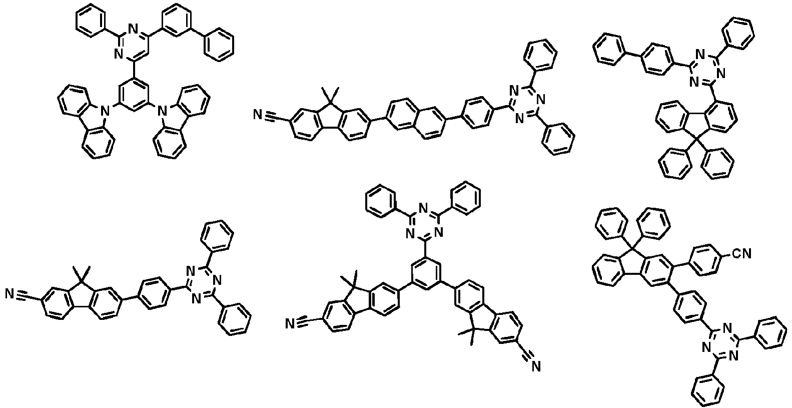

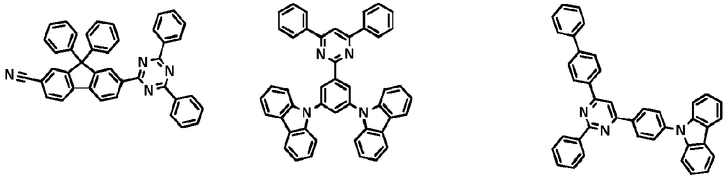

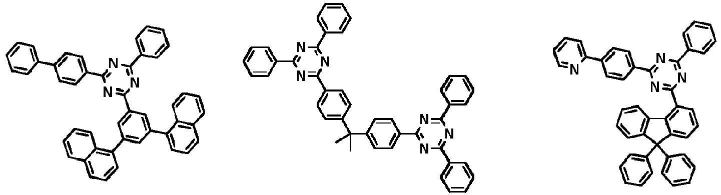

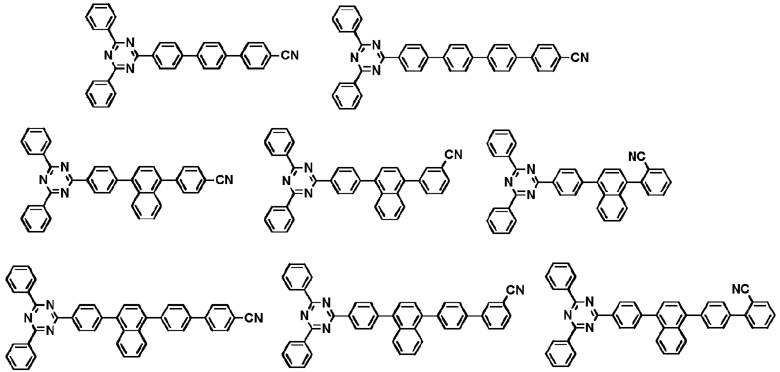

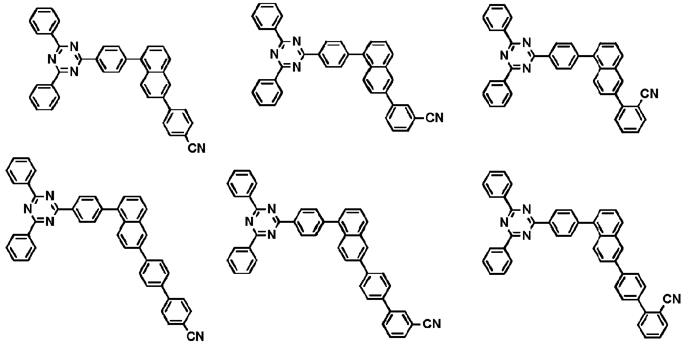

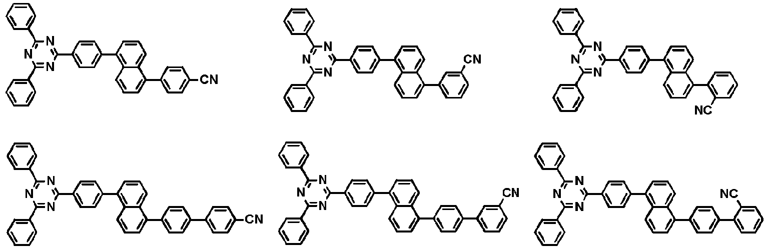

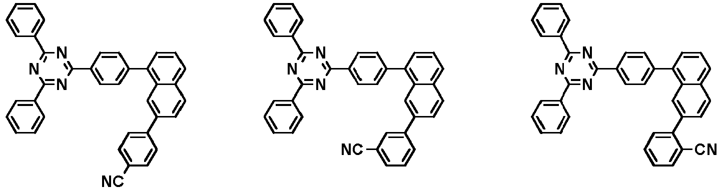

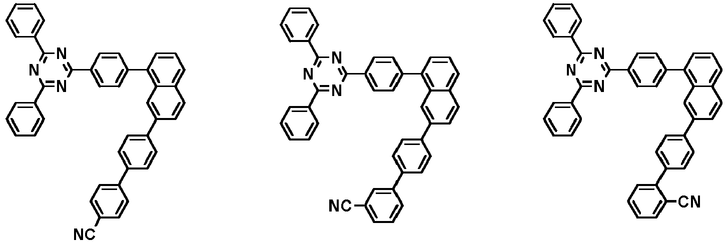

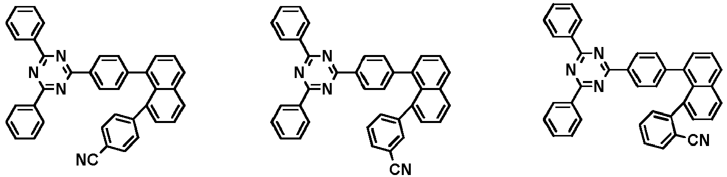

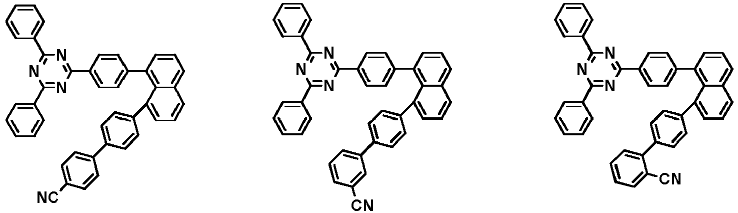

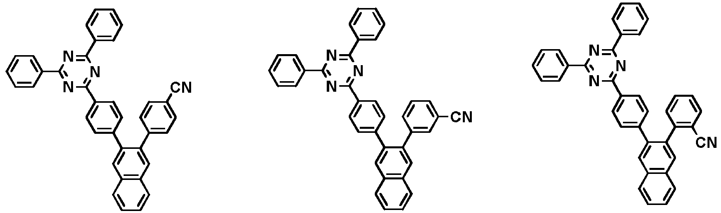

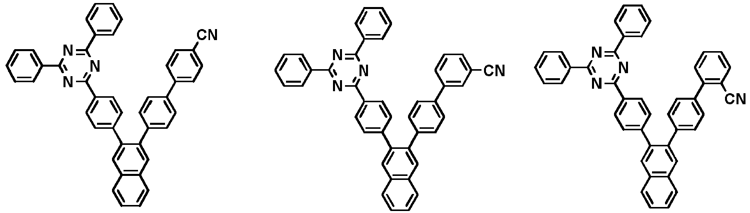

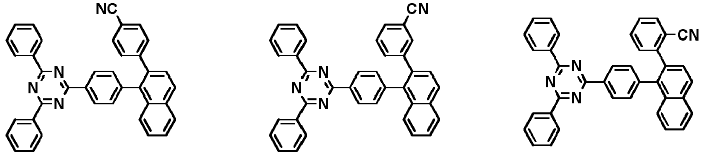

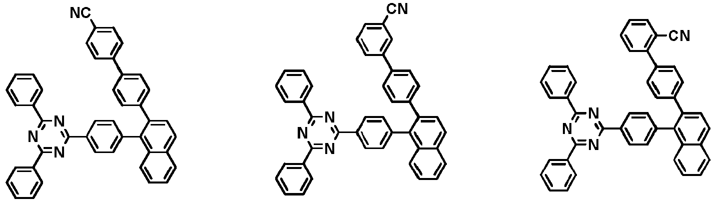

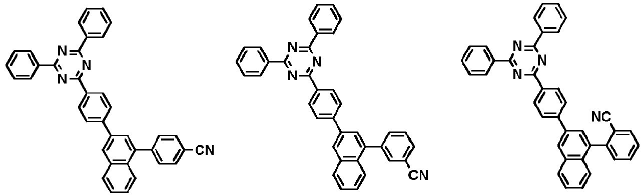

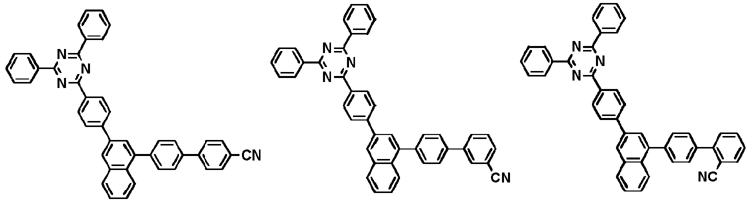

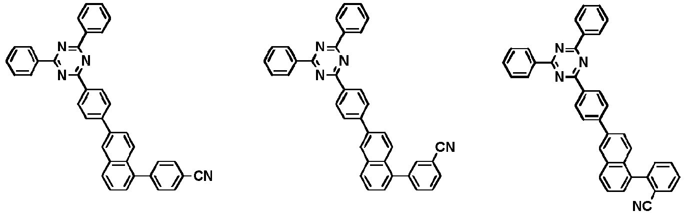

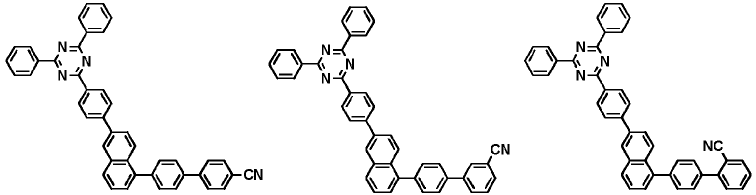

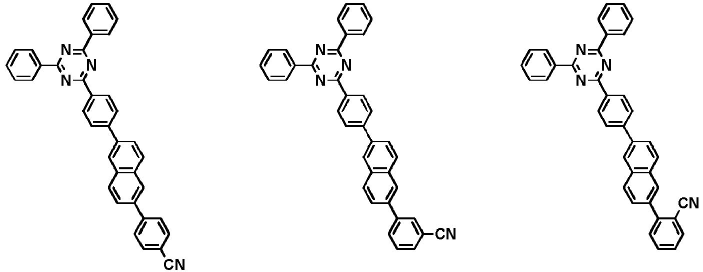

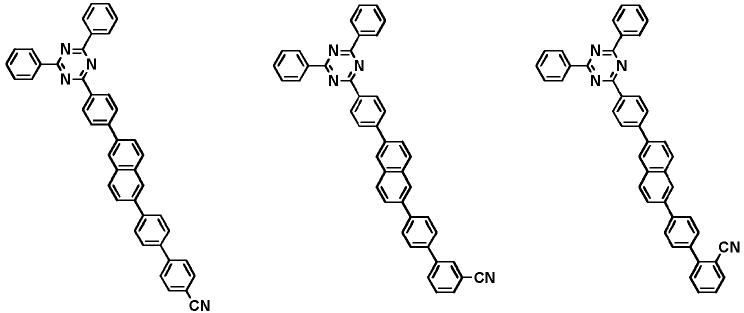

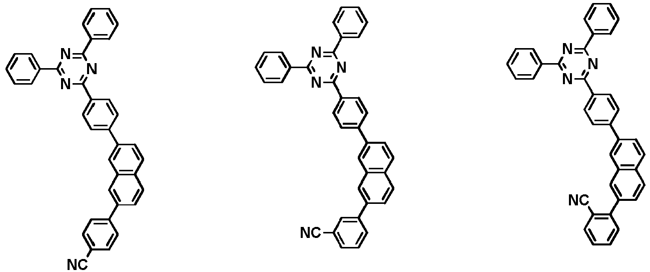

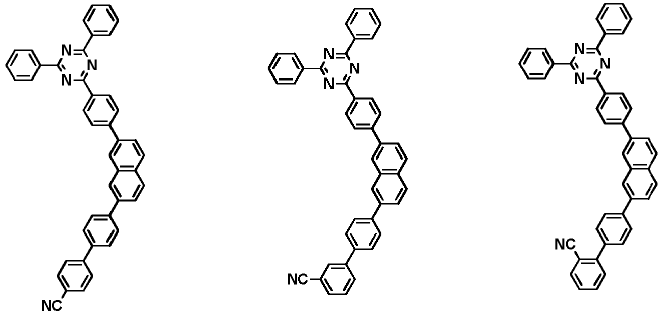

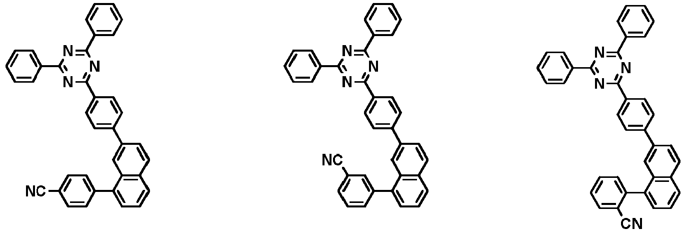

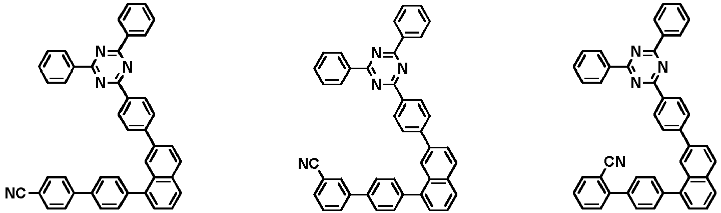

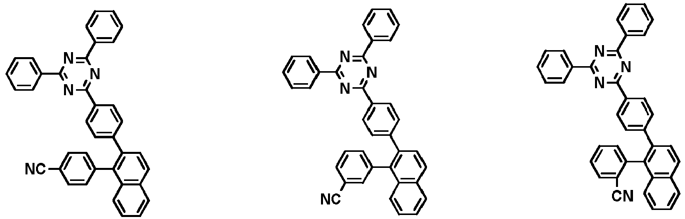

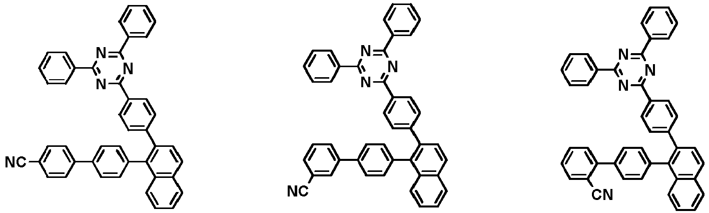

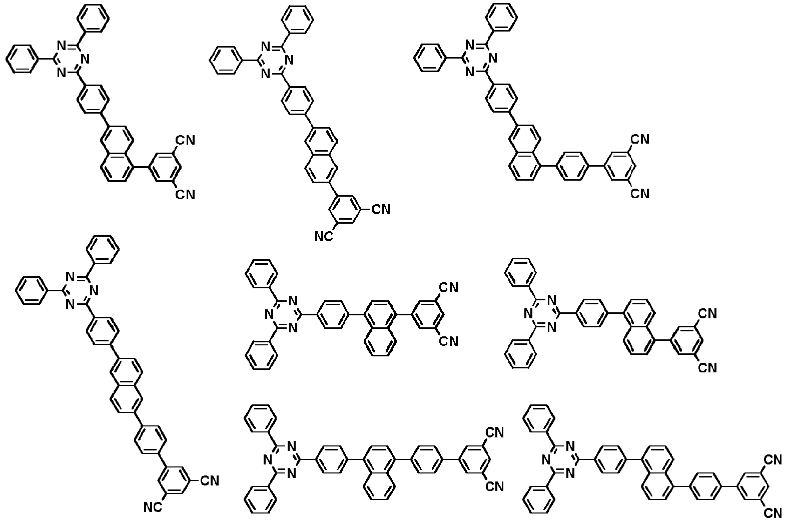

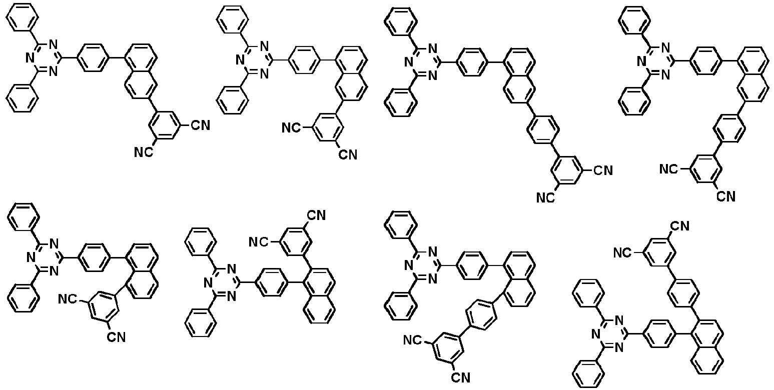

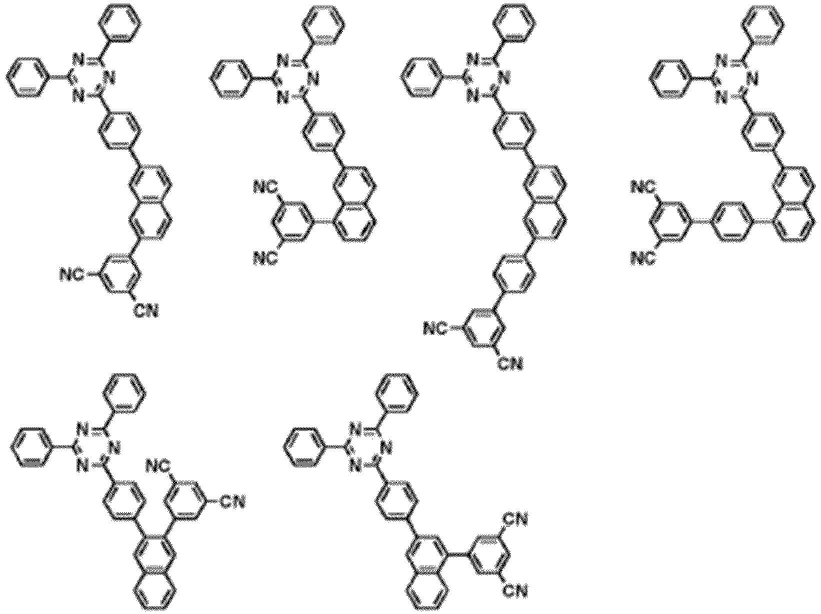

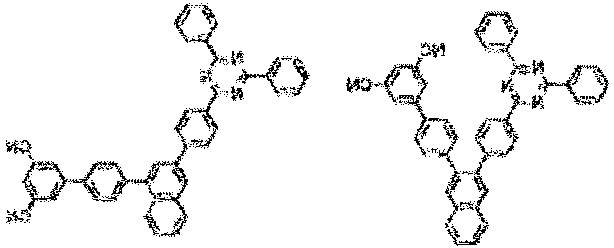

13. Dispositif électroluminescent organique selon la revendication 1, dans lequel le composé représenté par la formule chimique 1 présente une bande interdite de 3,0 eV ou plus.

14. Dispositif électroluminescent organique selon la revendication 1, dans lequel le dispositif électroluminescent organique inclut en outre une ou plusieurs couches de matière organique sélectionnées parmi une couche d'injection de trous, une couche de transfert de trous et une couche d'injection d'électrons.
